# EUROPEAN PATENT APPLICATION

(11) **EP 4 847 568 A1**
(43) Date of publication of application: **02.12.2026**
(21) Application number: 26173118.6
(22) Date of filing: 17.04.2026
(51) Int. Cl.: C09B 57/00

(54) **LIGHT EMITTING ELEMENT, FUSED POLYCYCLIC COMPOUND FOR THE LIGHT EMITTING ELEMENT, AND ELECTRONIC DEVICE INCLUDING THE LIGHT EMITTING ELEMENT**

(30) Priority: 01.05.2025 JP 2025076050
(71) Applicant: Samsung Display Co., Ltd, Yongin-si, Gyeonggi-Do (KR)
(72) Inventor: HOSHI, Keigo, Yokohama-shi, 220-0011 (JP); KIM, Jeongeun, Yongin-si (KR); YAMAMOTO, Makoto, Yokohama-shi, 220-0011 (JP)
(74) Representative: Marks & Clerk LLP

(57) **Abstract**

Provided is a light emitting element including a first electrode, a second electrode disposed on the first electrode, and an emission layer disposed between the first electrode and the second electrode, wherein the emission layer includes a first compound represented by Formula 1. Accordingly, the light emitting element according to one or more embodiments may exhibit high efficiency and long lifespan: 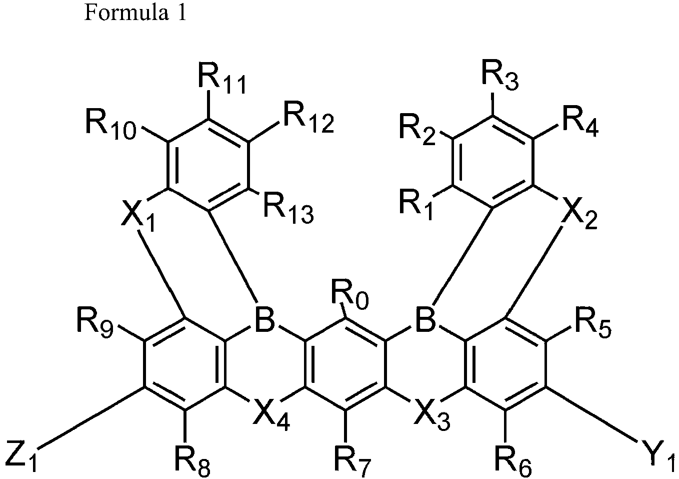 wherein the substituent groups are as defined herein.

## Description

### BACKGROUND

The present disclosure herein relates to a light emitting element, a fused polycyclic compound used therein, and an electronic device including the light emitting element.

As image display devices, organic electroluminescence display devices and the like have been actively developed recently. The organic electroluminescence display devices and the like are display devices including so-called self-luminescent light emitting elements in which holes and electrons injected from a first electrode and a second electrode recombine in an emission layer, and thus a luminescent material in the emission layer emits light to accomplish display.

For application of light emitting elements to display devices, there is a demand for greater lifespan, and development of materials, for light emitting elements, capable of stably attaining such characteristics is continuously needed.

### SUMMARY

The present disclosure provides a light emitting element exhibiting high efficiency and long lifespan, and an electronic device including the same.

The present disclosure also provides a fused polycyclic compound as a material for a light emitting element, which improves efficiency and lifespan.

An aspect provides a light emitting element including a first electrode, a second electrode disposed on the first electrode, and an emission layer disposed between the first electrode and the second electrode, wherein the emission layer includes a first compound represented by Formula 1:

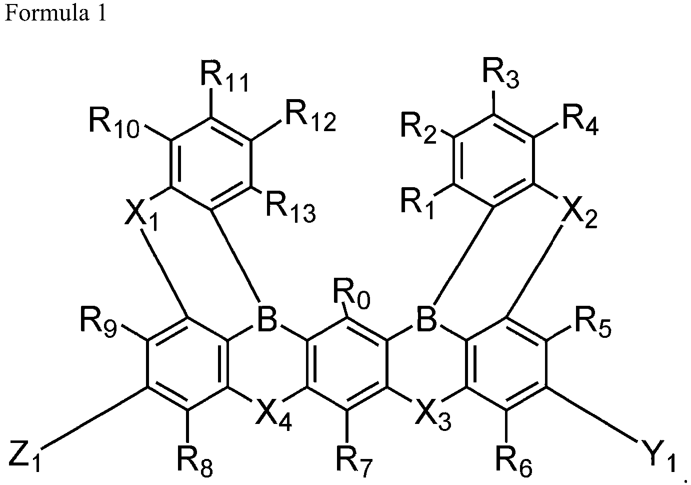

In Formula 1, Y₁ and Z₁ are each independently a hydrogen atom, a deuterium atom, a cyano group, a nitro group, a substituted or unsubstituted amine group, a substituted or unsubstituted alkyl group having 1 to 20 carbon atoms, or a substituted or unsubstituted aryl group having 6 to 30 ring-forming carbon atoms; X₁ to X₄ are each independently O, S, or a group represented by Formula 2; at least two of X₁ to X₄ are a group represented by Formula 2; R₀ to R₁₃ are each independently a hydrogen atom, a deuterium atom, a halogen atom, a cyano group, a nitro group, a substituted or unsubstituted amine group, a substituted or unsubstituted alkyl group having 1 to 20 carbon atoms, a substituted or unsubstituted aryl group having 6 to 30 ring-forming carbon atoms, a substituted or unsubstituted heteroaryl group having 5 to 30 ring-forming carbon atoms, or a group represented by Formula 3; at least one of R₁ to R₄ is a group represented by Formula 3; and at least one of R₁₀ to R₁₃ is a group represented by Formula 3:

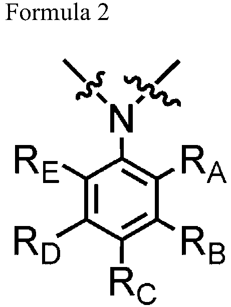

In Formula 2, R_{A} to R_{E} are each independently a hydrogen atom, a deuterium atom, a halogen atom, a cyano group, a nitro group, a substituted or unsubstituted amine group, a substituted or unsubstituted alkyl group having 1 to 20 carbon atoms, a substituted or unsubstituted cycloalkyl group having 3 to 10 ring-forming carbon atoms, a substituted or unsubstituted aryl group having 6 to 30 ring-forming carbon atoms, a substituted or unsubstituted heteroaryl group having 5 to 30 ring-forming carbon atoms, or a group represented by Formula 3:

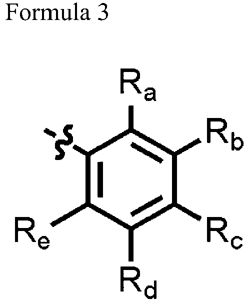

In Formula 3,
Rₐ to Rₑ are each independently a hydrogen atom, a deuterium atom, a halogen atom, a cyano group, a nitro group, a substituted or unsubstituted amine group, a substituted or unsubstituted alkyl group having 1 to 20 carbon atoms, a substituted or unsubstituted aryl group having 6 to 30 ring-forming carbon atoms, or a substituted or unsubstituted heteroaryl group having 5 to 30 ring-forming carbon atoms; wherein the at least two of Formula 2 include 4 or more substituents represented by Formula 3. The first compound includes a structure in which any hydrogen atoms may be substituted with deuterium atoms.

In one or more embodiments, the emission layer may further include at least one of a second compound represented by Formula HT-1, a third compound represented by Formula ET-1, or a fourth compound represented by Formula D-1.

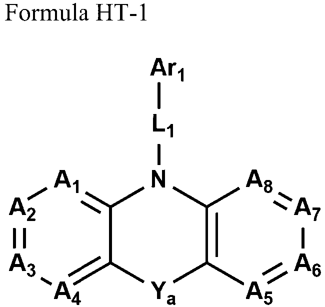

In Formula HT-1, A₁ to A₈ are each independently N or CR₅₁, and L₁ is a direct linkage, a substituted or unsubstituted arylene group having 6 to 30 ring-forming carbon atoms, or a substituted or unsubstituted heteroarylene group having 2 to 30 ring-forming carbon atoms, Yₐ is a direct linkage, CR₅₂R₅₃, or SiR₅₄R₅₅, Ar₁ is a substituted or unsubstituted aryl group having 6 to 30 ring-forming carbon atoms, or a substituted or unsubstituted heteroaryl group having 2 to 30 ring-forming carbon atoms, and R₅₁ to R₅₅ are each independently a hydrogen atom, a deuterium atom, a halogen atom, a cyano group, a substituted or unsubstituted silyl group, a substituted or unsubstituted thio group, a substituted or unsubstituted oxy group, a substituted or unsubstituted amine group, a substituted or unsubstituted boron group, a substituted or unsubstituted alkyl group having 1 to 20 carbon atoms, a substituted or unsubstituted alkenyl group having 2 to 20 ring-forming carbon atoms, a substituted or unsubstituted aryl group having 6 to 60 ring-forming carbon atoms, or a substituted or unsubstituted heteroaryl group having 2 to 60 ring-forming carbon atoms, or R₅₁ to R₅₅ are optionally bonded to an adjacent group to form a ring.

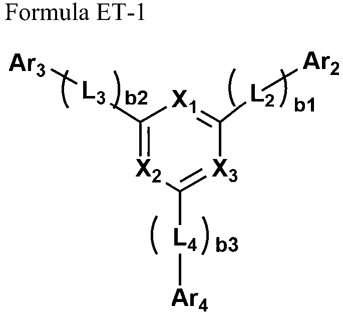

In Formula ET-1, at least one of X₁ to X₃ is N and the others of X₁ to X₃ are CR₅₆, each R₃₆ is independently be a hydrogen atom, a deuterium atom, a substituted or unsubstituted alkyl group having 1 to 20 carbon atoms, a substituted or unsubstituted aryl group having 6 to 60 ring-forming carbon atoms, or a substituted or unsubstituted heteroaryl group having 2 to 60 ring-forming carbon atoms, b1 to b3 are each dependently an integer of 0 to 10, Ar₂ to Ar₄ are each independently a hydrogen atom, a deuterium atom, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms, and L₂ to L₄ are each independently a direct linkage, a substituted or unsubstituted arylene group having 6 to 30 ring-forming carbon atoms, or a substituted or unsubstituted heteroarylene group having 2 to 30 ring-forming carbon atoms.

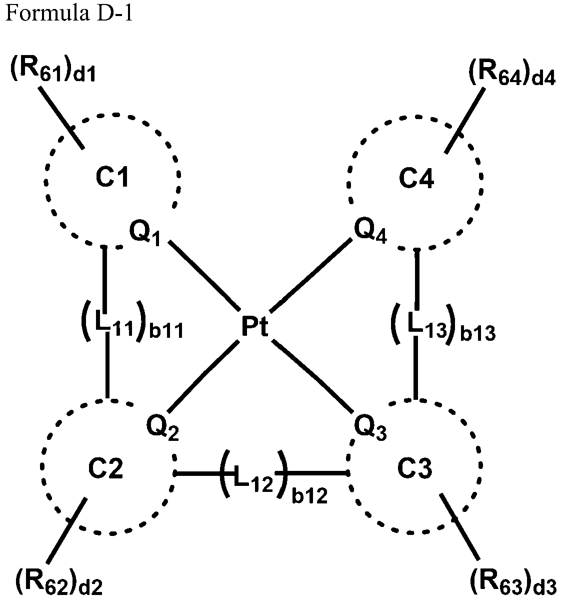

In Formula D-1, Q₁ to Q₄ are each independently C or N, ring C1 to ring C4 are each independently a substituted or unsubstituted aliphatic hydrocarbon ring having 5 to 30 ring-forming carbon atoms, a substituted or unsubstituted aryl group having 6 to 30 ring-forming carbon atoms, or a substituted or unsubstituted heterocycle having 2 to 30 ring-forming carbon atoms, L₁₁ to L₁₃ are each independently a direct linkage, 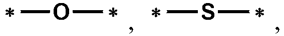 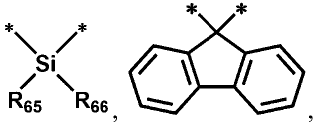 a substituted or unsubstituted alkylene group having 1 to 20 carbon atoms, a substituted or unsubstituted arylene group having 6 to 30 ring-forming carbon atoms, or a substituted or unsubstituted heteroarylene group having 2 to 30 ring-forming carbon atoms, b11 to b13 are each independently 0 or 1, R₆₁ to R₆₆ are each independently a hydrogen atom, a deuterium atom, a halogen atom, a cyano group, a substituted or unsubstituted silyl group, a substituted or unsubstituted thio group, a substituted or unsubstituted oxy group, a substituted or unsubstituted amine group, a substituted or unsubstituted boron group, a substituted or unsubstituted alkyl group having 1 to 20 carbon atoms, a substituted or unsubstituted alkenyl group having 2 to 20 ring-forming carbon atoms, a substituted or unsubstituted aryl group having 6 to 60 ring-forming carbon atoms, or a substituted or unsubstituted heteroaryl group having 2 to 60 ring-forming carbon atoms, and d1 to d4 are each independently an integer of 0 to 4.

In one or more embodiments, Formula 1 above may be represented by one of Formulae 1-A1 to 1-A3.

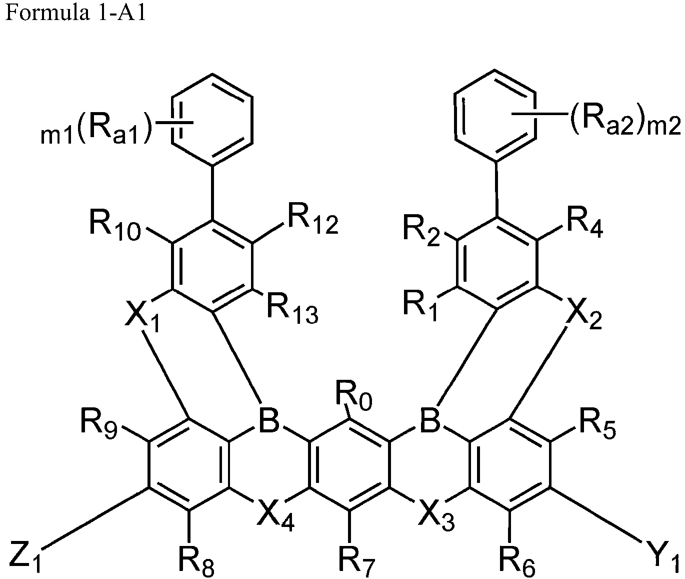

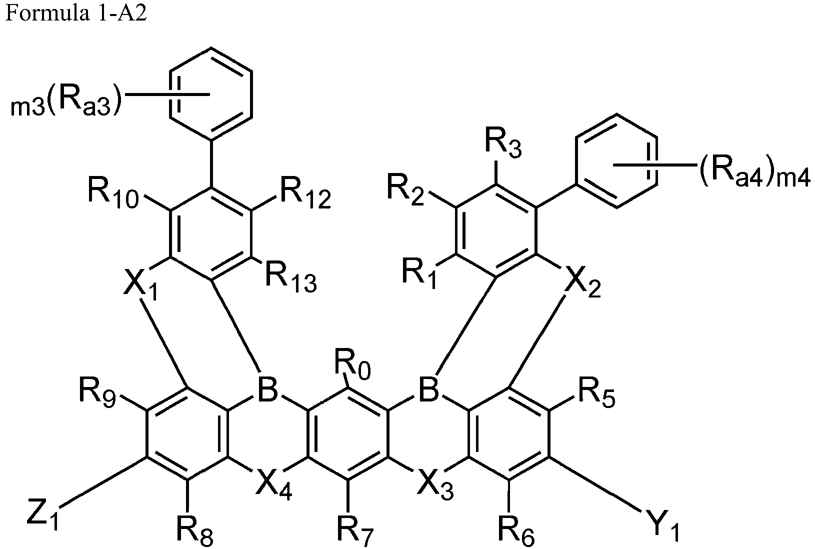

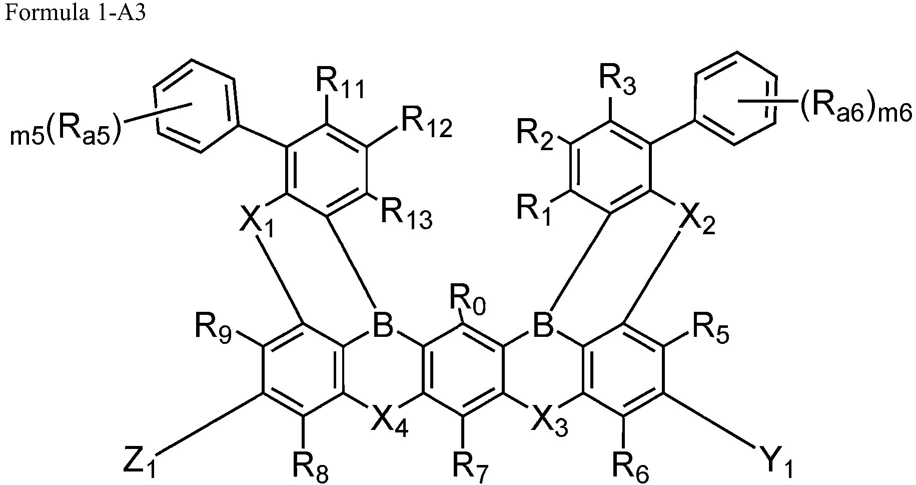

In Formulae 1-A1 to 1-A3, m1 to m6 are each independently an integer of 0 to 5, Rₐ₁ to Rₐ₆ are each independently a hydrogen atom, a deuterium atom, a cyano group, a substituted or unsubstituted alkyl group having 1 to 20 carbon atoms, or a substituted or unsubstituted aryl group having 6 to 30 ring-forming carbon atoms, and X₁ to X₄, R₀ to R₁₃, Y₁, and Z₁ are the same as defined in Formula 1.

In one or more embodiments, Formula 1 may be represented by one of Formulae 1-B1 to 1-B3.

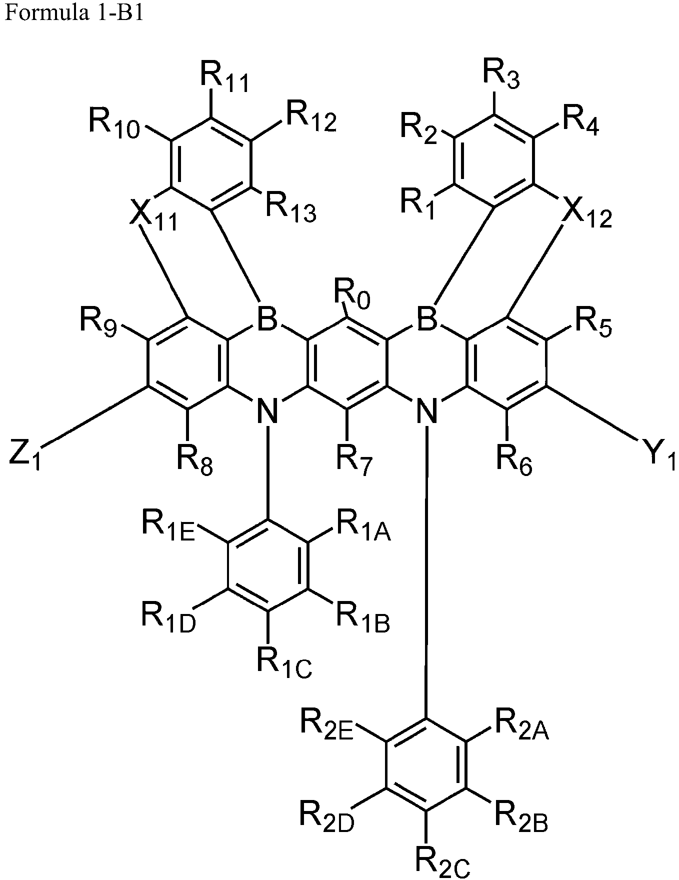

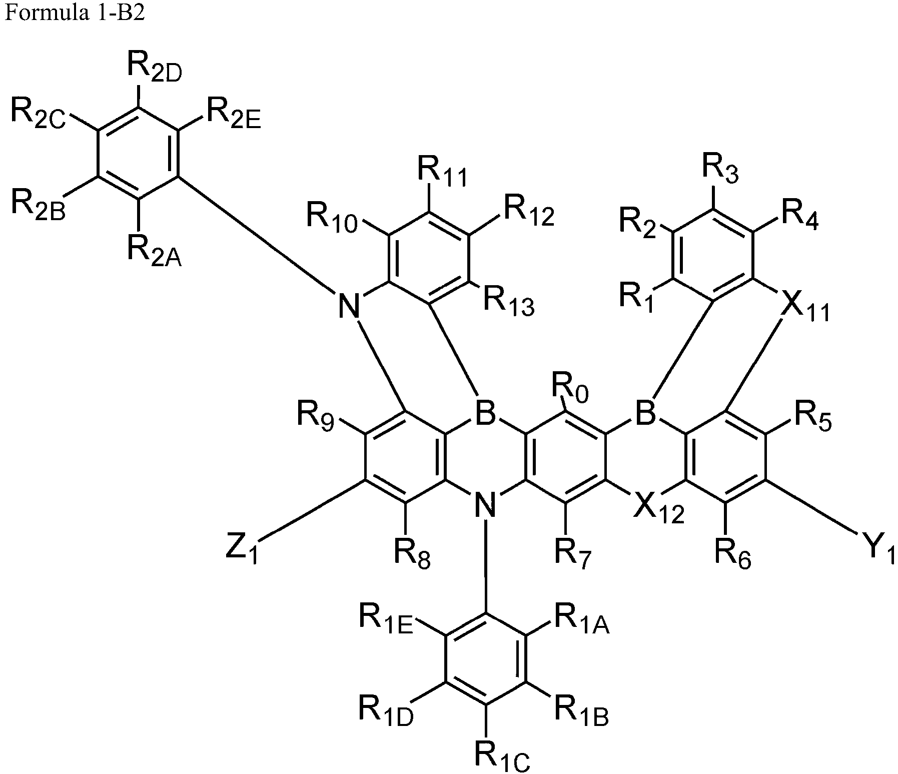

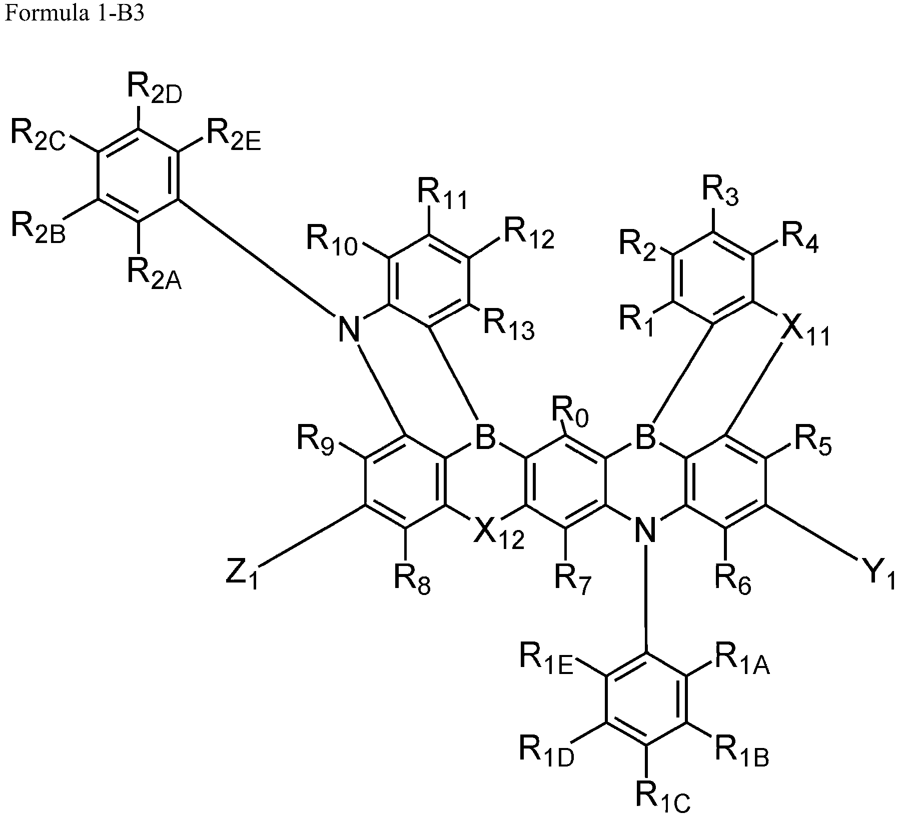

In Formulae 1-B1 to 1-B3, X₁₁ and X₁₂ are each independently O or S, R_{1A} to R_{1E} and R_{2A} to R_{2E} are each independently a hydrogen atom, a deuterium atom, a halogen atom, a cyano group, a nitro group, a substituted or unsubstituted amine group, a substituted or unsubstituted alkyl group having 1 to 20 carbon atoms, a substituted or unsubstituted cycloalkyl group having 3 to 10 ring-forming carbon atoms, a substituted or unsubstituted aryl group having 6 to 30 ring-forming carbon atoms, a substituted or unsubstituted heteroaryl group having 5 to 30 ring-forming carbon atoms, or a group represented by Formula 3, among R_{1A} to R_{1E} and R_{2A} to R_{2E}, the number of substituents represented by Formula 3 is 4 or more, and R₀ to R₁₃, Y₁, and Z₁ are the same as defined in Formula 1.

In one or more embodiments, Formula 2 may be represented by one of Formulae 2-1 to 2-8.

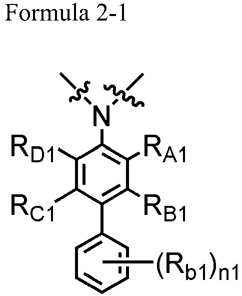

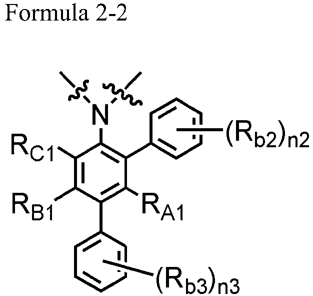

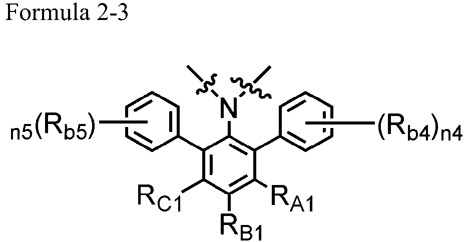

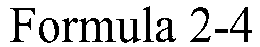

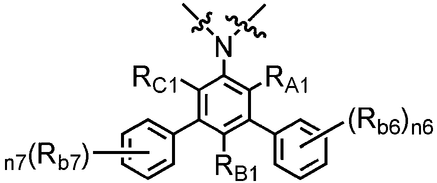

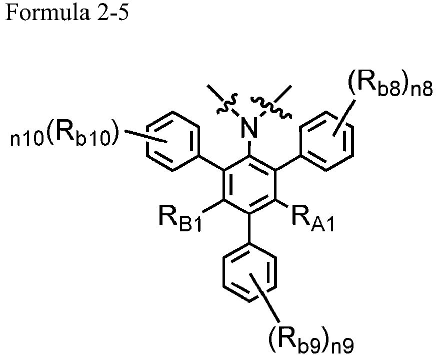

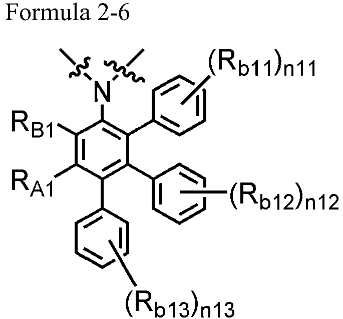

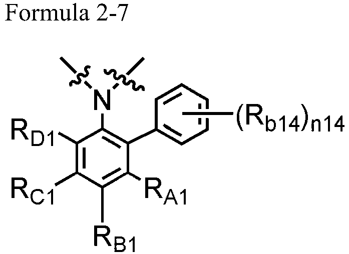

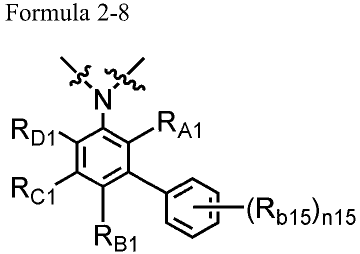

In Formulae 2-1 to 2-8, n1 to n15 are each independently an integer of 0 to 5, R_{b1} to R_{b15} are each independently a hydrogen atom, a deuterium atom, a substituted or unsubstituted alkyl group having 1 to 20 carbon atoms, or a substituted or unsubstituted aryl group having 6 to 30 ring-forming carbon atoms, and R_{A1} to R_{D1} are each independently a hydrogen atom, a deuterium atom, a substituted or unsubstituted alkyl group having 1 to 20 carbon atoms, or a substituted or unsubstituted cycloalkyl group having 3 to 10 ring-forming carbon atoms.

In one or more embodiments, Formula 2-1 may be represented by one of 2-1A to 2-1C, Formula 2-2 may be represented by one of 2-2A and 2-2B, Formula 2-3 may be represented by one of 2-3A to 2-3G, Formula 2-4 may be represented by one of 2-4A and 2-4B, Formula 2-5 may be represented by one of 2-5A to 2-5D, Formula 2-6 may be represented by 2-6A, Formula 2-7 may be represented by 2-7A, and Formula 2-8 may be represented by 2-8A.

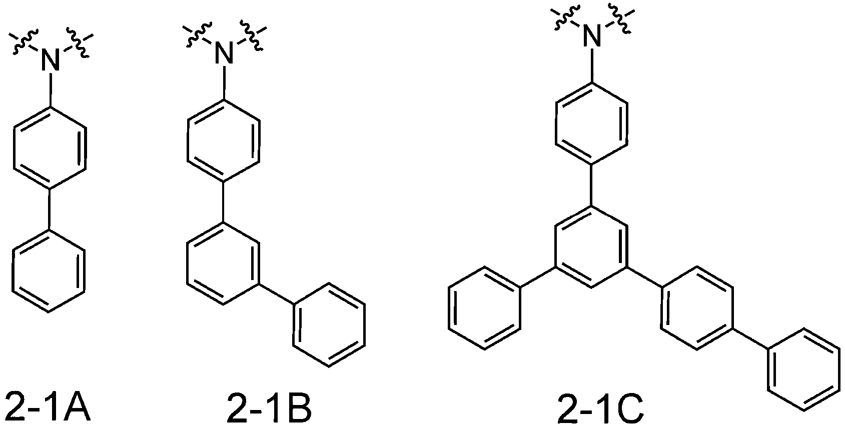

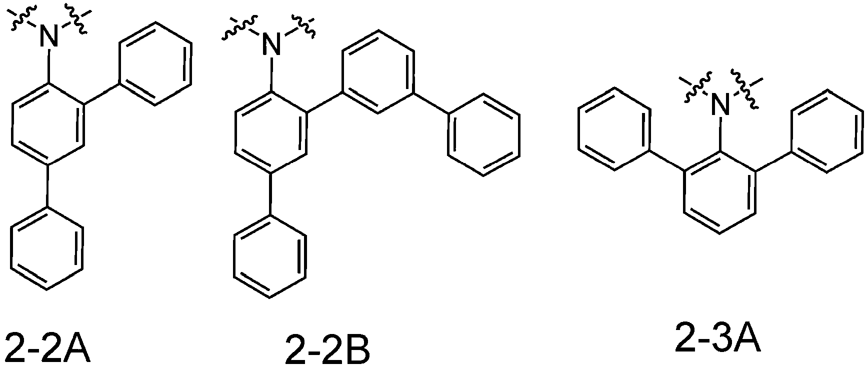

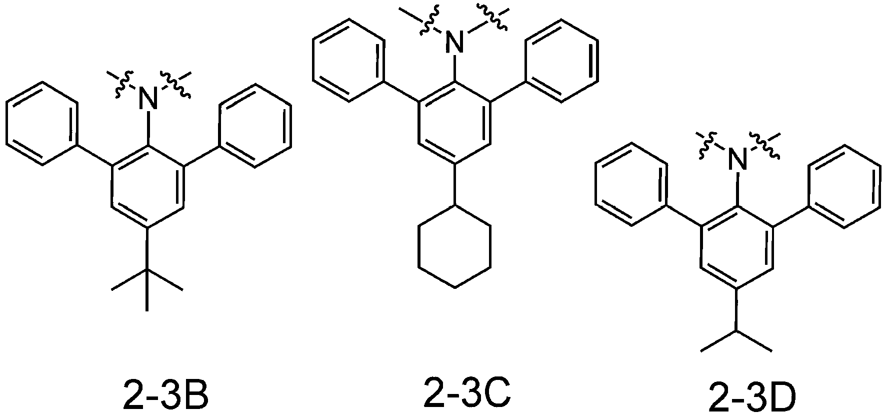

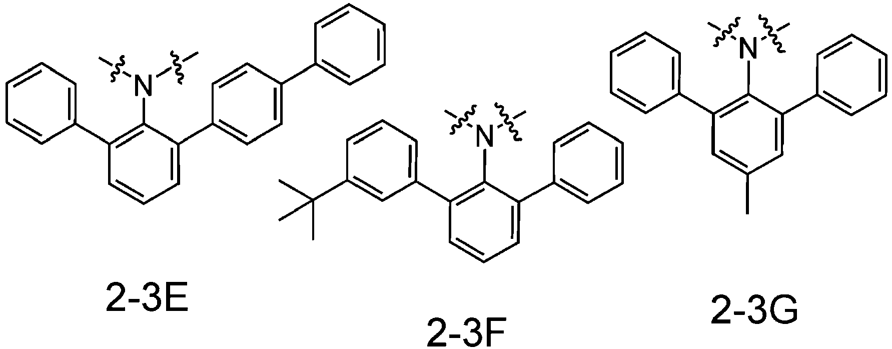

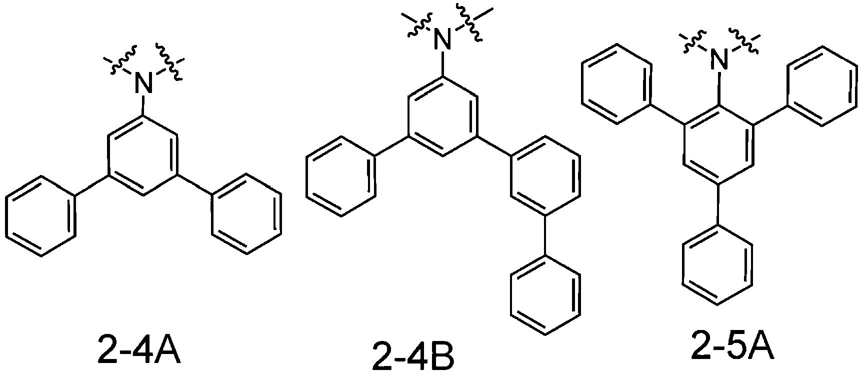

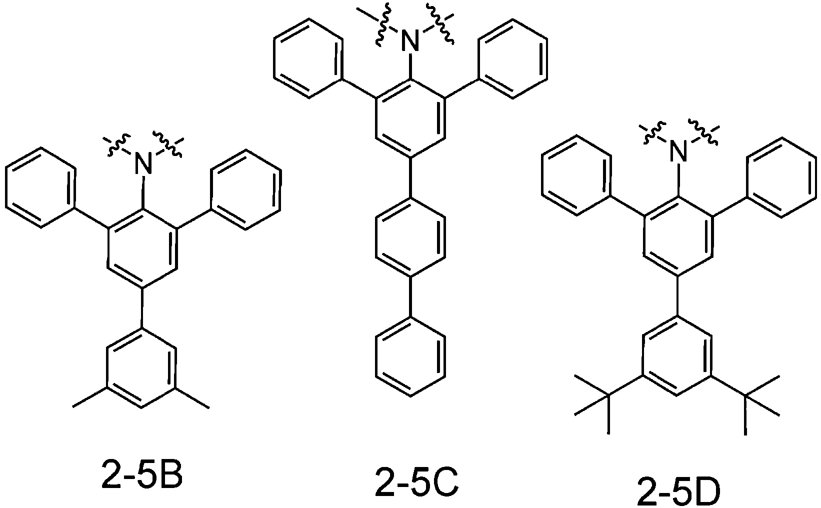

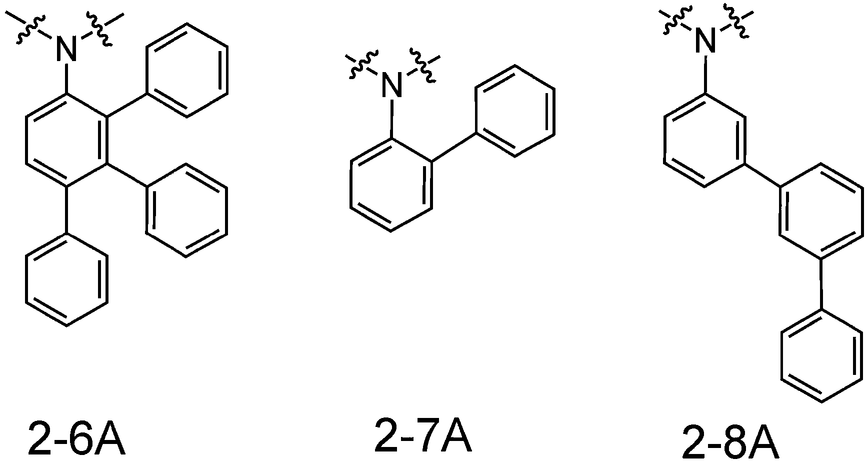

In one or more embodiments, in Formula 1, the others of R₁ to R₄ and R₁₀ to R₁₃, which are not a group represented by Formula 3, may each independently be a hydrogen atom or a deuterium atom.

In one or more embodiments, Formula 3 may be represented by one of R-1 to R-13.

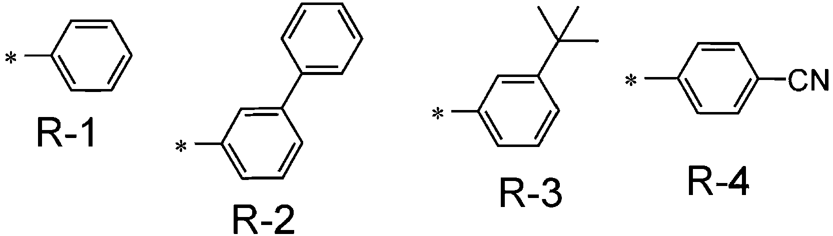

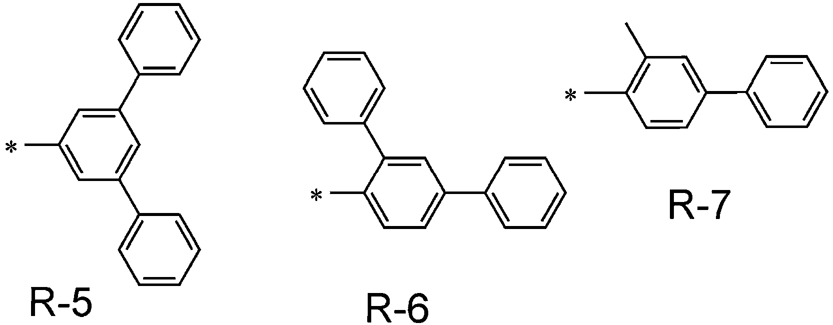

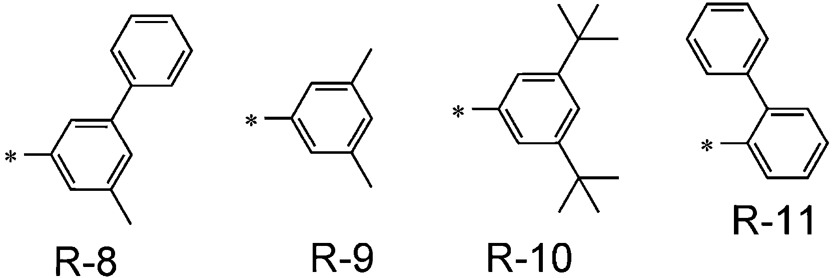

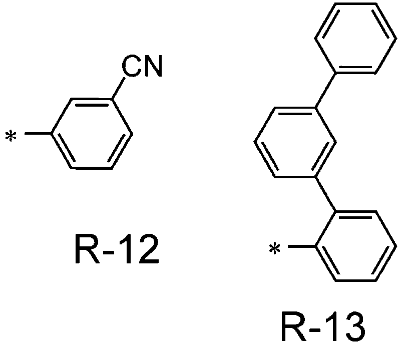

In one or more embodiments, in Formula 1, Y₁ and Z₁ may each independently be represented by one of W-1 to W-7.

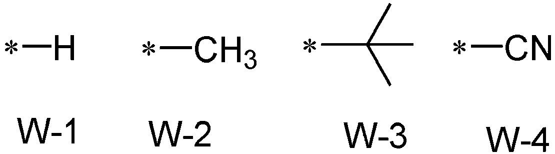

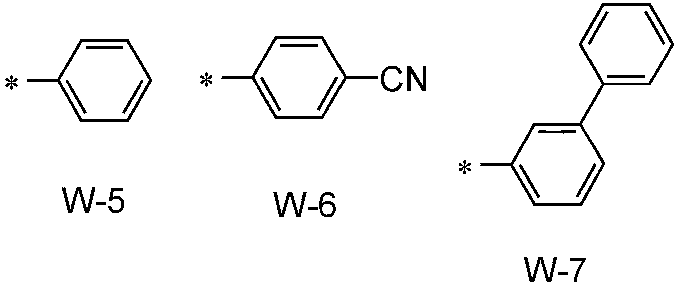

According to another aspect, provided is a fused polycyclic compound represented by Formula 1:

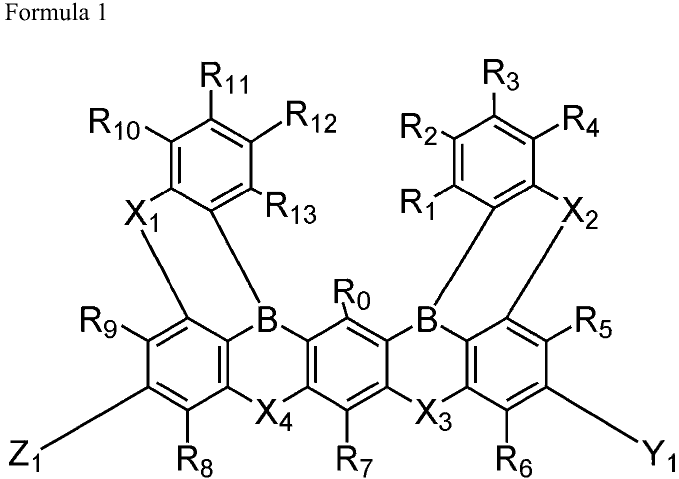

In Formula 1, Y₁ and Z₁ are each independently a hydrogen atom, a deuterium atom, a cyano group, a nitro group, a substituted or unsubstituted amine group, a substituted or unsubstituted alkyl group having 1 to 20 carbon atoms, or a substituted or unsubstituted aryl group having 6 to 30 ring-forming carbon atoms; X₁ to X₄ are each independently O, S, or a group represented by Formula 2; at least two of X₁ to X₄ are a group represented by Formula 2; R₀ to R₁₃ are each independently a hydrogen atom, a deuterium atom, a halogen atom, a cyano group, a nitro group, a substituted or unsubstituted amine group, a substituted or unsubstituted alkyl group having 1 to 20 carbon atoms, a substituted or unsubstituted aryl group having 6 to 30 ring-forming carbon atoms, a substituted or unsubstituted heteroaryl group having 5 to 30 ring-forming carbon atoms, or a group represented by Formula 3; at least one of R₁ to R₄ is a group represented by Formula 3; and at least one of R₁₀ to R₁₃ is a group represented by Formula 3:

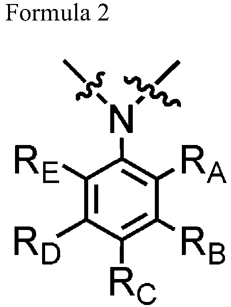

In Formula 2, R_{A} to R_{E} are each independently a hydrogen atom, a deuterium atom, a halogen atom, a cyano group, a nitro group, a substituted or unsubstituted amine group, a substituted or unsubstituted alkyl group having 1 to 20 carbon atoms, a substituted or unsubstituted cycloalkyl group having 3 to 10 ring-forming carbon atoms, a substituted or unsubstituted aryl group having 6 to 30 ring-forming carbon atoms, a substituted or unsubstituted heteroaryl group having 5 to 30 ring-forming carbon atoms, or a group represented by Formula 3:

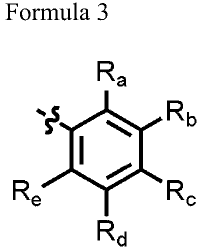

In Formula 3,
Rₐ to Rₑ are each independently a hydrogen atom, a deuterium atom, a halogen atom, a cyano group, a nitro group, a substituted or unsubstituted amine group, a substituted or unsubstituted alkyl group having 1 to 20 carbon atoms, a substituted or unsubstituted aryl group having 6 to 30 ring-forming carbon atoms, or a substituted or unsubstituted heteroaryl group having 5 to 30 ring-forming carbon atoms; wherein the at least two of Formula 2 include 4 or more substituents represented by Formula 3. In some embodiments, the fused polycyclic compound includes a structure in which any hydrogen atoms may be substituted with deuterium atoms.

In one or more embodiments, an electronic device includes a display module configured to provide images, wherein the display module includes a base layer, a circuit layer disposed on the base layer, and a display element layer disposed on the circuit layer and including a light emitting element, wherein the light emitting element includes a first electrode, a second electrode disposed on the first electrode, and an emission layer disposed between the first electrode and the second electrode, and the emission layer includes a fused polycyclic compound represented by Formula 1.

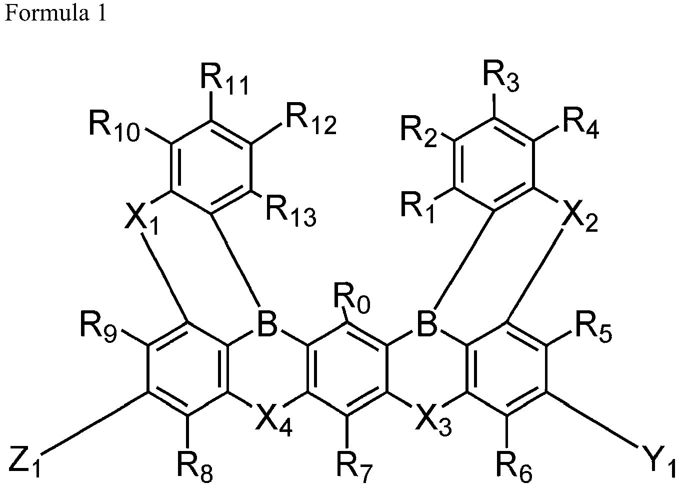

In Formula 1, Y₁ and Z₁ are each independently a hydrogen atom, a deuterium atom, a cyano group, a nitro group, a substituted or unsubstituted amine group, a substituted or unsubstituted alkyl group having 1 to 20 carbon atoms, or a substituted or unsubstituted aryl group having 6 to 30 ring-forming carbon atoms; X₁ to X₄ are each independently O, S, or a group represented by Formula 2; at least two of X₁ to X₄ are a group represented by Formula 2; R₀ to R₁₃ are each independently a hydrogen atom, a deuterium atom, a halogen atom, a cyano group, a nitro group, a substituted or unsubstituted amine group, a substituted or unsubstituted alkyl group having 1 to 20 carbon atoms, a substituted or unsubstituted aryl group having 6 to 30 ring-forming carbon atoms, a substituted or unsubstituted heteroaryl group having 5 to 30 ring-forming carbon atoms, or a group represented by Formula 3; at least one of R₁ to R₄ is a group represented by Formula 3; and at least one of R₁₀ to R₁₃ is a group represented by Formula 3:

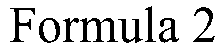

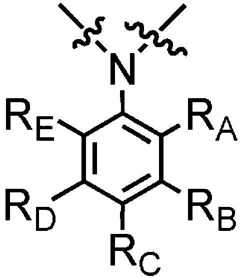

In Formula 2, R_{A} to R_{E} are each independently a hydrogen atom, a deuterium atom, a halogen atom, a cyano group, a nitro group, a substituted or unsubstituted amine group, a substituted or unsubstituted alkyl group having 1 to 20 carbon atoms, a substituted or unsubstituted cycloalkyl group having 3 to 10 ring-forming carbon atoms, a substituted or unsubstituted aryl group having 6 to 30 ring-forming carbon atoms, a substituted or unsubstituted heteroaryl group having 5 to 30 ring-forming carbon atoms, or a group represented by Formula 3:

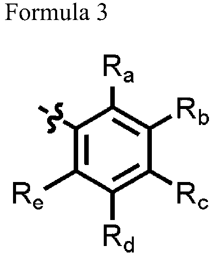

In Formula 3,
Rₐ to Rₑ are each independently a hydrogen atom, a deuterium atom, a halogen atom, a cyano group, a nitro group, a substituted or unsubstituted amine group, a substituted or unsubstituted alkyl group having 1 to 20 carbon atoms, a substituted or unsubstituted aryl group having 6 to 30 ring-forming carbon atoms, or a substituted or unsubstituted heteroaryl group having 5 to 30 ring-forming carbon atoms, wherein the at least two of Formula 2 include 4 or more substituents represented by Formula 3. In some embodiments, the fused polycyclic compound represented by Formula 1 includes a structure in which any hydrogen atoms may be substituted with deuterium atoms.

In one or more embodiments, the electronic device may further include at least one of a light control layer or a color filter layer, wherein the light control layer may include quantum dots, and the color filter layer may include pigments or dyes.

In one or more embodiments, the electronic device may further include at least one of a processor, a memory, or a power module.

At least some of the above and other features of the invention are set out in the claims.

### BRIEF DESCRIPTION OF THE FIGURES

The accompanying drawings are included to provide a further understanding of the disclosure, and are incorporated in and constitute a part of this specification. The drawings illustrate embodiments of the disclosure and, together with the detailed description, serve to explain principles of the disclosure. In the drawings:
FIG. 1 is a plan view showing a display module according to one or more embodiments;
FIG. 2 is a cross-sectional view showing a portion corresponding to line I-I' of FIG. 1;
FIG. 3 is a cross-sectional view schematically showing a light emitting element according to one or more embodiments;
FIG. 4 is a cross-sectional view schematically showing a light emitting element according to one or more embodiments;
FIG. 5 is a cross-sectional view schematically showing a light emitting element according to one or more embodiments;
FIG. 6 is a cross-sectional view schematically showing a light emitting element according to one or more embodiments;
FIG. 7 is a cross-sectional view showing a display module according to one or more embodiments;
FIG. 8 is a cross-sectional view showing a display module according to one or more embodiments;
FIG. 9 is a cross-sectional view showing a display module according to one or more embodiments;
FIG. 10 is a cross-sectional view showing a display module according to one or more embodiments;
FIG. 11 is a view showing the inside of a vehicle in which an electronic device according to one or more embodiments is disposed;
FIG. 12 is a perspective view showing an electronic device according to one or more embodiments;
FIG. 13 is an exploded perspective view showing an electronic device according to one or more embodiments;
FIG. 14 is a block diagram of an electronic device according to one or more embodiments; and
FIG. 15 shows schematic views of electronic devices according to various embodiments.

### DETAILED DESCRIPTION

The present disclosure may be modified in many alternate forms, and thus specific embodiments will be exemplified in the drawings and described in further detail. It should be understood, however, that it is not intended to limit the present disclosure to the particular forms disclosed, but rather, is intended to cover all modifications, equivalents, and alternatives falling within the scope of the present disclosure.

In this specification, it will be understood that when an element (or a region, a layer, a portion, or the like) is referred to as being "on", "connected to" or "coupled to" another element, it may be directly disposed on, connected to, or coupled to the other element, or other elements may be disposed therebetween.

Like reference numerals or symbols refer to like elements throughout. In the drawings, the thickness, ratio, and size of the elements are exaggerated for effectively describing the technical contents. The term "and/or" includes any and all combinations of one or more of the associated listed elements.

It will be understood that, although the terms "first", "second", etc. may be used herein to describe various elements, the elements are not to be limited by these terms. These terms are only used to distinguish one element from another element. For instance, a first element could be termed a second element without departing from the scope of the inventive concept. Similarly, a second element could be termed a first element. The singular expressions "a", "an" and "the" are intended to include the plural forms as well, unless the context clearly indicates otherwise.

In addition, the terms "below", "under", "on the lower side", "above", "over", "on the upper side", or the like may be used to describe the relationships between the elements illustrated in the drawings. These terms are relative concepts and are described on the basis of the directions indicated in the drawings.

It will be further understood that the terms "comprises, includes, has" and/or "comprising, including, having", when used in this specification, specify the presence of stated features, numbers, steps, operations, elements, components or combinations thereof, but do not preclude the possibility of the presence or addition of one or more other features, numbers, steps, operations, elements, components, and/or combinations thereof.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

"About" or "approximately" as used herein is inclusive of the stated value and means within an acceptable range of deviation for the particular value as determined by one of ordinary skill in the art, considering the measurement in question and the error associated with measurement of the particular quantity *(i.e.,* the limitations of the measurement system). For example, "about" can mean within one or more standard deviations, or within ± 30%, 20%, 10%, 5% of the stated value.

As used herein, the term "substituted or unsubstituted" may indicate that a group is substituted or unsubstituted with at least one substituent selected from the group consisting of a deuterium atom, a halogen atom, a cyano group, a nitro group, an amine group, a silyl group, oxy group, thio group, sulfinyl group, sulfonyl group, carbonyl group, a boron group, a phosphine oxide group, a phosphine sulfide group, an alkyl group, an alkenyl group, an alkynyl group, a hydrocarbon ring group, an aryl group, and a heterocyclic group. In addition, each of the substituents presented as an example above may be substituted or unsubstituted. For example, a biphenyl group may be interpreted as an aryl group or as a phenyl group substituted with a phenyl group.

As used herein, the term "bonded to an adjacent group to form a ring" may indicate that a group is bonded to an adjacent group to form a substituted or unsubstituted hydrocarbon ring, or a substituted or unsubstituted heterocycle. The hydrocarbon ring includes an aliphatic hydrocarbon ring and an aromatic hydrocarbon ring. The heterocycle includes an aliphatic heterocycle and an aromatic heterocycle. The hydrocarbon ring and the heterocycle may be monocyclic or polycyclic. In addition, the rings formed by being bonded to each other may be linked to another ring to form a spiro structure.

As used herein, the term "adjacent group" may indicate a substituent substituted for an atom which is directly linked to an atom substituted with a corresponding substituent, another substituent substituted for an atom which is substituted with a corresponding substituent, or a substituent sterically closest to a corresponding substituent. For example, two methyl groups in 1,2-dimethylbenzene may be interpreted as mutually "adjacent groups" and two ethyl groups in 1,1-diethylcyclopentane may be interpreted as mutually "adjacent groups". In addition, two methyl groups in 4,5-dimethylphenanthrene may be interpreted as mutually "adjacent groups".

As used herein, examples of a halogen atom may include a fluorine atom, a chlorine atom, a bromine atom, or an iodine atom.

As used herein, an "alkyl group" may be linear or branched. The number of carbon atoms in the alkyl group is 1 to 60, 1 to 50, 1 to 30, 1 to 20, 1 to 10, or 1 to 6. Non-limiting examples of the alkyl group may include a methyl group, an ethyl group, an n-propyl group, an isopropyl group, an n-butyl group, a s-butyl group, a t-butyl group, an i-butyl group, a 2-ethylbutyl group, a 3,3-dimethylbutyl group, an n-pentyl group, an i-pentyl group, a neopentyl group, a t-pentyl group, a 1-methylpentyl group, a 3-methylpentyl group, a 2-ethylpentyl group, a 4-methyl-2-pentyl group, an n-hexyl group, a 1-methylhexyl group, a 2-ethylhexyl group, a 2-butylhexyl group, an n-heptyl group, a 1-methylheptyl group, a 2,2-dimethylheptyl group, a 2-ethylheptyl group, a 2-butylheptyl group, an n-octyl group, a t-octyl group, a 2-ethyloctyl group, a 2-butyloctyl group, a 2-hexyloctyl group, a 3,7-dimethyloctyl group, an n-nonyl group, an n-decyl group, a 2-ethyldecyl group, a 2-butyldecyl group, a 2-hexyldecyl group, a 2-octyldecyl group, an n-undecyl group, an n-dodecyl group, a 2-ethyldodecyl group, a 2-butyldodecyl group, a 2-hexyldocecyl group, a 2-octyldodecyl group, an n-tridecyl group, an n-tetradecyl group, an n-pentadecyl group, an n-hexadecyl group, a 2-ethylhexadecyl group, a 2-butylhexadecyl group, a 2-hexylhexadecyl group, a 2-octylhexadecyl group, an n-heptadecyl group, an n-octadecyl group, an n-nonadecyl group, an n-icosyl group, a 2-ethylicosyl group, a 2-butylicosyl group, a 2-hexylicosyl group, a 2-octylicosyl group, an n-henicosyl group, an n-docosyl group, an n-tricosyl group, an n-tetracosyl group, an n-pentacosyl group, an n-hexacosyl group, an n-heptacosyl group, an n-octacosyl group, an n-nonacosyl group, an n-triacontyl group, or the like, but embodiments are not limited thereto.

As used herein, a "cycloalkyl group" indicates a cyclic alkyl group. The number of carbon atoms in the cycloalkyl group is 3 to 60, 3 to 50, 3 to 30, 3 to 20, or 3 to 10. Non-limiting examples of the cycloalkyl group include a cyclopropyl group, a cyclobutyl group, a cyclopentyl group, a cyclohexyl group, a 4-methylcyclohexyl group, a 4-t-butylcyclohexyl group, a cycloheptyl group, a cyclooctyl group, a cyclononyl group, a cyclodecyl group, a norbornyl group, a 1-adamantyl group, a 2-adamantyl group, an isobornyl group, a bicycloheptyl group, or the like, but embodiments are not limited thereto.

As used herein, an "alkenyl group" indicates a hydrocarbon group including at least one carbon-carbon double bond in the middle or end of an alkyl group having 2 or more carbon atoms. The alkenyl group may be linear or branched. The number of carbon atoms is not particularly limited, but is 2 to 60, 2 to 30, 2 to 20, or 2 to 10. Non-limiting examples of the alkenyl group include a vinyl group, a 1-butenyl group, a 1-pentenyl group, a 1,3-butadienyl aryl group, a styrenyl group, a styryl vinyl group, or the like, but embodiments are not limited thereto.

As used herein, an "alkynyl group" indicates a hydrocarbon group including at least one carbon-carbon triple bond in the middle or end of an alkyl group having 2 or more carbon atoms. The alkynyl group may be linear or branched. The number of carbon atoms is not particularly limited, but is 2 to 30, 2 to 20, or 2 to 10. Non-limiting examples of the alkynyl group may include an ethynyl group, a propynyl group, or the like, but embodiments are not limited thereto.

As used herein, a "hydrocarbon ring group" indicates any functional group or substituent derived from an aliphatic hydrocarbon ring or an aromatic hydrocarbon ring. The number of ring-forming carbon atoms in the hydrocarbon ring group may be 5 to 60, 5 to 30, 5 to 20, or 5 to 10.

As used herein, an "aryl group" indicates any functional group or substituent derived from an aromatic hydrocarbon ring. The aryl group may be a monocyclic aryl group or a polycyclic aryl group. The number of ring-forming carbon atoms in the aryl group may be 6 to 60, 6 to 30, 6 to 20, or 6 to 15. Non-limiting examples of the aryl group may include a phenyl group, a naphthyl group, a fluorenyl group, an anthracenyl group, a phenanthryl group, a biphenyl group, a terphenyl group, a quaterphenyl group, a quinquephenyl group, a sexiphenyl group, a triphenylenyl group, a pyrenyl group, a benzofluoranthenyl group, a chrysenyl group, or the like, but embodiments are not limited thereto.

As used herein, a "fluorenyl group" may be substituted, and two substituents may be bonded to each other to form a spiro structure. An example that the fluorenyl group is substituted is as follows. However, embodiments are not limited thereto.

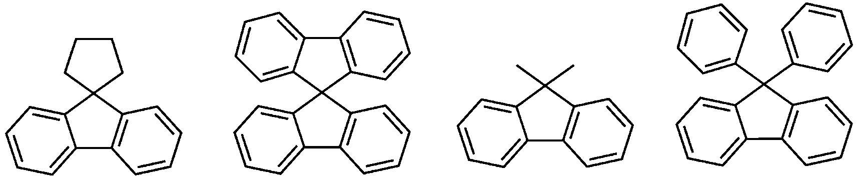

As used herein, a "heterocyclic group" refers to any functional groups or substituents derived from a ring containing at least one of B, O, N, P, Si, or S as a heteroatom. The heterocyclic group includes an aliphatic heterocyclic group and an aromatic heterocyclic group. The aromatic heterocyclic group may be a heteroaryl group. The aliphatic heterocycle and the aromatic heterocycle may be monocyclic or polycyclic.

As used herein, the heterocyclic group may contain at least one of B, O, N, P, Si or S as a heteroatom. When the heterocyclic group contains two or more heteroatoms, the two or more hetero atoms may be the same as or different from each other. The heterocyclic group may be a monocyclic heterocyclic group or a polycyclic heterocyclic group, and include a heteroaryl group. The number of ring-forming carbon atoms in the heterocyclic group may be 2 to 60, 2 to 30, 2 to 20, or 2 to 10.

As used herein, the aliphatic heterocyclic group may contain at least one of B, O, N, P, Si or S as a heteroatom. The number of ring-forming carbon atoms in the aliphatic heterocyclic group may be 2 to 60, 2 to 30, 2 to 20, or 2 to 10. Non-limiting examples of the aliphatic heterocyclic group include an oxirane group, a thiirane group, a pyrrolidine group, a piperidine group, a tetrahydrofuran group, a tetrahydrothiophene group, a thiane group, a tetrahydropyran group, a 1,4-dioxane group, or the like, but embodiments are not limited to thereto.

As used herein, a "heteroaryl group" includes at least one of B, O, N, P, Si, or S as a heteroatom. When the heteroaryl group contains two or more heteroatoms, the two or more heteroatoms may be the same as or different from each other. The heteroaryl group may be a monocyclic heteroaryl group or a polycyclic heteroaryl group. The number of ring-forming carbon atoms in the heteroaryl group may be 2 to 60, 2 to 30, 2 to 20, or 2 to 10. Non-limiting examples of the heteroaryl group include a thiophene group, a furan group, a pyrrole group, an imidazole group, a pyridine group, a bipyridine group, a pyrimidine group, a triazine group, a triazole group, an acridyl group, a pyridazine group, a pyrazinyl group, a quinoline group, a quinazoline group, a quinoxaline group, a phenoxazine group, a phthalazine group, a pyrido pyrimidine group, a pyrido pyrazine group, a pyrazino pyrazine group, an isoquinoline group, an indole group, a carbazole group, an N-arylcarbazole group, an N-heteroarylcarbazole group, an N-alkylcarbazole group, a benzoxazole group, a benzoimidazole group, a benzothiazole group, a benzocarbazole group, a benzothiophene group, a dibenzothiophene group, a thienothiophene group, a benzofuran group, a phenanthroline group, a thiazole group, an isoxazole group, an oxazole group, an oxadiazole group, a thiadiazole group, a phenothiazine group, a dibenzosilole group, a dibenzofuran group, or the like, but embodiments are not limited thereto.

As used herein, the above description of the aryl group may also apply to an arylene group, except that the arylene group is a divalent group. The above description of the heteroaryl group may also apply to a heteroarylene group, except that the heteroarylene group is a divalent group.

As used herein, a "silyl group" includes an alkyl silyl group and an aryl silyl group. Non-limiting examples of the silyl group include a trimethylsilyl group, a triethylsilyl group, a t-butyldimethylsilyl group, a vinyldimethylsilyl group, a propyldimethylsilyl group, a triphenylsilyl group, a diphenylsilyl group, a phenylsilyl group, or the like, but embodiments are not limited thereto.

As used herein, the number of carbon atoms in a "carbonyl group" is not particularly limited, but may be 1 to 40, 1 to 30, or 1 to 20. For example, the carbonyl group may have the following structure, but embodiments are not limited thereto:

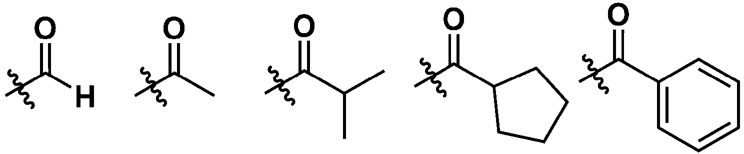

As used herein, the number of carbon atoms in a "sulfinyl group" and a "sulfonyl group" are not particularly limited, but may be 1 to 30. The sulfinyl group may include an alkyl sulfinyl group and an aryl sulfinyl group. The sulfonyl group may include an alkyl sulfonyl group and an aryl sulfonyl group.

As used herein, a "thio group" may include an alkyl thio group and an aryl thio group. The thio group may indicate that a sulfur atom is bonded to the alkyl group or the aryl group as defined above. Non-limiting examples of the thio group include a methylthio group, an ethylthio group, a propylthio group, a pentylthio group, a hexylthio group, an octylthio group, a dodecylthio group, a cyclopentylthio group, a cyclohexylthio group, a phenylthio group, a naphthylthio group, or the like, but embodiments are not limited to thereto.

As used herein, an "oxy group" may indicate that an oxygen atom is bonded to the alkyl group or the aryl group as defined above. The oxy group may include an alkoxy group and an aryloxy group. The alkoxy group may be linear, branched, or cyclic. The number of carbon atoms in the alkoxy group is not particularly limited, but may be, for example, 1 to 20, or 1 to 10. Non-limiting examples of the oxy group include methoxy, ethoxy, n-propoxy, isopropoxy, butoxy, pentyloxy, hexyloxy, octyloxy, nonyloxy, decyloxy, benzyloxy, or the like, but embodiments are not limited thereto.

As used herein, a "boron group" may indicate that a boron atom is bonded to the alkyl group or the aryl group as defined above. The boron group includes an alkyl boron group and an aryl boron group. Non-limiting examples of the boron group include a dimethylboron group, a diethylboron group, a t-butylmethylboron group, a diphenylboron group, a phenylboron group, or the like, but embodiments are not limited thereto.

As used herein, the number of carbon atoms in an "amine group" is not particularly limited, but may be 1 to 50, 1 to 30, or 1 to 20. The amine group may include an alkyl amine group and an aryl amine group. Non-limiting examples of the amine group include a methylamine group, a dimethylamine group, a phenylamine group, a diphenylamine group, a naphthylamine group, a 9-methyl-anthracenylamine group, or the like, but embodiments are not limited thereto.

As used herein, the above-described examples of the alkyl group also apply to an alkyl group from an alkylthio group, an alkyl sulfoxy group, an alkylaryl group, an alkylamino group, an alkyl boron group, an alkyl silyl group, and an alkyl amine group.

As used herein, the above-described examples of the aryl group also apply to an aryl group from an aryloxy group, an arylthio group, an aryl sulfoxy group, an arylamino group, an aryl boron group, an aryl silyl group, and an aryl amine group.

As used herein, the phosphine oxide group may be substituted with, for example, at least one of the alkyl groups or aryl groups described above.

As used herein, the phosphine sulfide group may be substituted with, for example, at least one of the alkyl groups or aryl groups described above.

As used herein, a direct linkage may indicate a single bond. Herein, 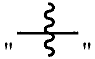 and 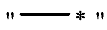 indicate positions to be linked.

Hereinafter, embodiments of the disclosure will be described in further detail and with reference to the accompanying drawings.

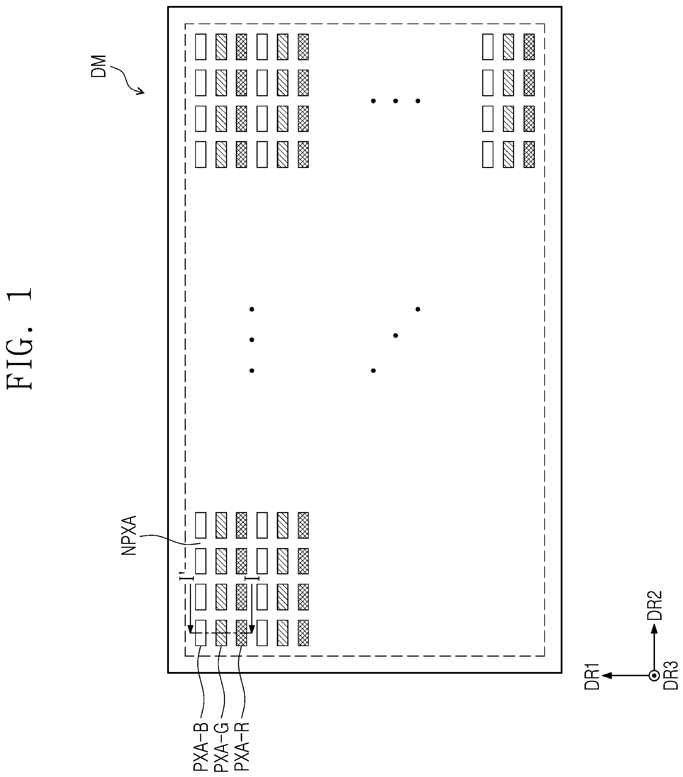

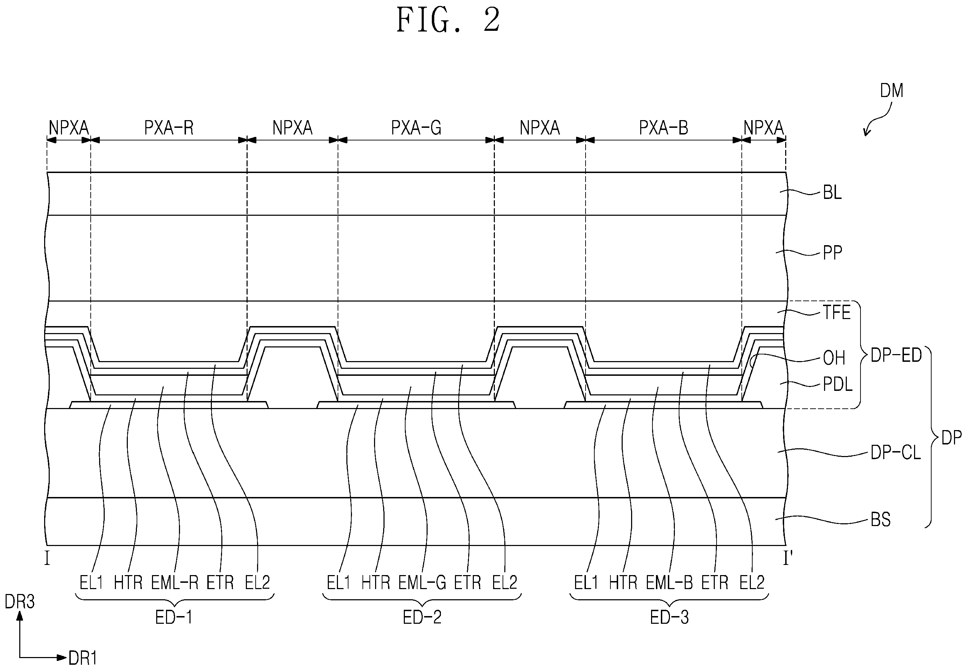

FIG. 1 is a plan view showing one or more embodiments of a display module DM. FIG. 2 is a cross-sectional view showing a display module DM according to one or more embodiments. FIG. 2 is a cross-sectional view showing a portion corresponding to line I-I' of FIG. 1.

The display module DM may include a display panel DP and an optical layer PP disposed on the display panel DP. The display panel DP includes light emitting elements ED-1, ED-2, and ED-3. The display module DM may include a plurality of light emitting elements ED-1, ED-2, and ED-3. The optical layer PP may be disposed on the display panel DP to control reflected light in the display panel DP due to external light. The optical layer PP may include, for example, a polarizing layer or a color filter layer. Unlike what is shown in the drawings, the optical layer PP may not be provided in the display module DM according to one or more embodiments.

A base substrate BL may be disposed on the optical layer PP. The base substrate BL may be a member providing a base surface on which the optical layer PP is disposed. The base substrate BL may be a glass substrate, a metal substrate, a plastic substrate, or the like. However, embodiments are not limited thereto, and the base substrate BL may be an inorganic layer, an organic layer, or a composite material layer. In addition, unlike what is shown, the base substrate BL may not be provided in one or more embodiments.

The display module DM according to one or more embodiments may further include a filling layer (not shown). The filling layer (not shown) may be disposed between a display element layer DP-ED and the base substrate BL. The filling layer (not shown) may be an organic material layer. The filling layer (not shown) may include at least one of an acrylic resin, a silicone-based resin, or an epoxy-based resin.

The display panel DP may include a base layer BS, a circuit layer DP-CL provided on the base layer BS, and a display element layer DP-ED. The display element layer DP-ED may include pixel defining films PDL, a plurality of light emitting elements ED-1, ED-2, and ED-3 disposed between the pixel defining films PDL, and an encapsulation layer TFE disposed on the plurality of light emitting elements ED-1, ED-2, and ED-3.

The base layer BS may be a member providing a base surface on which the display element layer DP-ED is disposed. The base layer BS may be a glass substrate, a metal substrate, a plastic substrate, and the like. However, embodiments are not limited thereto, and the base layer BS may be an inorganic layer, an organic layer, or a composite material layer.

In one or more embodiments, the circuit layer DP-CL may be disposed on the base layer BS, and the circuit layer DP-CL may include a plurality of transistors (not shown). The transistors (not shown) may each include a control electrode, an input electrode, and an output electrode. For example, the circuit layer DP-CL may include a switching transistor and a driving transistor for driving the light emitting elements ED-1, ED-2, and ED-3 of the display element layer DP-ED.

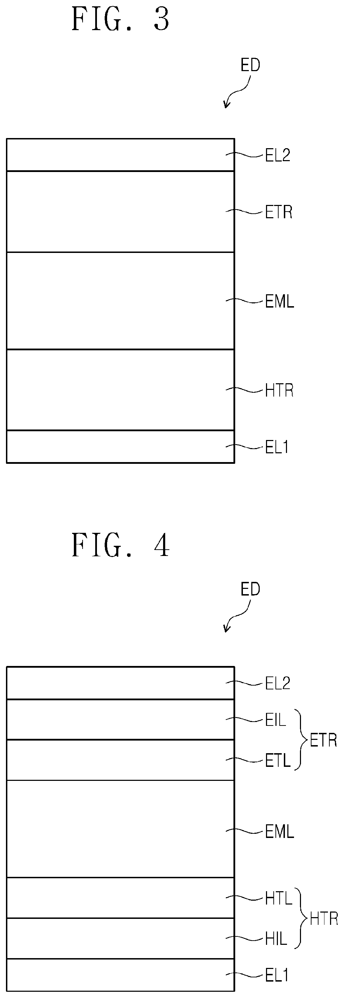

The light emitting elements ED-1, ED-2, and ED-3 may each have a structure of a light emitting element ED according to one or more embodiments from FIGS. 3 to 6, which will be described herein. The light emitting elements ED-1, ED-2, and ED-3 may each include a first electrode EL1, a hole transport region HTR, emission layers EML-R, EML-G, and EML-B, an electron transport region ETR, and a second electrode EL2.

FIG. 2 shows one or more embodiments in which the emission layers EML-R, EML-G, and EML-B of the light emitting elements ED-1, ED-2, and ED-3 are disposed in openings OH defined in the pixel defining films PDL, and the hole transport region HTR, the electron transport region ETR, and the second electrode EL2 are provided as a common layer throughout the light emitting elements ED-1, ED-2, and ED-3. However, embodiments are not limited thereto, and unlike what is shown in FIG. 2, in one or more embodiments, the hole transport region HTR and the electron transport region ETR may be provided to be patterned inside the openings OH defined in the pixel defining films PDL. For example, in one or more embodiments, the hole transport region HTR, the emission layers EML-R, EML-G, and EML-B, and the electron transport region ETR of the light emitting elements ED-1, ED-2, and ED-3 may be patterned and provided through an inkjet printing method.

The encapsulation layer TFE may cover the light emitting elements ED-1, ED-2, and ED-3. The encapsulation layer TFE may seal the display element layer DP-ED. The encapsulation layer TFE may be a thin film encapsulation layer. The encapsulation layer TFE may be a single layer or a stack layer of a plurality of layers. The encapsulation layer TFE includes at least one insulating layer. The encapsulation layer TFE according to one or more embodiments may include at least one inorganic film (hereinafter, an encapsulation inorganic film). In addition, the encapsulation layer TFE according to one or more embodiments may include at least one organic film (hereinafter, an encapsulation organic film) and at least one encapsulation inorganic film.

The encapsulation inorganic film protects the display element layer DP-ED from moisture and/or oxygen, and the encapsulation organic film protects the display element layer DP-ED from foreign substances such as dust particles. The encapsulation inorganic film may include silicon nitride, silicon oxynitride, silicon oxide, titanium oxide, aluminium oxide, or the like, but embodiments are not limited thereto. The encapsulation organic film may include an acrylic compound, an epoxy-containing compound, or the like. The encapsulation organic film may include a photopolymerizable organic material, and is not particularly limited.

The encapsulation layer TFE may be disposed on the second electrode EL2, and may be disposed to fill the openings OH.

Referring to FIGS. 1 and 2, the display module DM may include a non-light emitting region NPXA and light emitting regions PXA-R, PXA-G, and PXA-B. The light emitting regions PXA-R, PXA-G, and PXA-B may each be a region emitting light generated from each of the light emitting elements ED-1, ED-2, and ED-3. The light emitting regions PXA-R, PXA-G, and PXA-B may be spaced apart from each other when viewed on a plane.

The light emitting regions PXA-R, PXA-G, and PXA-B may each be a region separated by the pixel defining films PDL. The non-light emitting region NPXA may be a region between neighboring light emitting regions PXA-R, PXA-G, and PXA-B, and may correspond to the pixel defining films PDL. In some embodiments, herein, the light emitting regions PXA-R, PXA-G, and PXA-B may each correspond to a pixel. The pixel defining films PDL may separate the light emitting elements ED-1, ED-2 and ED-3. The emission layers EML-R, EML-G, and EML-B of the light emitting elements ED-1, ED-2, and ED-3 may be disposed in the openings OH defined by the pixel defining films PDL, and thus be separated.

The light emitting regions PXA-R, PXA-G, and PXA-B may be divided into a plurality of groups according to the color of light generated from the light emitting elements ED-1, ED-2, and ED-3. In the display module DM according to one or more embodiments shown in FIGS. 1 and 2, three light emitting regions PXA-R, PXA-G, and PXA-B which emit a red light, a green light, and a blue light, are shown as an example. For example, the display module DM according to one or more embodiments may include a red light emitting region PXA-R, a green light emitting region PXA-G, and a blue light emitting region PXA-B, which are distinct from one another.

In the display module DM according to one or more embodiments, the plurality of light emitting elements ED-1, ED-2, and ED-3 may emit light having different wavelength ranges. For example, in one or more embodiments, the display module DM may include a first light emitting element ED-1 emitting a red light, a second light emitting element ED-2 emitting a green light, and a third light emitting element ED-3 emitting a blue light. That is, the red light emitting region PXA-R, the green light emitting region PXA-G, and the blue light emitting region PXA-B of the display module DM may correspond to the first light emitting element ED-1, the second light emitting element ED-2, and the third light emitting element ED-3, respectively.

However, embodiments are not limited thereto, and the first to third light emitting elements ED-1, ED-2, and ED-3 may emit light in the same wavelength range or emit light in at least one different wavelength range. For example, the first to third light emitting elements ED-1, ED-2, and ED-3 may all emit a blue light.

The light emitting regions PXA-R, PXA-G, and PXA-B in the display module DM according to one or more embodiments may be arranged in the form of a stripe. Referring to FIG. 1, a plurality of red light emitting regions PXA-R, a plurality of green light emitting regions PXA-G, and a plurality of blue light emitting regions PXA-B may each be arranged along a second directional axis DR2. Alternatively, the red light emitting region PXA-R, the green light emitting region PXA-G, and the blue light emitting region PXA-B may be alternately arranged in that order along a first directional axis DR1.

FIGS. 1 and 2 show that the light emitting regions PXA-R, PXA-G, and PXA-B are all similar in size, but embodiments are not limited thereto, and the light emitting regions PXA-R, PXA-G, and PXA-B may be different in size from each other according to wavelength range of emitted light. The areas of the light emitting regions PXA-R, PXA-G, and PXA-B may indicate areas when viewed on a plane defined by the first directional axis DR1 and the second directional axis DR2.

The arrangement of the light emitting regions PXA-R, PXA-G, and PXA-B is not limited to what is shown in FIG. 1, and the order in which the red light emitting region PXA-R, the green light emitting region PXA-G, and the blue light emitting region PXA-B are arranged comes with varied combination according to display quality characteristics required for the display module DM. For example, the light emitting regions PXA-R, PXA-G, and PXA-B may be arranged in the form of a pentile (PENTILE^{™}) or a diamond (Diamond Pixel^{™}).

In addition, areas of each of the light emitting regions PXA-R, PXA-G, and PXA-B may be different in size from one another. For example, in one or more embodiments, the green light emitting region PXA-G may be smaller than the blue light emitting region PXA-B in size, but embodiments are not limited thereto.

Hereinafter, FIGS. 3 to 6 are cross-sectional views schematically showing a light emitting element according to one or more embodiments. The light emitting element ED according to one or more embodiments may include a first electrode EL1, a hole transport region HTR, an emission layer EML, an electron transport region ETR, and a second electrode EL2, which are sequentially stacked.

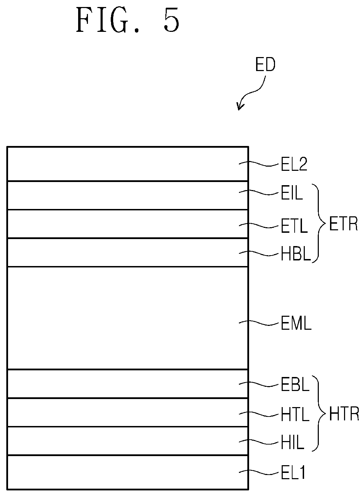

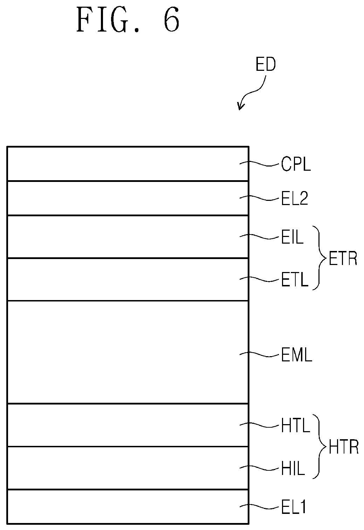

FIG. 4 shows, compared with FIG. 3, a cross-sectional view of a light emitting element ED of one or more embodiments in which the hole transport region HTR includes a hole injection layer HIL and a hole transport layer HTL, and the electron transport region ETR includes an electron injection layer EIL and an electron transport layer ETL. In addition, FIG. 5 shows, compared with FIG. 3, a cross-sectional view of a light emitting element ED of one or more embodiments, in which the hole transport region HTR includes a hole injection layer HIL, a hole transport layer HTL, and an electron blocking layer EBL, and the electron transport region ETR includes an electron injection layer EIL, an electron transport layer ETL, and a hole blocking layer HBL. FIG. 6 shows, compared with FIG. 4, a cross-sectional view of a light emitting element ED of one or more embodiments, in which a capping layer CPL disposed on the second electrode EL2 is provided.

The first electrode EL1 has conductivity. The first electrode EL1 may be formed of a metal material, a metal alloy, or a conductive compound. The first electrode EL1 may be an anode or a cathode. However, embodiments are not limited thereto. In addition, the first electrode EL1 may be a pixel electrode. The first electrode EL1 may be a transmissive electrode, a transflective electrode, or a reflective electrode. The first electrode EL1 may include at least one of Ag, Mg, Cu, Al, Pt, Pd, Au, Ni, Nd, Ir, Cr, Li, Ca, LiF, Mo, Ti, W, In, Sn, or Zn, at least two compounds selected therefrom, two or more mixtures selected therefrom, or an oxide thereof.

When the first electrode EL1 is a transmissive electrode, the first electrode EL1 may include a transparent metal oxide such as indium tin oxide (ITO), indium zinc oxide (IZO), zinc oxide (ZnO), or indium tin zinc oxide (ITZO). When the first electrode EL1 is a transflective electrode or a reflective electrode, the first electrode EL1 may include Ag, Mg, Cu, Al, Pt, Pd, Au, Ni, Nd, Ir, Cr, Li, Ca, LiF/Ca (a stack structure of LiF and Ca), LiF/Al (a stack structure of LiF and Al), Mo, Ti, W, or a compound thereof or a mixture thereof (e.g., a mixture of Ag and Mg). Alternatively, the first electrode EL1 may have a multilayer structure including a reflective film or a transflective film formed of the above-described materials, and a transparent conductive film formed of indium tin oxide (ITO), indium zinc oxide (IZO), zinc oxide (ZnO), indium tin zinc oxide (ITZO), or the like. For example, the first electrode EL1 may have a three-layer structure of ITO/Ag/ITO, but embodiments are not limited thereto. In addition, embodiments are not limited thereto, and the first electrode EL1 may include the above-described metal materials, a combination of two or more metal materials selected from the above-described metal materials, or oxides of the above-described metal materials. The first electrode EL1 may have a thickness of about 700 angstroms (Å) to about 10000 Å. For example, the first electrode EL1 may have a thickness of about 1000 Å to about 3000 Å.

The hole transport region HTR is provided on the first electrode EL1. The hole transport region HTR may include at least one among a hole injection layer HIL, a hole transport layer HTL, a buffer layer, a light emitting auxiliary layer (not shown), or an electron blocking layer EBL. The hole transport region HTR may have, for example, a thickness of about 50 Å to about 15000 Å.

The hole transport region HTR may have a single layer formed of a single material, a single layer formed of a plurality of different materials, or a multilayer structure having a plurality of layers formed of a plurality of different materials.

For example, the hole transport region HTR may have a single-layer structure formed of the hole injection layer HIL or the hole transport layer HTL, or a single-layer structure formed of a hole injection material or a hole transport material. For example, the hole transport region HTR may have a single-layer structure formed of a plurality of different materials, or a structure in which a hole injection layer HIL/hole transport layer HTL, a hole injection layer HIL/hole transport layer HTL/buffer layer (not shown), a hole injection layer HIL/buffer layer (not shown), a hole transport layer HTL/buffer layer (not shown), or a hole injection layer HIL/hole transport layer HTL/electron blocking layer EBL are stacked in order from the first electrode EL1, but embodiments are not limited thereto.

The hole transport region HTR may be formed using various methods such as a vacuum deposition method, a spin coating method, a cast method, a Langmuir-Blodgett (LB) method, an inkjet printing method, a laser printing method, a laser induced thermal imaging (LITI) method, or the like, but embodiments are not limited thereto.

The hole transport region HTR may include a compound represented by Formula H-1:

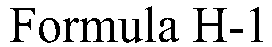

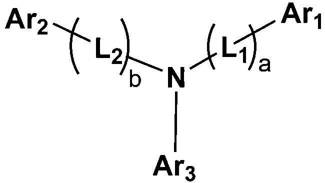

In Formula H-1, L₁ and L₂ may each independently be a direct linkage, a substituted or unsubstituted arylene group having 6 to 30 ring-forming carbon atoms, or a substituted or unsubstituted heteroarylene group having 2 to 30 ring-forming carbon atoms. a and b may each independently be an integer of 0 to 10. When a or b is an integer of 2 or greater, a plurality of L₁'s and L₂'s may each independently be a substituted or unsubstituted arylene group having 6 to 30 ring-forming carbon atoms, or a substituted or unsubstituted heteroarylene group having 2 to 30 ring-forming carbon atoms.

In Formula H-1, Ar₁ and Ar₂ may each independently be a substituted or unsubstituted aryl group having 6 to 30 ring-forming carbon atoms, or a substituted or unsubstituted heteroaryl group having 2 to 30 ring-forming carbon atoms. In addition, in Formula H-1, Ar₃ may be a substituted or unsubstituted aryl group having 6 to 30 ring-forming carbon atoms.

The compound represented by Formula H-1 may be a monoamine compound. Alternatively, the compound represented by Formula H-1 may be a diamine compound in which at least one of Ar₁ to Ar₃ includes an amine group as a substituent. In addition, the compound represented by Formula H-1 may be a carbazole-containing compound including a substituted or unsubstituted carbazole group in at least one of Ar₁ or Ar₂ or a substituted or unsubstituted fluorene-containing group including a substituted or unsubstituted fluorene group in at least one of Ar₁ or Ar₂.

The compound represented by Formula H-1 may be represented by one of compounds from Compound Group H. However, the compounds listed in Compound Group H below are presented as an example, and the compound represented by Formula H-1 is not limited to the those listed in Compound Group H.

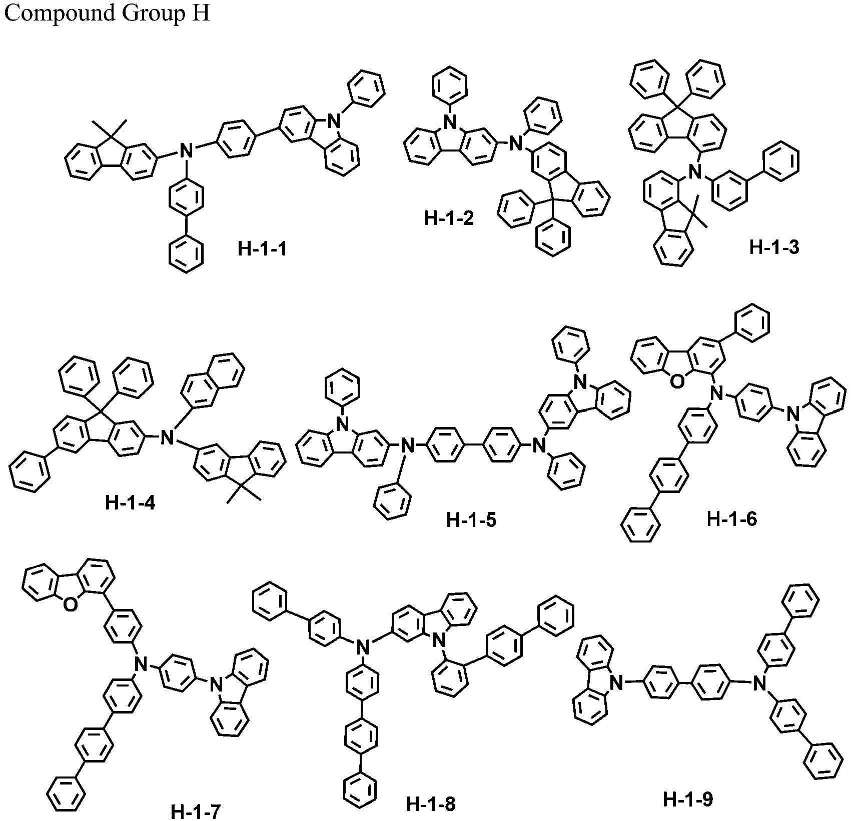

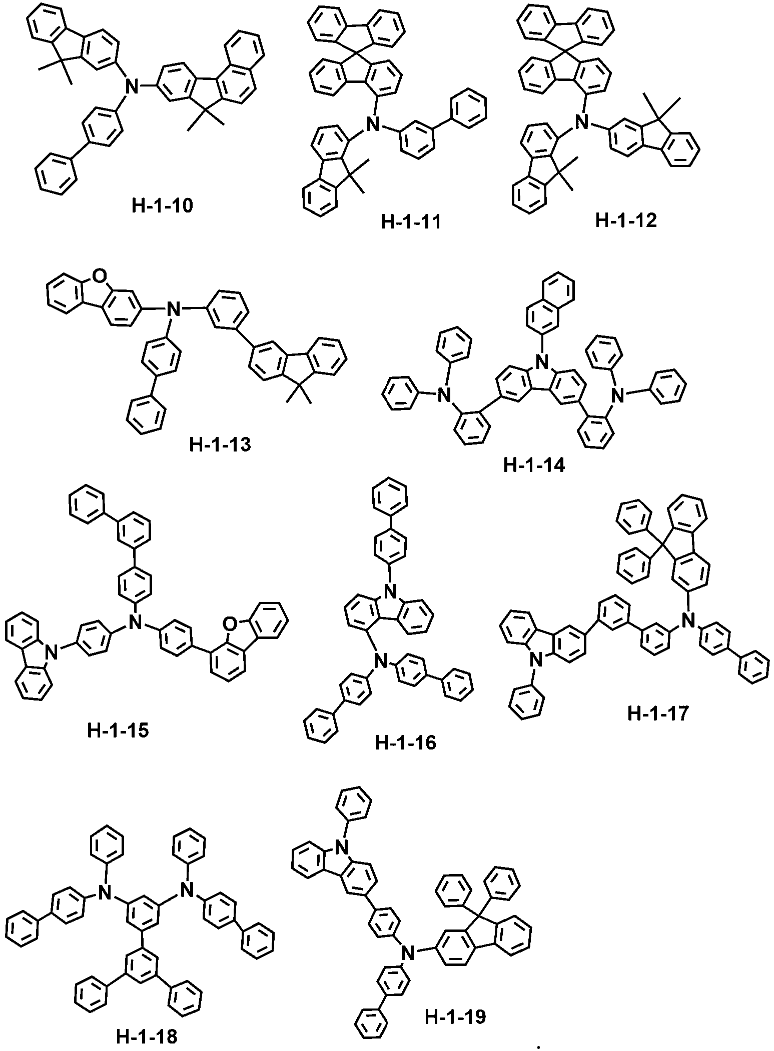

The hole transport region HTR may include at least one of a phthalocyanine compound such as copper phthalocyanine, N¹,N^{1'}-([1,1'-biphenyl]-4,4'-diyl)bis(N¹-phenyl-N⁴,N⁴-di-m-tolylbenzene-1,4-diamine) (DNTPD), 4,4',4"-[tris(3-methylphenyl)phenylamino] triphenylamine (m-MTDATA), 4,4'4"-tris(N,N-diphenylamino)triphenylamine (TDATA), 4,4',4"-tris[N(2-naphthyl)-N-phenylamino]-triphenylamine (2-TNATA), poly(3,4-ethylenedioxythiophene)/poly(4-styrenesulfonate) (PEDOT/PSS), polyaniline/dodecylbenzenesulfonic acid (PANI/DBSA), polyaniline/camphor sulfonicacid (PANI/CSA), polyaniline/poly(4-styrenesulfonate) (PANI/PSS), N,N'-di(naphthalen-1-yl)-N,N'-diphenyl-benzidine (NPB), triphenylamine-containing polyetherketone (TPAPEK), 4-isopropyl-4'-methyldiphenyliodonium tetrakis(pentafluorophenyl)borate, dipyrazino[2,3-f: 2',3'-h]quinoxaline-2,3,6,7,10,11-hexacarbonitrile (HATCN), or the like, but embodiments are not limited thereto.

The hole transport region HTR may include at least one of carbazole-containing derivatives such as N-phenyl carbazole or polyvinyl carbazole, fluorene-containing derivatives, N,N'-bis(3-methylphenyl)-N,N'-diphenyl-[1,1-biphenyl]-4,4'-diamine (TPD), triphenylamine-based derivatives such as 4,4',4"-tris(N-carbazolyl)triphenylamine (TCTA), N,N'-di(naphthalen-1-yl)-N,N'-diphenyl-benzidine (NPB), 4,4'-cyclohexylidene bis[N,N-bis(4-methylphenyl]benzenamine] (TAPC), 4,4'-bis[N,N'-(3-tolyl)amino]-3,3'-dimethylbiphenyl (HMTPD), and 1,3-bis(N-carbazolyl)benzene (mCP), or the like, but embodiments are not limited thereto.

In addition, the hole transport region HTR may include at least one of 9-(4-tert-butylphenyl)-3,6-bis(triphenylsilyl)-9H-carbazole (CzSi), 9-phenyl-9H-3,9'-bicarbazole (CCP), 1,3-bis(1,8-dimethyl-9H-carbazol- 9-yl)benzene (mDCP), or the like, but embodiments are not limited thereto.

The hole transport region HTR may include the compounds of the hole transport region described above in at least one among the hole injection layer HIL, the hole transport layer HTL, or the electron blocking layer EBL.

The hole transport region HTR may have a thickness of about 100 Å to about 10000 Å, for example, about 100 Å to about 5000 Å. When the hole transport region HTR includes the hole injection layer HIL, the hole injection layer HIL may have a thickness of, for example, about 30 Å to about 1000 Å. When the hole transport region HTR includes the hole transport layer HTL, the hole transport layer HTL may have a thickness of about 30 Å to about 1000 Å. When the hole transport region HTR includes the electron blocking layer EBL, the electron blocking layer EBL may have a thickness of, for example, about 10 Å to about 1000 Å. When the thicknesses of the hole transport region HTR, the hole injection layer HIL, the hole transport layer HTL, and the electron blocking layer EBL satisfy the above-described ranges, satisfactory hole transport properties may be obtained without a substantial increase in driving voltage.

The hole transport region HTR may further include, in addition to the above-described materials, a charge generation material to increase conductivity. The charge generation material may be uniformly or non-uniformly dispersed in the hole transport region HTR. The charge generation material may be, for example, a p-dopant. The p-dopant may include at least one of halogenated metal compounds, quinone derivatives, metal oxides, or cyano group-containing compounds, but embodiments are not limited thereto. For example, the p-dopant may include halogenated metal compounds such as CuI or RbI, quinone derivatives such as tetracyanoquinodimethane (TCNQ) or 2,3,5,6-tetrafluoro-7,7',8,8'-tetracyanoquinodimethane (F4-TCNQ), metal oxides such as tungsten oxides or molybdenum oxides, cyano group-containing compounds such as dipyrazino[2,3-f: 2',3'-h] quinoxaline-2,3,6,7,10,11-hexacarbonitrile (HATCN) or 4-[[2,3-bis[cyano-(4-cyano-2,3,5,6-tetrafluorophenyl)methylidene]cyclopropylidene]-cyanomethyl]-2,3,5,6-tetrafluorobenzonitrile (NDP9), or the like, but embodiments are not limited thereto.

As described herein, the hole transport region HTR may further include at least one of a buffer layer (not shown) or an electron blocking layer EBL in addition to the hole injection layer HIL and the hole transport layer HTL. The buffer layer (not shown) may compensate a resonance distance according to wavelengths of light emitted from an emission layer EML, and may thus increase light emitting efficiency. Materials which may be included in the hole transport region HTR may be used as materials included in the buffer layer (not shown). The electron blocking layer EBL is a layer that serves to prevent electrons from being injected from the electron transport region ETR to the hole transport region HTR.

In one or more embodiments, the emission layer EML includes a first compound according to one or more embodiments. The emission layer EML according to one or more embodiments may further include at least one of second to fourth compounds. The second compound may include a fused ring of three rings, which contains a nitrogen atom as a ring-forming atom. The third compound may include a 6-membered ring group containing at least one nitrogen atom as a ring-forming atom. The fourth compound may include an organometallic complex. The second to fourth compounds are as described herein.

Herein, the first compound may be referred to as a fused polycyclic compound represented by Formula 1 according to one or more embodiments. The fused polycyclic compound represented by Formula 1 according to one or more embodiments may include, as a core structure, a fused ring of nine rings, which contains two boron atoms, at least two nitrogen atoms, and at least one oxygen or sulfur atom as ring-forming atoms. In addition, in the fused polycyclic compound represented by Formula 1 according to one or more embodiments, benzene rings bonded to at least two nitrogen atoms of the core structure may include at least four phenyl groups as substituents. In addition, benzene rings bonded to two boron atoms may each independently include a phenyl group at a para position or a position immediately adjacent to the para position. Accordingly, the fused polycyclic compound represented by Formula 1 according to one or more embodiments may exhibit excellent material stability and contribute to improving efficiency and lifespan of a light emitting element ED.

The light emitting element ED according to one or more embodiments may include the fused polycyclic compound according to one or more embodiments. The fused polycyclic compound is represented by Formula 1.

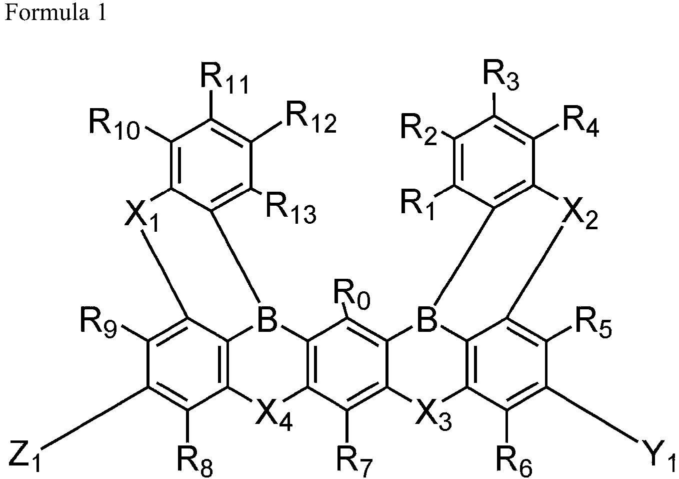

In Formula 1, Y₁ and Z₁ are each independently a hydrogen atom, a deuterium atom, a cyano group, a nitro group, a substituted or unsubstituted amine group, a substituted or unsubstituted alkyl group having 1 to 20 carbon atoms, or a substituted or unsubstituted aryl group having 6 to 30 ring-forming carbon atoms. For example, Y₁ and Z₁ may each independently be a hydrogen atom, a deuterium atom, a cyano group, a substituted or unsubstituted methyl group, a substituted or unsubstituted t-butyl group, a substituted or unsubstituted phenyl group, or a substituted or unsubstituted biphenyl group. In one or more embodiments, Y₁ and Z₁ may each independently be represented by any one of W-1 to W-7:

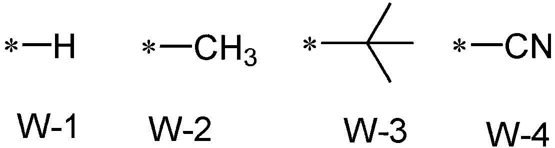

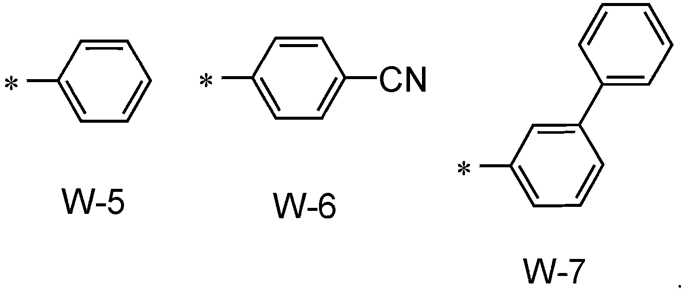

In Formula 1, X₁ to X₄ are each independently be O, S, or a group represented by Formula 2. At least two of X₁ to X₄ are represented by Formula 2. In one or more embodiments, at least one of X₁ to X₄ may be O or S. In one or more embodiments, at least two of X₁ to X₄ may each independently be O or S.

In Formula 1, R₀ to R₁₃ are each independently a hydrogen atom, a deuterium atom, a halogen atom, a cyano group, a nitro group, a substituted or unsubstituted amine group, a substituted or unsubstituted alkyl group having 1 to 20 carbon atoms, a substituted or unsubstituted aryl group having 6 to 30 ring-forming carbon atoms, a substituted or unsubstituted heteroaryl group having 5 to 30 ring-forming carbon atoms, or a group represented by Formula 3. In Formula 1, at least one of R₁ to R₄ is a group represented by Formula 3, and at least one of R₁₀ to R₁₃ is a group represented by Formula 3. In one or more embodiments, in Formula 1, at least one of R₂ to R₄ may be a group represented by Formula 3, and at least one of R₁₀ to R₁₂ may be a group represented by Formula 3. In some embodiments, the others of R₁ to R₄ and R₁₀ to R₁₃, which are not represented by Formula 3, may each independently be a hydrogen atom or a deuterium atom. In one or more embodiments, R₀ may be a hydrogen atom.

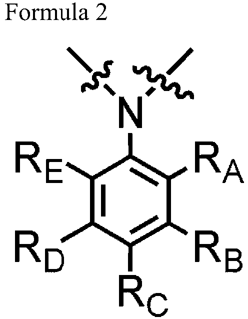

In Formula 2, R_{A} to R_{E} are each independently a hydrogen atom, a deuterium atom, a halogen atom, a cyano group, a nitro group, a substituted or unsubstituted amine group, a substituted or unsubstituted alkyl group having 1 to 20 carbon atoms, a substituted or unsubstituted cycloalkyl group having 3 to 10 ring-forming carbon atoms, a substituted or unsubstituted aryl group having 6 to 30 ring-forming carbon atoms, a substituted or unsubstituted heteroaryl group having 5 to 30 ring-forming carbon atoms, or a group represented by Formula 3. At least two of Formula 2 include 4 or more substituents represented by Formula 3.

In two of Formula 2, R_{A} to R_{E} are each provided in two, and the two of Formulas 2 may include ten groups represented by any one of R_{A} to R_{E}. For example, among the 10 groups, 4 are phenyl groups represented by Formula 3. One of the 10 groups may include 4 phenyl groups represented by Formula 3. Among the 10 groups, one may include three phenyl groups represented by Formula 3, and another may include one phenyl group represented by Formula 3. Two of the 10 groups may each independently include two phenyl groups represented by Formula 3. In this case, two phenyl groups may form a biphenyl group. Alternatively, among the 10 groups, any two may each independently be phenyl groups represented by Formula 3, and the other one may include two phenyl groups represented by Formula 3. In this case, two phenyl groups may form a biphenyl group.

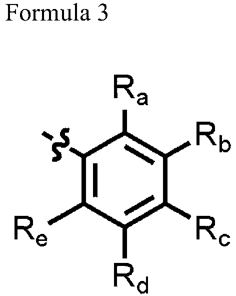

In Formula 3, Rₐ to Rₑ may each independently be a hydrogen atom, a deuterium atom, a halogen atom, a cyano group, a nitro group, a substituted or unsubstituted amine group, a substituted or unsubstituted alkyl group having 1 to 20 carbon atoms, a substituted or unsubstituted aryl group having 6 to 30 ring-forming carbon atoms, or a substituted or unsubstituted heteroaryl group having 5 to 30 ring-forming carbon atoms. For example, Rₐ to Rₑ may each independently be a hydrogen atom, a deuterium atom, a substituted or unsubstituted phenyl group, a substituted or unsubstituted biphenyl group, a substituted or unsubstituted t-butylphenyl group, a substituted or unsubstituted cyanophenyl group, a substituted or unsubstituted terphenyl group, a substituted or unsubstituted alkylbiphenyl group, a substituted or unsubstituted dimethylphenyl group, or a substituted or unsubstituted di-t-butylphenyl group. In one or more embodiments, Formula 3 may be represented by one of R-1 to R-13:

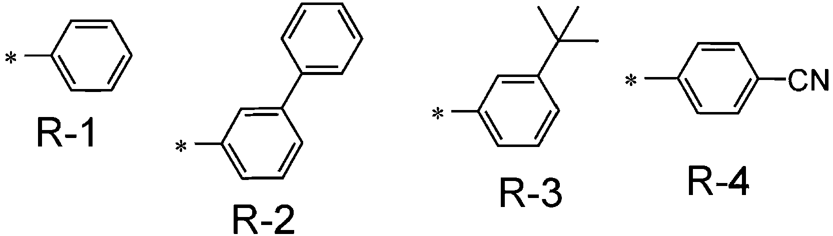

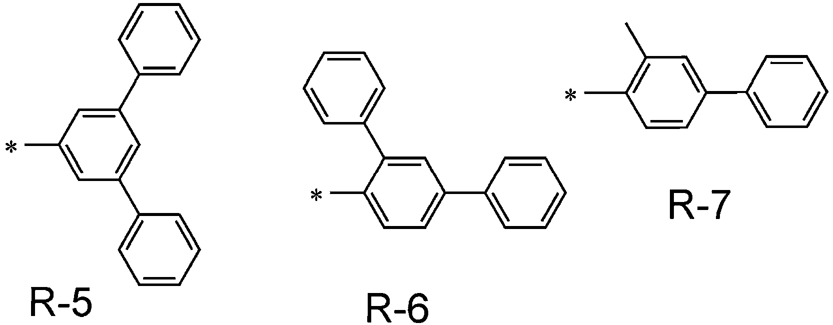

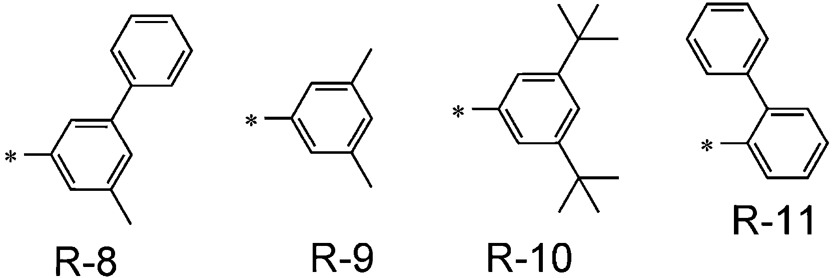

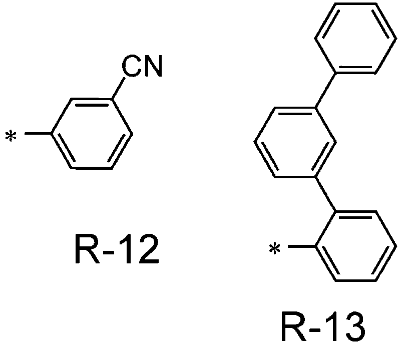

In one or more embodiments, the fused polycyclic compound represented by Formula 1 may include a structure in which any hydrogen atoms in molecules are substituted with deuterium atoms. For example, a deuterium atom may be directly bonded to a fused ring of nine rings, which contains two boron atoms and two nitrogen atoms as ring-forming atoms. Alternatively, a substituent substituted with a deuterium atom may be bonded to a fused ring of the nine rings.

In one or more embodiments, Formula 1 may be represented by one of Formulas 1-A1 to 1-A3. Formula 1-A1 may be a case in which R₃ and R₁₁ in Formula 1 are each independently a substituted or unsubstituted phenyl group. Formula 1-A2 may be a case in which R₄ and R₁₁ in Formula 1 are each independently a substituted or unsubstituted phenyl group. Formula 1-A3 may be a case in which R₄ and R₁₀ in Formula 1 are each independently a substituted or unsubstituted phenyl group.

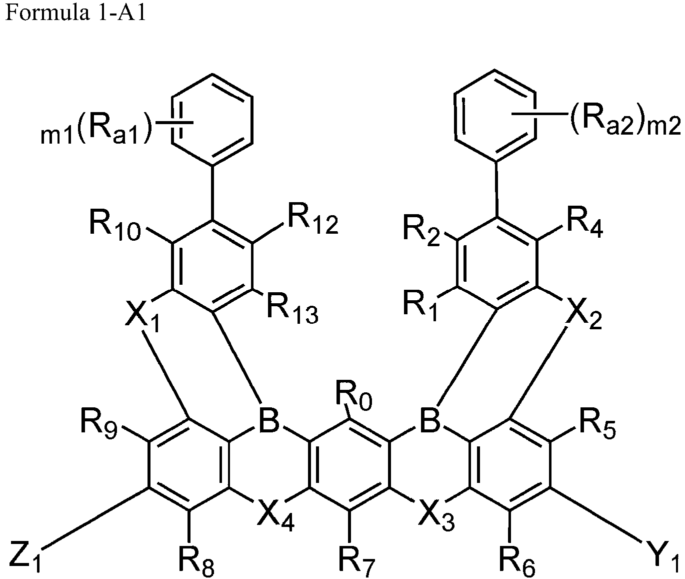

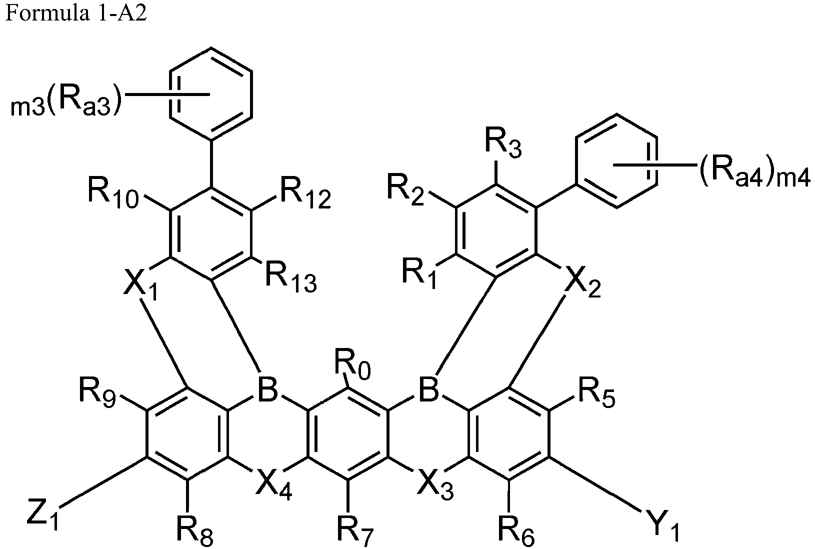

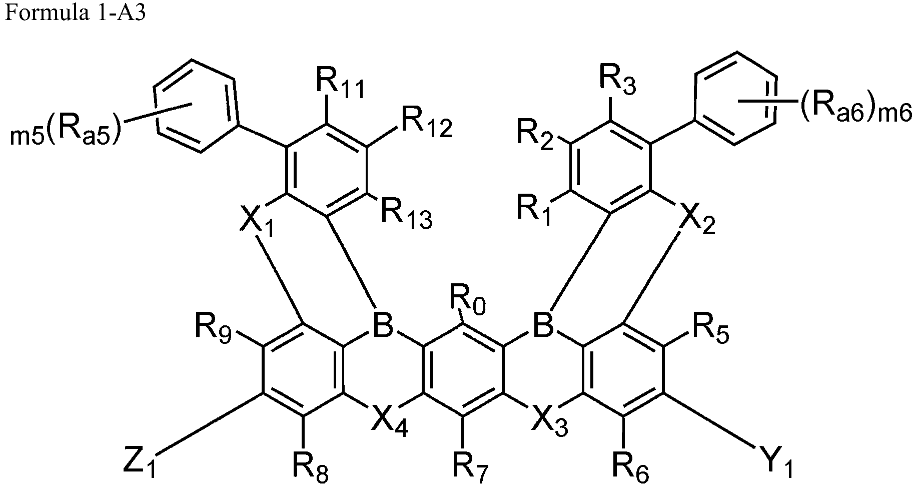

In Formulae 1-A1 to 1-A3, the same descriptions as in Formula 1 above may also be applied to X₁ to X₄, R₀ to R₁₃, Y₁, and Z₁.

In Formulae 1-A1 to 1-A3, Rₐ₁ to Rₐ₆ are each independently a hydrogen atom, a deuterium atom, a cyano group, a substituted or unsubstituted alkyl group having 1 to 20 carbon atoms, or a substituted or unsubstituted aryl group having 6 to 30 ring-forming carbon atoms. In Formulas 1-A1 to 1-A3, m1 to m6 are each independently an integer of 0 to 5.

When m1 is an integer of 2 or greater, a plurality of Rₐ₁'s may all be the same or at least one may be different from the others. When m1 is 5 and five Rₐ₁'s are hydrogen atoms, the case may be the same as a case in which m1 is 0. When m2 is an integer of 2 or greater, a plurality of Rₐ₂'s may all be the same or at least one may be different from the others. When m2 is 5 and five Rₐ₂'s are hydrogen atoms, the case may be the same as a case in which m2 is 0. When m3 is an integer of 2 or greater, a plurality of Rₐ₃'s may all be the same or at least one may be different from the others. When m3 is 5 and five Rₐ₃'s are hydrogen atoms, the case may be the same as a case in which m3 is 0.

When m4 is an integer of 2 or greater, a plurality of Rₐ₄'s may all be the same or at least one may be different from the others. When m4 is 5 and five Rₐ₄'s are hydrogen atoms, the case may be the same as a case in which m4 is 0. When m5 is an integer of 2 or greater, a plurality of Rₐ₅'s may all be the same or at least one may be different from the others. When m5 is 5 and five Rₐ₅'s are hydrogen atoms, the case may be the same as a case in which m5 is 0. When m6 is an integer of 2 or greater, a plurality of Rₐ₆'s may all be the same or at least one may be different from the others. When m6 is 5 and five Rₐ₆'s are hydrogen atoms, the case may be the same as a case in which m6 is 0.

In one or more embodiments, Formula 1 may be represented by one of Formulas 1-B1 to 1-B3. Formula 1-B1 to Formula 1-B3 may be a case in which two of X₁ to X₄ in Formula 1 are Formula 2. Formula 1-B1 may be a case in which X₃ and X₄ in Formula 1 are each independently Formula 2. Formula 1-B2 may be a case in which X₁ and X₄ in Formula 1 are each independently Formula 2. Formula 1-B3 may be a case in which X₁ and X₃ in Formula 1 are each independently Formula 2.

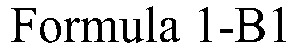

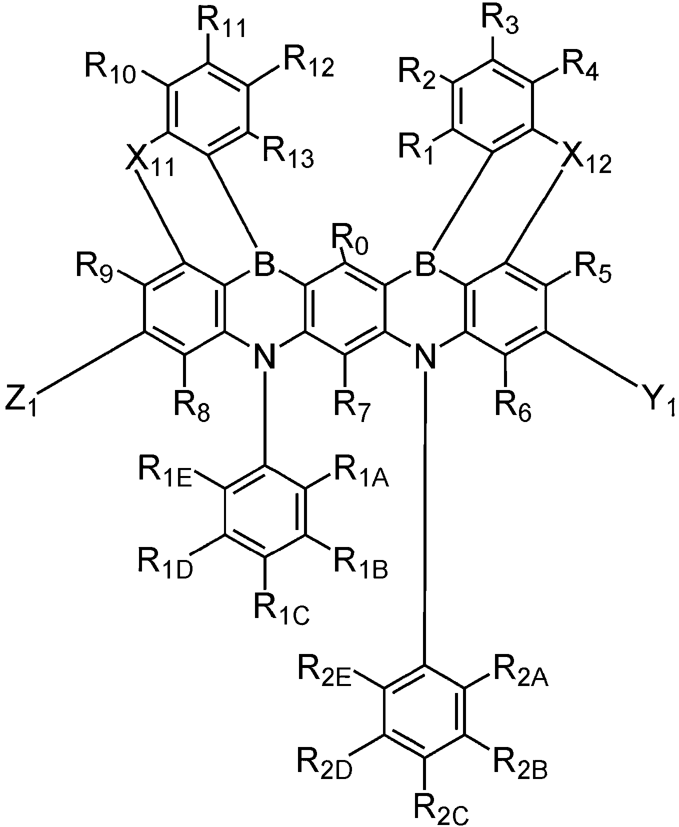

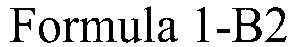

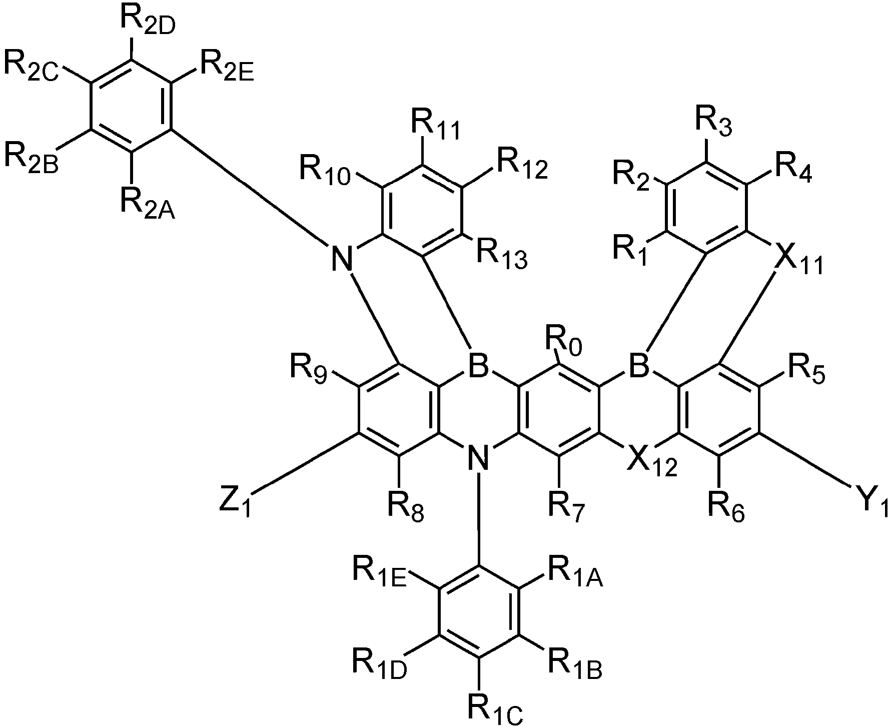

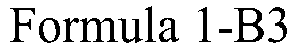

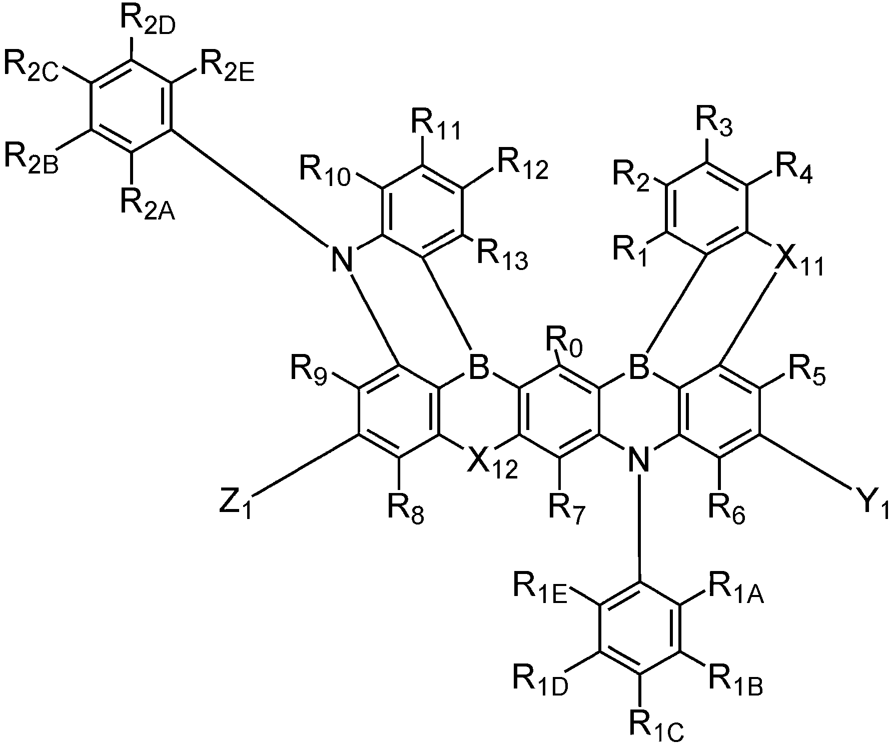

In Formulas 1-B1 to 1-B3, the same descriptions as in Formula 1 above may also be applied to R₀ to R₁₃, Y₁, and Z₁. In Formulas 1-B1 to 1-B3, X₁₁ and X₁₂ are each independently O or S. For example, in Formula 1-B1, X₁₁ and X₁₂ may be O. In Formula 1-B2, X₁₁ and X₁₂ may be O. In Formula 1-B2, X₁₁ and X₁₂ may be S. In Formula 1-B2, X₁₁ may be O and X₁₂ may be S. In Formula 1-B3, X₁₁ and X₁₂ may be O. In Formula 1-B3, X₁₁ may be O and X₁₂ may be S.

In Formulas 1-B1 to 1-B3, R_{1A} to R_{1E} and R_{2A} to R_{2E} may each independently be a hydrogen atom, a deuterium atom, a halogen atom, a cyano group, a nitro group, a substituted or unsubstituted amine group, a substituted or unsubstituted alkyl group having 1 to 20 carbon atoms, a substituted or unsubstituted cycloalkyl group having 3 to 10 ring-forming carbon atoms, a substituted or unsubstituted aryl group having 6 to 30 ring-forming carbon atoms, a substituted or unsubstituted heteroaryl group having 5 to 30 ring-forming carbon atoms, or a group represented by Formula 3.

In Formulae 1-B1 to 1-B3, the number of substituents represented by Formula 3 in R_{1A} to R_{1E} and R_{2A} to R_{2E} is 4 or more. In two of Formula 2, R_{1A} to R_{1E} and R_{2A} to R_{2E} may each be provided once, and the two of Formula 2 may include 10 groups represented by any one of R_{1A} to R_{1E} and R_{2A} to R_{2E}. For example, among the 10 groups, 4 may be phenyl groups represented by Formula 3. One of the 10 groups may include 4 phenyl groups represented by Formula 3. Among the 10 groups, one may include three phenyl groups represented by Formula 3, and another may include one phenyl group represented by Formula 3. Two of the 10 groups may each independently include two phenyl groups represented by Formula 3. In this case, two phenyl groups may form a biphenyl group. Alternatively, among the 10 groups, any two may each independently be phenyl groups represented by Formula 3, and the other one may include two phenyl groups represented by Formula 3. In this case, two phenyl groups may form a biphenyl group.

In one or more embodiments, Formula 2 may be represented by any one of Formulas 2-1 to 2-8. Formula 2-1 may be a case in which R_{C} in Formula 2 is a substituted or unsubstituted phenyl group. Formula 2-2 may be a case in which R_{A} and R_{C} in Formula 2 are each independently a substituted or unsubstituted phenyl group. Formula 2-3 may be a case in which R_{A} and R_{E} in Formula 2 are each independently a substituted or unsubstituted phenyl group. Formula 2-4 may be a case in which R_{B} and R_{D} in Formula 2 are each independently a substituted or unsubstituted phenyl group. Formula 2-5 may be a case in which R_{A}, R_{C}, and R_{E} in Formula 2 are each independently a substituted or unsubstituted phenyl group. Formula 2-6 may be a case in which R_{A}, R_{B}, and R_{C} in Formula 2 are each independently a substituted or unsubstituted phenyl group. Formula 2-7 may be a case in which R_{A} in Formula 2 is a substituted or unsubstituted phenyl group. Formula 2-8 may be a case in which R_{B} in Formula 2 is a substituted or unsubstituted phenyl group.

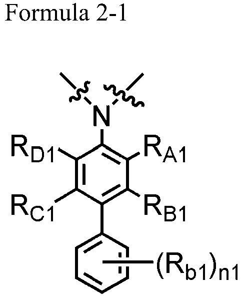

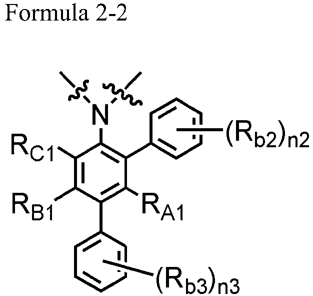

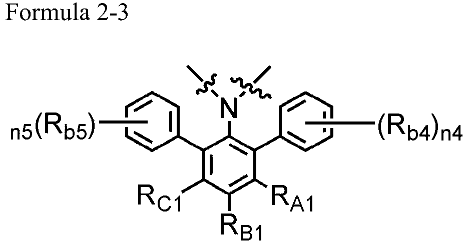

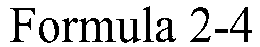

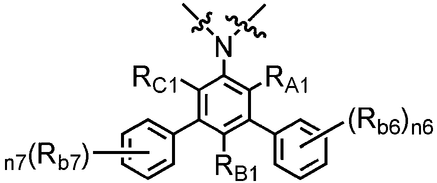

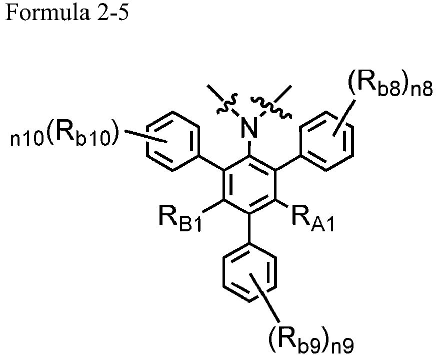

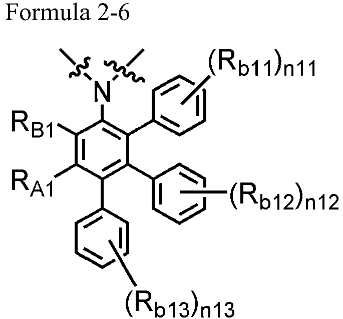

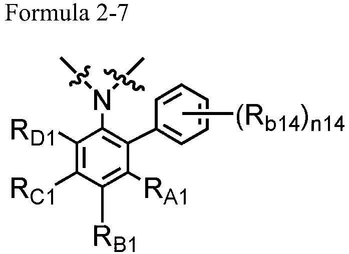

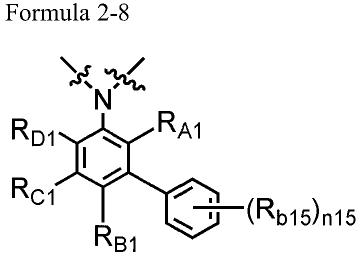

In Formulas 2-1 to 2-8, R_{A1} to R_{D1} are each independently a hydrogen atom, a deuterium atom, a substituted or unsubstituted alkyl group having 1 to 20 carbon atoms, or a substituted or unsubstituted cycloalkyl group having 3 to 10 ring-forming carbon atoms. R_{b1} to R_{b15} are each independently a hydrogen atom, a deuterium atom, a substituted or unsubstituted alkyl group having 1 to 20 carbon atoms, or a substituted or unsubstituted aryl group having 6 to 30 ring-forming carbon atoms. n1 to n15 are each independently an integer of 0 to 5.

When n1 is an integer of 2 or greater, a plurality of R_{b1}'s may all be the same or at least one may be different from the others. When n1 is 5 and five R_{b1}'s are hydrogen atoms, the case may be the same as a case in which n1 is 0. When n2 is an integer of 2 or greater, a plurality of R_{b2}'s may all be the same or at least one may be different from the others. When n2 is 5 and five R_{b2}'s are hydrogen atoms, the case may be the same as a case in which n2 is 0. When n3 is an integer of 2 or greater, a plurality of R_{b3}'s may all be the same or at least one may be different from the others. When n3 is 5 and five R_{b3}'s are hydrogen atoms, the case may be the same as a case in which n3 is 0.

When n4 is an integer of 2 or greater, a plurality of R_{b4}'s may all be the same or at least one may be different from the others. When n4 is 5 and five R_{b4}'s are hydrogen atoms, the case may be the same as a case in which n4 is 0. When n5 is an integer of 2 or greater, a plurality of R_{b5}'s may all be the same or at least one may be different from the others. When n5 is 5 and five R_{b5}'s are hydrogen atoms, the case may be the same as a case in which n5 is 0. When n6 is an integer of 2 or greater, a plurality of R_{b6}'s may all be the same or at least one may be different from the others. When n6 is 5 and five R_{b6}'s are hydrogen atoms, the case may be the same as a case in which n6 is 0.

When n7 is an integer of 2 or greater, a plurality of R_{b7}'s may all be the same or at least one may be different from the others. When n7 is 5 and five R_{b7}'s are hydrogen atoms, the case may be the same as a case in which n7 is 0. When n8 is an integer of 2 or greater, a plurality of R_{b8}'s may all be the same or at least one may be different from the others. When n8 is 5 and five R_{b8}'s are hydrogen atoms, the case may be the same as a case in which n8 is 0. When n9 is an integer of 2 or greater, a plurality of R_{b9}'s may all be the same or at least one may be different from the others. When n9 is 5 and five R_{b9}'s are hydrogen atoms, the case may be the same as a case in which n9 is 0.

When n10 is an integer of 2 or greater, a plurality of R_{b10}'s may all be the same or at least one may be different from the others. When n10 is 5 and five R_{b10}'s are hydrogen atoms, the case may be the same as a case in which n10 is 0. When n11 is an integer of 2 or greater, a plurality of R_{b11}'s may all be the same or at least one may be different from the others. When n11 is 5 and five R_{b11}'s are hydrogen atoms, the case may be the same as a case in which n11 is 0. When n12 is an integer of 2 or greater, a plurality of R_{b12}'s may all be the same or at least one may be different from the others. When n12 is 5 and five R_{b12}'s are hydrogen atoms, the case may be the same as a case in which n12 is 0.

When n13 is an integer of 2 or greater, a plurality of R_{b13}'s may all be the same or at least one may be different from the others. When n13 is 5 and five R_{b13}'s are hydrogen atoms, the case may be the same as a case in which n13 is 0. When n14 is an integer of 2 or greater, a plurality of R_{b14}'s may all be the same or at least one may be different from the others. When n14 is 5 and five R_{b14}'s are hydrogen atoms, the case may be the same as a case in which n14 is 0. When n15 is an integer of 2 or greater, a plurality of R_{b15}'s may all be the same or at least one may be different from the others. When n15 is 5 and five R_{b15}'s are hydrogen atoms, the case may be the same as a case in which n15 is 0.

In one or more embodiments, Formula 2-1 may be represented by one of 2-1A to 2-1C, Formula 2-2 may be represented by one of 2-2A and 2-2B, Formula 2-3 may be represented by one of 2-3A to 2-3G, Formula 2-4 may be represented by one of 2-4A and 2-4B, Formula 2-5 may be represented by one of 2-5A to 2-5D, Formula 2-6 may be represented by 2-6A, Formula 2-7 may be represented by 2-7A, and Formula 2-8 may be represented by 2-8A.

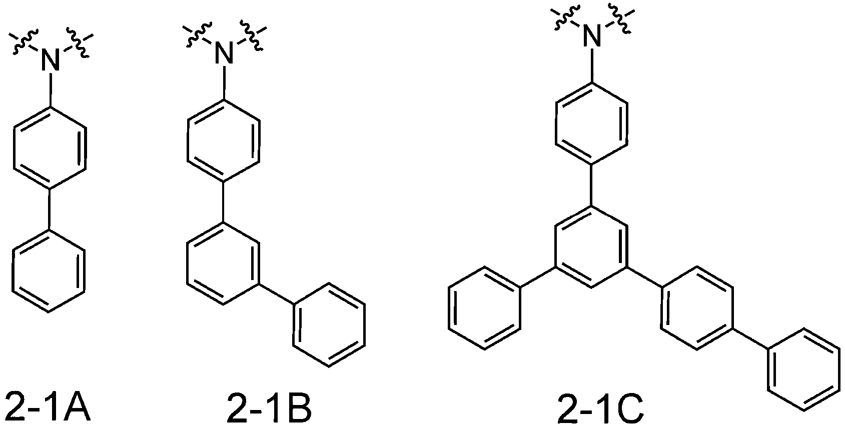

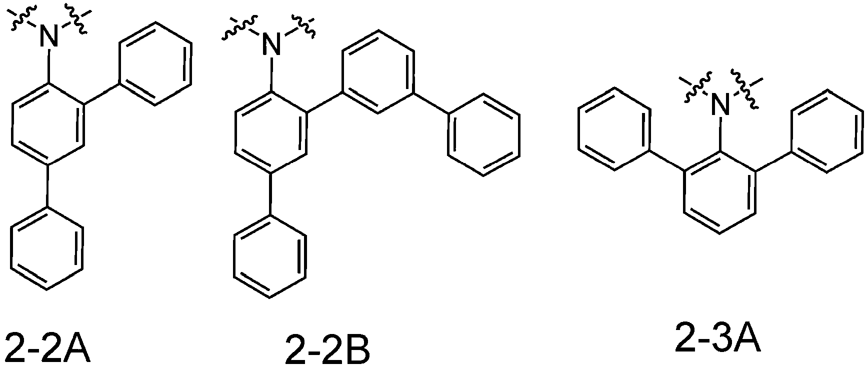

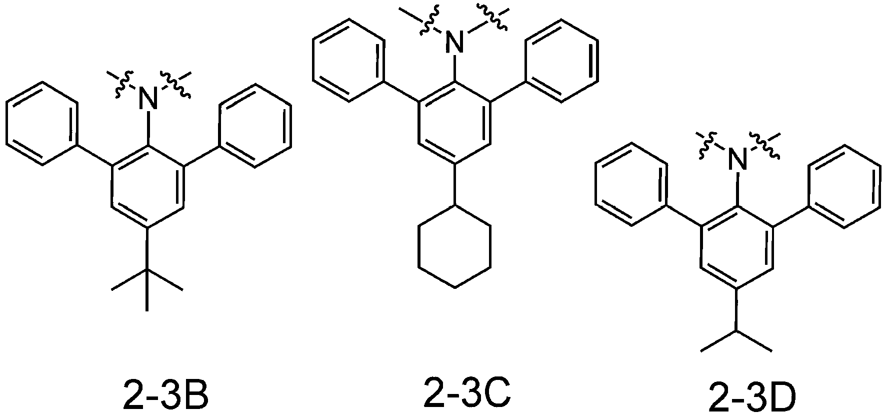

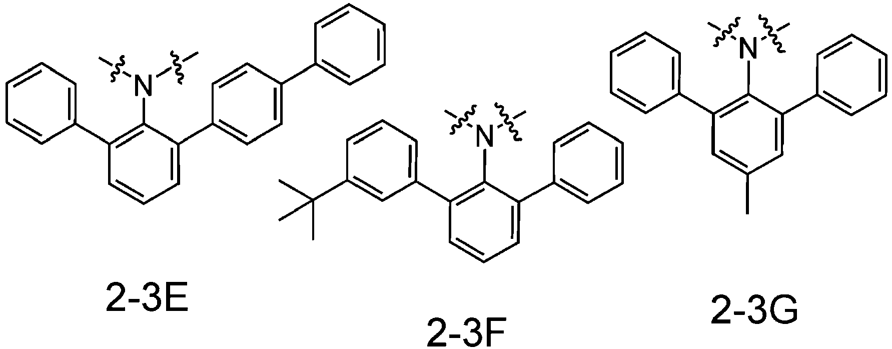

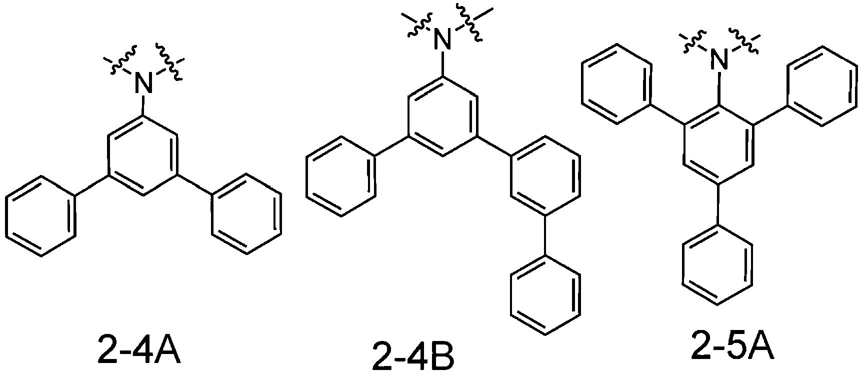

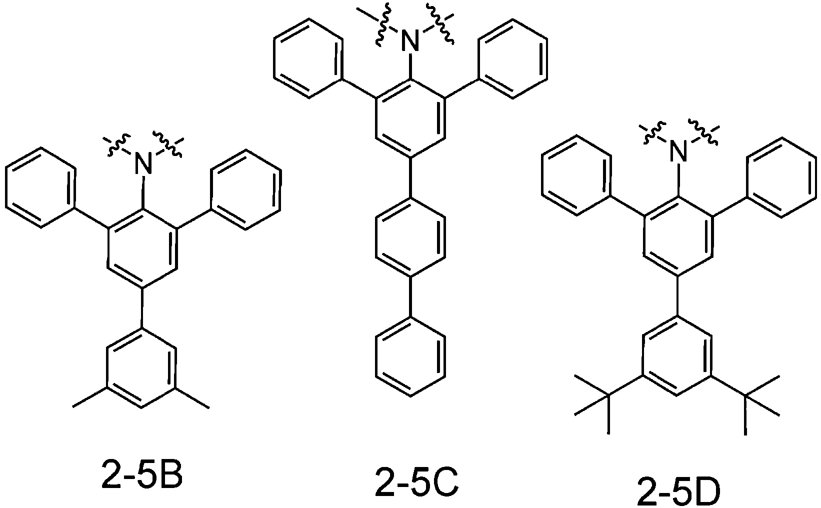

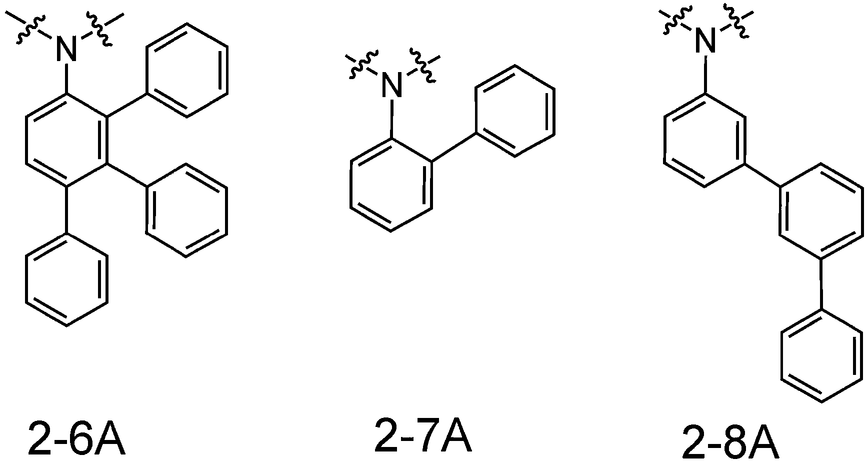

The fused polycyclic compound of Formula 1 may be represented by one of the compounds from Compound Group 1. The light emitting element ED according to one or more embodiments may include at least one of the compounds from Compound Group 1.

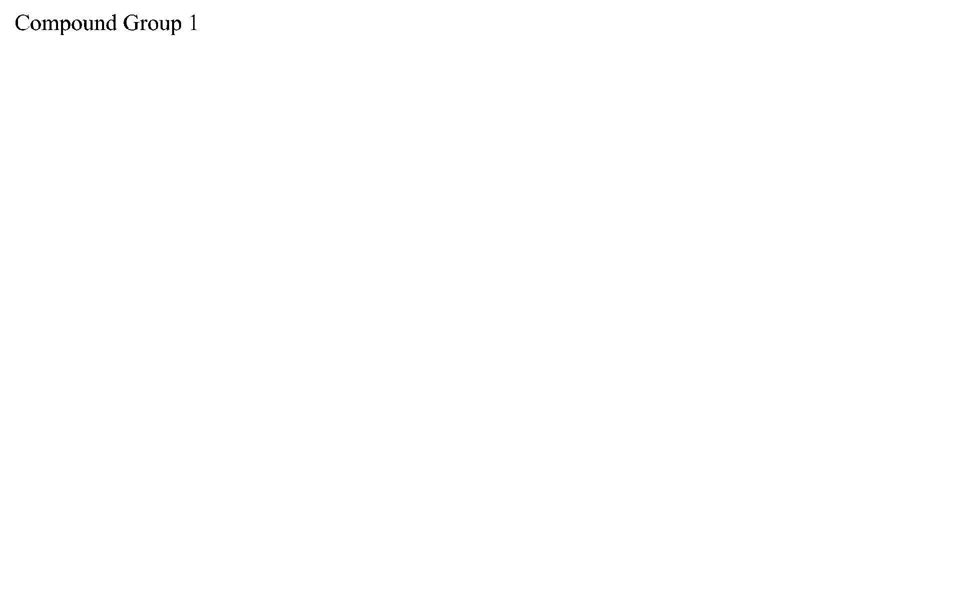

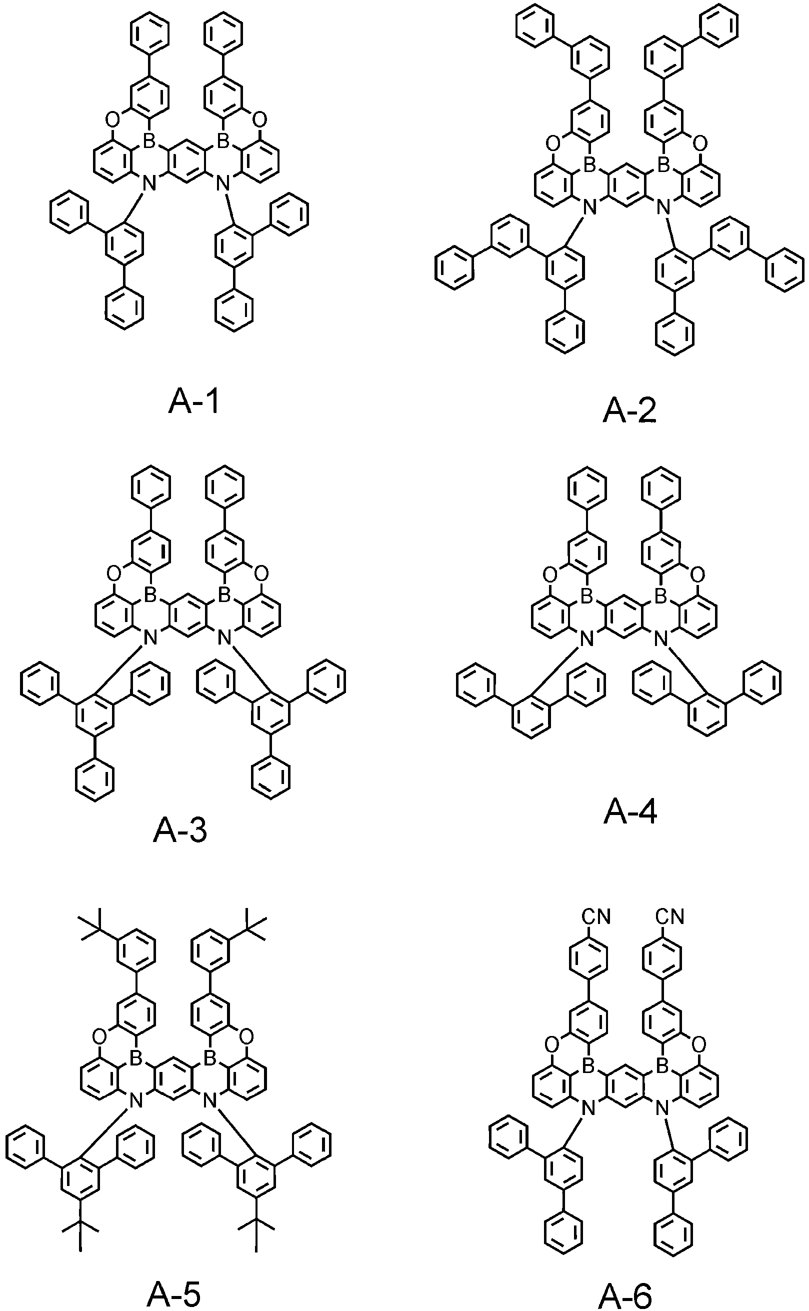

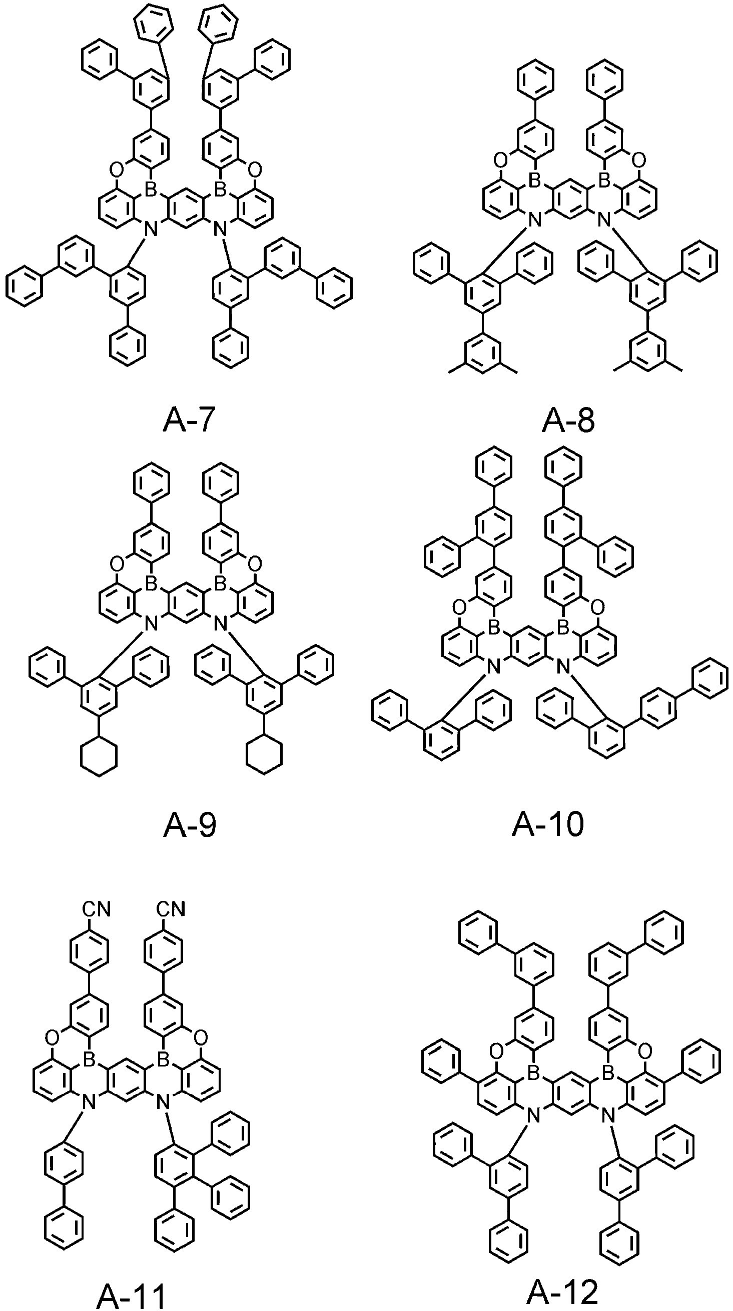

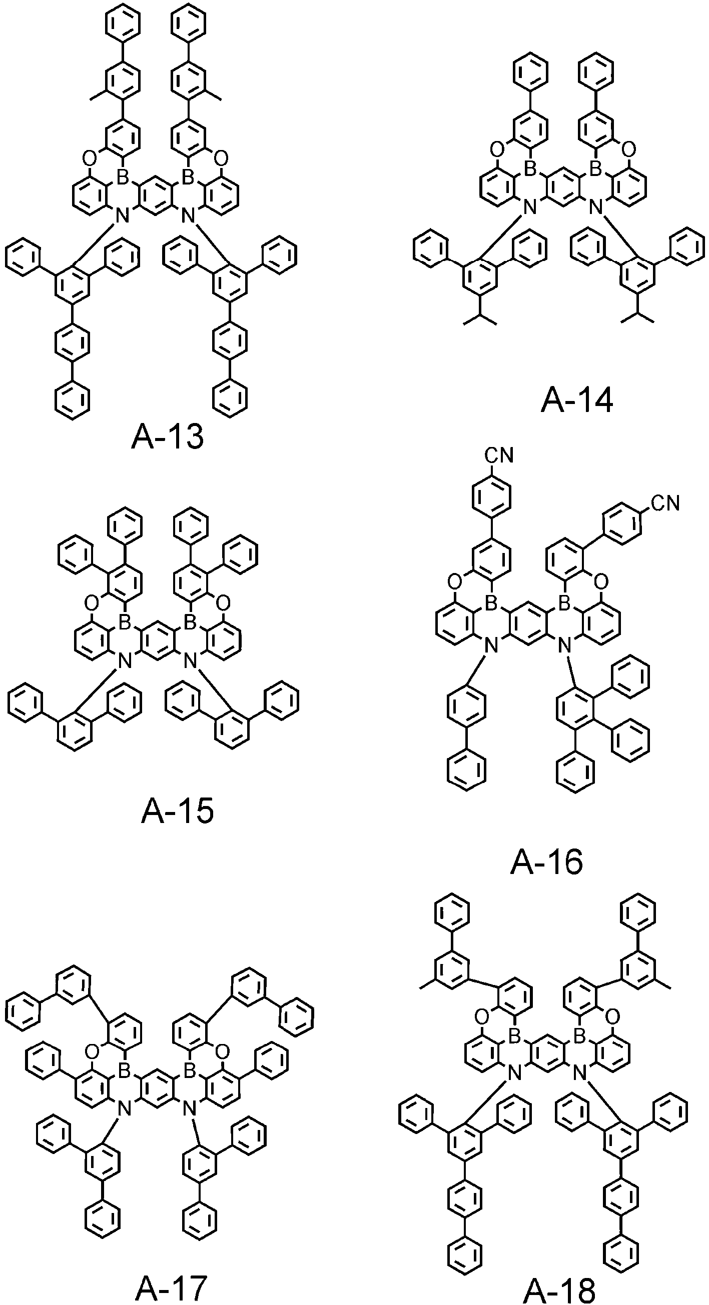

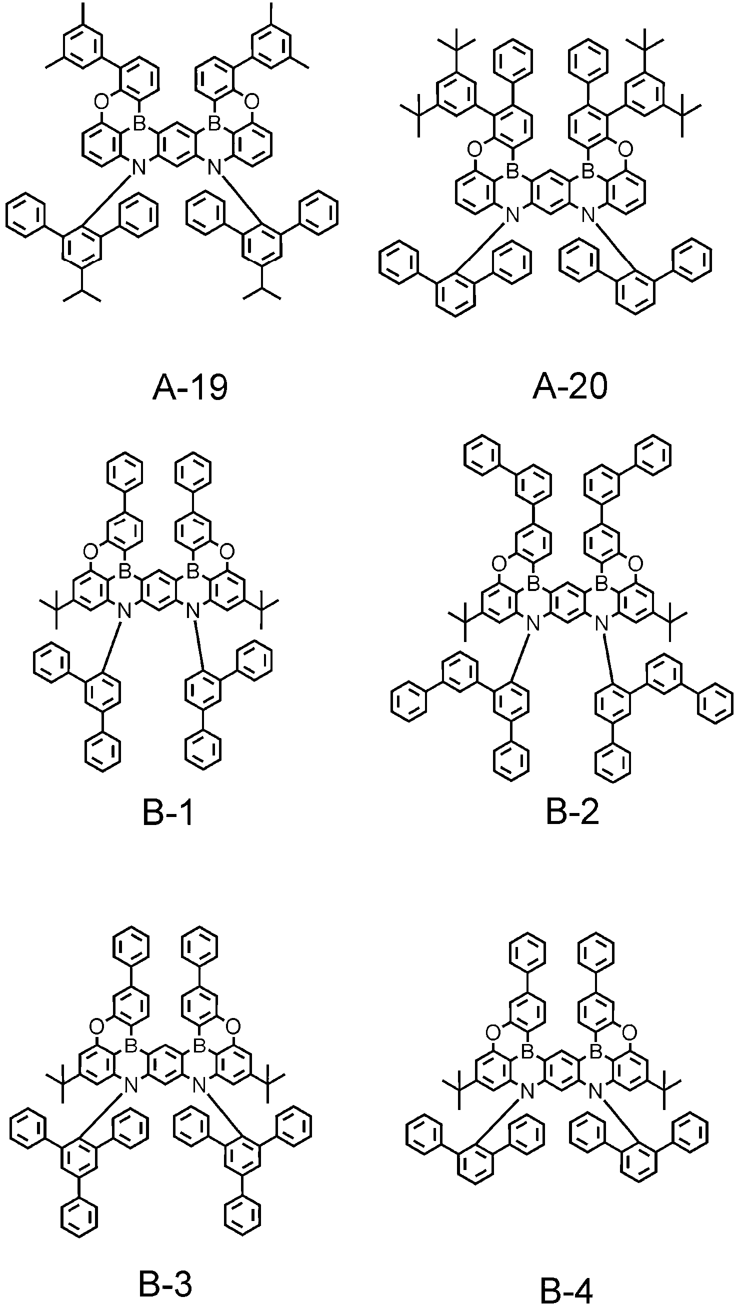

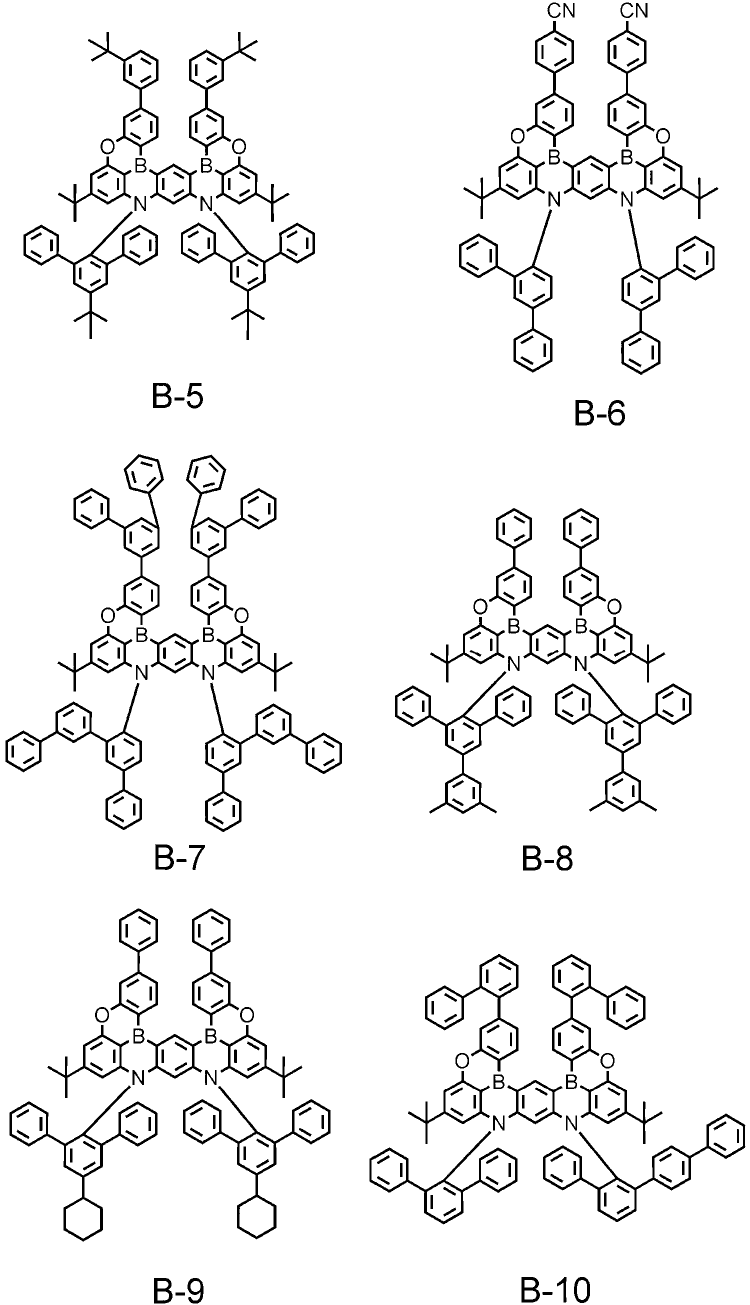

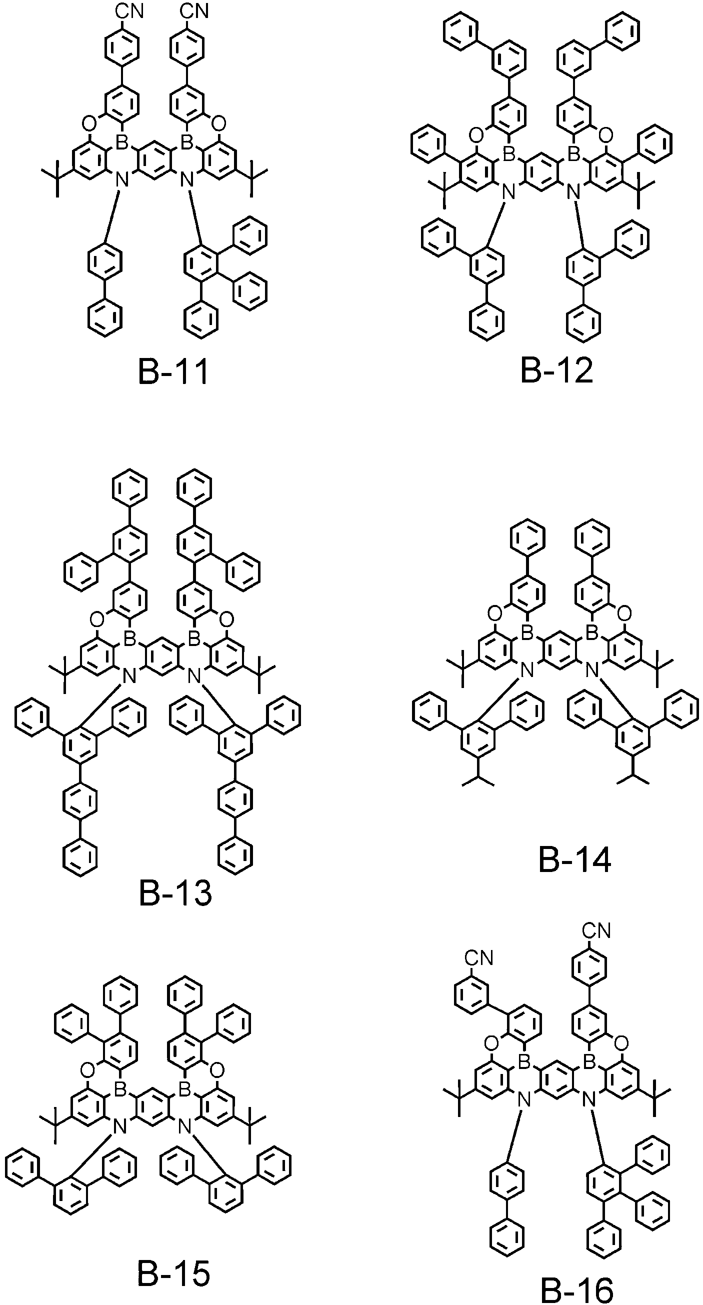

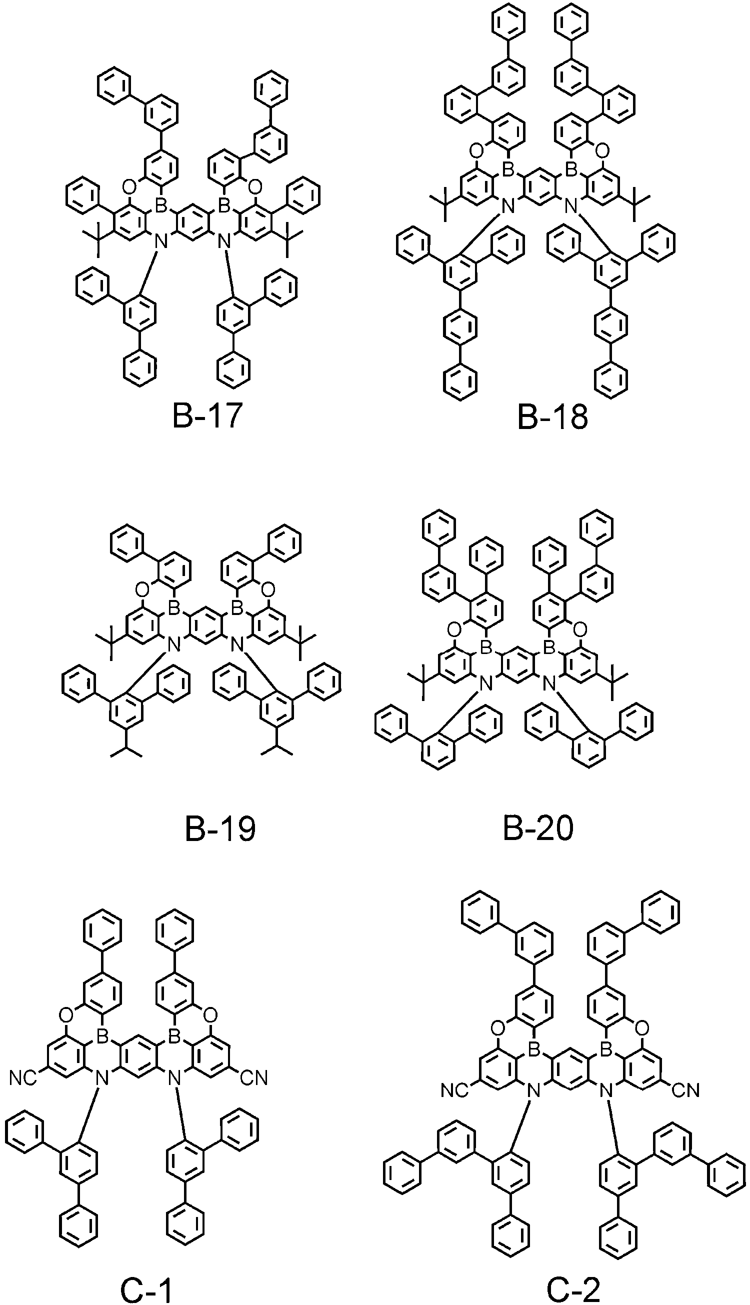

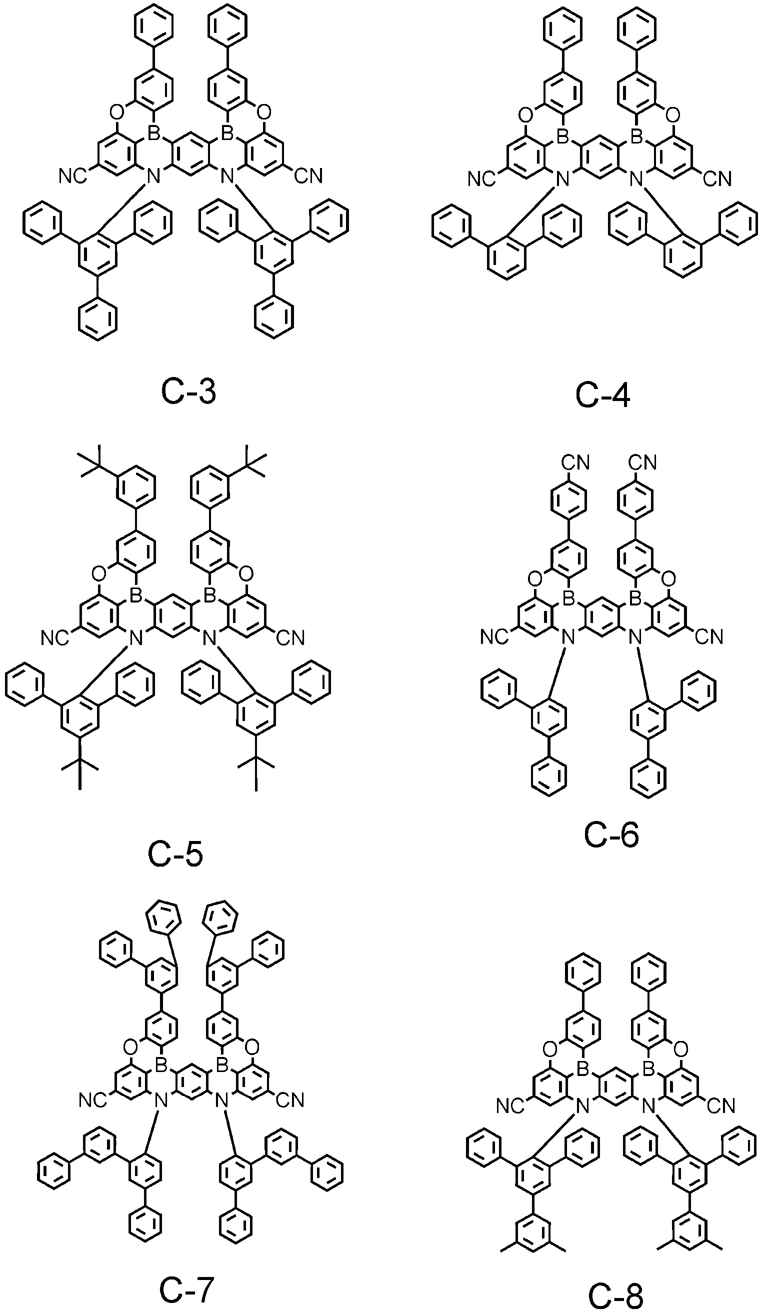

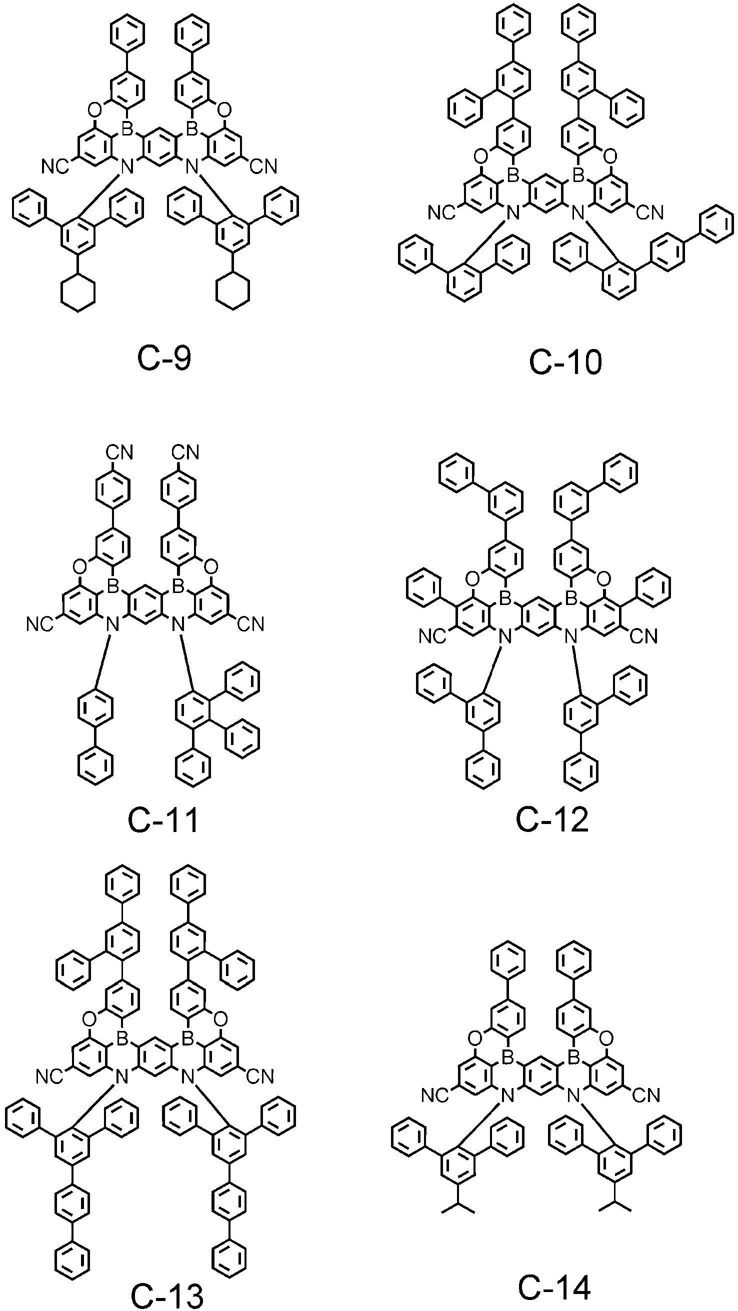

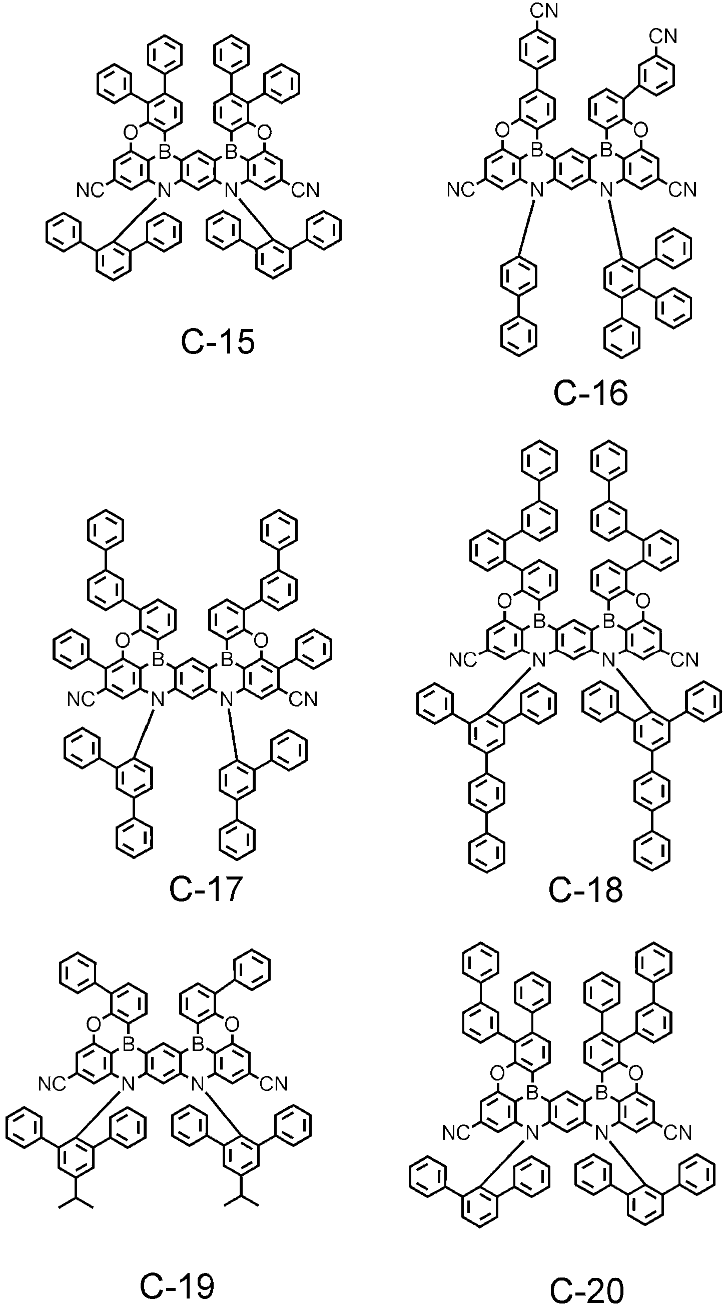

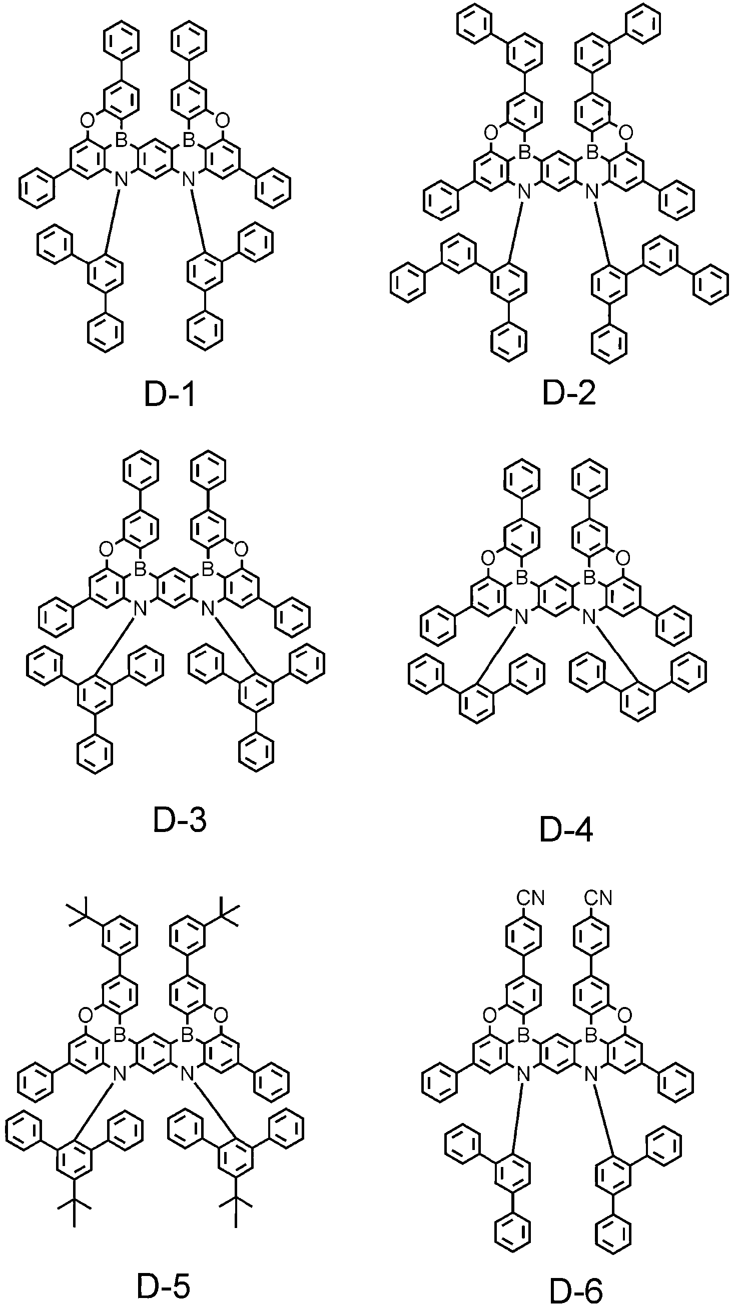

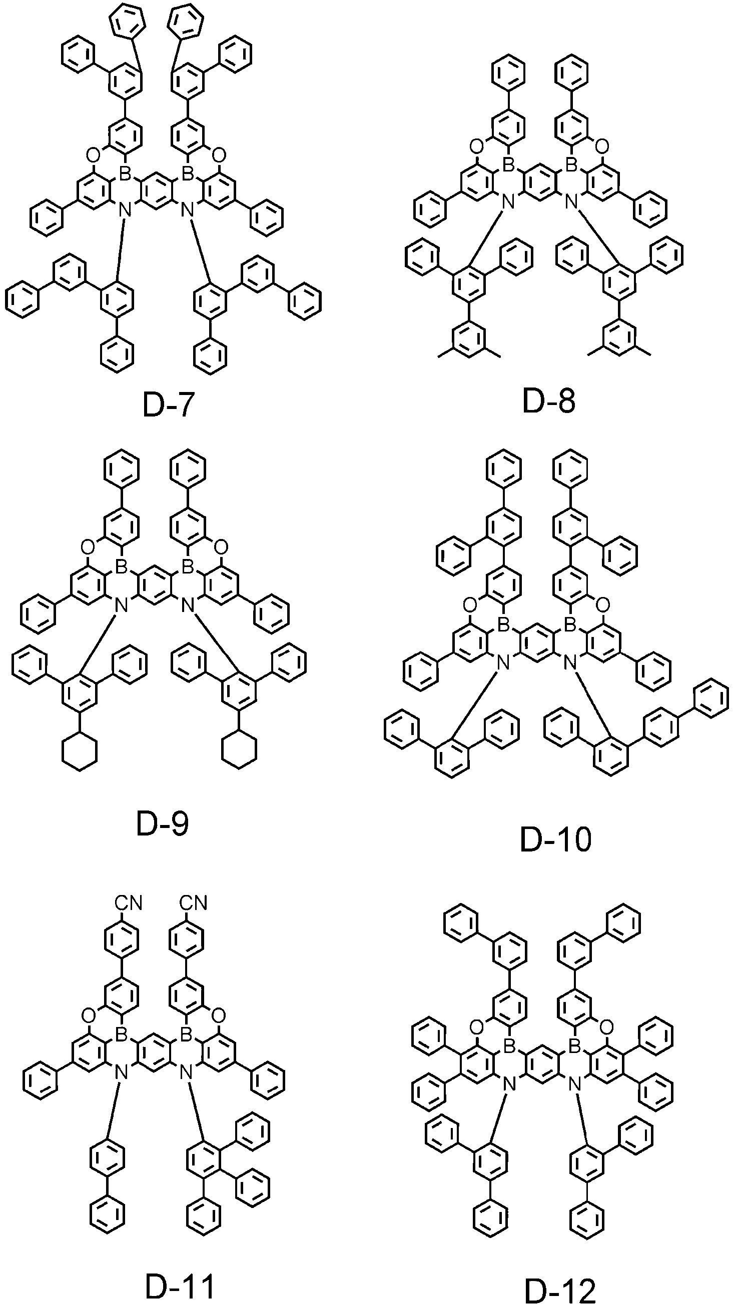

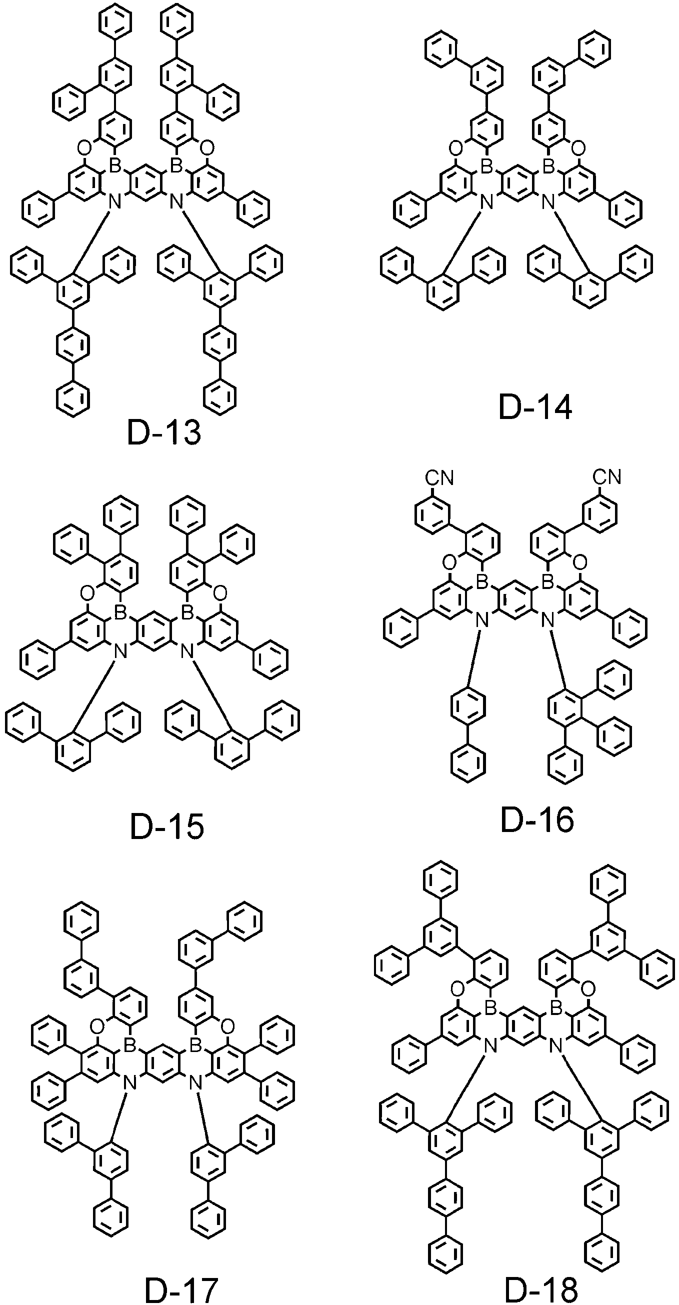

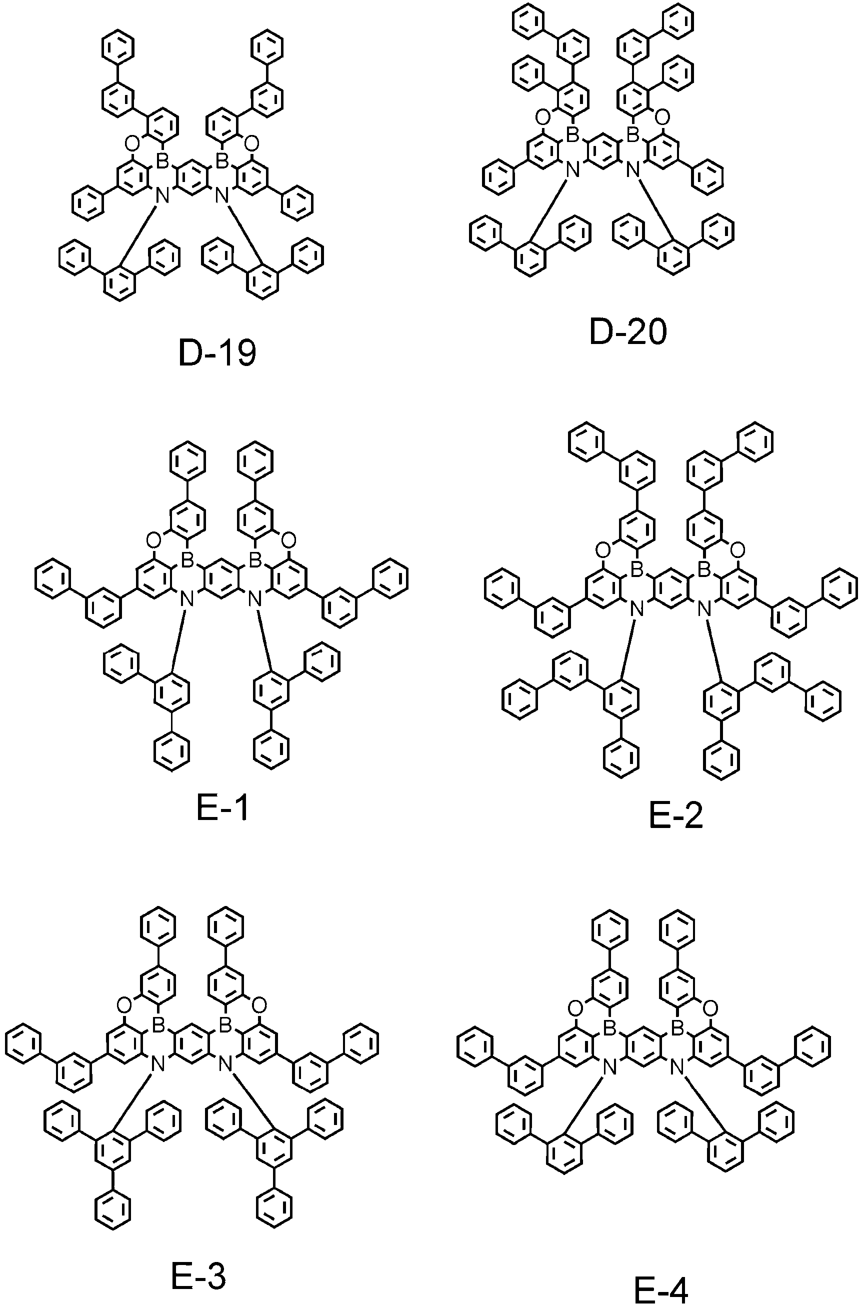

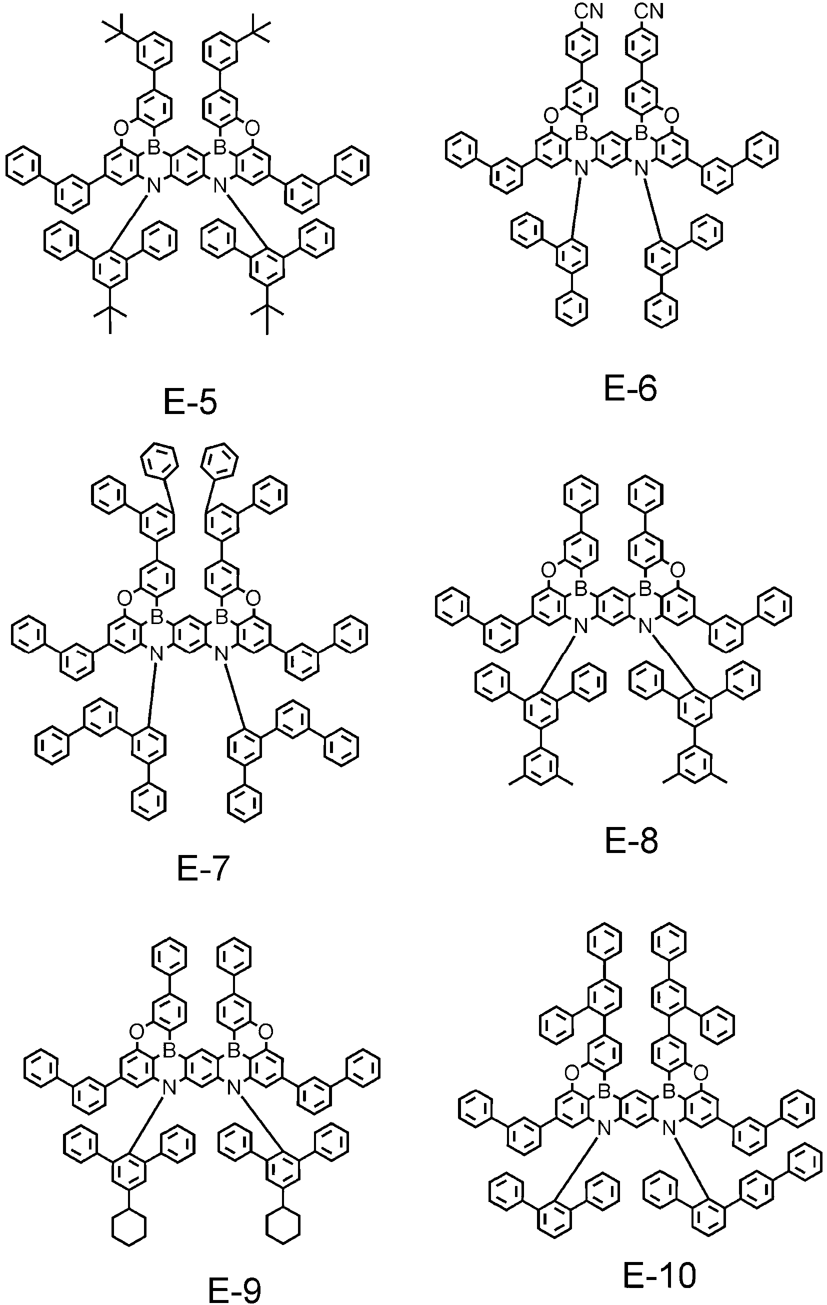

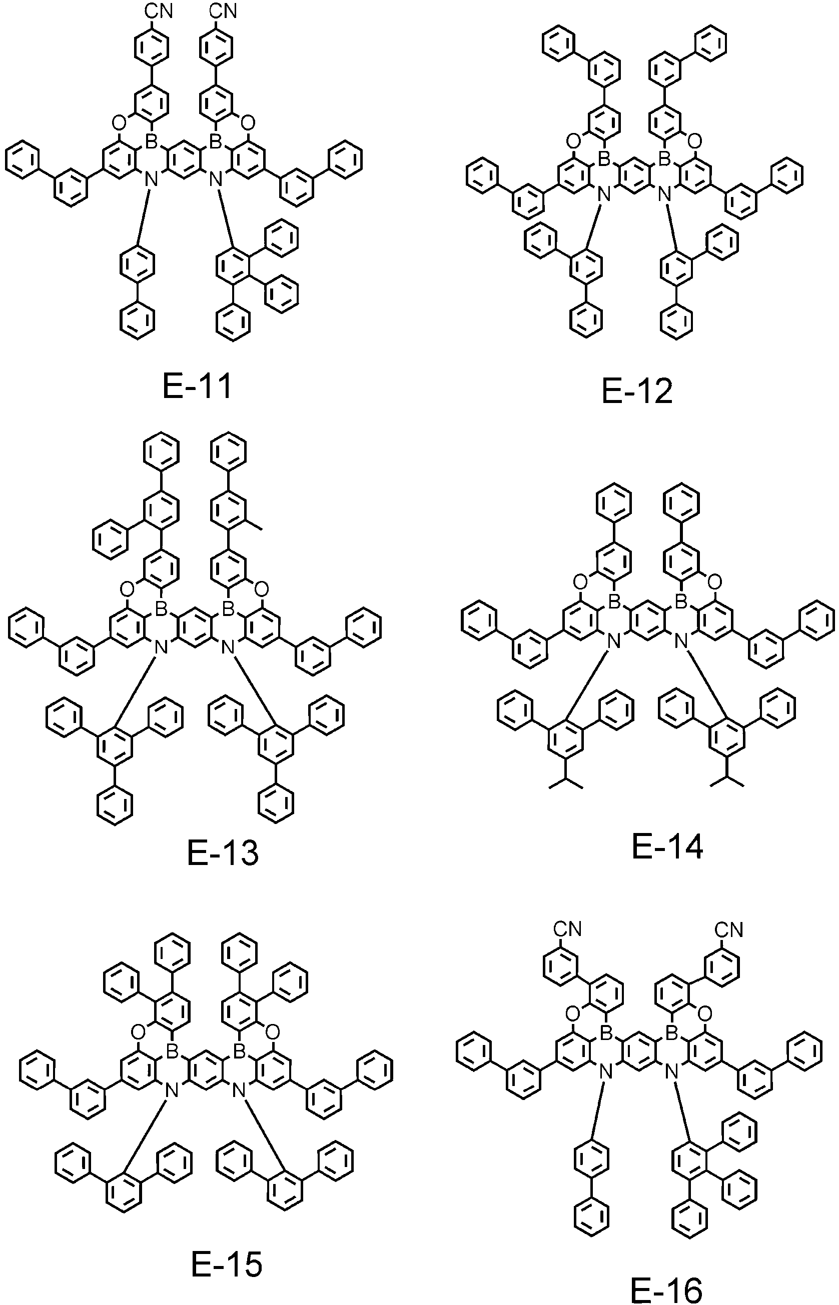

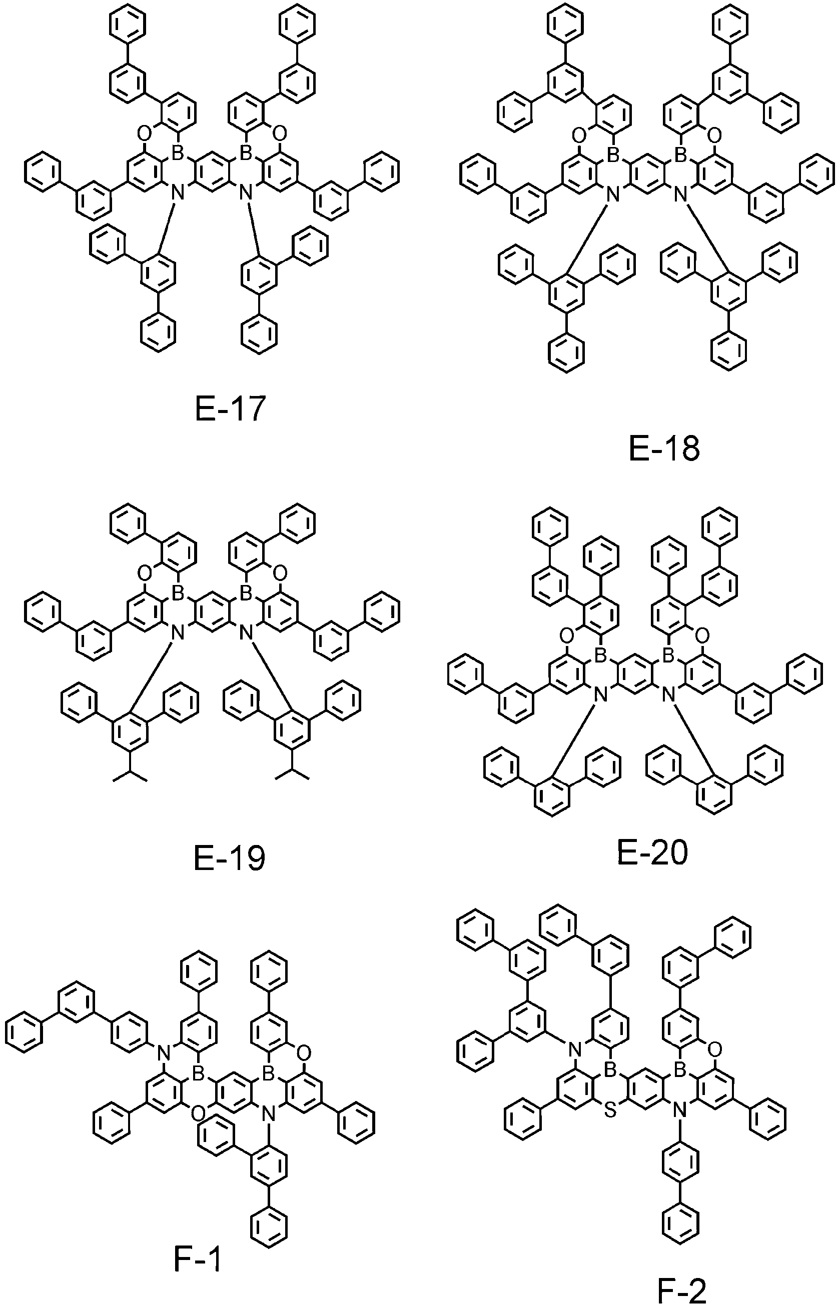

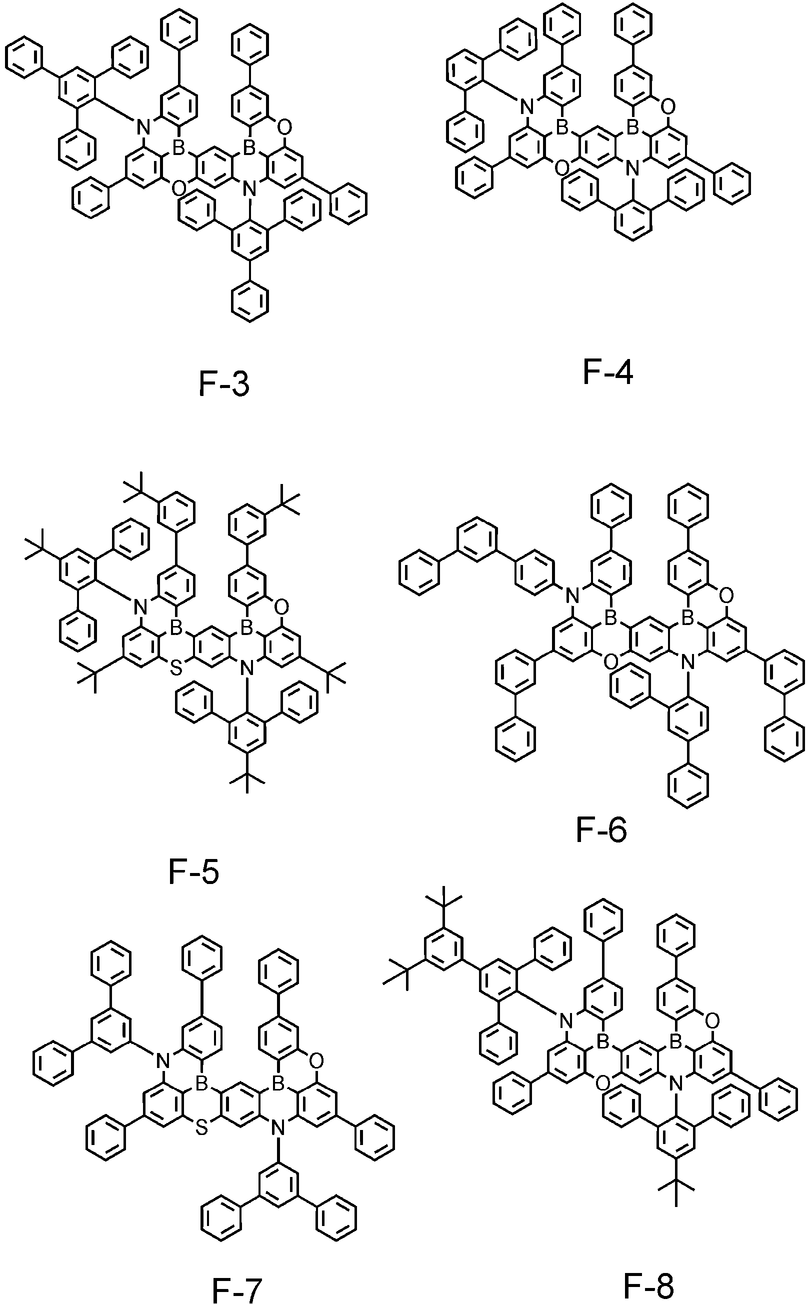

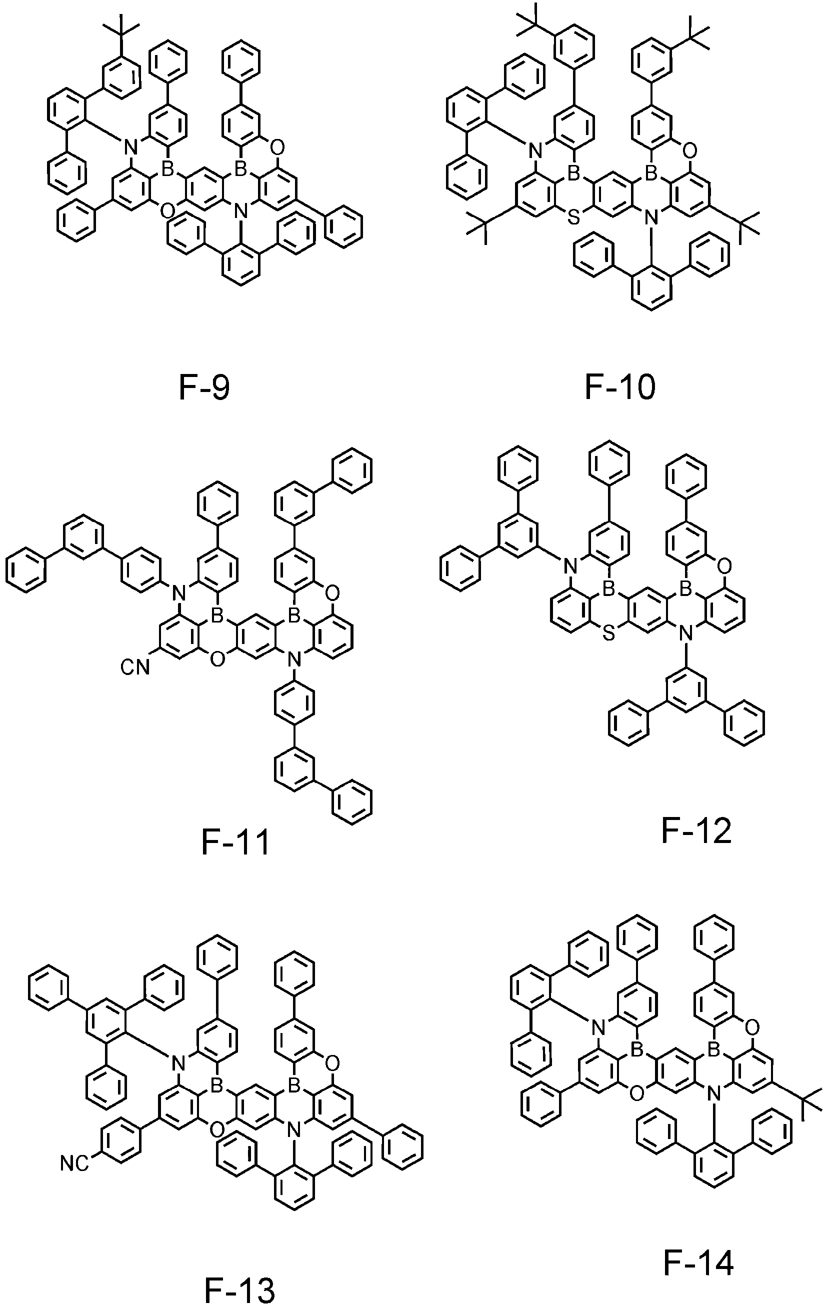

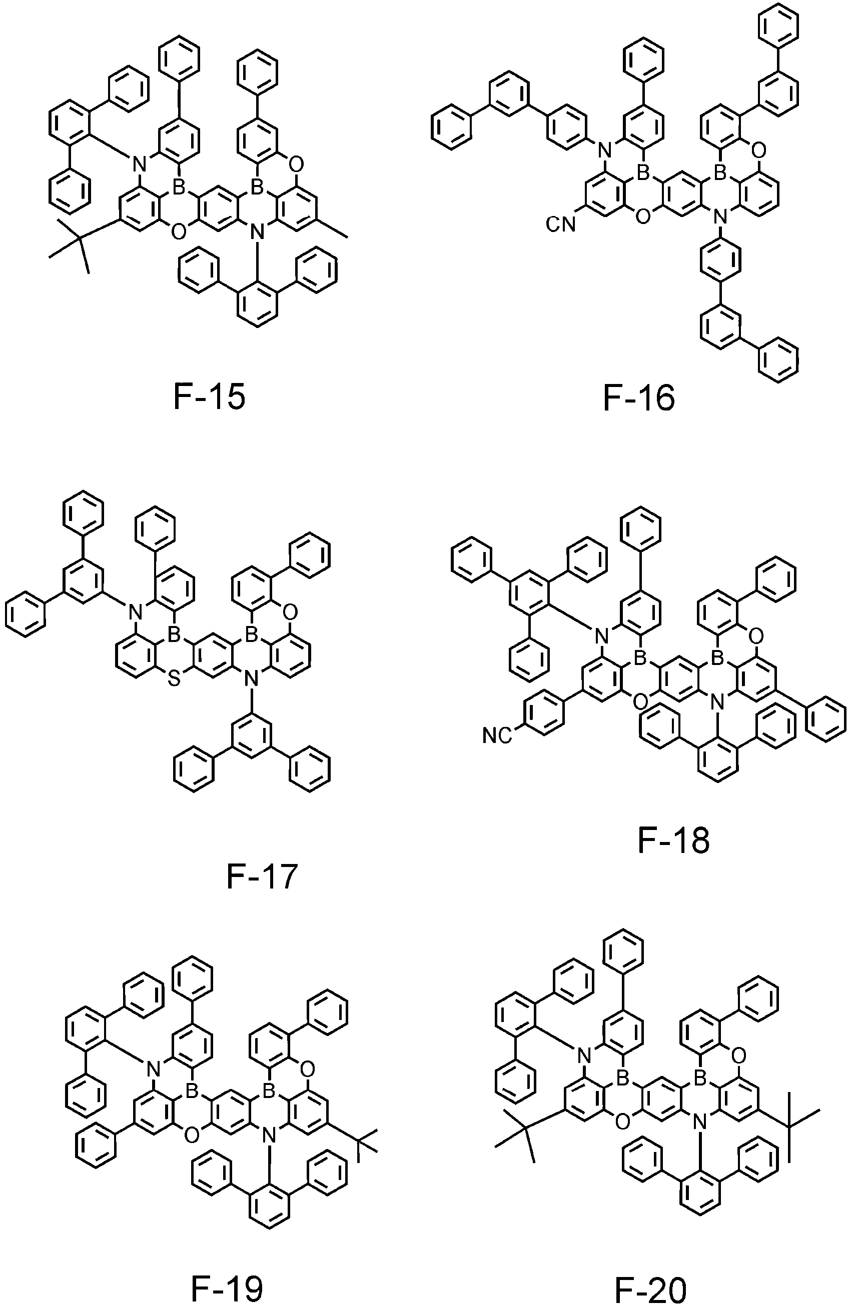

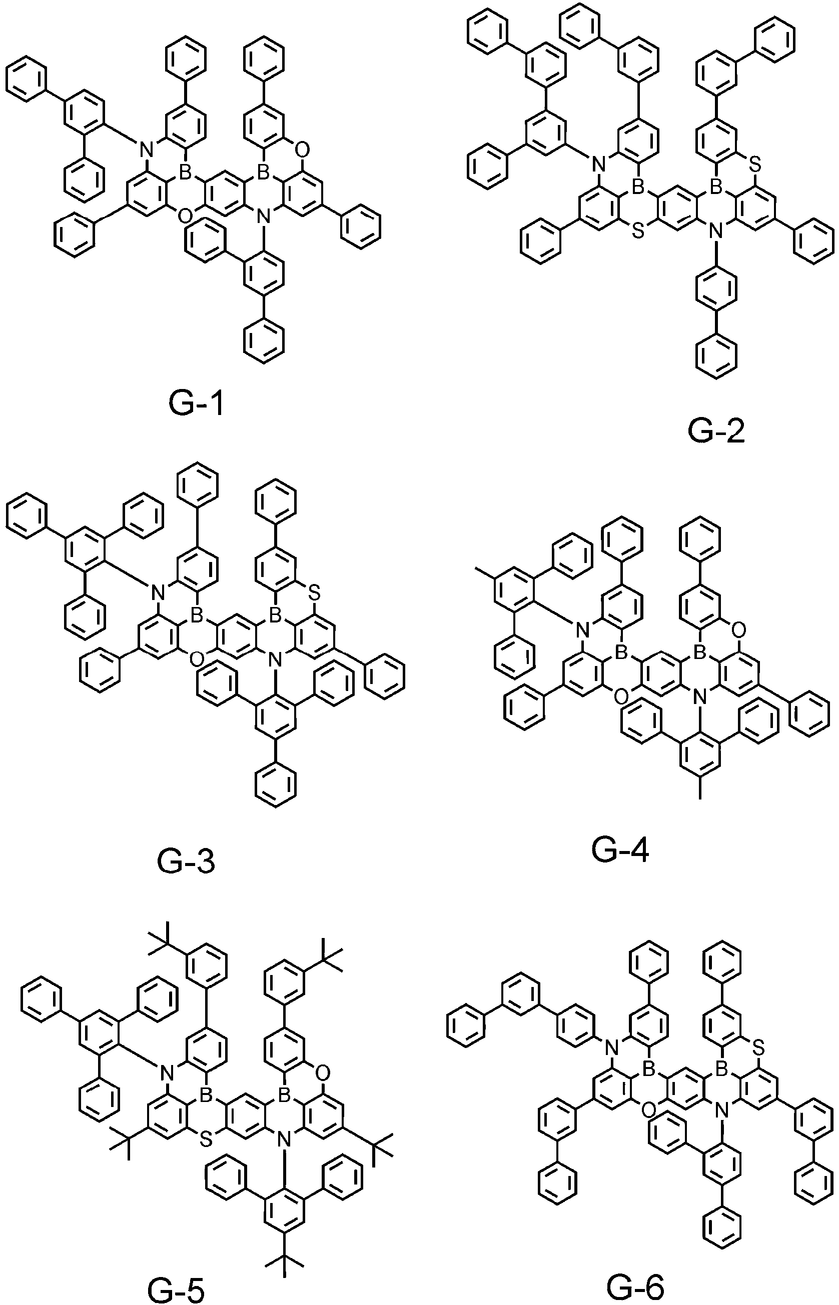

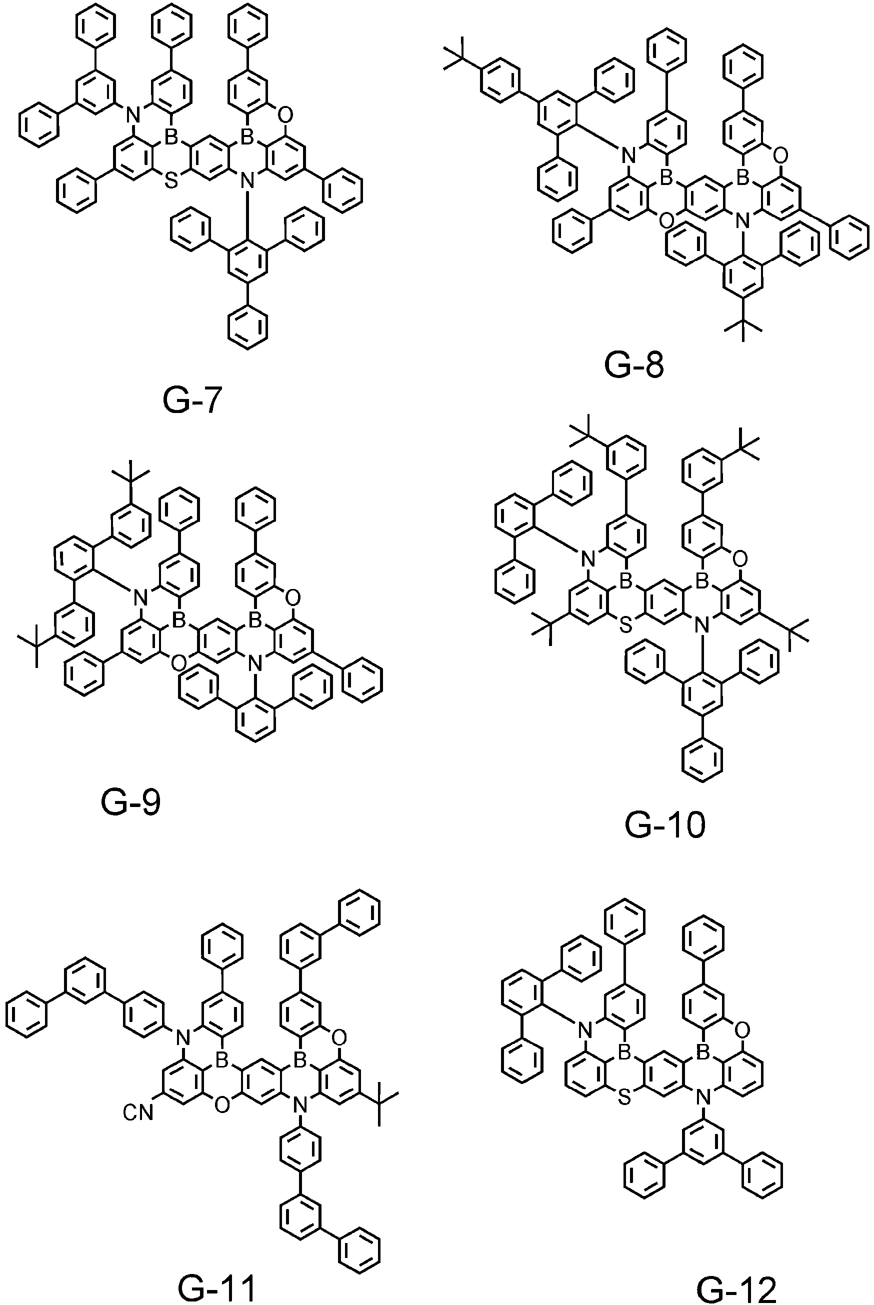

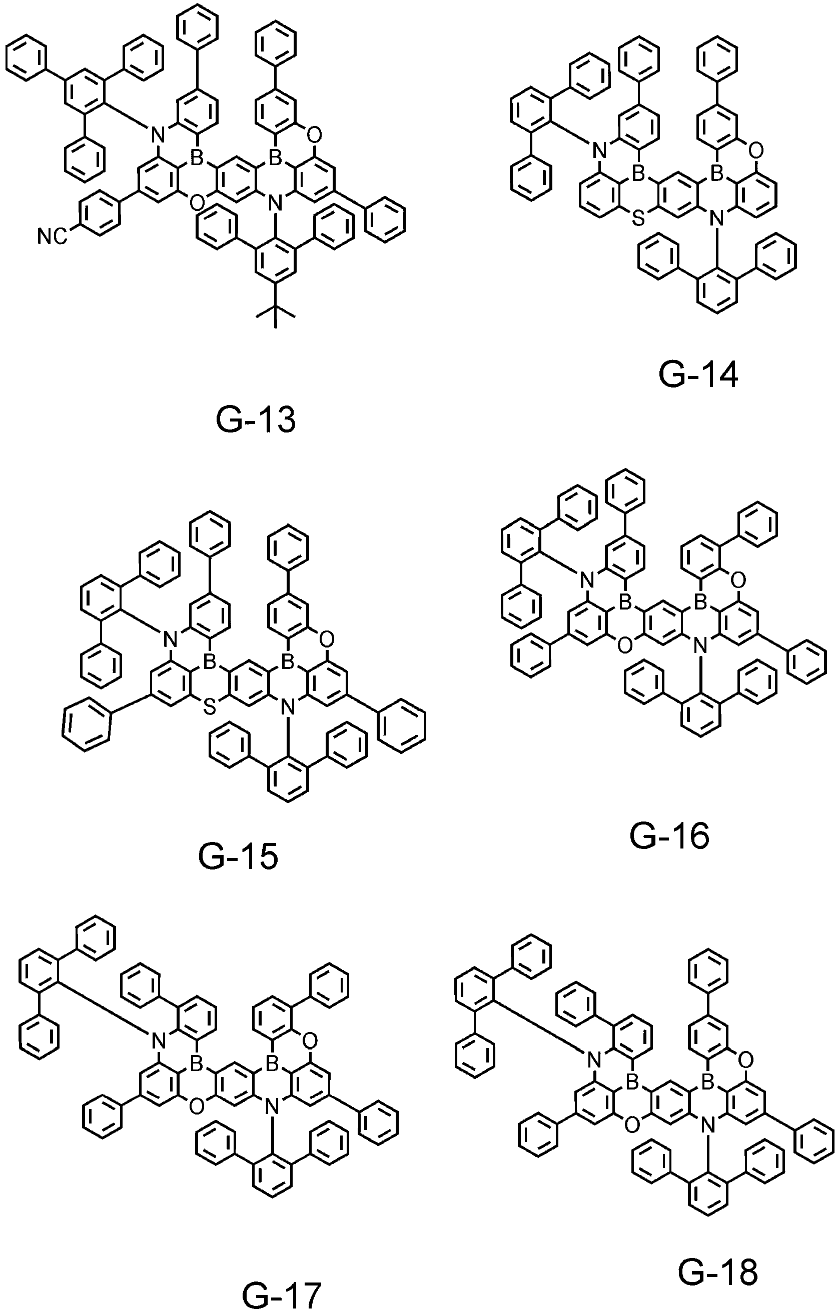

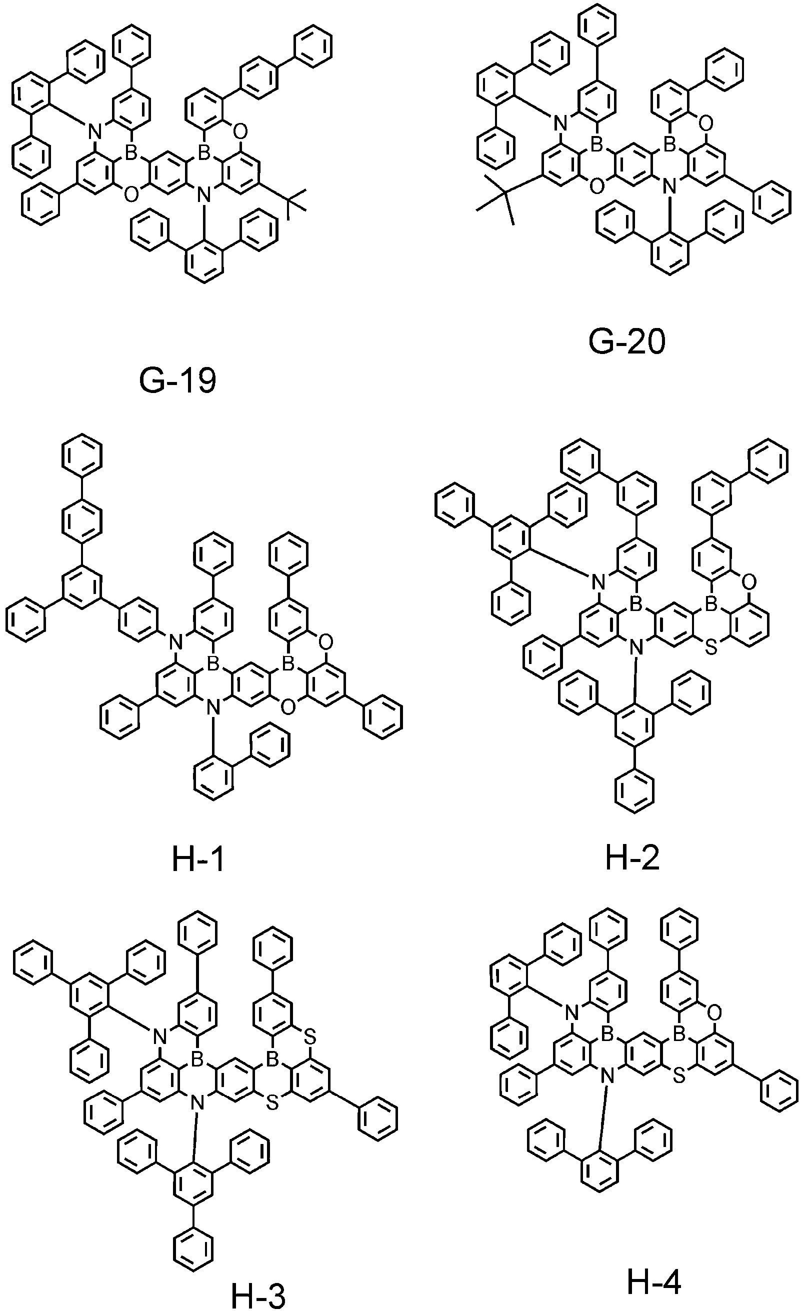

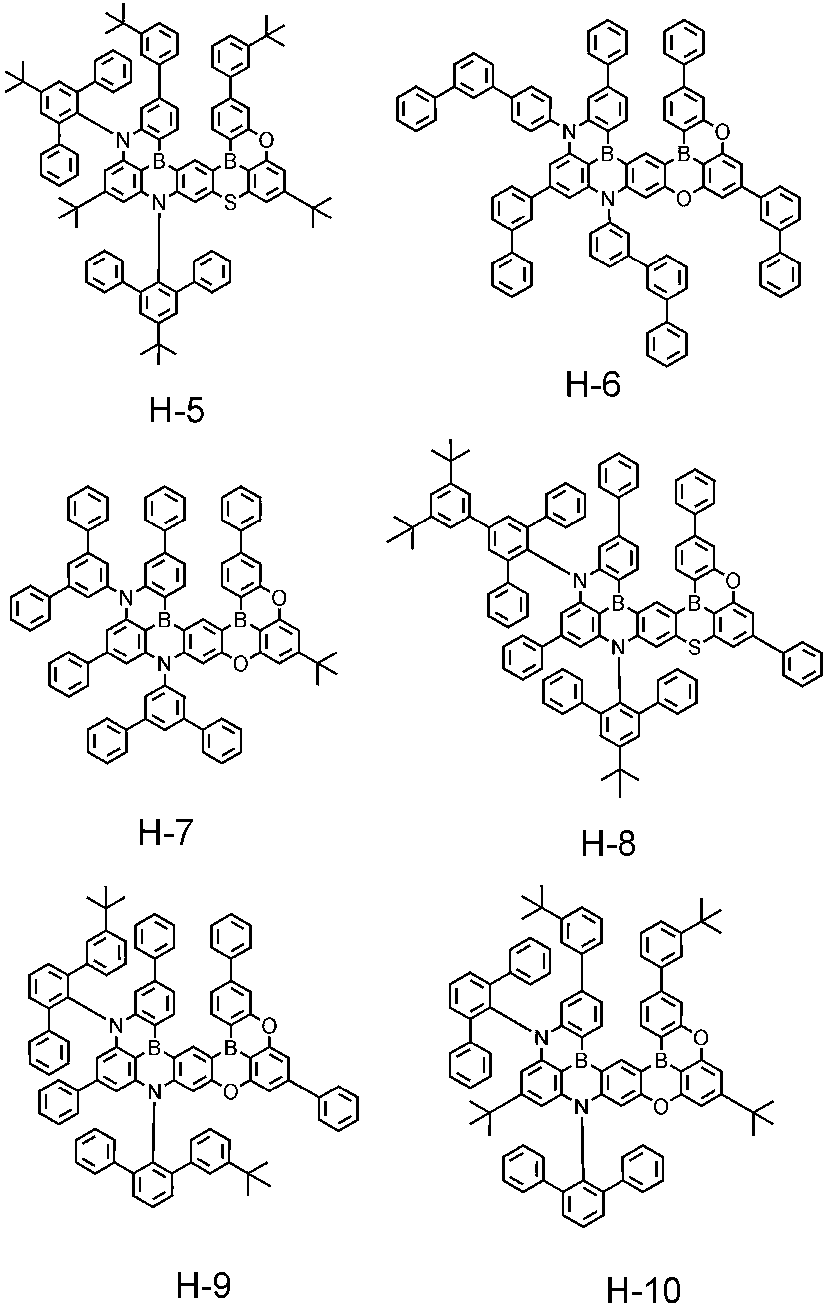

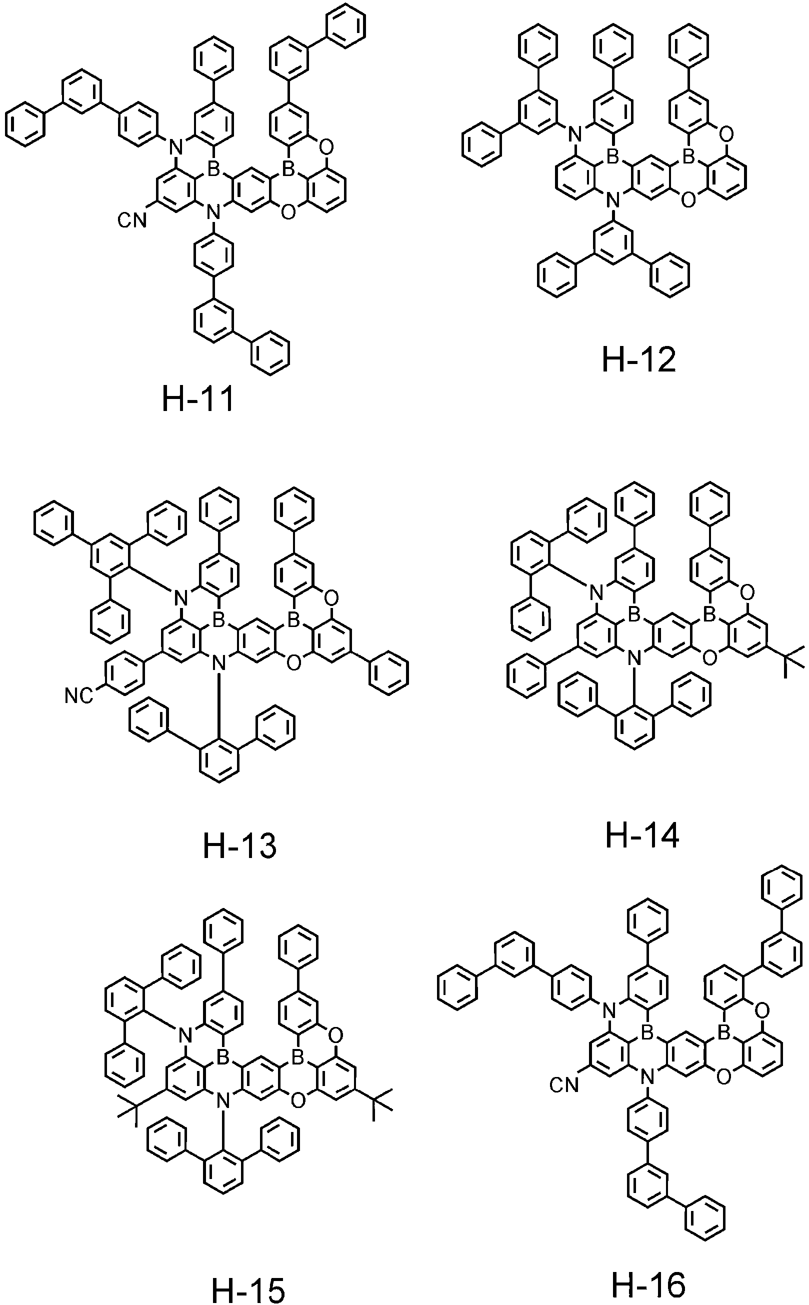

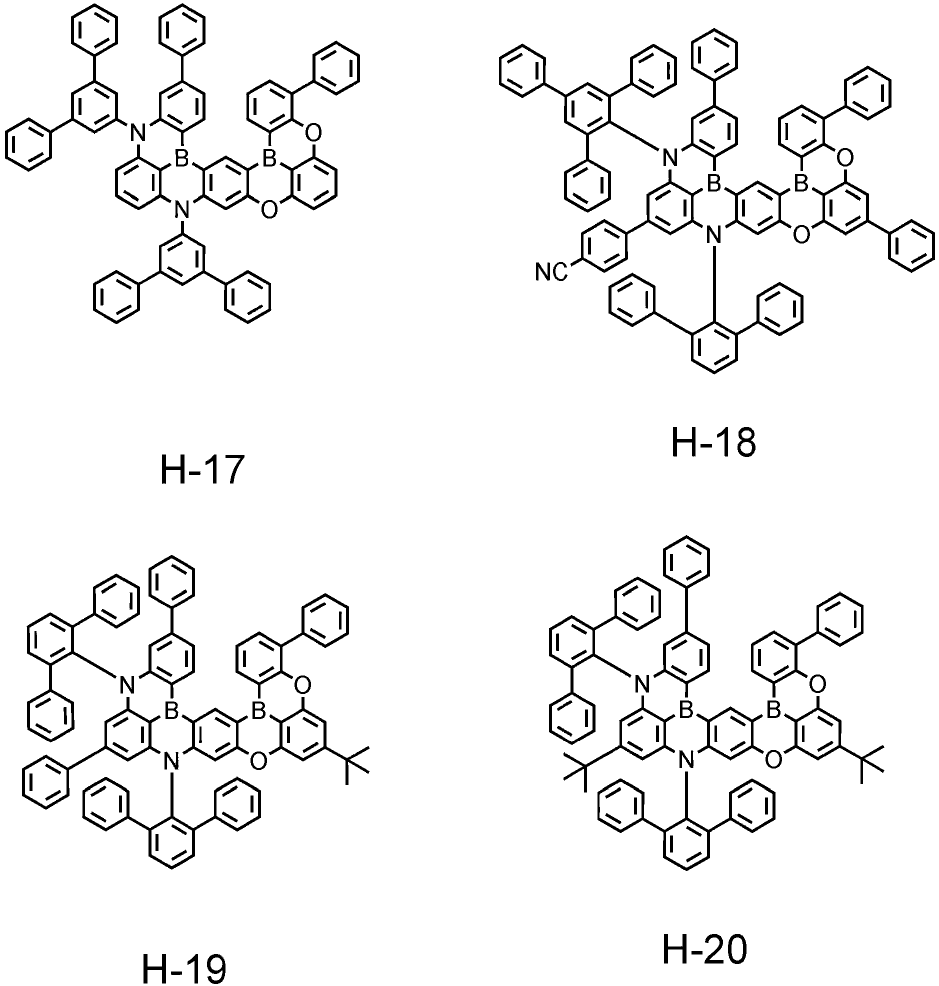

The light emitting element ED including the fused polycyclic compound represented by Formula 1 according to one or more embodiments may have a central emission wavelength in a wavelength range of about 440 nm to about 490 nm. The central emission wavelength may indicate a wavelength at a point of which maximum emission intensity in an emission spectrum. The light emitting element ED including the fused polycyclic compound represented by Formula 1 according to one or more embodiments may emit a blue light. The third light emitting element ED-3 (FIG. 2) emitting a blue light may include the fused polycyclic compound represented by Formula 1 according to one or more embodiments.

The emission layer EML may include the fused polycyclic compound represented by Formula 1 according to one or more embodiments as a dopant. The fused polycyclic compound represented by Formula 1 according to one or more embodiments may be a delayed fluorescence material. The fused polycyclic compound represented by Formula 1 according to one or more embodiments may be a material of thermally activated delayed fluorescence (TADF). The fused polycyclic compound represented by Formula 1 according to one or more embodiments may emit light through a reverse intersystem crossing (RISC) mechanism, which converts triplet excitons into singlet excitons.

Typical compounds including one or two phenyl groups in a benzene ring bonded to a nitrogen atom exhibited active intermolecular interactions, which caused a reduction in element lifespan. In addition, typical compounds having no phenyl group on a benzene ring bonded to a boron atom exhibited high electron density, which caused a reduction in element stability. In addition, typical compounds including a heterocycle such as carbazole exhibited reduced heat resistance.

A compound that includes a fused ring of nine rings containing a boron atom and an oxygen atom (or a sulfur atom) as ring-forming atoms, and is such that at least one of the above-described R₁ to R₄ and at least one of the above-described R₁₀ to R₁₃ are each not represented by Formula 3, has an increased electron density of the benzene ring adjacent to the oxygen atom (or sulfur atom), allowing the benzene ring to become a hole trap site. Accordingly, the compound causes a reduction in the stability of a light emitting element. In addition, compounds including a fused ring of nine rings containing two boron atoms as ring-forming atoms and not containing substituents according to one or more embodiments undergo decomposition when deposited for forming a light emitting element, and are required to suppress intermolecular aggregation.

Conversely, the fused polycyclic compound represented by Formula 1 according to one or more embodiments may introduce at least four phenyl groups onto benzene rings bonded to at least two nitrogen atoms of a core structure, and the benzene rings bonded to two boron atoms may each independently introduce phenyl groups at a para position or a position immediately adjacent to the para position, resulting in improved heat resistance. In one or more embodiments, the fused polycyclic compound represented by Formula 1 introduces a phenyl group represented by Formula 3, and may thus have improved material stability, and may be adjusted to emit light at a wavelength suitable for use in the display module DM (FIG. 1). In addition, the fused polycyclic compound represented by Formula 1 according to one or more embodiments including such a chemical structure may contribute to improved sublimation properties, long lifespan, and high element stability of a light emitting element.

In one or more embodiments, the fused polycyclic compound represented by Formula 1 includes, as a core structure, a fused ring of nine rings containing two boron atoms, at least two nitrogen atoms, and at least one oxygen or sulfur atom as ring-forming atoms, and may thus induce reduced molecular weight and improved reverse intersystem crossing rate. The fused polycyclic compound represented by Formula 1 according to one or more embodiments may exhibit improved sublimation properties during compound synthesis.

The fused polycyclic compound represented by Formula 1 according to one or more embodiments may include at least two nitrogen atoms as ring-forming atoms in the core structure. The benzene rings bonded to at least two nitrogen atoms may include at least four phenyl groups as substituents. The benzene rings and phenyl groups bonded thereto may form a sterically bulky substituent. In one or more embodiments, the fused polycyclic compound represented by Formula 1 introduces a sterically bulky substituent, and may thus prevent intermolecular interaction, thereby suppressing intermolecular aggregation, and the light emitting element ED including the fused polycyclic compound represented by Formula 1 according to one or more embodiments may exhibit characteristics such as high photoluminescence quantum yield, narrow full width of half maximum, and resistance to easy degradation of element lifespan.

The fused polycyclic compound represented by Formula 1 according to one or more embodiments includes two boron atoms as ring-forming atoms in the core structure. The benzene rings bonded to two boron atoms may each independently include phenyl groups bonded to the boron atoms at a para position or a position immediately adjacent to the para position. Accordingly, the fused polycyclic compound represented by Formula 1 according to one or more embodiments may be resonance-stabilized by having HOMO/LOMO orbitals extended throughout molecules, and the light emitting element ED including the fused polycyclic compound represented by Formula 1 according to one or more embodiments may exhibit characteristics of high element stability and suppressed material degradation.

The fused polycyclic compound represented by Formula 1 according to one or more embodiments may not include a heterocycle such as a carbazole. Accordingly, the light emitting element ED including the fused polycyclic compound represented by Formula 1 according to one or more embodiments may exhibit improved heat resistance.

In one or more embodiments, the emission layer EML includes the fused polycyclic compound represented by Formula 1 according to one or more embodiments, and may further include at least one of the second to fourth compounds. In one or more embodiments, the emission layer EML may include a second compound represented by Formula HT-1. For example, the second compound may be used as a hole transporting host material of the emission layer EML.

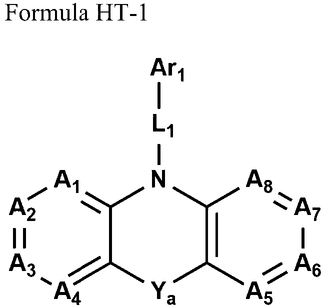

In Formula HT-1, A₁ to A₈ may each independently be N or CR₅₁. For example, A₁ to A₈ may all be CR₅₁. Alternatively, any one of A₁ to A₈ may be N, and the others may be CR₅₁.

In Formula HT-1, L₁ may be a direct linkage, a substituted or unsubstituted arylene group having 6 to 30 ring-forming carbon atoms, or a substituted or unsubstituted heteroarylene group having 2 to 30 ring-forming carbon atoms. For example, L₁ may be a direct linkage, a substituted or unsubstituted phenylene group, a substituted or unsubstituted divalent biphenyl group, a substituted or unsubstituted divalent carbazole group, or the like, but embodiments are not limited thereto.

In Formula HT-1, Yₐ may be a direct linkage, CR₅₂R₅₃, or SiR₅₄R₅₅. That is, two benzene rings connected to nitrogen atoms of Formula HT-1 may be connected through a direct linkage, 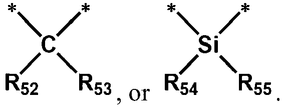 In Formula HT-1, when Yₐ is a direct linkage, the second compound represented by Formula HT-1 may include a carbazole moiety.

In Formula HT-1, Ar₁ is a substituted or unsubstituted aryl group having 6 to 30 ring-forming carbon atoms, or a substituted or unsubstituted heteroaryl group having 2 to 30 ring-forming carbon atoms. For example, Ar₁ may be a substituted or unsubstituted carbazole group, a substituted or unsubstituted dibenzofuran group, a substituted or unsubstituted dibenzothiophene group, or a substituted or unsubstituted biphenyl group, but embodiments are not limited thereto.

In Formula HT-1, R₅₁ to R₅₅ may each independently be a hydrogen atom, a deuterium atom, a halogen atom, a cyano group, a substituted or unsubstituted silyl group, a substituted or unsubstituted thio group, a substituted or unsubstituted oxy group, a substituted or unsubstituted amine group, a substituted or unsubstituted boron group, a substituted or unsubstituted alkyl group having 1 to 20 carbon atoms, a substituted or unsubstituted alkenyl group having 2 to 20 ring-forming carbon atoms, a substituted or unsubstituted aryl group having 6 to 60 ring-forming carbon atoms, or a substituted or unsubstituted heteroaryl group having 2 to 60 ring-forming carbon atoms. Alternatively, R₅₁ to R₅₅ may each be bonded to an adjacent group to form a ring. For example, R₅₁ to R₅₅ may each independently be a hydrogen atom or a deuterium atom. In one or more embodiments, R₅₁ to R₅₅ may each independently be an unsubstituted methyl group or an unsubstituted phenyl group.

In one or more embodiments, the second compound represented by Formula HT-1 may be represented by one of the compounds shown in Compound Group 2. The emission layer EML may include at least one of the compounds shown in Compound Group 2, as an electron transporting host material.

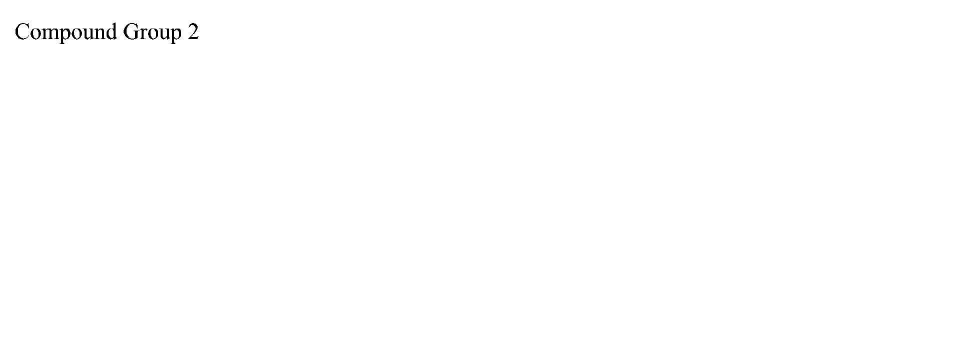

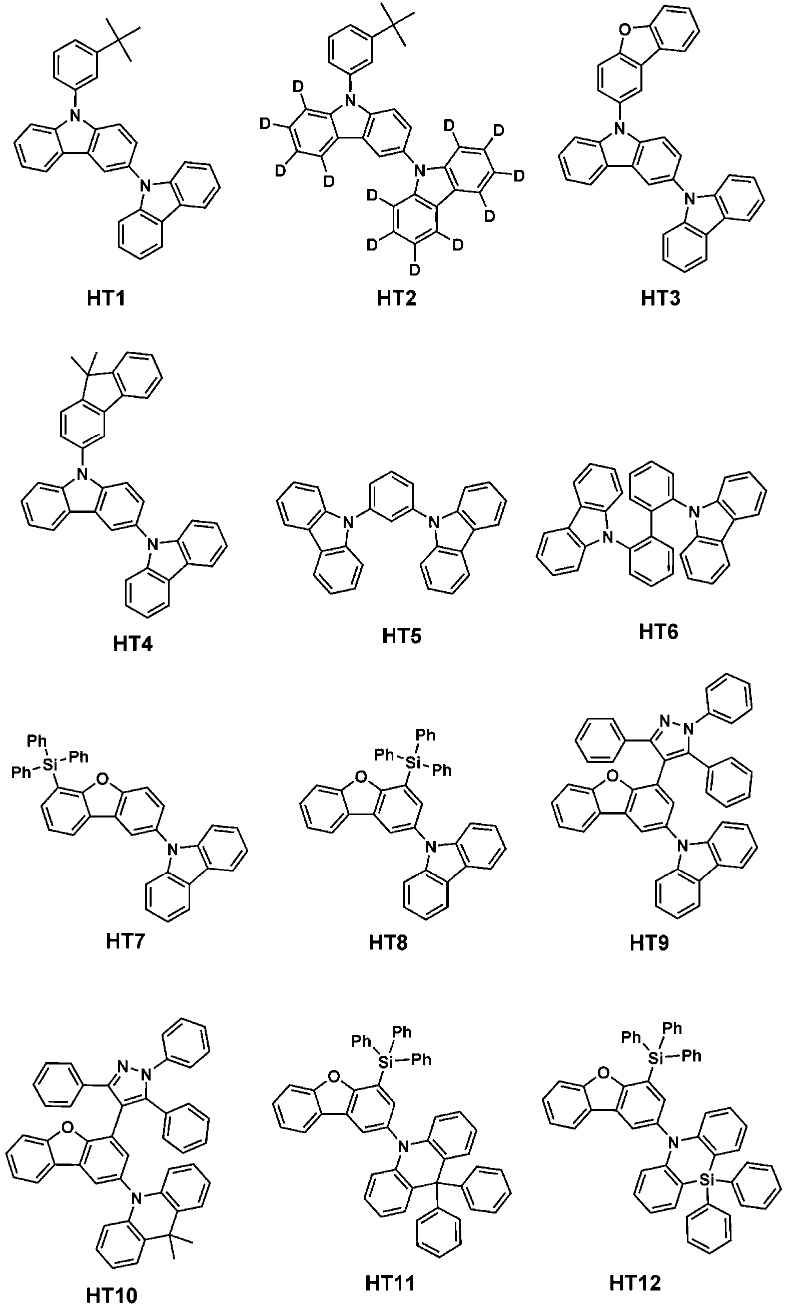

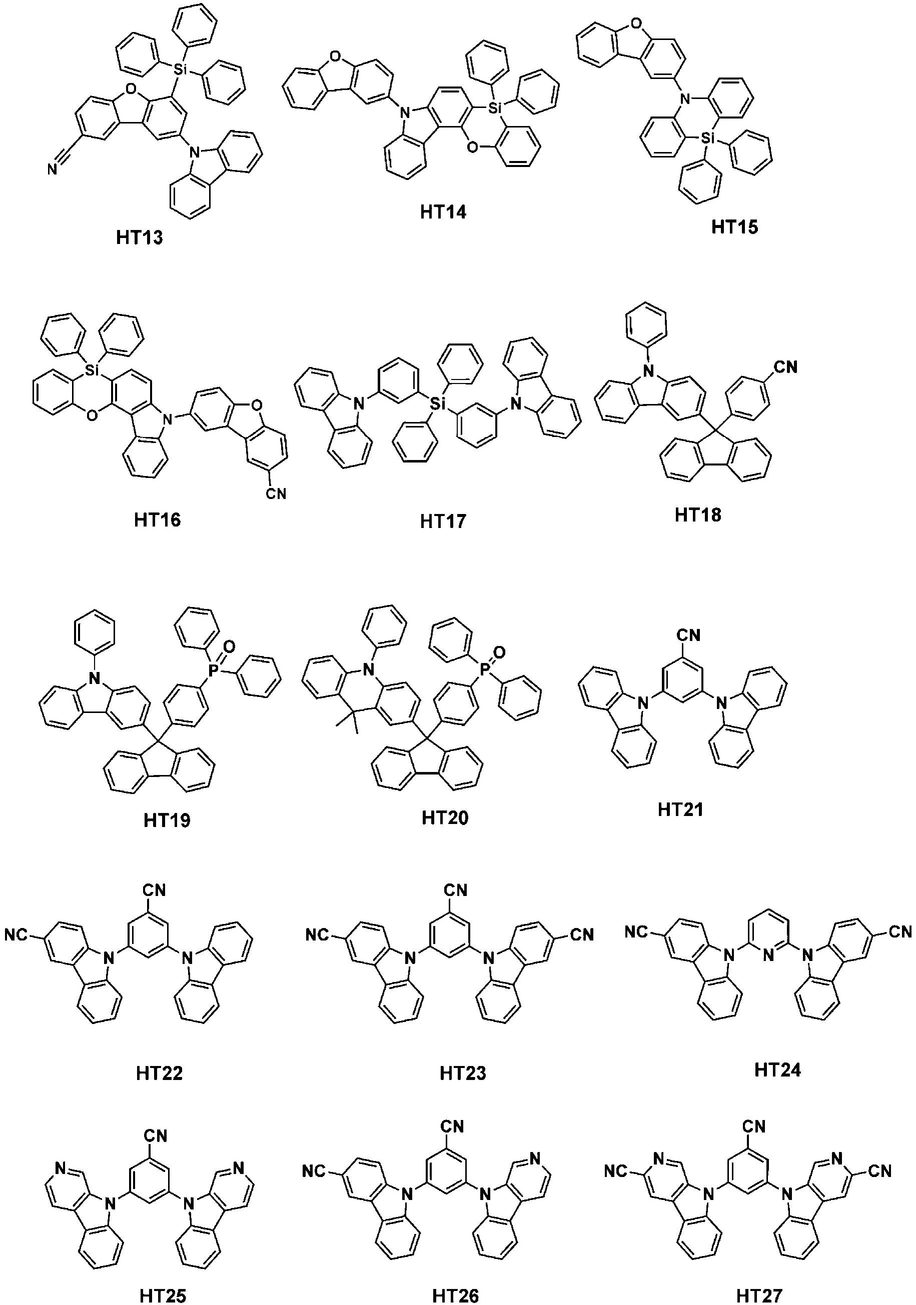

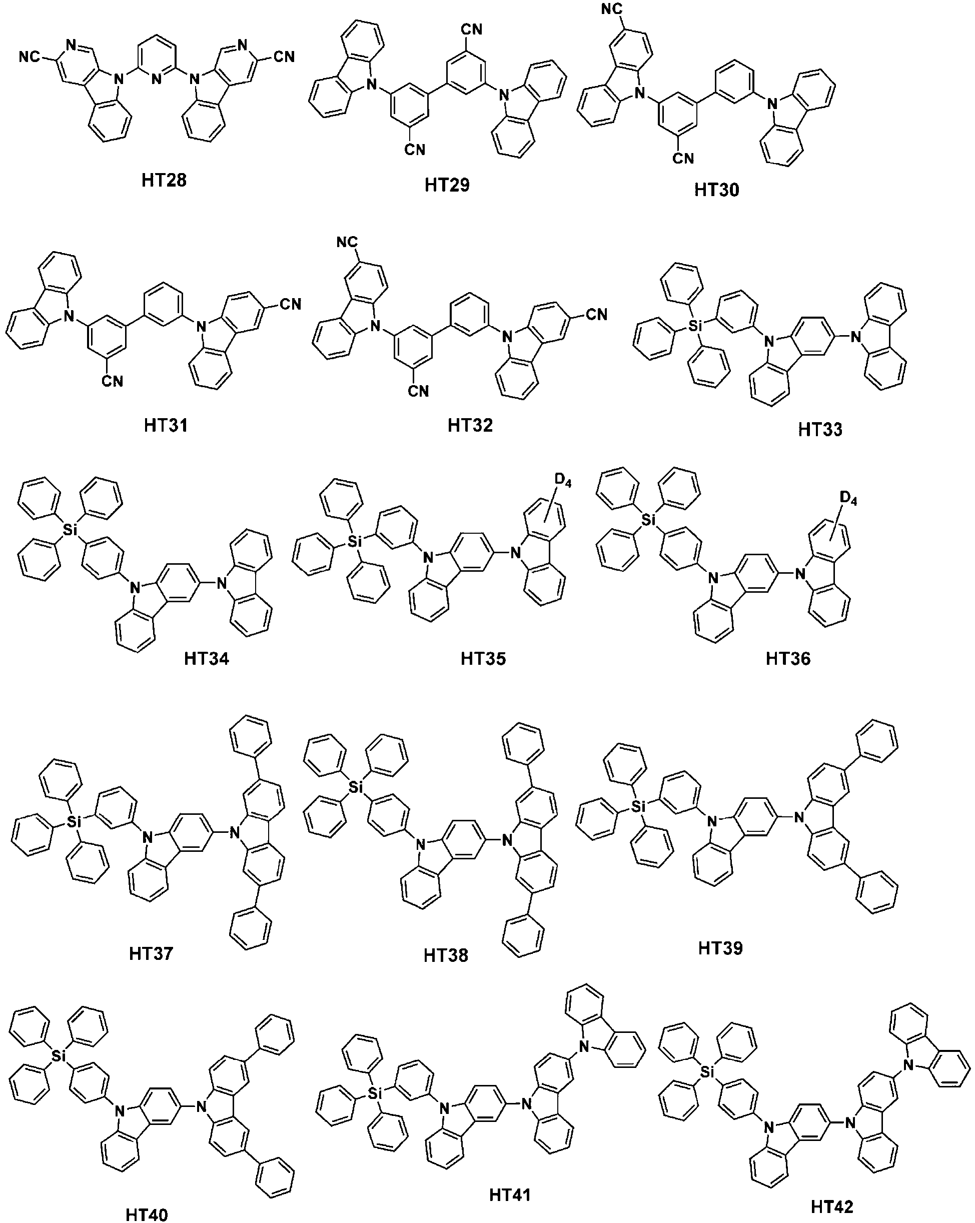

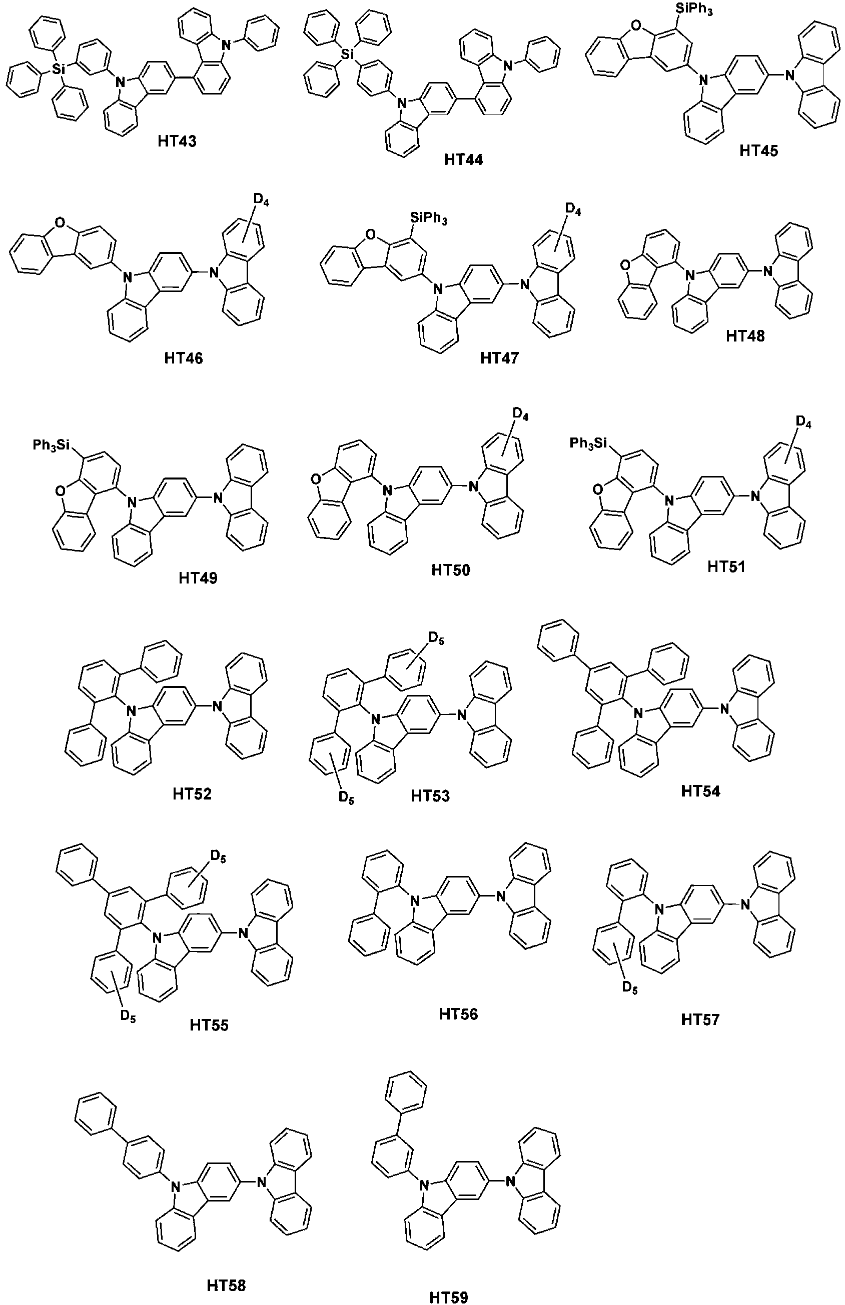

In the specific example compounds presented in Compound Group 2, "D" may indicate a deuterium atom, and "Ph" may indicate a substituted or unsubstituted phenyl group. For example, in the specific example compounds presented in Compound Group 2, "Ph" may be an unsubstituted phenyl group.

In one or more embodiments, the emission layer EML may include a third compound represented by Formula ET-1. For example, the third compound may be used as an electron transporting host material of the emission layer EML.

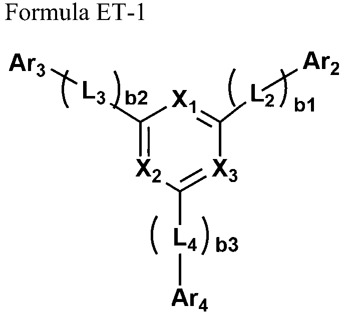

In Formula ET-1, at least one of X₁ to X₃ may be N and the others may be CR₅₆. For example, any one of X₁ to X₃ may be N, and the other two may each independently be CR₅₆. In this case, the third compound represented by Formula ET-1 may include a pyridine moiety. Alternatively, two of X₁ to X₃ may be N and the other one may be CR₅₆. In this case, the third compound represented by Formula ET-1 may include a pyrimidine moiety. Alternatively, X₁ to X₃ may all be N. In this case, the third compound represented by Formula ET-1 may include a triazine moiety.

In Formula ET-1, R₅₆ may be a hydrogen atom, a deuterium atom, a substituted or unsubstituted alkyl group having 1 to 20 carbon atoms, a substituted or unsubstituted aryl group having 6 to 60 ring-forming carbon atoms, or a substituted or unsubstituted heteroaryl group having 2 to 60 ring-forming carbon atoms.

In Formula ET-1, b1 to b3 may each independently be an integer of 0 to 10.

In Formula ET-1, Ar₂ to Ar₄ may each independently be a hydrogen atom, a deuterium atom, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms. For example, Ar₂ to Ar₄ may be a substituted or unsubstituted phenyl group or a substituted or unsubstituted carbazole group.

In Formula ET-1, L₂ to L₄ may each independently be a direct linkage, a substituted or unsubstituted arylene group having 6 to 30 ring-forming carbon atoms, or a substituted or unsubstituted heteroarylene group having 2 to 30 ring-forming carbon atoms. When b1 to b3 are an integer of 2 or greater, L₂ to L₄ may each independently be a substituted or unsubstituted arylene group having 6 to 30 ring-forming carbon atoms, or a substituted or unsubstituted heteroarylene group having 2 to 30 ring-forming carbon atoms.

In one or more embodiments, the third compound may be represented by one of the compounds from Compound Group 3. The light emitting element ED according to one or more embodiments may include one of the compounds from Compound Group 3.

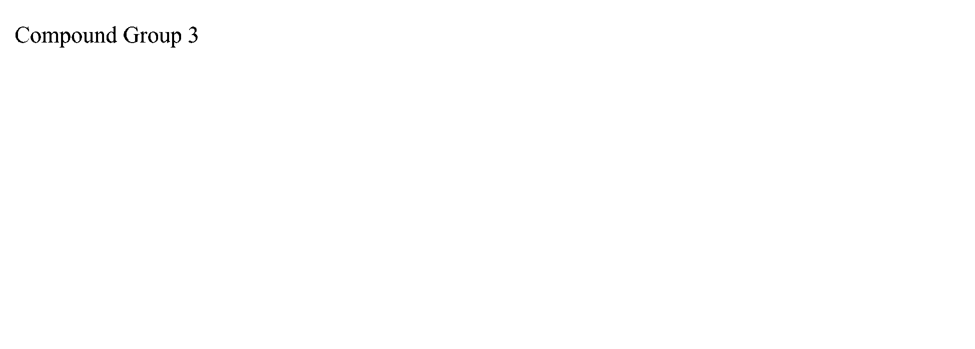

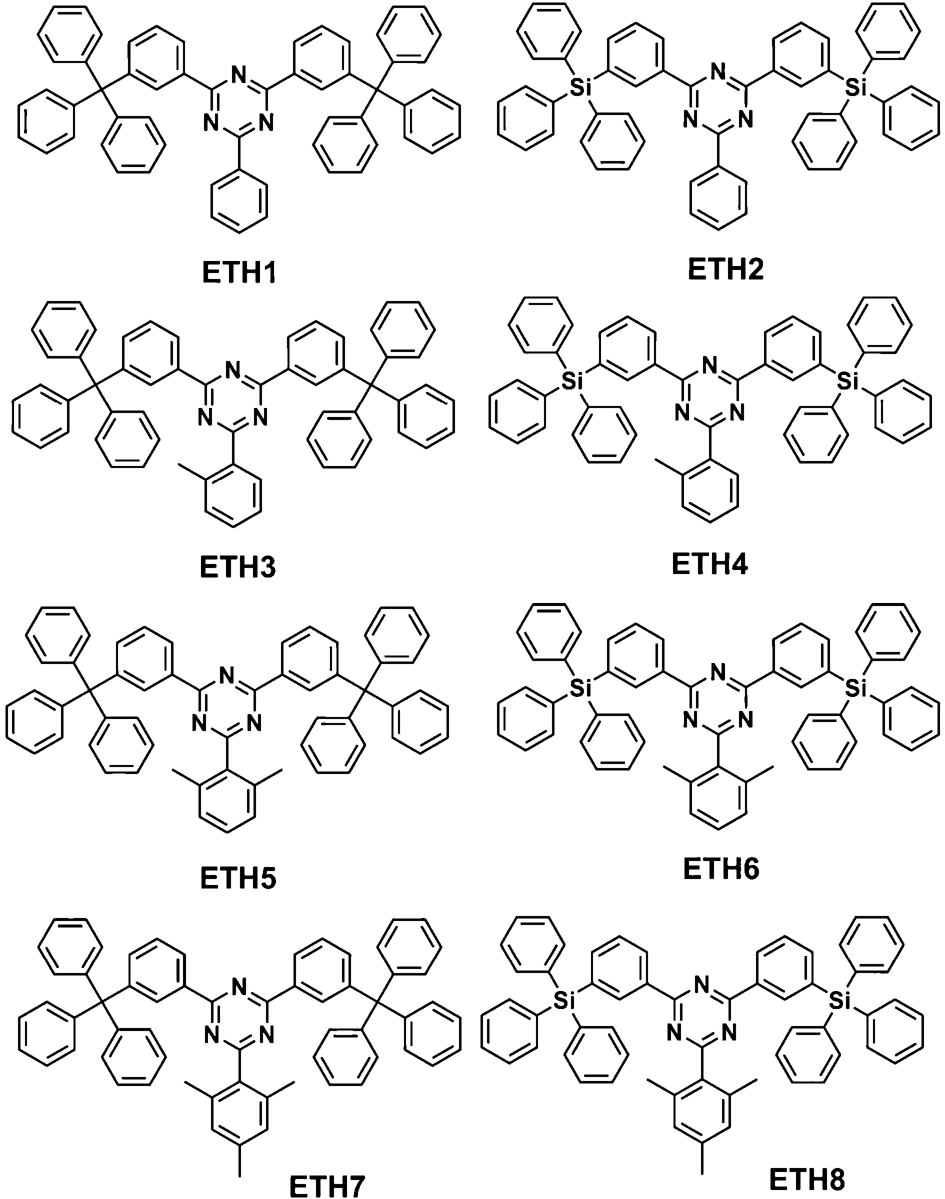

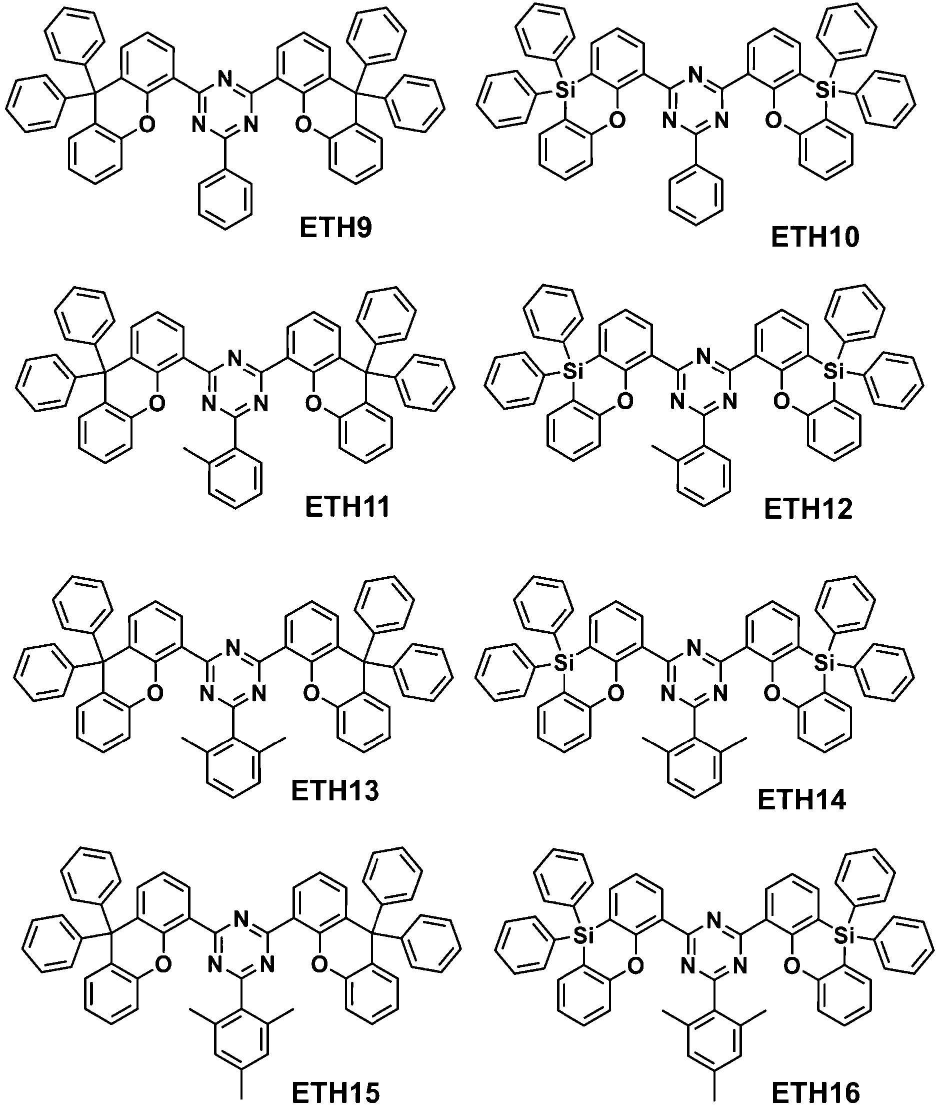

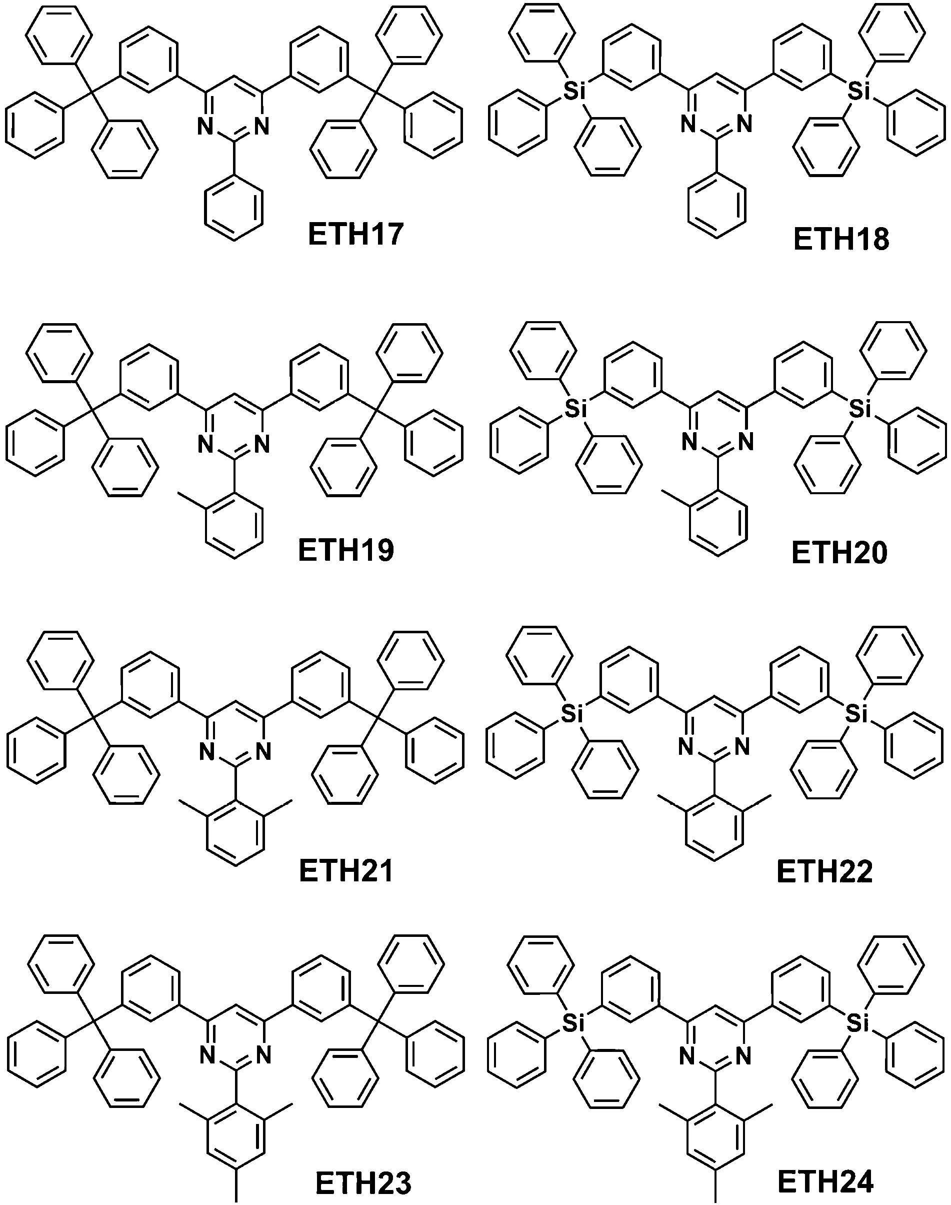

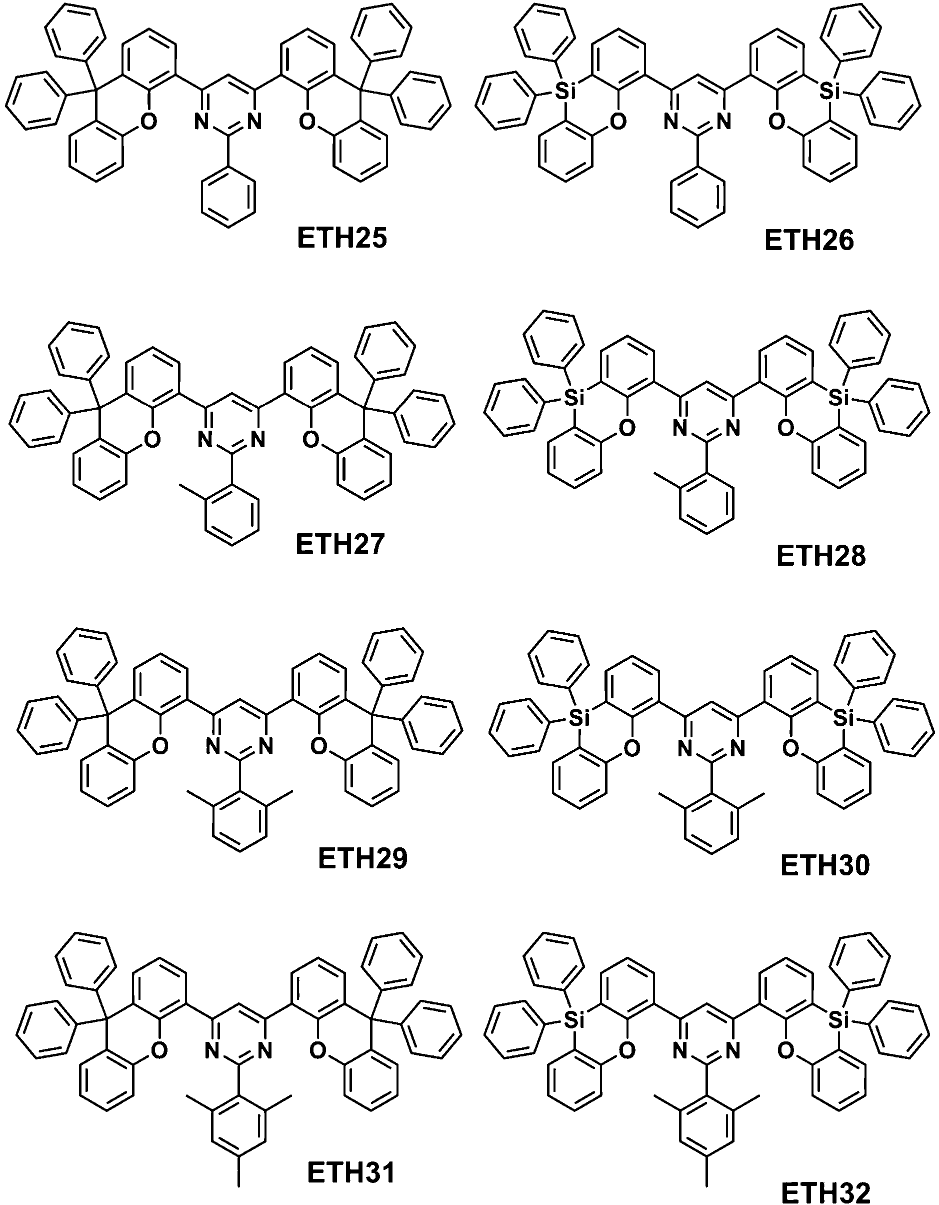

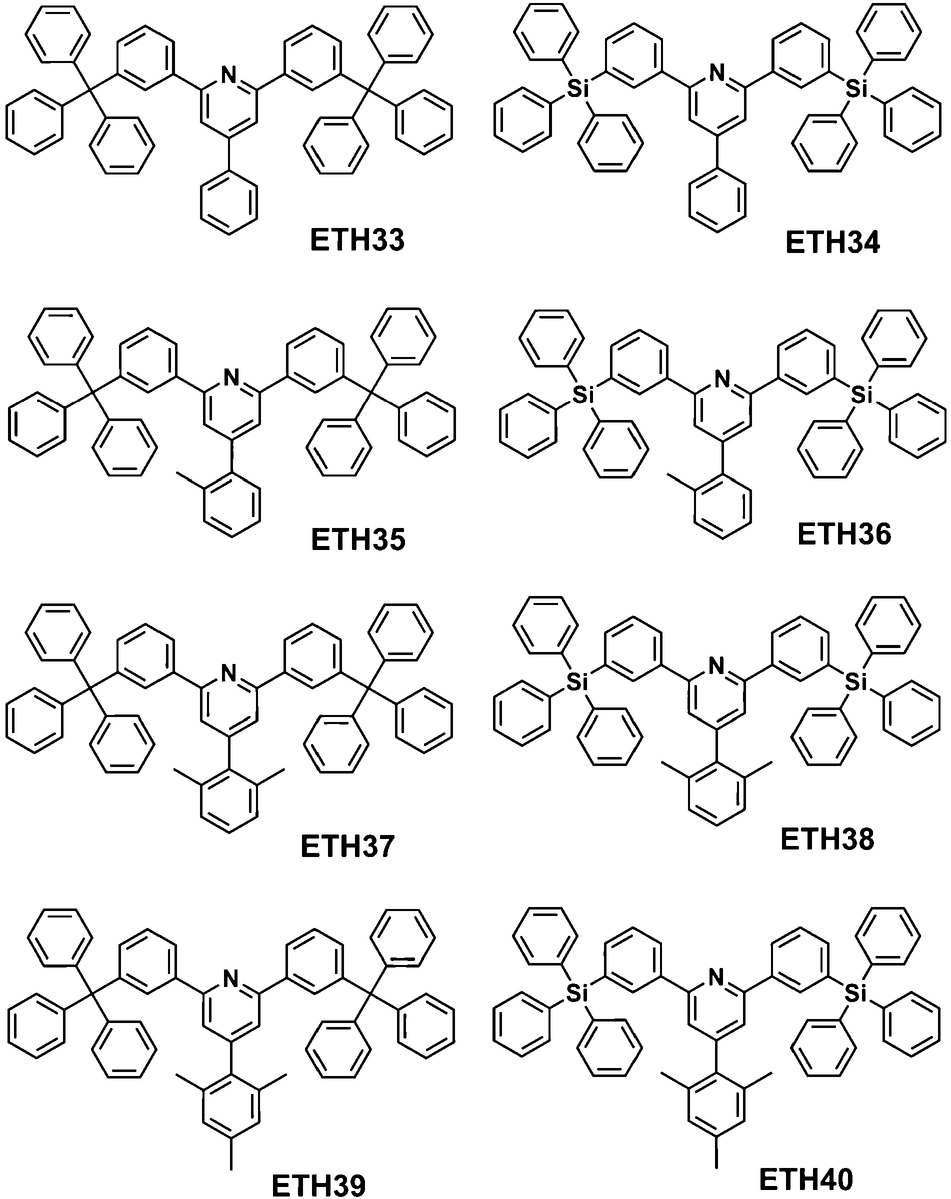

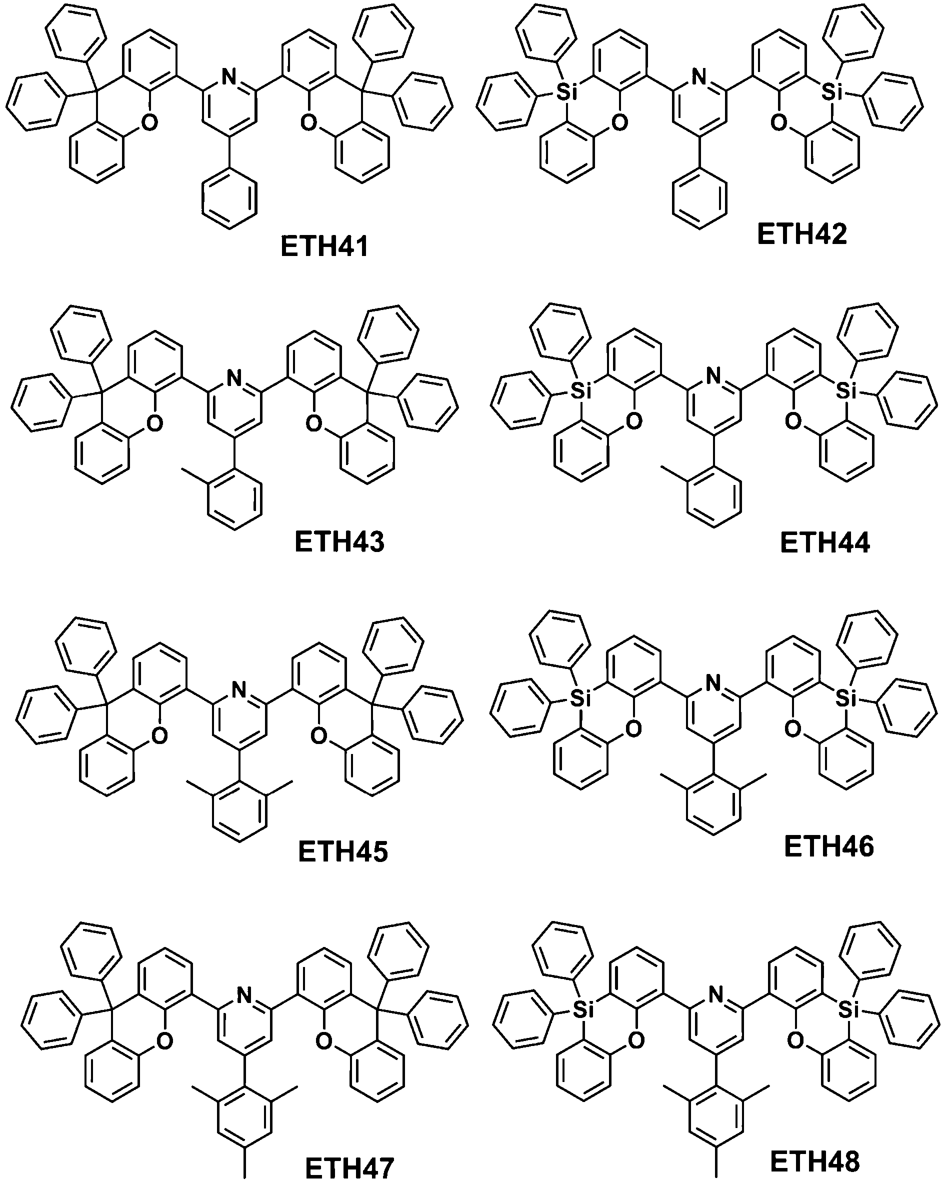

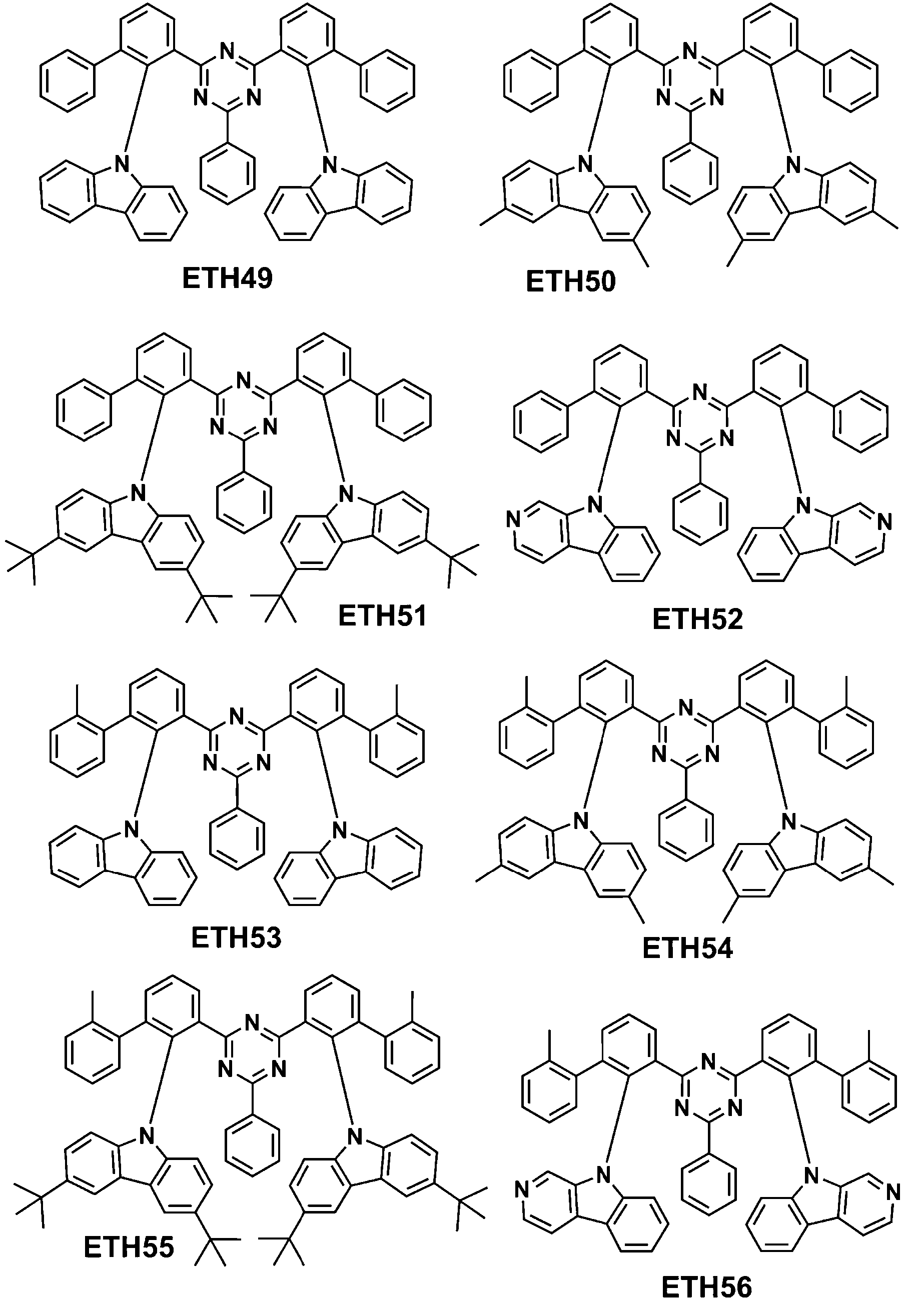

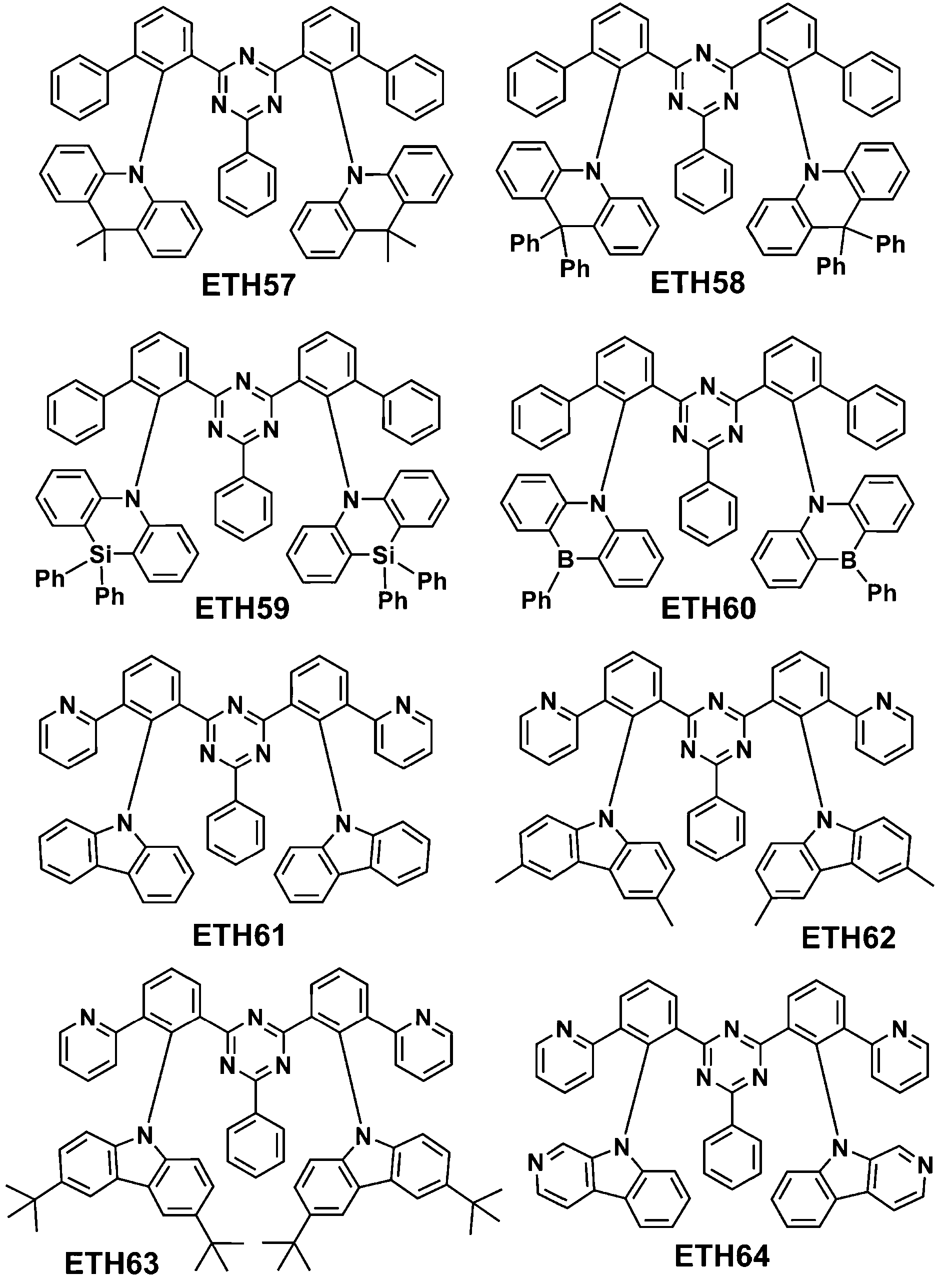

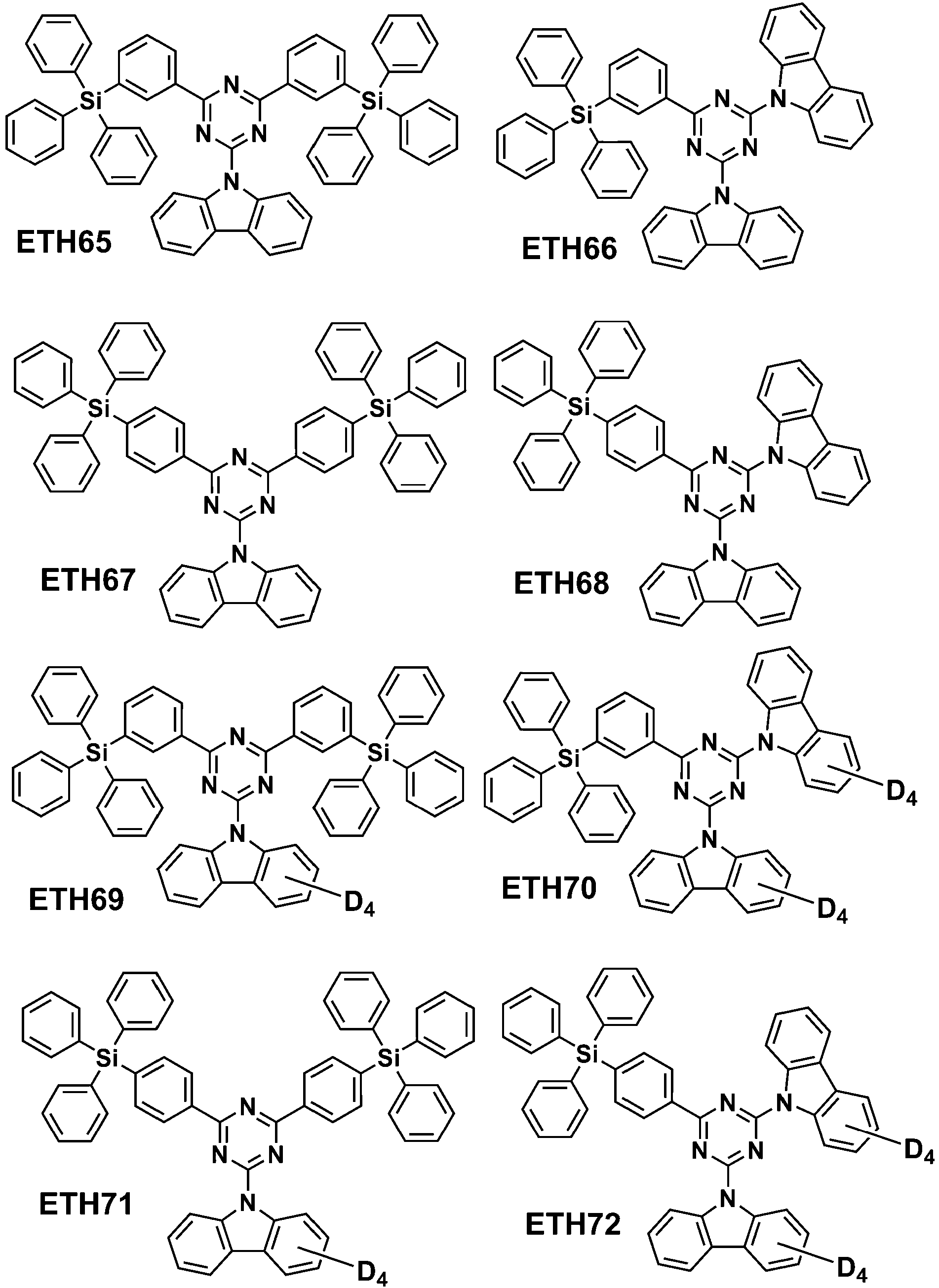

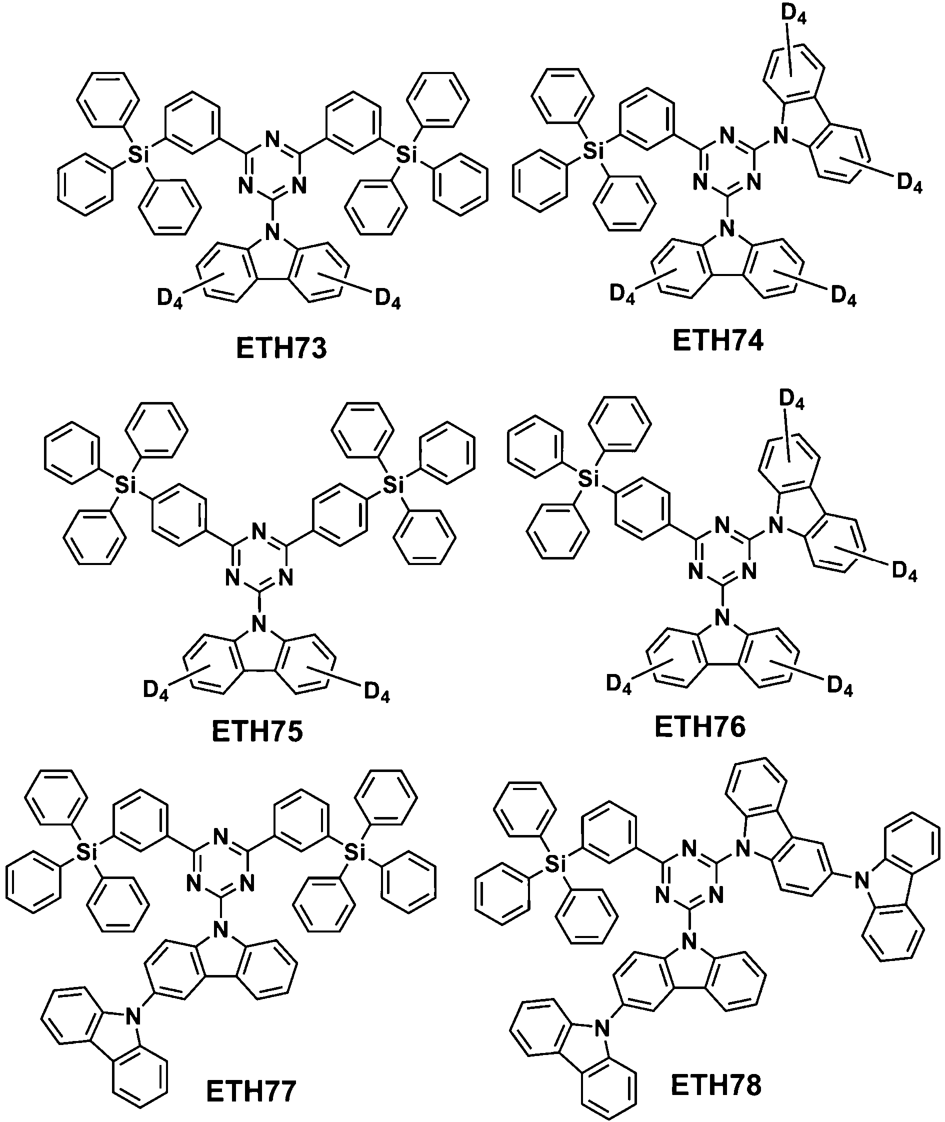

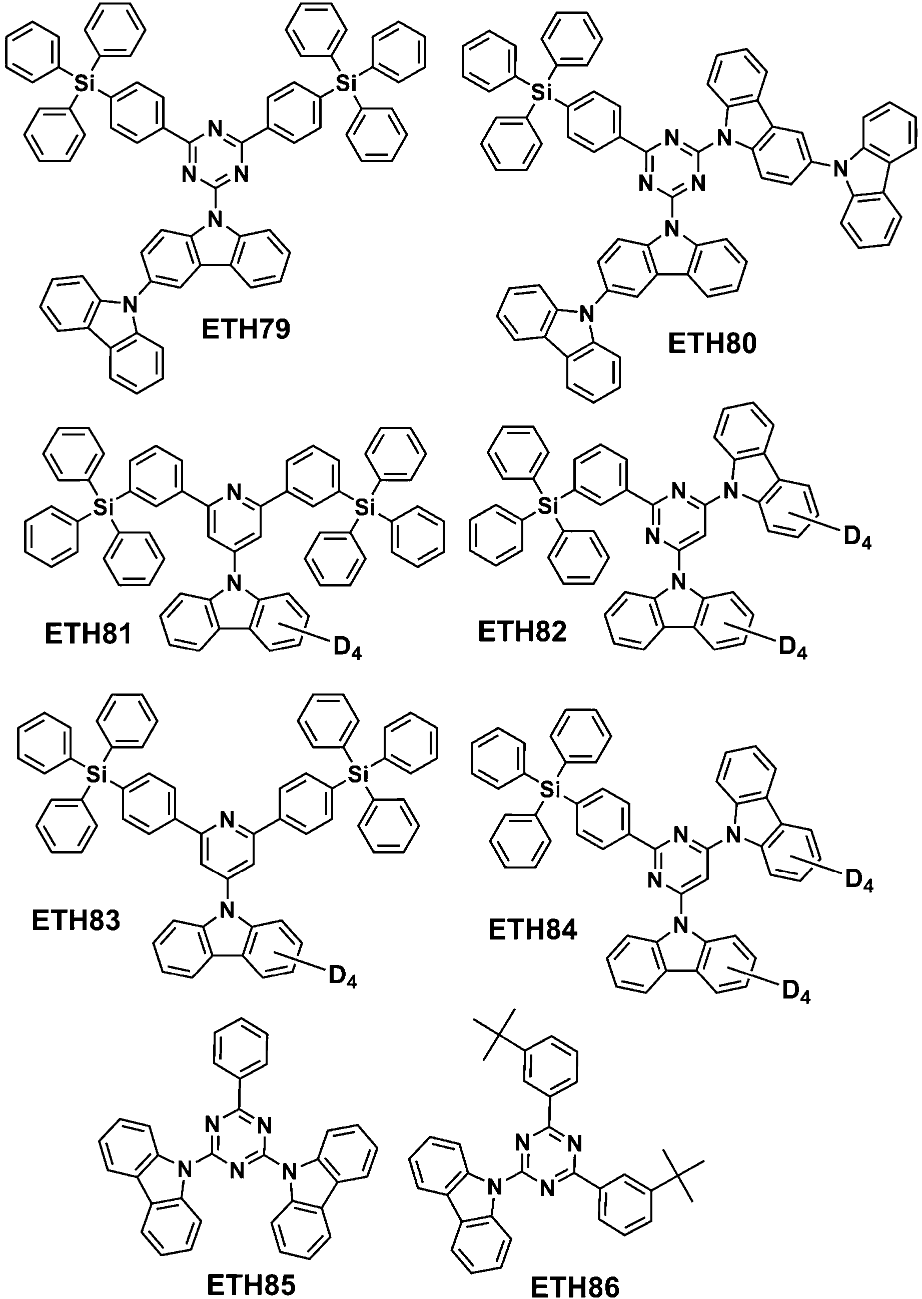

In the specific example compounds presented in Compound Group 3, "D" indicates a deuterium atom, and "Ph" indicates an unsubstituted phenyl group.

The emission layer EML may include a second compound and a third compound, and the second compound and the third compound may form an exciplex. In the emission layer EML, the hole transporting host and the electron transporting host may form an exciplex. In this case, the triplet energy of the exciplex formed by the hole transporting host and the electron transporting host corresponds to a difference between Lowest Unoccupied Molecular Orbital (LUMO) energy level of the electron transporting host and Highest Occupied Molecular Orbital (HOMO) energy level of the hole transporting host.

For example, the triplet energy level (T1) of the exciplex formed by the hole transporting host and the electron transporting host may have an absolute value of about 2.4 electron Volts (eV) to about 3.0 eV. In addition, the triplet energy of the exciplex may have a value smaller than the energy gap of each host material. The exciplex may have a triplet energy of about 3.0 eV or less, which is an energy gap between the hole transporting host and the electron transporting host.

In one or more embodiments, the emission layer EML may include a fourth compound in addition to the first to third compounds described herein. The fourth compound may be used as a phosphorescent sensitizer of the emission layer EML. Energy may be transferred from the fourth compound to the first compound to emit light.

For example, the emission layer EML may include, as the fourth compound, an organometallic complex containing platinum (Pt) as a central metal atom and ligands bound to the central metal atom. In the light emitting element ED according to one or more embodiments, the emission layer EML may include a compound represented by Formula D-1 as the fourth compound.

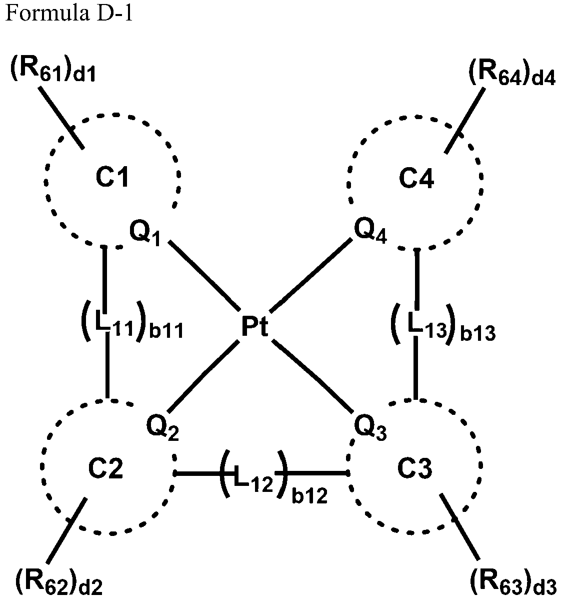

In Formula D-1, Q₁ to Q₄ may each independently be C or N.

In Formula D-1, ring C1 to ring C4 may each independently be a substituted or unsubstituted aliphatic hydrocarbon ring having 5 to 30 ring-forming carbon atoms, a substituted or unsubstituted aryl group having 6 to 30 ring-forming carbon atoms, or a substituted or unsubstituted heterocycle having 2 to 30 ring-forming carbon atoms.

In Formula D-1, L₁₁ to L₁₃ may each independently be a direct linkage, 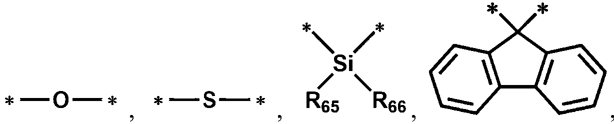 a substituted or unsubstituted divalent alkyl group having 1 to 20 carbon atoms, a substituted or unsubstituted arylene group having 6 to 30 ring-forming carbon atoms, or a substituted or unsubstituted heteroarylene group having 2 to 30 ring-forming carbon atoms. In L₁₁ to L₁₃, "-*" indicates sites connected to ring C1 to ring C4.

In Formula D-1, b11 to b13 may each independently be 0 or 1. When b11 is 0, ring C1 and ring C2 may not be connected. When b12 is 0, ring C2 and ring C3 may not be connected. When b13 is 0, ring C3 and ring C4 may not be connected.

In Formula D-1, R₆₁ to R₆₆ may each independently be a hydrogen atom, a deuterium atom, a halogen atom, a cyano group, a substituted or unsubstituted silyl group, a substituted or unsubstituted thio group, a substituted or unsubstituted oxy group, a substituted or unsubstituted amine group, a substituted or unsubstituted boron group, a substituted or unsubstituted alkyl group having 1 to 20 carbon atoms, a substituted or unsubstituted alkenyl group having 2 to 20 ring-forming carbon atoms, a substituted or unsubstituted aryl group having 6 to 60 ring-forming carbon atoms, or a substituted or unsubstituted heteroaryl group having 2 to 60 ring-forming carbon atoms. Alternatively, R₆₁ to R₆₆ may each be bonded to an adjacent group to form a ring. In one or more embodiments, R₆₁ to R₆₆ may each independently be a substituted or unsubstituted methyl group, or a substituted or unsubstituted t-butyl group.

In Formula D-1, d1 to d4 may each independently be an integer of 0 to 4. In Formula D-1, when d1 to d4 are each 0, the fourth compound may not be substituted with R₆₁ to R₆₄. When d1 to d4 are each 4 and R₆₁ to R₆₄ are each a hydrogen atom, the case may be the same as when d1 to d4 are each 0. When d1 to d4 are each an integer of 2 or greater, R₆₁ to R₆₄ provided in plurality may each be the same, or at least one of the plurality of R₆₁ to R₆₄ may be different.

In Formula D-1, ring C1 to ring C4 may each independently be a substituted or unsubstituted hydrocarbon ring or a substituted or unsubstituted heterocycle, which is represented by any one of C-1 to C-4.

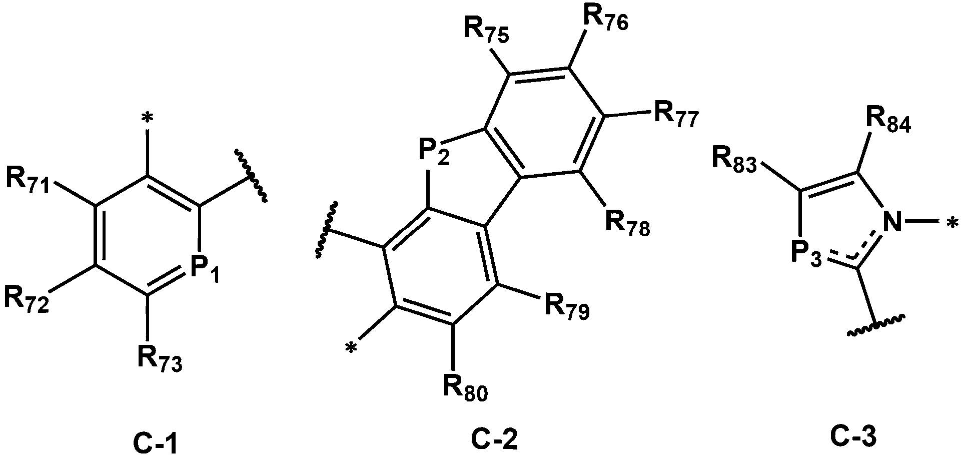

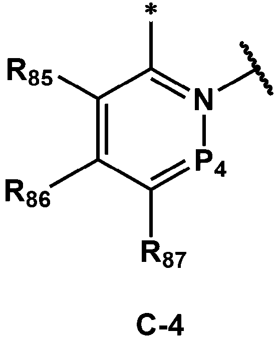

In C-1 to C-4, P₁- may be C-* or CR₇₄, P₂ may be N-* or NR₈₁, P₃ may be N-* or NR₈₂, and P₄ may be C-* or CR₈₈. R₇₁ to R₈₈ may each independently be a substituted or unsubstituted alkyl group having 1 to 20 carbon atoms, a substituted or unsubstituted aryl group having 6 to 30 ring-forming carbon atoms, a substituted or unsubstituted heteroaryl group having 2 to 30 ring-forming carbon atoms, or bonded to an adjacent group to form a ring.

In addition, in C-1 to C-4, 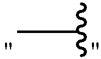 indicates a portion connected to the central metal atom, Pt, and 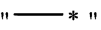 indicates a portion connected to neighboring ring groups (C1 to C4) or linkers (L₁₁ to L₁₃).

The emission layer EML according to one or more embodiments may include the first compound, which is a fused polycyclic compound represented by Formula 1, and at least one of the second to fourth compounds. For example, the emission layer EML may include the first compound, the second compound, and the third compound. In the emission layer EML, the second compound and the third compound form an exciplex, and energy may be transferred from the exciplex to the first compound to emit light.

In addition, the emission layer EML may include the first compound, the second compound, the third compound, and the fourth compound. In the emission layer EML, the second compound and the third compound form an exciplex, and energy may be transferred from the exciplex to the fourth compound and the first compound to emit light. In one or more embodiments, the fourth compound may be a sensitizer. In the light emitting element ED according to one or more embodiments, the fourth compound included in the emission layer EML may serve as a sensitizer to transfer energy from the host to the first compound, which is a light emitting dopant. That is, the fourth compound serving as an auxiliary dopant may accelerate the energy transfer to the first compound serving as the light emitting dopant, thereby increasing the light emitting ratio of the first compound. Accordingly, the emission layer EML according to one or more embodiments may have increased luminous efficiency. In addition, when the energy transfer to the first compound is increased, excitons formed in the emission layer EML do not accumulate in the emission layer EML and emit light quickly, resulting in less deterioration of an element. Accordingly, the light emitting element ED of one or more embodiments may have increased lifespan.

The light emitting element ED according to one or more embodiments may include each of a first compound, a second compound, a third compound, and a fourth compound, and the emission layer EML may thus include a combination of two host materials and two dopant materials. In the light emitting element ED according to one or more embodiments, the emission layer EML include the second compound and the third compound that are two different hosts, the first compound emitting delayed fluorescence, and the fourth compound containing an organometallic complex, and may thus exhibit excellent light emitting efficiency.

In one or more embodiments, the fourth compound represented by Formula D-1 may be represented by at least one of the compounds shown in Compound Group 4. The emission layer EML may include at least one of the compounds from Compound Group 4 as a sensitizer.

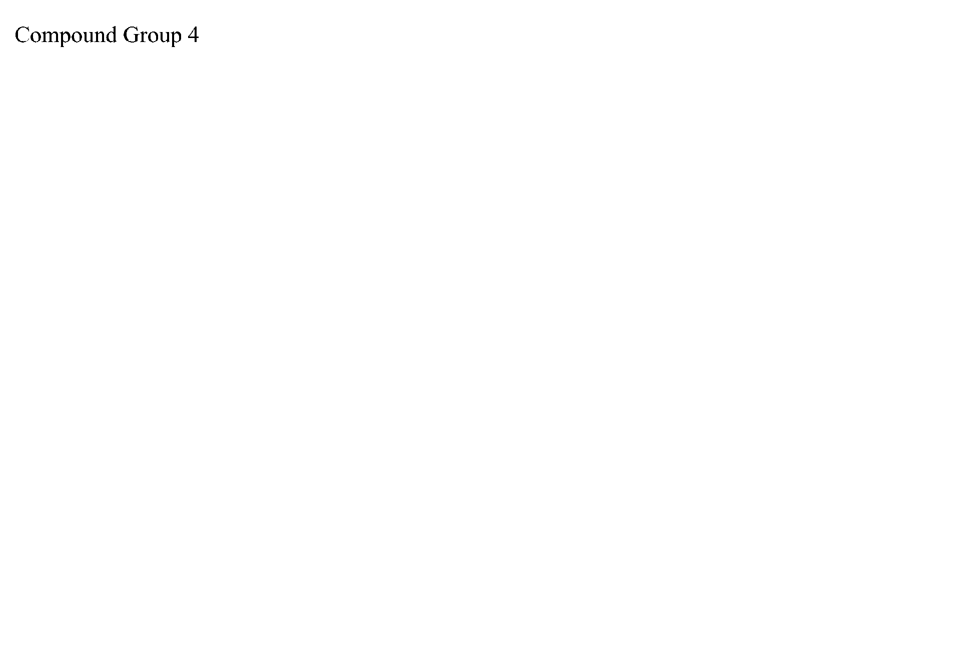

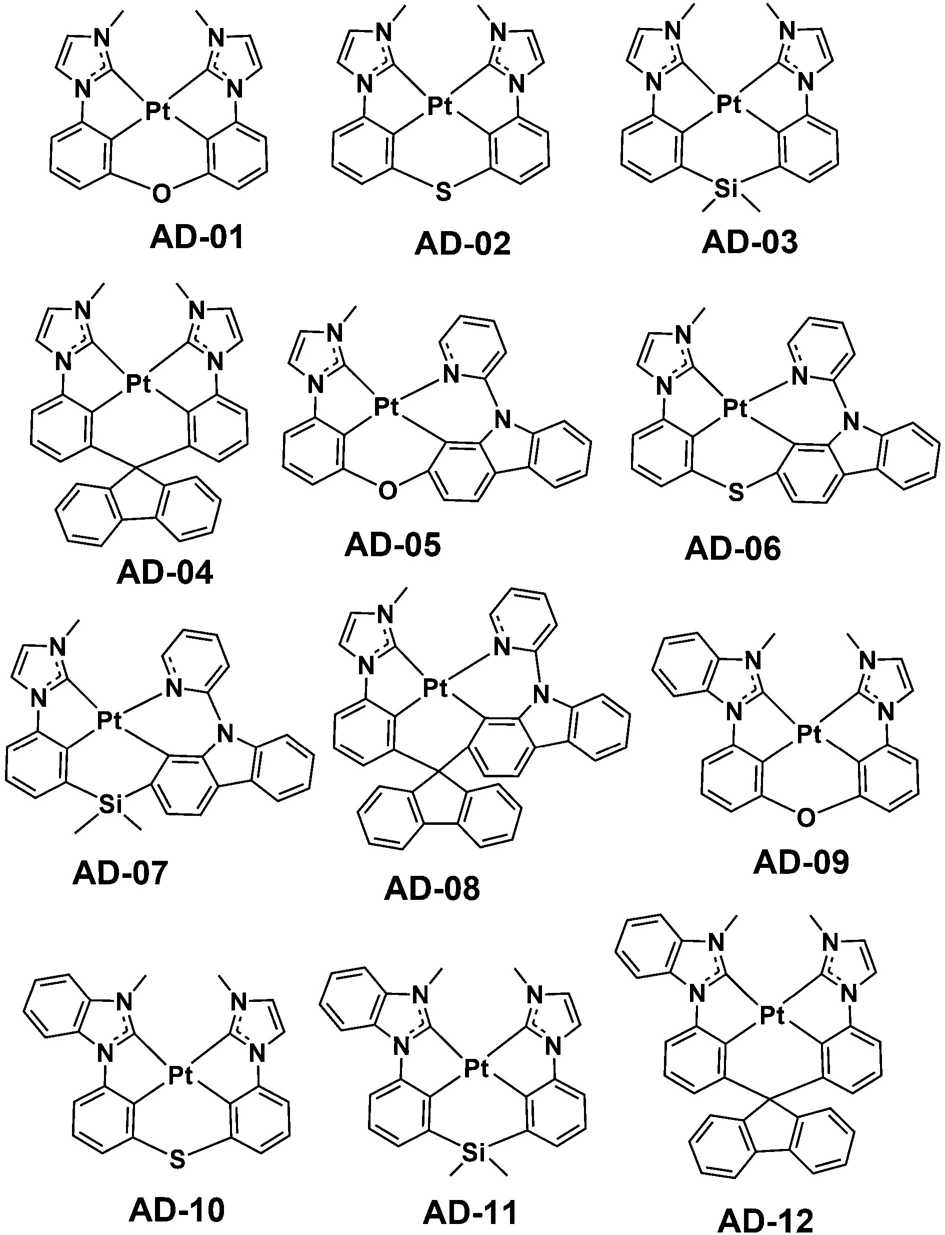

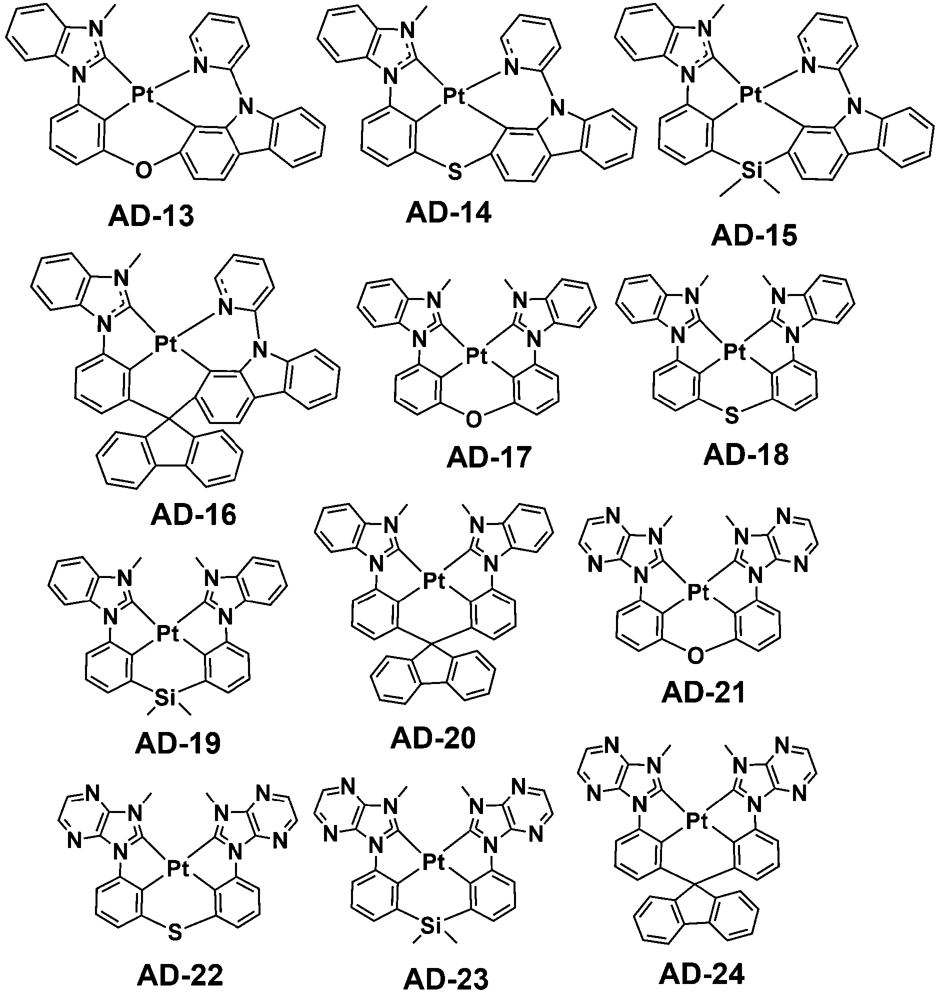

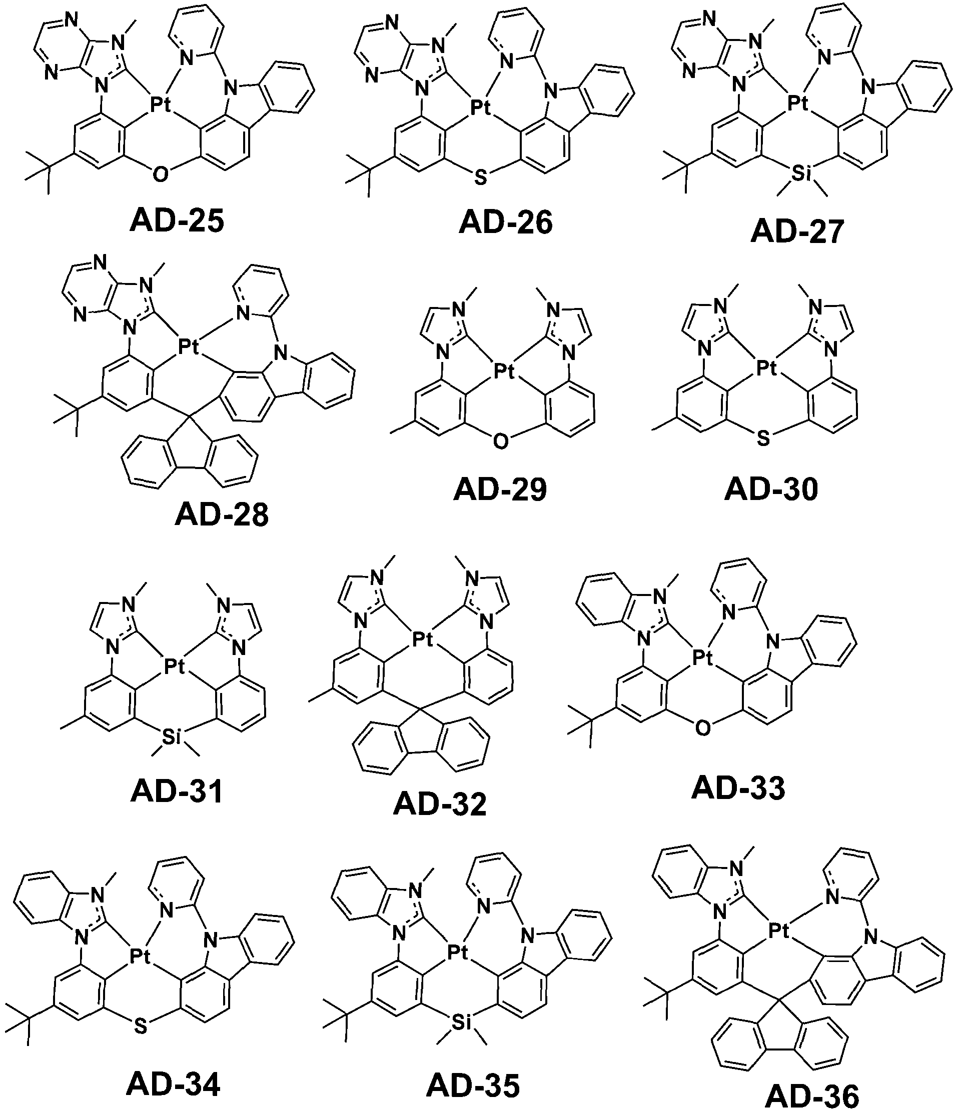

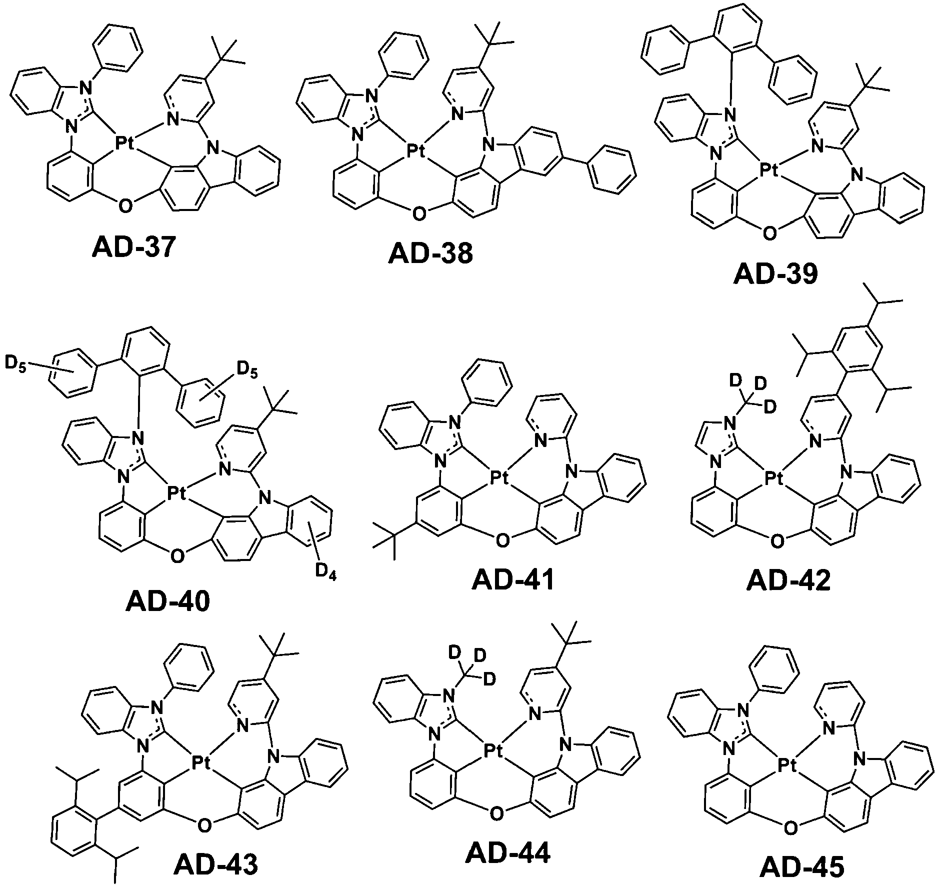

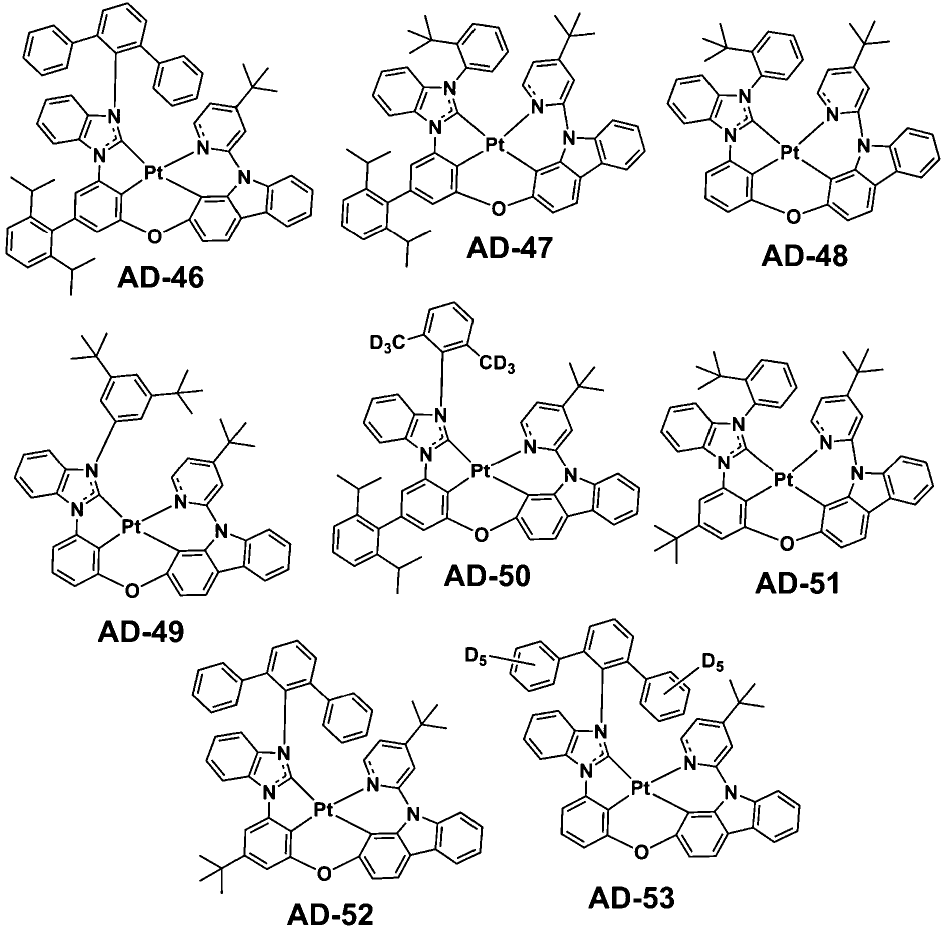

In the specific example compounds presented in Compound Group 4, "D" indicates a deuterium atom.

When the emission layer EML in the light emitting element ED according to one or more embodiments includes all of the first compound, the second compound, and the third compound described above, the first compound may be provided in an amount of about 0.1 weight percent (wt%) to about 5 wt% with respect to a total weight of the first compound, the second compound, and the third compound. However, embodiments are not limited thereto. When the amount of the first compound satisfies the above-described ratio, energy transfer from the second compound and the third compound to the first compound may be greater, and accordingly, luminous efficiency and element service life may be increased.

In the emission layer EML, the amount of the second compound and the third compound may be the remainder excluding the weight of the first compound described herein. For example, in the emission layer EML, the amount of the second compound and the third compound may be provided in an amount of about 65 wt% to about 95 wt% with respect to the total weight of the first compound, the second compound, and the third compound.

A weight ratio of the second compound and the third compound with respect to the total weight of the second compound and the third compound may be about 3:7 to about 7:3.

When the amount of the second compound and the third compound satisfies the above-described ratio, charge balance in the emission layer EML may be improved to increase luminous efficiency and element service life. When the amount of the second compound and the third compound is out of the above-described ratio range, the charge balance in the emission layer EML may be impaired to reduce luminous efficiency and easily deteriorate an element.

When the emission layer EML includes the fourth compound, the fourth compound may be provided in an amount of about 10 wt% to about 30 wt% with respect to the total weight of the first compound, the second compound, the third compound, and the fourth compound. However, embodiments are not limited thereto. When the amount of the fourth compound satisfies the amount described above, energy transfer from a host to the first compound, which is a light emitting dopant, may be increased, thereby improving the light emitting ratio and consequently enhancing the luminous efficiency of the emission layer EML. When the first compound, the second compound, the third compound, and the fourth compound included in the emission layer EML satisfy the above-described amount ratio ranges, excellent luminous efficiency and long lifespan may be achieved.

The emission layer EML is provided on the hole transport region HTR. The emission layer EML may have, for example, a thickness of about 100 Å to about 1000 Å, or about 100 Å to about 300 Å. The emission layer EML may have a single layer formed of a single material, a single layer formed of a plurality of different materials, or a multilayer structure having a plurality of layers formed of a plurality of different materials.

The emission layer EML may further include compounds which will be described herein in addition to the fused polycyclic compound represented by Formula 1 according to one or more embodiments.

In the light emitting element ED according to one or more embodiments, the emission layer EML may include an anthracene derivative, a pyrene derivative, a fluoranthene derivative, a chrysene derivative, a dihydrobenzanthracene derivative, or a triphenylene derivative. In one or more embodiments, the emission layer EML may include an anthracene derivative or a pyrene derivative.

In the light emitting element ED according to one or more embodiments shown in FIGS. 3 to 6, the emission layer EML may include a host and a dopant, and the emission layer EML may include a compound represented by Formula E-1. The compound represented by Formula E-1 may be used as a fluorescent host material.

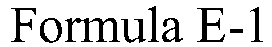

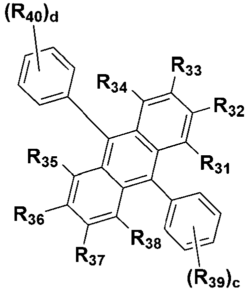

In Formula E-1, R₃₁ to R₄₀ may each independently be a hydrogen atom, a deuterium atom, a halogen atom, a substituted or unsubstituted silyl group, a substituted or unsubstituted thio group, a substituted or unsubstituted oxy group, a substituted or unsubstituted alkyl group having 1 to 10 carbon atoms, a substituted or unsubstituted alkenyl group having 2 to 10 carbon atoms, a substituted or unsubstituted aryl group having 6 to 30 ring-forming carbon atoms, a substituted or unsubstituted heteroaryl group having 2 to 30 ring-forming carbon atoms, or R₃₁ to R₄₀ may be bonded to an adjacent group to form a ring. For example, R₃₁ to R₄₀ may be bonded to an adjacent group to form a saturated hydrocarbon ring, an unsaturated hydrocarbon ring, a saturated heterocycle, or an unsaturated heterocycle.

In Formula E-1, c and d may each independently be an integer of 0 to 5.

In one or more embodiments, Formula E-1 may be represented by one of compounds E1 to E21.

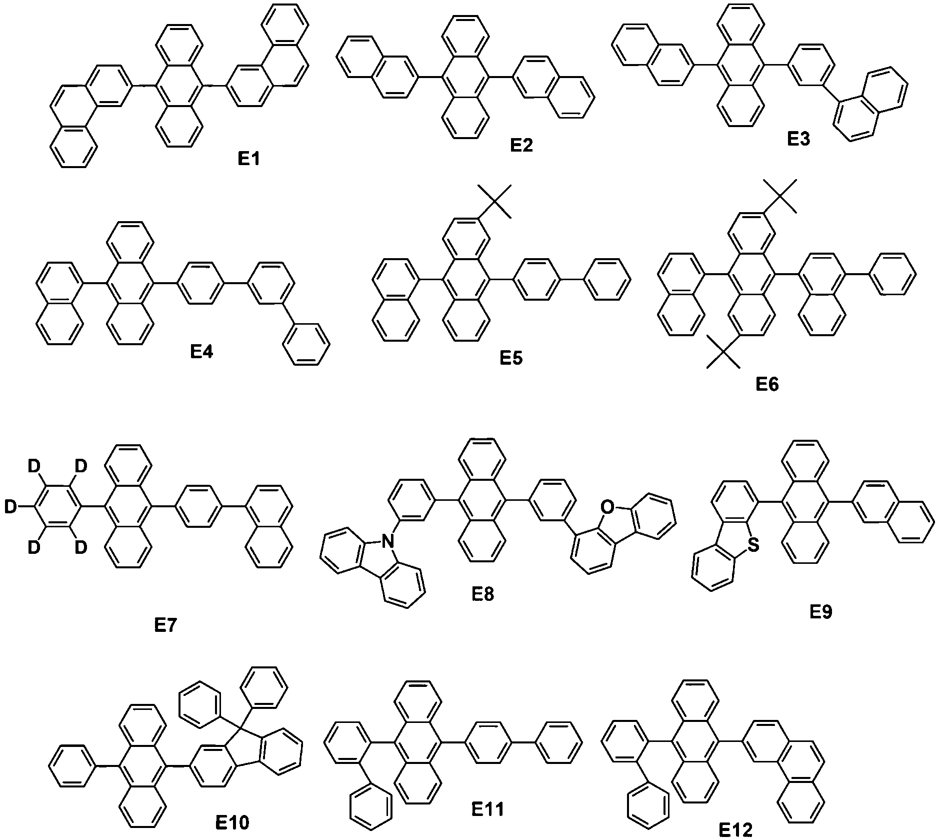

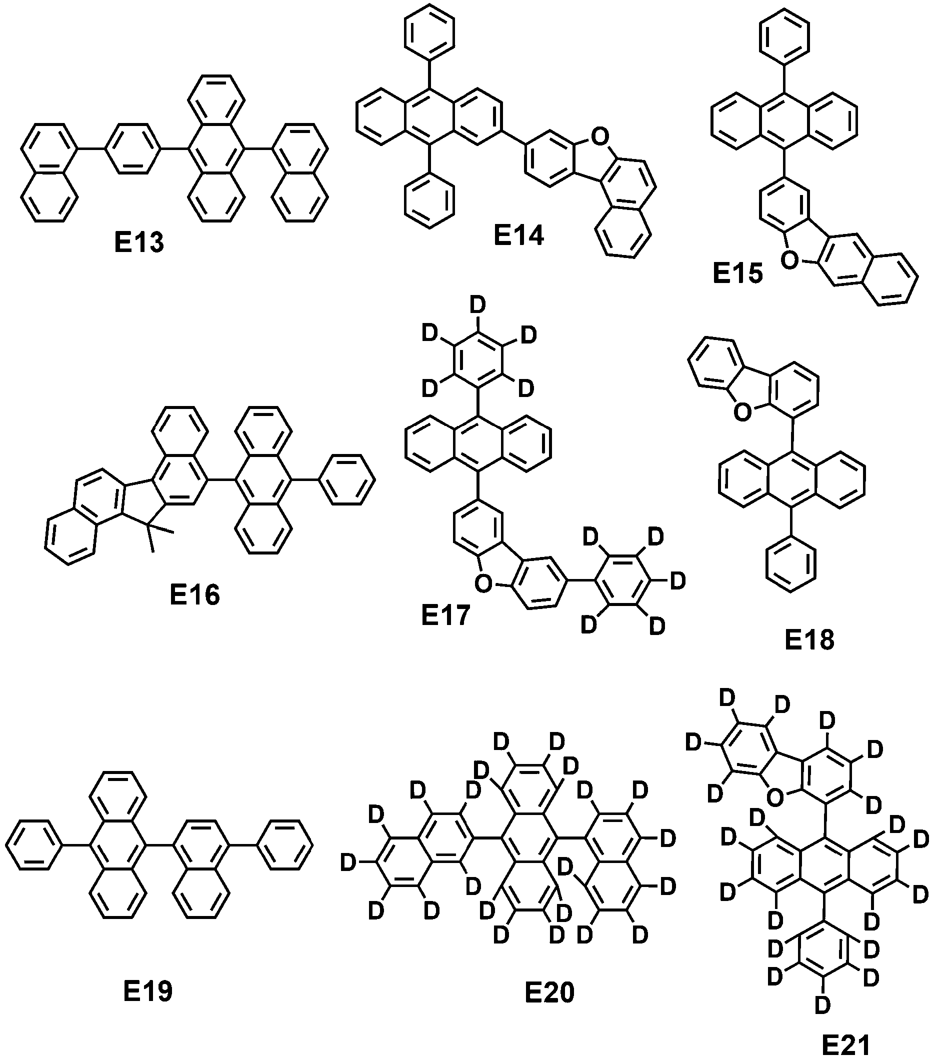

In one or more embodiments, the emission layer EML may include a compound represented by Formula E-2a or Formula E-2b. The compound represented by Formula E-2a or Formula E-2b may be used as a host material for a phosphorescent emission layer.

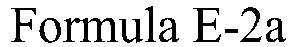

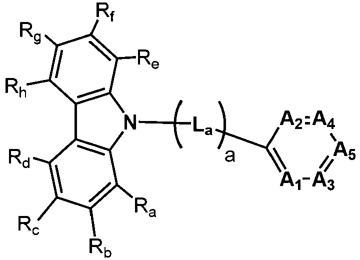

In Formula E-2a, a may be an integer of 0 to 10, and each Lₐ may independently be a direct linkage, a substituted or unsubstituted arylene group having 6 to 30 ring-forming carbon atoms, or a substituted or unsubstituted heteroarylene group having 2 to 30 ring-forming carbon atoms. When a is an integer of 2 or greater, a plurality of Lₐ's may each independently be a substituted or unsubstituted arylene group having 6 to 30 ring-forming carbon atoms, or a substituted or unsubstituted heteroarylene group having 2 to 30 ring-forming carbon atoms.

In addition, in Formula E-2a, A₁ to A₅ may each independently be N or CRᵢ. Rₐ to Rᵢ may each independently be a hydrogen atom, a deuterium atom, a substituted or unsubstituted amine group, a substituted or unsubstituted thio group, a substituted or unsubstituted oxy group, a substituted or unsubstituted alkyl group having 1 to 20 carbon atoms, a substituted or unsubstituted alkenyl group having 2 to 20 carbon atoms, a substituted or unsubstituted aryl group having 6 to 30 ring-forming carbon atoms, a substituted or unsubstituted heteroaryl group having 2 to 30 ring-forming carbon atoms, or Rₐ to Rᵢ may be bonded to an adjacent group to form a ring. Rₐ to Rᵢ may be bonded to an adjacent group to form a hydrocarbon ring or a heterocycle containing N, O, S, or the like as a ring-forming atom.

For example, in Formula E-2a, two or three selected from A₁ to A₅ may be N, and the others may be CRᵢ.

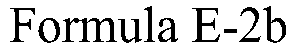

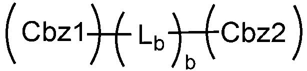

In Formula E-2b, Cbz1 and Cbz2 may each independently be an unsubstituted carbazole group or an aryl-substituted carbazole group having 6 to 30 ring-forming carbon atoms. Each L_{b} may independently be a direct linkage, a substituted or unsubstituted arylene group having 6 to 30 ring-forming carbon atoms, or a substituted or unsubstituted heteroarylene group having 2 to 30 ring-forming carbon atoms, b may be an integer of 0 to 10, and when b is an integer of 2 or greater, a plurality of L_{b}'s may each independently be a substituted or unsubstituted arylene group having 6 to 30 ring-forming carbon atoms, or a substituted or unsubstituted heteroarylene group having 2 to 30 ring-forming carbon atoms.

The compound represented by Formula E-2a or Formula E-2b may be represented by one of the compounds from Compound Group E-2. However, the compounds listed in Compound Group E-2 are presented as an example, and the compound represented by Formula E-2a or Formula E-2b is not limited to those listed in Compound Group E-2.

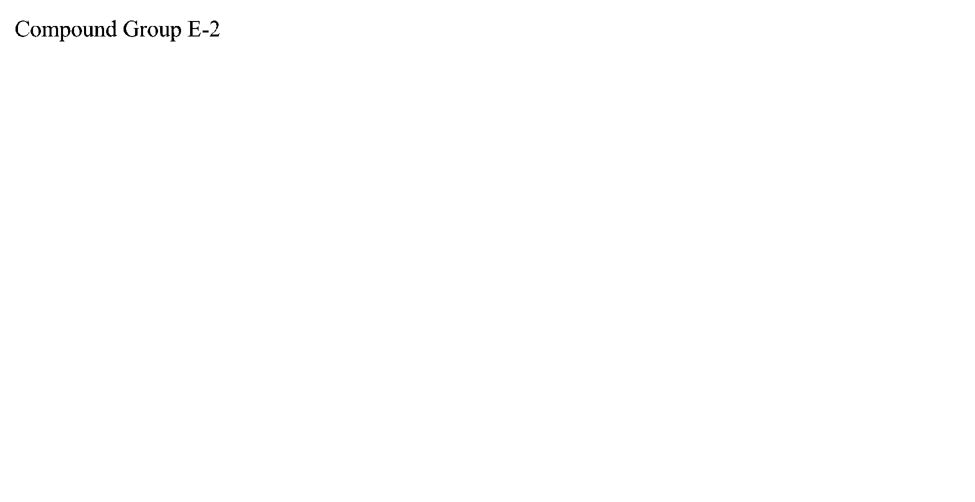

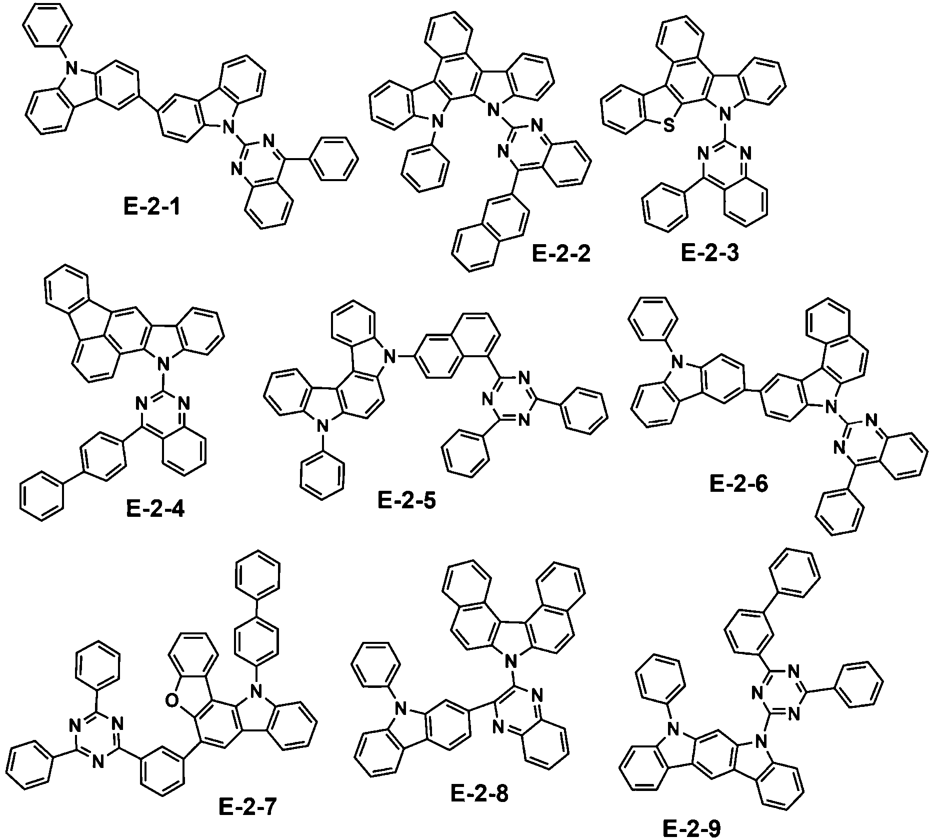

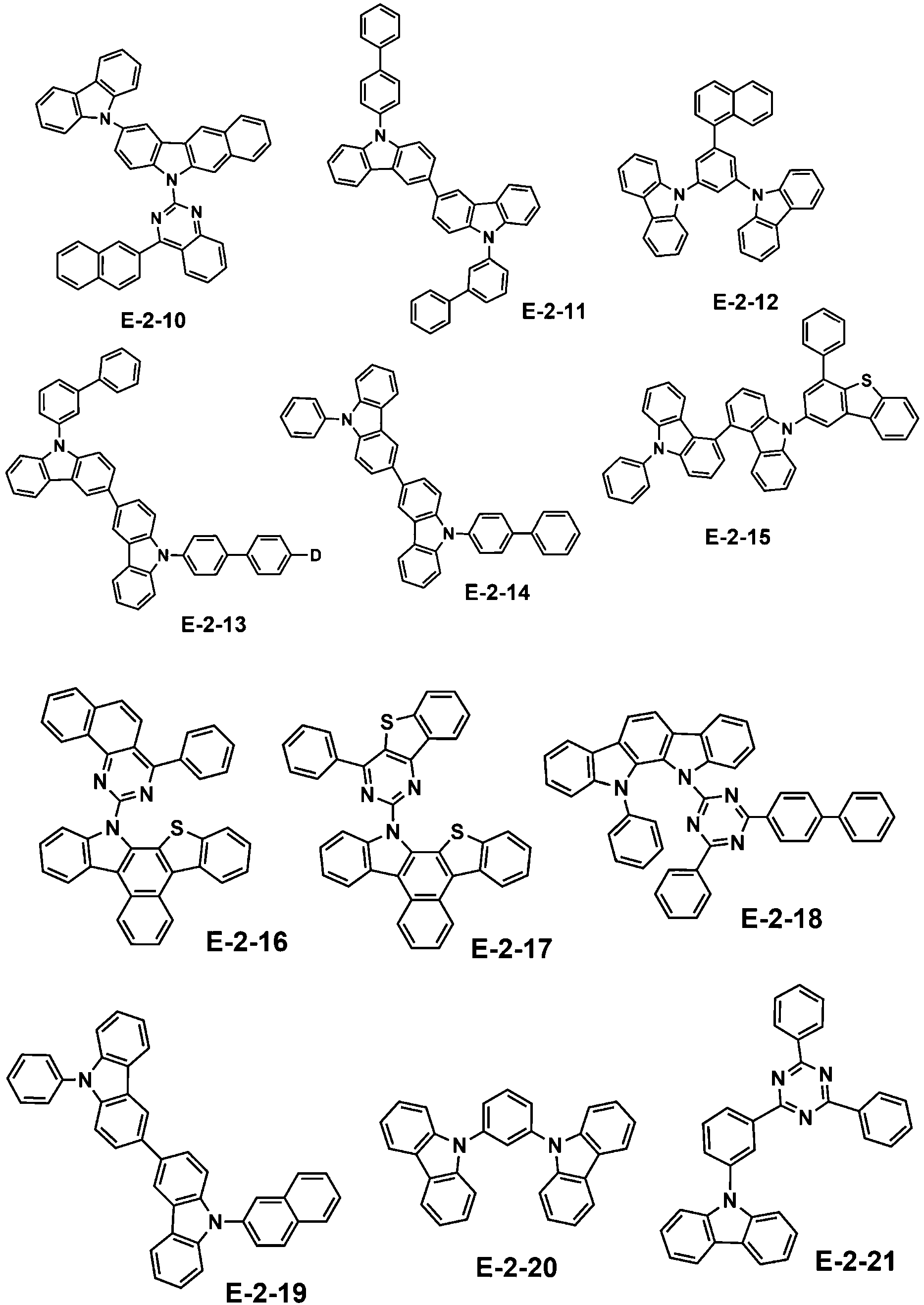

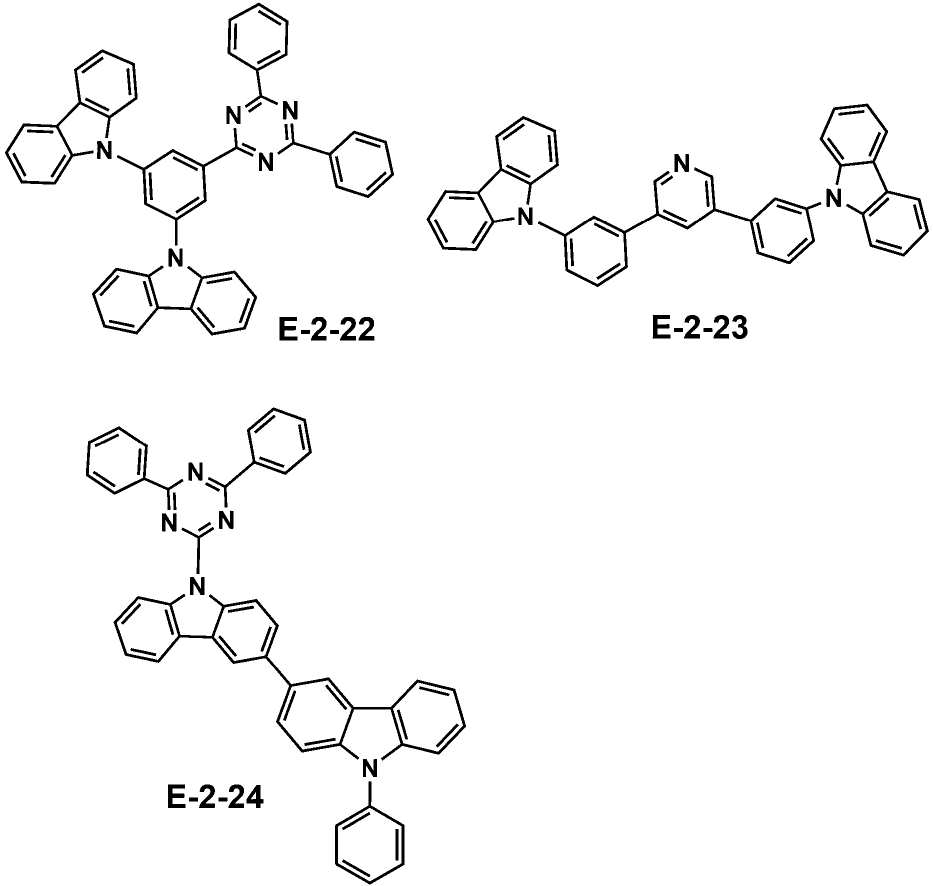

The emission layer EML may further include a material known in the art as a host material. For example, the emission layer EML may include at least one of bis(4-(9H-carbazol-9-yl)phenyl)diphenylsilane (BCPDS), (4-(1-(4-(diphenylamino)phenyl)cyclohexyl)phenyl)diphenyl-phosphine oxide (POPCPA), bis[2-(diphenylphosphino)phenyl]ether oxide (DPEPO), 4,4'-bis(N-carbazolyl)-1,1'-biphenyl (CBP), 1,3-bis(carbazolyl-9-yl)benzene (mCP), 2,8-bis(diphenylphosphoryl)dibenzofuran (PPF), 4,4',4"-tris(carbazol-9-yl)-triphenylamine (TCTA), or 1,3,5-tris(1-phenyl-1H-benzo[d]imidazol-2-yl)benzene (TPBi). However, embodiments are not limited thereto, and for example, at least one of tris(8-hydroxyquinolino)aluminium (Alq₃), 9,10-di(naphthalen-2-yl)anthracene (ADN), 3-tert-butyl-9,10-di(naphth-2-yl)anthracene (TBADN), distyrylarylene (DSA), 4,4'-bis(9-carbazolyl)-2,2'-dimethyl-biphenyl (CDBP), 2-methyl-9,10-bis(naphthalen-2-yl)anthracene (MADN), hexaphenyl cyclotriphosphazene (CP1), 1,4-bis(triphenylsilyl)benzene (UGH2), hexaphenylcyclotrisiloxane (DPSiO₃), octaphenylcyclotetrasiloxane (DPSiO₄), or the like, may be used as a host material.

The emission layer EML may include a compound represented by Formula Ma. The compound represented by Formula M-a may be used as a phosphorescent dopant material.

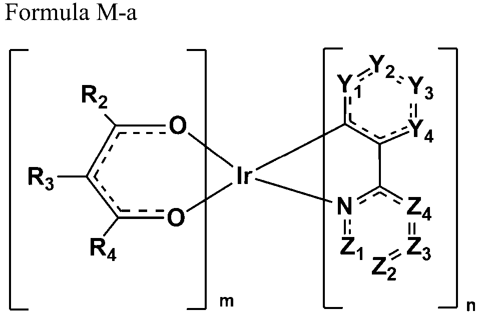

In Formula M-a, Y₁ to Y₄ and Z₁ to Z₄ may each independently be CR₁ or N, and R₁ to R₄ may each independently be a hydrogen atom, a deuterium atom, a substituted or unsubstituted amine group, a substituted or unsubstituted thio group, a substituted or unsubstituted oxy group, a substituted or unsubstituted alkyl group having 1 to 20 carbon atoms, a substituted or unsubstituted alkenyl group having 2 to 20 carbon atoms, a substituted or unsubstituted aryl group having 6 to 30 ring-forming carbon atoms, or a substituted or unsubstituted heteroaryl group having 2 to 30 ring-forming carbon atoms, or R₁ to R₄ may be bonded to an adjacent group to form a ring. In Formula M-a, m is 0 or 1, and n is 2 or 3. In Formula M-a, when m is 0, n is 3, and when m is 1, n is 2.

The compound represented by Formula M-a may be represented by one of compounds M-a1 to M-a25. However, the compounds M-a1 to M-a25 are presented as an example, and the compound represented by Formula M-a is not limited to those represented by the compounds M-a1 to M-a25.

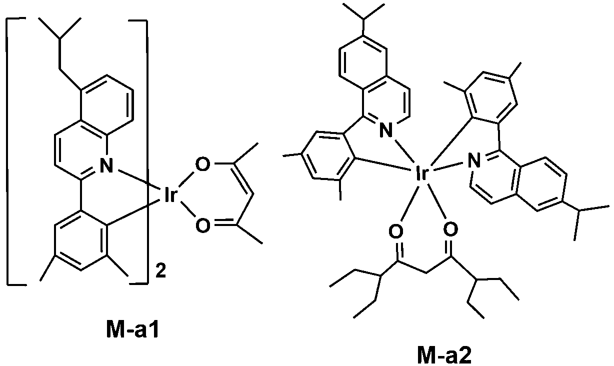

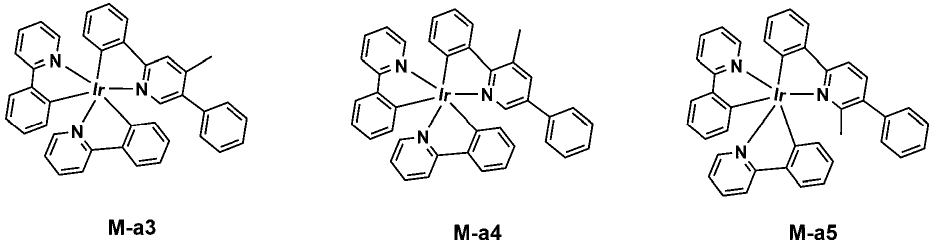

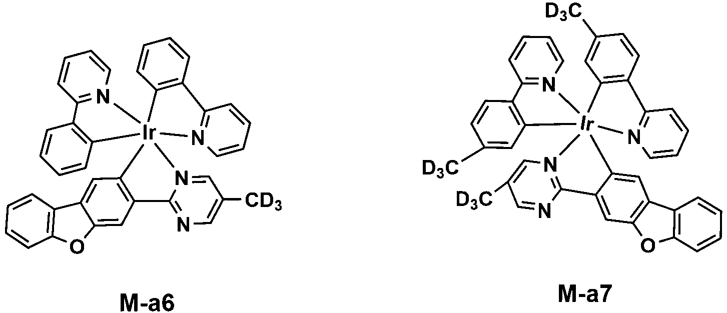

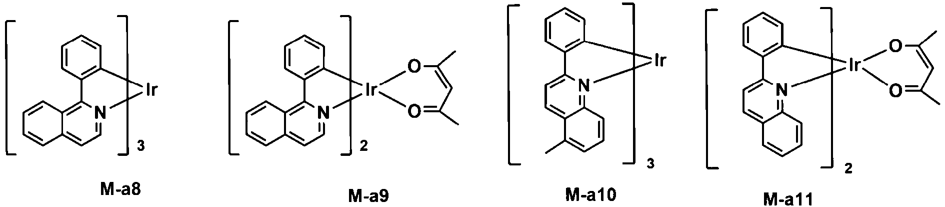

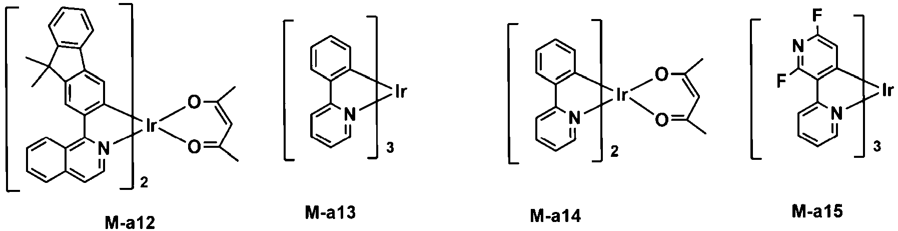

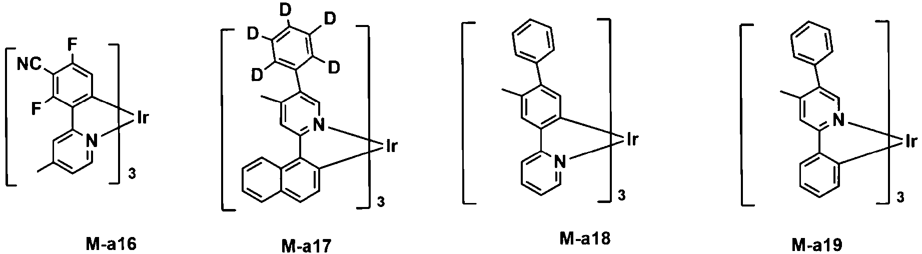

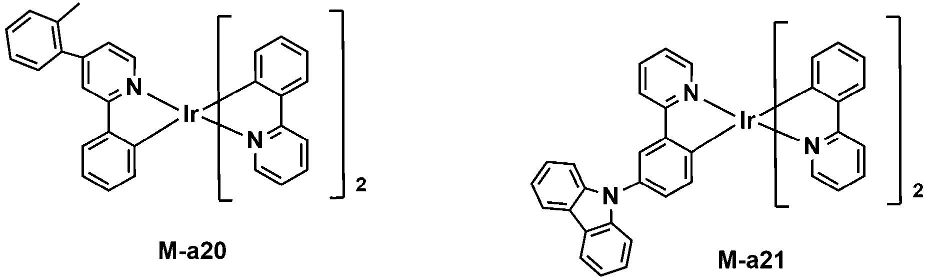

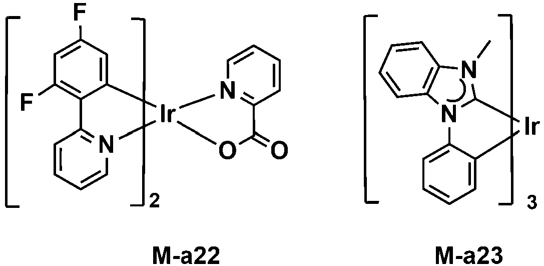

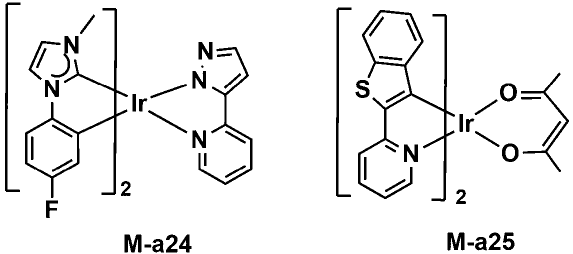

The emission layer EML may include a compound represented by one of Formulae F-a to F-c. The compounds represented by Formulas F-a to F-c may be used as a fluorescence dopant material.

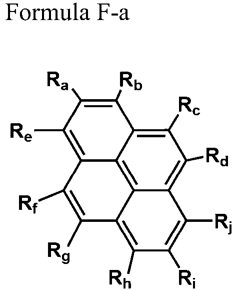

In Formula F-a, two selected from Rₐ to Rⱼ may each independently be substituted with *-NAr₁Ar₂. The others among Rₐ to Rⱼ which are not substituted with *-NAr₁Ar₂ may each independently be a hydrogen atom, a deuterium atom, a halogen atom, a cyano group, a substituted or unsubstituted amine group, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms.

In *-NAr₁Ar₂, Ar₁ and Ar₂ may each independently be a substituted or unsubstituted aryl group having 6 to 30 ring-forming carbon atoms, or a substituted or unsubstituted heteroaryl group having 2 to 30 ring-forming carbon atoms. For example, at least one of Ar₁ or Ar₂ may be a heteroaryl group containing O or S as a ring-forming atom.

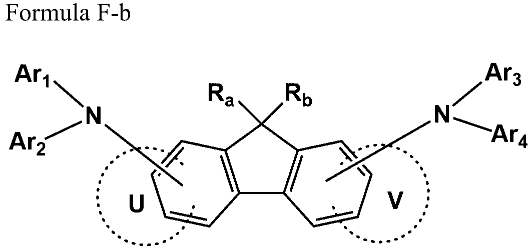

In Formula F-b, Rₐ and R_{b} may each independently be a hydrogen atom, a deuterium atom, a substituted or unsubstituted alkyl group having 1 to 20 carbon atoms, a substituted or unsubstituted alkenyl group having 2 to 20 carbon atoms, a substituted or unsubstituted aryl group having 6 to 30 ring-forming carbon atoms, a substituted or unsubstituted heteroaryl group having 2 to 30 ring-forming carbon atoms, or Rₐ and R_{b} may be bonded to an adjacent group to form a ring. Ar₁ to Ar₄ may each independently be a substituted or unsubstituted aryl group having 6 to 30 ring-forming carbon atoms, or a substituted or unsubstituted heteroaryl group having 2 to 30 ring-forming carbon atoms.

In Formula F-b, ring U and ring V may each independently be a substituted or unsubstituted hydrocarbon ring having 5 to 30 ring-forming carbon atoms, or a substituted or unsubstituted heterocycle having 2 to 30 ring-forming carbon atoms. At least one of Ar₁ to Ar₄ may be a heteroaryl group containing O or S as a ring-forming atom.

In Formula F-b, the number of rings represented by ring U and ring V may each independently be 0 or 1. For example, in Formula F-b, when the number of ring U or ring V is 1, one ring forms a fused ring in a portion indicated by ring U or ring V, and when the number of ring U or ring V is 0, it means that no ring indicated by ring U or ring V is present. To be specific, when the number of ring U is 0 and the number of ring V is 1, or when the number of ring U is 1 and the number of ring V is 0, a fused ring having a fluorene core of Formula F-b may be a cyclic compound having four rings. In addition, when the number of ring U and ring V are both 0, the fused ring of Formula F-b may be a cyclic compound having three rings. In addition, when the number of ring U and ring V are both 1, the fused ring having a fluorene core of Formula F-b may be a cyclic compound having five rings.

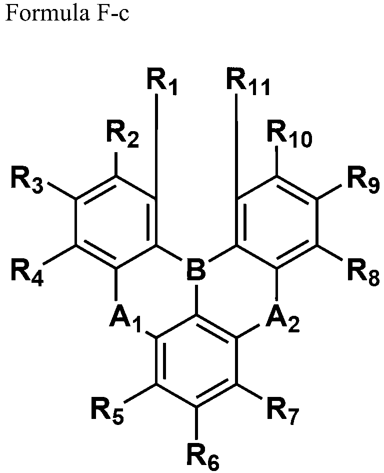

In Formula F-c, A₁ and A₂ may each independently be O, S, Se, or NRₘ, and Rₘ may be a hydrogen atom, a deuterium atom, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms. R₁ to R₁₁ are each independently a hydrogen atom, a deuterium atom, a halogen atom, a cyano group, a substituted or unsubstituted amine group, a substituted or unsubstituted boryl group, a substituted or unsubstituted oxy group, a substituted or unsubstituted thio group, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms, or R₁ to R₁₁ may be bonded to an adjacent group to form a ring.

In Formula F-c, A₁ and A₂ may each independently be bonded to substituents of neighboring rings to form a fused ring. For example, when A₁ and A₂ are each independently NRₘ, A₁ may be bonded to R₄ or R₅ to form a ring. In addition, A₂ may be bonded to R₇ or R₈ to form a ring.

The emission layer EML may include, as a dopant material, at least one of styryl derivatives (e.g., 1,4-bis[2-(3-N-ethylcarbazoryl)vinyl]benzene (BCzVB), 4-(di-p-tolylamino)-4'-[(di-p-tolylamino)styryl]stilbene (DPAVB), or N-(4-((E)-2-(6-((E)-4-(diphenylamino)styryl)naphthalen-2-yl)vinyl)phenyl)-N-phenylbenzenamine (N-BDAVBi), 4,4'-bis[2-(4-(N,N-diphenylamino)phenyl)vinyl]biphenyl (DPAVBi), perylene and derivatives thereof (e.g., 2,5,8,11-tetra-t-butylperylene (TBP)), pyrene and derivatives thereof (e.g., 1,1-dipyrene, 1,4-dipyrenylbenzene, 1,4-bis(N,N-diphenylamino)pyrene), or the like, but embodiments are not limited thereto.

The emission layer EML may include a phosphorescent dopant material. For example, as a phosphorescent dopant, a metal complex including iridium (Ir), platinum (Pt), osmium (Os), gold (Au), titanium (Ti), zirconium (Zr), hafnium (Hf), europium (Eu), terbium (Tb), or thulium (Tm) may be used. For example, iridium(III) bis(4,6-difluorophenylpyridinato-N,C2')picolinate (FIrpic), bis(2,4-difluorophenylpyridinato)-tetrakis(1-pyrazolyl)borate iridium(III) (FIr6), platinum octaethyl porphyrin (PtOEP), or the like may be used as a phosphorescent dopant. However, embodiments are not limited thereto.

The emission layer EML may include a quantum dot material. The core of a quantum dot may be a Group II-VI compound, a Group III-VI compound, a Group I-III-VI compound, a Group III-V compound, a Group III-II-V compound, a Group IV-VI compound, a Group IV element, a Group IV compound, or a combination thereof.

The Group II-VI compound may be a binary compound such as CdSe, CdTe, CdS, ZnS, ZnSe, ZnTe, ZnO, HgS, HgSe, HgTe, MgSe, MgS, or the like, or a combination thereof; a ternary compound such as CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, MgZnS, or the like, or a combination thereof; a quaternary compound such as HgZnTeS, CdZnSeS, CdZnSeTe, CdZnSTe, CdHgSeS, CdHgSeTe, CdHgSTe, HgZnSeS, HgZnSeTe, or the like, or a combination thereof; or a combination thereof.

The Group III-VI compound may include a binary compound such as In₂S₃, In₂Se₃, or the like, or a combination thereof; a ternary compound such as InGaS₃, InGaSe₃, or the like, or a combination thereof; or a combination thereof.

The Group I-III-VI compound may be a ternary compound such as AgInS, AgInS₂, CuInS, CuInS₂, AgGaS₂, CuGaS₂ CuGaO₂, AgGaO₂, AgAlO₂, or the like, or a combination thereof; a quaternary compound such as AgInGaS₂, CuInGaS₂, or the like, or a combination thereof; or a combination thereof.

The Group III-V compound may be a binary compound such as GaN, GaP, GaAs, GaSb, AlN, AlP, AlAs, AlSb, InN, InP, InAs, InSb, or the like, or a combination thereof; a ternary compound such as GaNP, GaNAs, GaNSb, GaPAs, GaPSb, AlNP, AlNAs, AlNSb, AlPAs, AlPSb, InGaP, InAlP, InNP, InNAs, InNSb, InPAs, InPSb, or the like, or a combination thereof; a quaternary compound such as GaAlNP, GaAlNAs, GaAlNSb, GaAlPAs, GaAlPSb, GaInNP, GaInNAs, GaInNSb, GaInPAs, GaInPSb, InAlNP, InAlNAs, InAlNSb, InAlPAs, InAlPSb, or the like, or a combination thereof; or a combination thereof. The Group III-V compound may further include a Group II metal. For example, InZnP or the like may be selected as a Group III-II-V compound.

The Group IV-VI compound may be a binary compound such as SnS, SnSe, SnTe, PbS, PbSe, PbTe, or the like, or a combination thereof; a ternary compound such as SnSeS, SnSeTe, SnSTe, PbSeS, PbSeTe, PbSTe, SnPbS, SnPbSe, SnPbTe, or the like, or a combination thereof; a quaternary compound such as SnPbSSe, SnPbSeTe, SnPbSTe, or the like, or a combination thereof; or a combination thereof. The Group IV element may be Si, Ge, or a combination thereof. The Group IV compound may be a binary compound such as SiC, SiGe, or a combination thereof.

Each element included in the multi-element compound such as the binary compound, ternary compound, and quaternary compound may be present in particles at a uniform concentration or at a non-uniform concentration. That is, the formulae above indicates the types of elements included in a compound, and element ratios in the compound may be different. For example, AgInGaS₂ may indicate AgInₓGa₁₋ₓS₂ (x is a real number between 0 and 1).

In some embodiments, the quantum dot may have a single structure having a uniform concentration of each element included in the corresponding quantum dot or a dual structure of core-shell. For example, materials included in the core may be different from materials included in the shell.

The shell of the quantum dot may serve as a protection layer to prevent the chemical degradation of the core so as to keep semiconductor properties, and/or a charging layer to impart electrophoresis properties to the quantum dot. The shell may be single-layered or multi-layered. An interface between the core and the shell may have a concentration gradient in which the concentration of an element present in the shell becomes lower towards the center.

In some embodiments, the quantum dot may have the above-described core/shell structure including a core having nano-crystals and a shell surrounding the core. Examples of the shell of the quantum dot may be a metal oxide or non-metal oxide, a semiconductor compound, or a combination thereof.

For example, the metal oxide or non-metal oxide may be a binary compound such as SiO₂, Al₂O₃, TiO₂, ZnO, MnO, Mn₂O₃, Mn₃O₄, CuO, FeO, Fe₂O₃, Fe₃O₄, CoO, Co₃O₄, NiO, or the like, or a combination thereof; a ternary compound such as MgAl₂O₄, CoFe₂O₄, NiFe₂O₄, CoMn₂O₄, or the like, or a combination thereof; or a combination thereof, but embodiments are not limited thereto.

In addition, the semiconductor compound may be, for example, CdS, CdSe, CdTe, ZnS, ZnSe, ZnTe, ZnSeS, ZnTeS, GaAs, GaP, GaSb, HgS, HgSe, HgTe, InAs, InP, InGaP, InSb, AlAs, AlP, AlSb, or the like, or a combination thereof, but embodiments are not limited thereto.

Each element included in the multi-element compound such as the binary compound and the ternary compound may be present in particles at a uniform concentration or at a non-uniform concentration. That is, the formulae above indicates the types of elements included in a compound, and element ratios in the compound may be different.

The quantum dot may have, in a light emitting wavelength spectrum, a full width of half maximum (FWHM) of about 45 nm or less, preferably about 40 nm or less, and more preferably about 30 nm or less, and in this range, color purity or color reproducibility may be improved. In addition, light emitted through the quantum dot is emitted in all directions, and thus a wide viewing angle may be improved.

In addition, the form of the quantum dot is not particularly limited as long as it is a form commonly used in the art, but more specifically, a quantum dot in the form of spherical, pyramidal, multi-arm, or cubic nanoparticles, nanotubes, nanowires, nanofibers, nanoplatelets, or the like may be used.

As the size of the quantum dot or the ratio of elements in the quantum dot compound is regulated, the energy band gap may be accordingly controlled to obtain light of various wavelengths from the quantum dot emission layer. Therefore, by using the quantum dots as described herein (using quantum dots of different sizes or having different element ratios in the quantum dot compound), a light emitting element emitting light of various wavelengths may be obtained. Specifically, the size of the quantum dot or the ratio of elements in the quantum dot compound may be regulated to emit a red, a green, and/or a blue light. In addition, the quantum dots may be configured to emit white light by combining light of various colors.

In the light emitting element ED according to one or more embodiments shown in FIGS. 3 to 6, an electron transport region ETR is provided on the emission layer EML. The electron transport region ETR may include at least one among a hole blocking layer HBL, an electron transport layer ETL, and an electron injection layer EIL, but embodiments are not limited thereto.

The electron transport region ETR may have a single layer formed of a single material, a single layer formed of a plurality of different materials, or a multilayer structure having a plurality of layers formed of a plurality of different materials.

For example, the electron transport region ETR may have a single layer structure of an electron injection layer EIL or an electron transport layer ETL, and may have a single layer structure formed of an electron injection material and an electron transport material. In addition, the electron transport region ETR may have a single layer structure formed of a plurality of different materials, or may have a structure in which an electron transport layer ETL/electron injection layer EIL, or a hole blocking layer HBL/electron transport layer ETL/electron injection layer EIL are stacked in order from the emission layer EML, but is not limited thereto. The electron transport region ETR may have a thickness of, for example, about 1000 Å to about 1500 Å.

The electron transport region ETR may be formed using various methods such as a vacuum deposition method, a spin coating method, a cast method, a Langmuir-Blodgett (LB) method, an inkjet printing method, a laser printing method, a laser induced thermal imaging (LITI) method, or the like, but embodiments are not limited thereto.

The electron transport region ETR may include a compound represented by Formula ET-2.

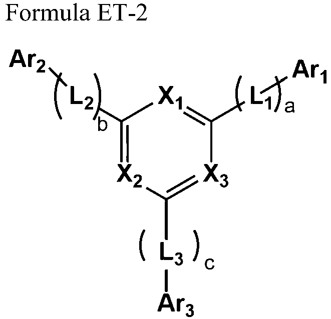

In Formula ET-2, at least one of X₁ to X₃ is N and the others are CRₐ. Rₐ may be a hydrogen atom, a deuterium atom, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms. Ar₁ to Ar₃ may each independently be a hydrogen atom, a deuterium atom, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms.

In Formula ET-2, a to c may each independently be an integer of 0 to 10. In Formula ET-2, L₁ to L₃ may each independently be a direct linkage, a substituted or unsubstituted arylene group having 6 to 30 ring-forming carbon atoms, or a substituted or unsubstituted heteroarylene group having 2 to 30 ring-forming carbon atoms. When a to c are an integer of 2 or greater, L₁ to L₃ may each independently be a substituted or unsubstituted arylene group having 6 to 30 ring-forming carbon atoms, or a substituted or unsubstituted heteroarylene group having 2 to 30 ring-forming carbon atoms.

The electron transport region ETR may include an anthracene-containing compound. However, embodiments are not limited thereto, and the electron transport region ETR may include, for example, at least one of tris(8-hydroxyquinolinato)aluminium (Alq₃), 1,3,5-tri[(3-pyridyl)-phen-3-yl]benzene, 2,4,6-tris(3'-(pyridin-3-yl)biphenyl-3-yl)-1,3,5-triazine, 2-(4-(N-phenylbenzoimidazolyl-1-ylphenyl)-9,10-dinaphthylanthracene, 1,3,5-tri(1-phenyl-1H-benzo[d]imidazol-2-yl)benzene (TPBi), 2,9-dimethyl-4,7-diphenyl-1,10-phenanthroline (BCP), 4,7-diphenyl-1,10-phenanthroline (Bphen), 3-(4-biphenylyl)-4-phenyl-5-tert-butylphenyl-1,2,4-triazole (TAZ), 4-(naphthalen-1-yl)-3,5-diphenyl-4H-1,2,4-triazole (NTAZ), 2-(4-biphenylyl)-5-(4-tert-butylphenyl)-1,3,4-oxadiazole (tBu-PBD), bis(2-methyl-8-quinolinolato-N1,O8)-(1,1'-biphenyl-4-olato)aluminium (BAlq), berylliumbis(benzoquinolin-10-olate (Bebq₂), 9,10-di(naphthalene-2-yl)anthracene (ADN), 1,3-bis[3,5-di(pyridin-3-yl)phenyl]benzene (BmPyPhB), or a combination thereof, but embodiments are not limited thereto.

The electron transport region ETR may include at least one of compounds ET1 to ET36.

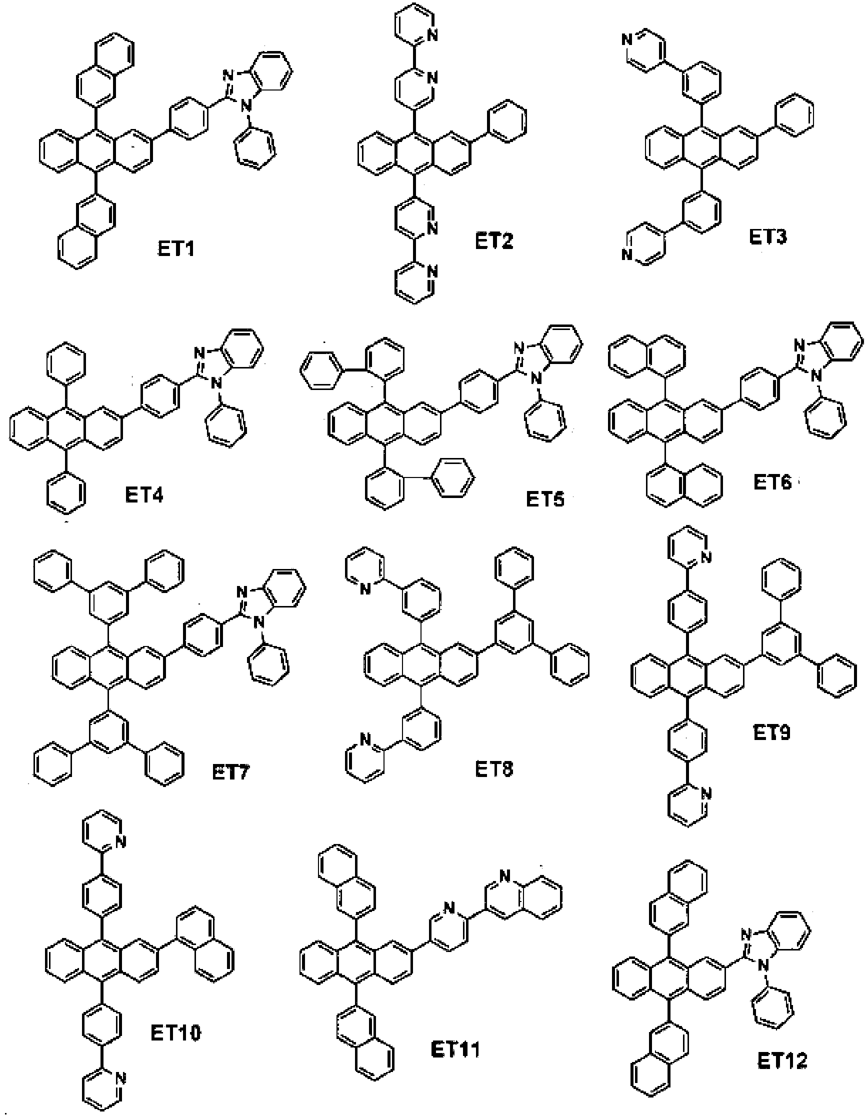

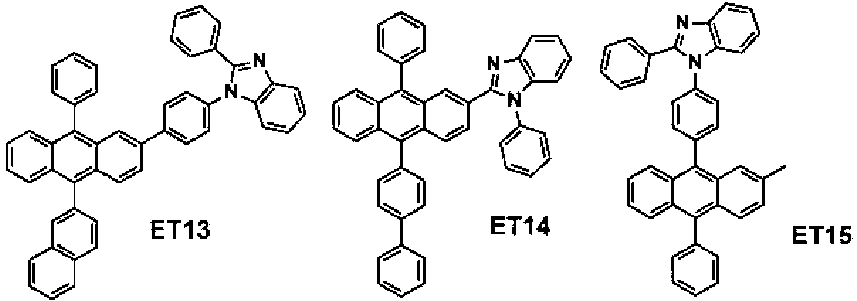

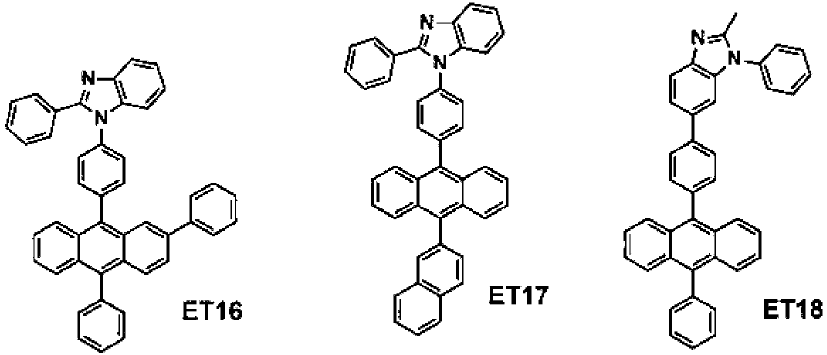

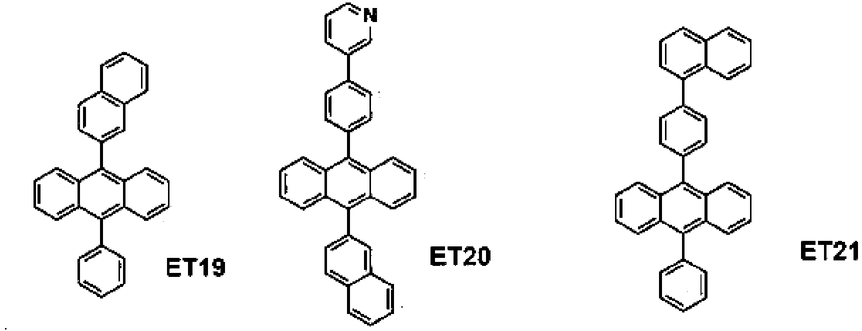

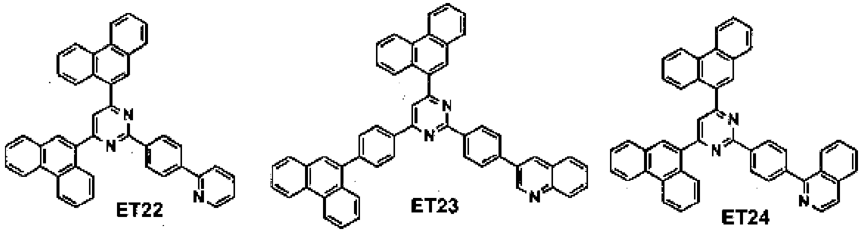

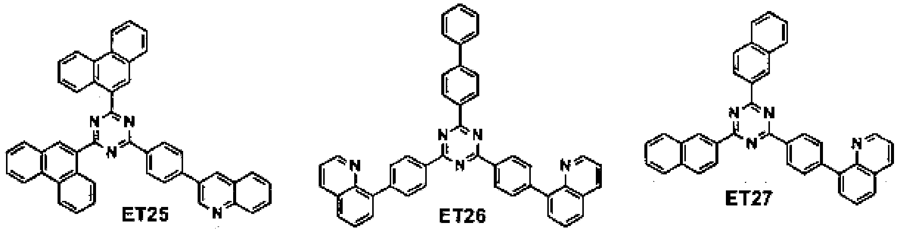

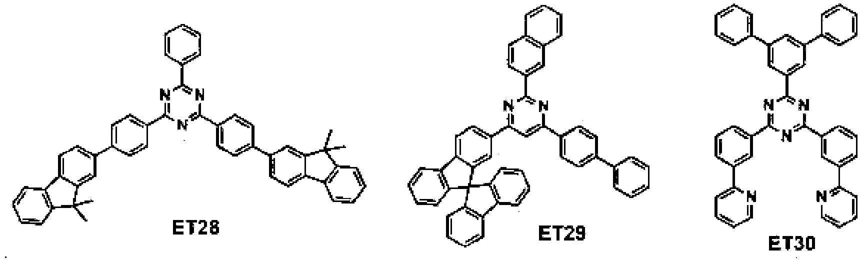

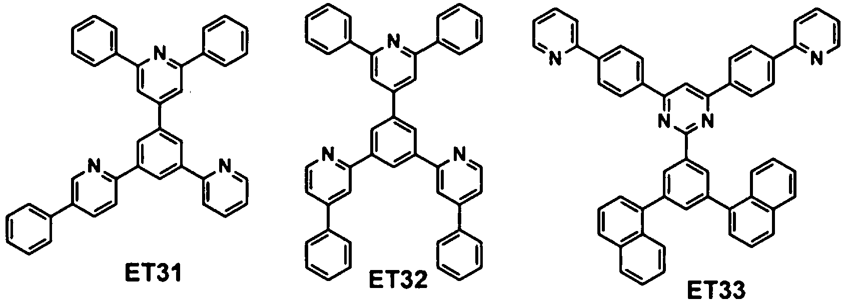

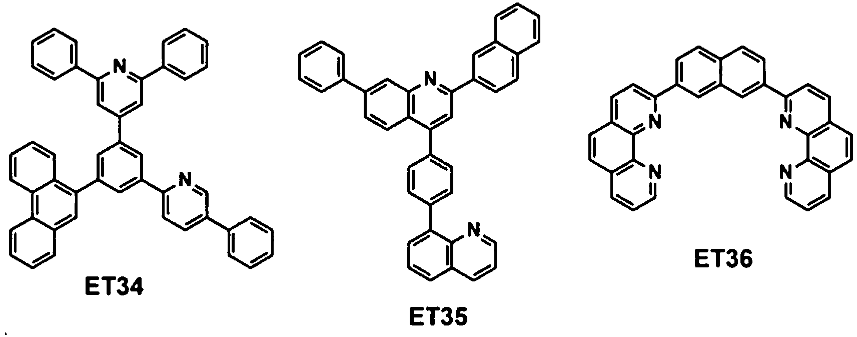

In addition, the electron transport region ETR may include halogenated metals such as LiF, NaCl, CsF, RbCl, RbI, Cul, KI, or the like; lanthanide metals such as Yb, or the like; or co-deposition materials of a halogenated metal and a lanthanide metal. For example, the electron transport region ETR may include KI:Yb, RbI:Yb, LiF:Yb, or the like as a co-deposition material. For the electron transport region ETR, a metal oxide such as Li₂O or BaO, 8-hydroxyl-lithium quinolate (Liq), or the like may be used, but embodiments are not limited thereto. The electron transport region ETR may also be formed of a mixture material of an electron transport material and an insulating organo-metal salt. The organo-metal salt may be a material having an energy band gap of about 4 eV or greater. Specifically, the organo-metal salt may include, for example, metal acetates, metal benzoates, metal acetoacetates, metal acetylacetonates, metal stearates, or a combination thereof.

The electron transport region ETR may further include, for example, at least one of 2,9-dimethyl-4,7-diphenyl-1,10-phenanthroline (BCP), diphenyl(4-(triphenylsilyl)phenyl)phosphine oxide (TSPO1), or 4,7-diphenyl-1,10-phenanthroline (Bphen) in addition to the materials described above, but embodiments are not limited thereto.

The electron transport region ETR may include the compounds of the electron transport region described above in at least one among the electron injection layer EIL, the electron transport layer ETL, and the hole blocking layer HBL.

When the electron transport region ETR includes the electron transport layer ETL, the electron transport layer ETL may have a thickness of about 100 Å to about 1000 Å, for example, about 150 Å to about 500 Å. When the thickness of the electron transport layer ETL satisfies the above-described range, satisfactory electron transport properties may be obtained without a substantial increase in driving voltage. When the electron transport region ETR includes the electron injection layer EIL, the electron injection layer EIL may have a thickness of about 1 Å to about 100 Å, for example, about 3 Å to about 90 Å. When the thickness of the electron injection layer EIL satisfies the above-described ranges, satisfactory electron injection properties may be obtained without a substantial increase in driving voltage.

The second electrode EL2 is provided on the electron transport region ETR. The second electrode EL2 may be a common electrode. The second electrode EL2 may be a cathode or an anode but embodiments are not limited thereto. For example, when the first electrode EL1 is an anode, the second electrode EL2 may be a cathode, and when the first electrode EL1 is a cathode, the second electrode EL2 may be an anode.

The second electrode EL2 may be a transmissive electrode, a transflective electrode, or a reflective electrode. When the second electrode EL2 is a transmissive electrode, the second electrode EL2 may be formed of a transparent metal oxide, for example, indium tin oxide (ITO), indium zinc oxide (IZO), zinc oxide (ZnO), indium tin zinc oxide (ITZO), or the like, or a combination thereof.

When the second electrode EL2 is a transflective electrode or a reflective electrode, the second electrode EL2 may include Ag, Mg, Cu, Al, Pt, Pd, Au, Ni, Nd, Ir, Cr, Li, Ca, LiF/Ca, LiF/Al, Mo, Ti, Yb, W, a compound thereof, or a mixture thereof (e.g., AgMg, AgYb, or MgYb). Alternatively, the second electrode EL2 may have a multilayer structure including a reflective film or a transflective film formed of the above-described materials, and a transparent conductive film formed of indium tin oxide (ITO), indium zinc oxide (IZO), zinc oxide (ZnO), indium tin zinc oxide (ITZO), or the like. For example, the second electrode EL2 may include the above-described metal materials, a combination of two or more metal materials selected from the above-described metal materials, or oxides of the above-described metal materials.

Although not shown, the second electrode EL2 may be connected with an auxiliary electrode. When the second electrode EL2 is connected with the auxiliary electrode, the resistance of the second electrode EL2 may decrease.

A capping layer CPL may be further disposed on the second electrode EL2 of the light emitting element ED according to one or more embodiments. The capping layer CPL may include a multi-layer or a single layer.

In one or more embodiments, the capping layer CPL may be an organic layer or an inorganic layer. For example, when the capping layer CPL includes an inorganic material, the inorganic material may include an alkali metal compound such as LiF, an alkaline earth metal compound such as MgF₂, SiON, SiN_{X}, SiO_{y}, or the like.

For example, when the capping layer CPL includes an organic material, the organic material may include α-NPD, NPB, TPD, m-MTDATA, Alq₃ CuPc, N4,N4,N4',N4'-tetra(biphenyl-4-yl) biphenyl-4,4'-diamine (TPD15), 4,4',4"-tris(carbazol-9-yl)triphenylamine (TCTA), or the like or may include an epoxy resin or acrylate such as methacrylate. However, embodiments are not limited thereto, and the capping layer CPL may include at least one of compounds P1 to P5.

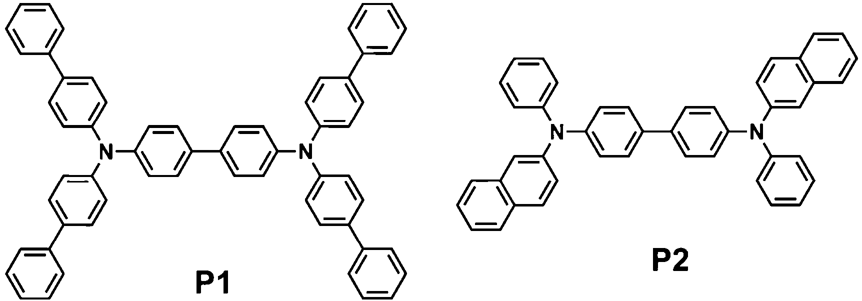

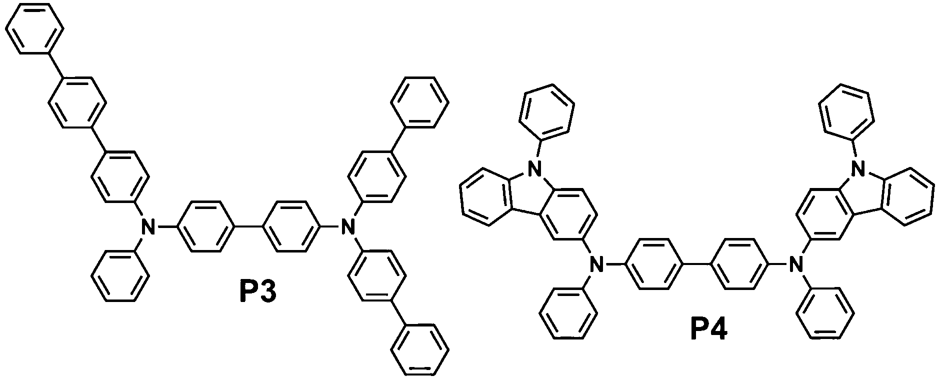

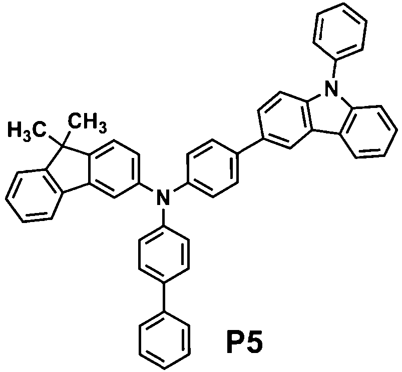

The capping layer CPL may have a refractive index of about 1.6 or greater. To be specific, the capping layer CPL may have a refractive index of about 1.6 or greater in a wavelength of about 550 nm to about 660 nm.

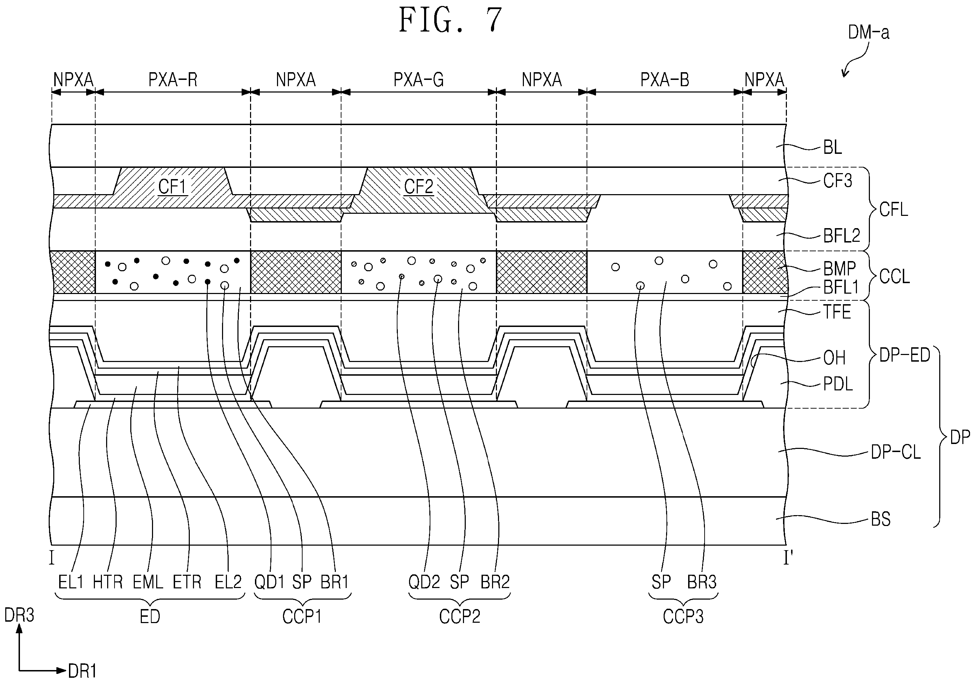

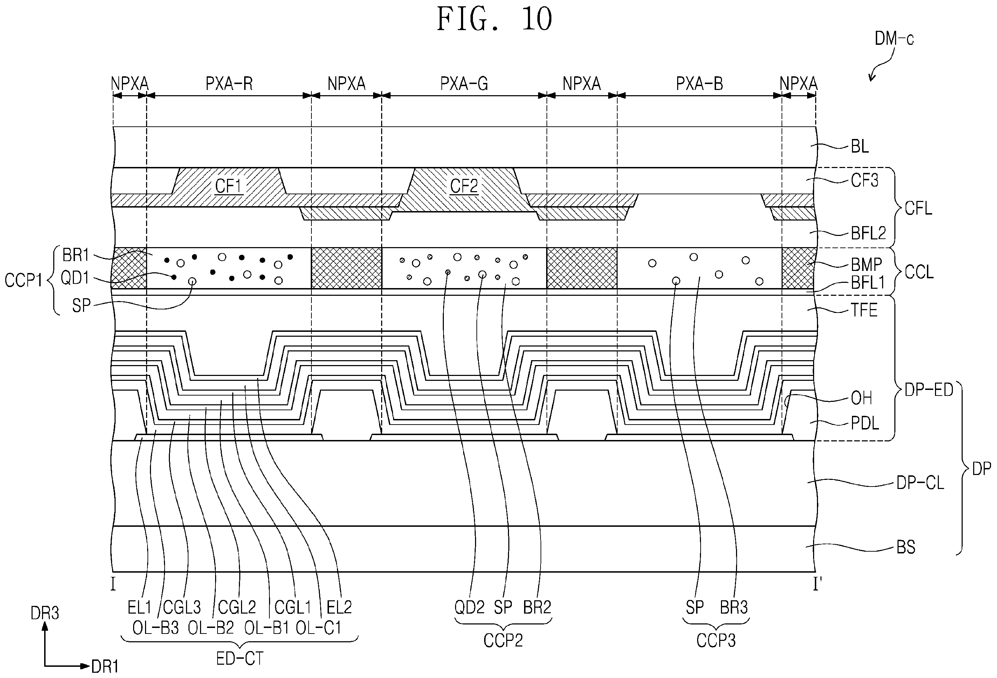

FIGS. 7 to 10 are each a cross-sectional view of a display module according to one or more embodiments. Hereinafter, in the description of the display module according to one or more embodiments with reference to FIGS. 7 and 10, content overlapping the one described above with reference to FIGS. 1 to 6 will not be described again, and the differences will be mainly described.

Referring to FIG. 7, a display module DM-a according to one or more embodiments may include a display panel DP having a display element layer DP-ED, a light control layer CCL disposed on the display panel DP, and a color filter layer CFL. In one or more embodiments shown in FIG. 7, the display panel DP may include a base layer BS, a circuit layer DP-CL provided on the base layer BS, and a display element layer DP-ED, and the element layer DP-ED may include a light emitting element ED.

The light emitting element ED may include a first electrode EL1, a hole transport region HTR disposed on the first electrode EL1, an emission layer EML disposed on the hole transport region HTR, an electron transport region ETR disposed on the emission layer EML, and a second electrode EL2 disposed on the electron transport region ETR. A structure of the light emitting element ED shown in FIG. 7 may be the same as the structure of the light emitting element ED of FIGS. 3 to 6 described above.

Referring to FIG. 7, the emission layer EML may be disposed in the openings OH defined in the pixel defining films PDL. For example, the emission layer EML separated by the pixel defining films PDL and provided corresponding to each of light emitting regions PXA-R, PXA-G, and PXA-B may emit light in the same wavelength ranges. In the display module DM-a according to one or more embodiments, the emission layer EML may emit a blue light. Unlike what is shown, in one or more embodiments, the emission layer EML may be provided as a common layer throughout the light emitting regions PXA-R, PXA-G, and PXA-B.

The light control layer CCL may be disposed on the display panel DP. The light control layer CCL may include a light converter. The light converter may be a quantum dot or a phosphor. The light converter may wavelength-convert the provided light and emit the wavelength-converted light. That is, the light control layer CCL may be a layer containing quantum dots or phosphors.

The light control layer CCL may include a plurality of light control units CCP1, CCP2, and CCP3. The light control units CCP1, CCP2, and CCP3 may be spaced apart from one another.

Referring to FIG. 7, a division pattern BMP may be disposed between the light control units CCP1, CCP2, and CCP3 spaced apart from each other, but embodiments are not limited thereto. In FIG. 7, the division pattern BMP is shown to nonoverlap the light control units CCP1, CCP2, and CCP3, but edges of the light control units CCP1, CCP2, and/or CCP3 may overlap at least a portion of the division pattern BMP.

The light control layer CCL may include a first light control unit CCP1 including a first quantum dot QD1 for converting first color light provided from the light emitting element ED into second color light, a second light control unit CCP2 including a second quantum dot QD2 for converting the first color light into third color light, and a third light control unit CCP3 transmitting the first color light.

In one or more embodiments, the first light control unit CCP1 may provide a red light, which is the second color light, and the second light control unit CCP2 may provide a green light, which is the third color light. The third light control unit CCP3 may transmit and provide a blue light, which is the first color light provided from the light emitting element ED. For example, the first quantum dot QD1 may be a red quantum dot and the second quantum dot QD2 may be a green quantum dot. The same descriptions above may be applied to the quantum dots QD1 and QD2.

In addition, the light control layer CCL may further include scatterers SP. The first light control unit CCP1 may include the first quantum dot QD1 and the scatterers SP, the second light control unit CCP2 may include the second quantum dot QD2 and the scatterers SP, and the third light control unit CCP3 may not include a quantum dot but may include the scatterers SP.

The scatterers SP may be inorganic particles. For example, the scatterers SP may include at least one among TiO₂, ZnO, Al₂O₃, SiO₂, or hollow silica. The scatterers SP may include one of TiO₂, ZnO, Al₂O₃, SiO₂, or hollow silica, or may be a mixture of two or more materials selected from TiO₂, ZnO, Al₂O₃, SiO₂, or hollow silica.

The first light control unit CCP1, the second light control unit CCP2, and the third light control unit CCP3 may each include base resins BR1, BR2, and BR3 for dispersing the quantum dots QD1 and QD2 and the scatterers SP. In one or more embodiments, the first light control unit CCP1 may include the first quantum dot QD1 and the scatterers SP dispersed in the first base resin BR1, the second light control unit CCP2 may include the second quantum dot QD2 and the scatterers SP dispersed in the second base resin BR2, and the third light control unit CCP3 may include the scatterers SP dispersed in the third base resin BR3.

The base resins BR1, BR2, and BR3 are a medium in which the quantum dots QD1 and QD2 and the scatterers SP are dispersed, and may be formed of various resin compositions, which may be generally referred to as a binder. For example, the base resins BR1, BR2, and BR3 may be an acrylic-containing resin, a urethane-containing resin, a silicone-containing resin, an epoxy-containing resin, or the like, or a combination thereof. Base resins BR1, BR2, and BR3 may be transparent resins. In one or more embodiments, the first base resin BR1, the second base resin BR2, and the third base resin BR3 may each be the same as or different from each other.

The light control layer CCL may include a barrier layer BFL1. The barrier layer BFL1 may serve to prevent moisture and/or oxygen (hereinafter referred to as "moisture/oxygen") from being introduced. The barrier layer BFL1 may be disposed on the light control units CCP1, CCP2, and CCP3 to prevent the light control units CCP1, CCP2, and CCP3 from being exposed to moisture/oxygen. The barrier layer BFL1 may cover the light control units CCP1, CCP2, and CCP3. In addition, a barrier layer BFL2 may be provided between the light control units CCP1, CCP2, and CCP3 and the color filter layer CFL.

The barrier layers BFL1 and BFL2 may include at least one inorganic layer. That is, the barrier layers BFL1 and BFL2 may be formed of an inorganic material. For example, the barrier layers BFL1 and BFL2 may be formed including silicon nitride, aluminium nitride, zirconium nitride, titanium nitride, hafnium nitride, tantalum nitride, silicon oxide, aluminium oxide, titanium oxide, tin oxide, cerium oxide, silicon oxynitride, or a metal thin film in which light transmittance is possible, or the like, or a combination thereof. The barrier layers BFL1 and BFL2 may further include an organic film. The barrier layers BFL1 and BFL2 may be formed of a single layer or a plurality of layers.

In the display module DM-a according to one or more embodiments, the color filter layer CFL may be disposed on the light control layer CCL. For example, the color filter layer CFL may be directly disposed on the light control layer CCL. In this case, the barrier layer BFL2 may be omitted.

The color filter layer CFL may include filters CF1, CF2, and CF3. That is, the color filter layer CFL may include a first filter CF1 transmitting second color light, a second filter CF2 transmitting third color light, and a third filter CF3 transmitting first color light. For example, the first filter CF1 may be a red filter, the second filter CF2 may be a green filter, and the third filter CF3 may be a blue filter. The filters CF1, CF2, and CF3 may each include a polymer photosensitive resin, a pigment or a dye. The first filter CF1 may include a red pigment or a red dye, the second filter CF2 may include a green pigment or a green dye, and the third filter CF3 may include a blue pigment or a blue dye.

Embodiments are not limited thereto, and the third filter CF3 may not include a pigment or a dye. The third filter CF3 may include a polymer photosensitive resin, but not include a pigment or a dye. The third filter CF3 may be transparent. The third filter CF3 may be formed of a transparent photosensitive resin.

In addition, in one or more embodiments, the first filter CF1 and the second filter CF2 may be yellow filters. The first filter CF1 and the second filter CF2 may not be separated and may be provided as a single body.

Although not shown, the color filter layer CFL may further include a light blocking unit (not shown). The light blocking unit may be a black matrix. The light blocking unit may be formed including an organic light blocking material or an inorganic light blocking material, both including a black pigment or a black dye. The light blocking unit may prevent light leakage, and separate boundaries between the adjacent filters CF1, CF2, and CF3. In addition, in one or more embodiments, the light blocking unit may be formed with a blue filter.

The first to third filters CF1, CF2, and CF3 may be disposed corresponding to the red light emitting region PXA-R, the green light emitting region PXA-G, and the blue light emitting region PXA-B, respectively.

The base substrate BL may be disposed on the color filter layer CFL. The base substrate BL may be a member providing a base surface on which the color filter layer CFL and the light control layer CCL are disposed. The base substrate BL may be a glass substrate, a metal substrate, a plastic substrate, or the like. However, embodiments are not limited thereto, and the base substrate BL may be an inorganic layer, an organic layer, or a composite material layer. In addition, unlike what is shown, the base substrate BL may not be provided in one or more embodiments.

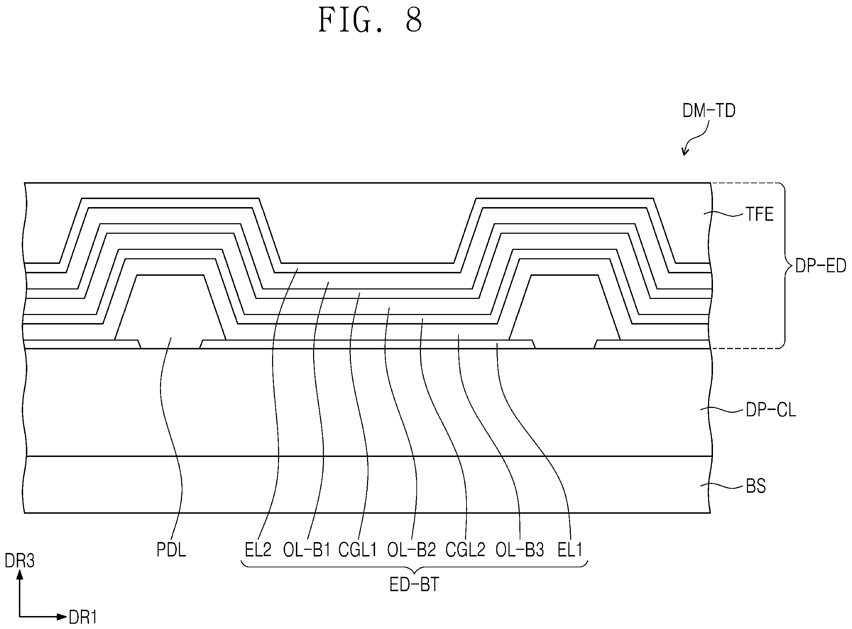

FIG. 8 is a cross-sectional view showing a portion of a display module according to one or more embodiments. In a display module DM-TD according to one or more embodiments, a light emitting element ED-BT may include a plurality of light emitting structures OL-B1, OL-B2, and OL-B3. The light emitting element ED-BT may include the first electrode EL1 and the second electrode EL2 facing each other, and the plurality of light emitting structures OL-B1, OL-B2, and OL-B3 provided by being sequentially stacked in a thickness direction between the first electrode EL1 and the second electrode EL2. The light emitting structures OL-B1, OL-B2, and OL-B3 each may include a hole transport region HTR, an electron transport region ETR, and the emission layer EML (FIG. 7) disposed between the hole transport region HTR and the electron transport region ETR. That is, the light emitting element ED-BT included in the display module DM-TD according to one or more embodiments may be a light emitting element having a tandem structure including a plurality of emission layers.

In one or more embodiments shown in FIG. 8, light emitted from each of the light emitting structures OL-B1, OL-B2, and OL-B3 may be blue light. However, embodiments are not limited thereto, and wavelength ranges of light emitted from each of the light emitting structures OL-B1, OL-B2, and OL-B3 may be different from each other. For example, the light emitting element ED-BT including the plurality of light emitting structures OL-B1, OL-B2, and OL-B3 emitting light in different wavelength ranges may emit white light.

Charge generation layers CGL1 and CGL2 may be disposed between neighboring light emitting structures OL-B1, OL-B2, and OL-B3. The charge generation layers CGL1 and CGL2 may include a p-type charge generation layer and/or an n-type charge generation layer.

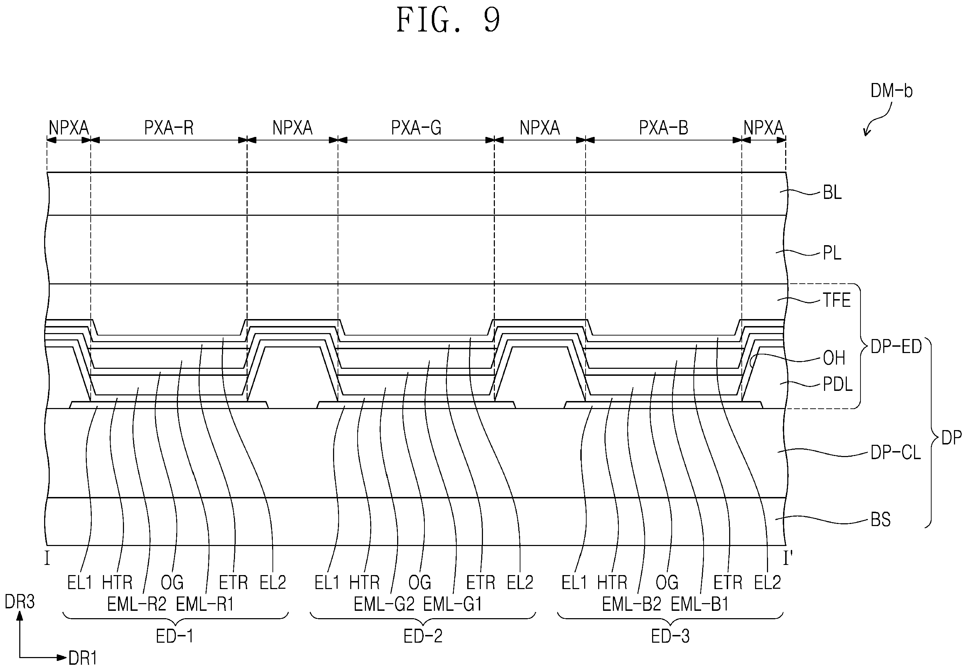

Referring to FIG. 9, a display module DM-b according to one or more embodiments may include light emitting elements ED-1, ED-2, and ED-3 in which two emission layers are stacked. Compared to the display module DM according to one or more embodiments shown in FIG. 2, the difference is that in one or more embodiments shown in FIG. 9, the first to third light emitting elements ED-1, ED-2, and ED-3 each include two emission layers stacked in a thickness direction. In each of the first to third light emitting elements ED-1, ED-2, and ED-3, the two emission layers may emit light in the same wavelength range.

The first light emitting element ED-1 may include a first red emission layer EML-R1 and a second red emission layer EML-R2. The second light emitting element ED-2 may include a first green emission layer EML-G1 and a second green emission layer EML-G2. In addition, the third light emitting element ED-3 may include a first blue emission layer EML-B1 and a second blue emission layer EML-B2. A light emitting auxiliary portion OG may be disposed between the first red emission layer EML-R1 and the second red emission layer EML-R2, between the first green emission layer EML-G1 and the second green emission layer EML-G2, and between the first blue emission layer EML-B1 and the second blue emission layer EML-B2.

The light emitting auxiliary portion OG may include a single layer or multiple layers. The light emitting auxiliary portion OG may include a charge generation layer. To be more specific, the light emitting auxiliary portion OG may include an electron transport region, a charge generation layer, and a hole transport region that are sequentially stacked. The light emitting auxiliary portion OG may be provided as a common layer throughout the first to third light emitting elements ED-1, ED-2, and ED-3. However, embodiments are not limited thereto, and the light emitting auxiliary portion OG may be provided to be patterned inside the openings OH defined in the pixel defining films PDL.

The first red emission layer EML-R1, the first green emission layer EML-G1, and the first blue emission layer EML-B1 may be disposed between the light emitting auxiliary portion OG and the electron transport region ETR. The second red emission layer EML-R2, the second green emission layer EML-G2, and the second blue emission layer EML-B2 may be disposed between the hole transport region HTR and the light emitting auxiliary portion OG.

That is, the light emitting element ED-1 may include the first electrode EL1, the hole transport region HTR, the second red emission layer EML-R2, the emission auxiliary portion OG, the first red emission layer EML-R1, the electron transport region ETR, and the second electrode EL2, which are sequentially stacked. The second light emitting element ED-2 may include the first electrode EL1, the hole transport region HTR, the second green emission layer EML-G2, the emission auxiliary portion OG, the first green emission layer EML-G1, the electron transport region ETR, and the second electrode EL2, which are sequentially stacked. The third light emitting element ED-3 may include the first electrode EL1, the hole transport region HTR, the second blue emission layer EML-B2, the emission auxiliary portion OG, the first blue emission layer EML-B1, the electron transport region ETR, and the second electrode EL2, which are sequentially stacked.

An optical auxiliary layer PL may be disposed on the display element layer DP-ED. The optical auxiliary layer PL may include a polarizing layer. The optical auxiliary layer PL may be disposed on the display panel DP to control reflected light in the display panel DP due to external light. Unlike what is shown, the optical auxiliary layer PL may not be provided in the display module according to one or more embodiments.

Unlike FIGS. 8 and 9, a display module DM-c of FIG. 10 is shown to include four light emitting structures OL-B1, OL-B2, OL-B3, and OL-C1. The light emitting element ED-BT may include the first electrode EL1 and the second electrode EL2 facing each other, and the first to fourth light emitting structures OL-B1, OL-B2, OL-B3, and OL-C1 sequentially stacked in a thickness direction between the first electrode EL1 and the second electrode EL2. Charge generation layers CGL1, CGL2, and CGL3 may be disposed between the first to fourth light emitting structures OL-B1, OL-B2, OL-B3, and OL-C1. Among the four light emitting structures, the first to third light emitting structures OL-B1, OL-B2, and OL-B3 may emit a blue light, and the fourth light emitting structure OL-C1 may emit a green light. However, embodiments are not limited thereto, and the first to fourth light emitting structures OL-B1, OL-B2, OL-B3, and OL-C1 may emit light having different wavelength ranges.

The charge generation layers CGL1, CGL2, and CGL3 disposed between the neighboring light emitting structures OL-B1, OL-B2, OL-B3, and OL-C1 may include a p-type charge generation layer and/or an n-type charge generation layer.

In one or more embodiments, an electronic device may include a display module including a plurality of light emitting elements, and a control portion configured to control the display module. The electronic device according to one or more embodiments may be a device activated in response to electrical signals. The electronic device may include electronic devices of various embodiments. For example, the electronic device may include large-sized electronic devices such as televisions, monitors, or outdoor billboards, as well as small- and medium-sized electronic devices such as personal computers, laptop computers, personal digital terminals, in-vehicle display devices, game consoles, portable electronic devices, or cameras.

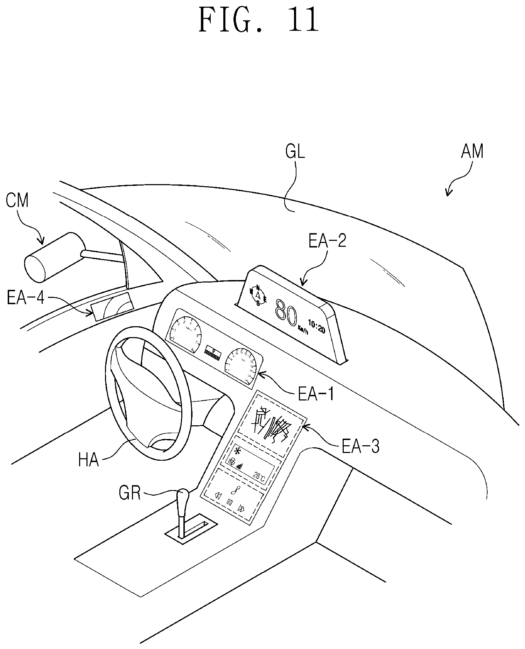

FIG. 11 is a view showing a vehicle AM in which first to fourth electronic devices EA-1, EA-2, EA-3, and EA-4 are disposed. At least one of the first to fourth electronic devices EA-1, EA-2, EA-3, and EA-4 may have the same configuration as the display modules DM, DM-TD, DM-a, DM-b, and/or DM-c according to one or more embodiments described with reference to FIGS. 1, 2, and 7 to 10.

FIG. 11 shows a car as the vehicle AM, but this is presented as an example, and the first to fourth electronic devices EA-1, EA-2, EA-3, and EA-4 may be disposed on other means of transportation, such as bicycles, motorcycles, trains, ships, and airplanes. In addition, at least one of the first to fourth electronic devices EA-1, EA-2, EA-3, and EA-4 having the same configuration as the display modules DM, DM-TD, DM-a, DM-b, and/or DM-c according to one or more embodiments may be adopted for personal computers, laptop computers, personal digital terminals, game consoles, portable electronic devices, televisions, monitors, outdoor billboards, or the like. In addition, these are merely presented as exemplary embodiments, and thus the electronic device may be adopted for other electronic devices without departing from the disclosure.

At least one of the first to fourth electronic devices EA-1, EA-2, EA-3, or EA-4 may include the light emitting element ED described with reference to FIGS. 3 to 6.

Referring to FIG. 11, the vehicle AM may include a wheel HA and a gear GR for operating the vehicle AM, and have a front window GL disposed to face a driver.

The first electronic device EA-1 may be disposed in a first region overlapping the wheel HA. For example, the first electronic device EA-1 may be a digital cluster displaying first information of the vehicle AM. The first information may include a first scale indicating driving speed of the vehicle AM, a second scale indicating engine revolutions (i.e., revolutions per minute (RPM)), and an image indicating fuel gauge, or the like. The first scale and the second scale may be displayed as digital images.

The second electronic device EA-2 may be disposed in a second region facing a driver seat and overlapping the front window GL. The driver seat may be a seat in which the wheel HA is disposed. For example, the second electronic device EA-2 may be a head up display (HUD) displaying second information of the vehicle AM. The second electronic device EA-2 may be optically transparent. The second information includes digital numbers indicating driving speed of the vehicle AM and may further include information such as current time. Unlike what is shown, the second information of the second electronic device EA-2 may be projected and displayed on the front window GL.

The third electronic device EA-3 may be disposed in a third region adjacent to the gear GR. For example, the third display device EA-3 may be a center information display CID for a vehicle, which is disposed between a driver seat and a passenger seat, and displays third information. The passenger seat may be a seat spaced apart from the driver seat with the gear GR therebetween. The third information may include information about road conditions (e.g., navigation information), music or radio play, dynamic video play, temperature inside the vehicle AM, or the like.

The fourth display device EA-4 may be disposed in a fourth region spaced apart from the wheel HA and the gear GR and adjacent to a side of the vehicle AM. For example, the fourth electronic device EA-4 may be a digital side mirror displaying fourth information. The fourth electronic device EA-4 may display images of conditions outside the vehicle AM, which are taken by the camera module CM disposed outside the vehicle AM. The fourth information may include images of conditions outside the vehicle AM.

The first to fourth information described above are presented as an example, and the first to fourth electronic devices EA-1, EA-2, EA-3, and EA-4 may further display information about inside or outside a vehicle. The first to fourth information may include different information. However, embodiments are not limited thereto, and some of the first to fourth information may include the same information.

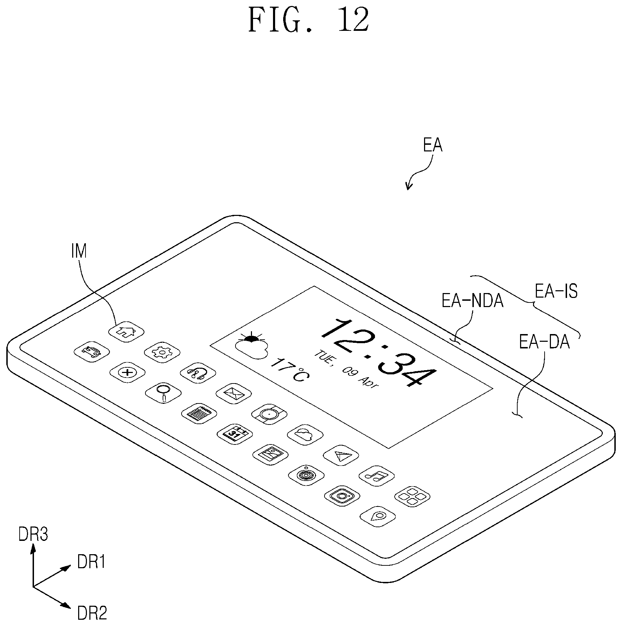

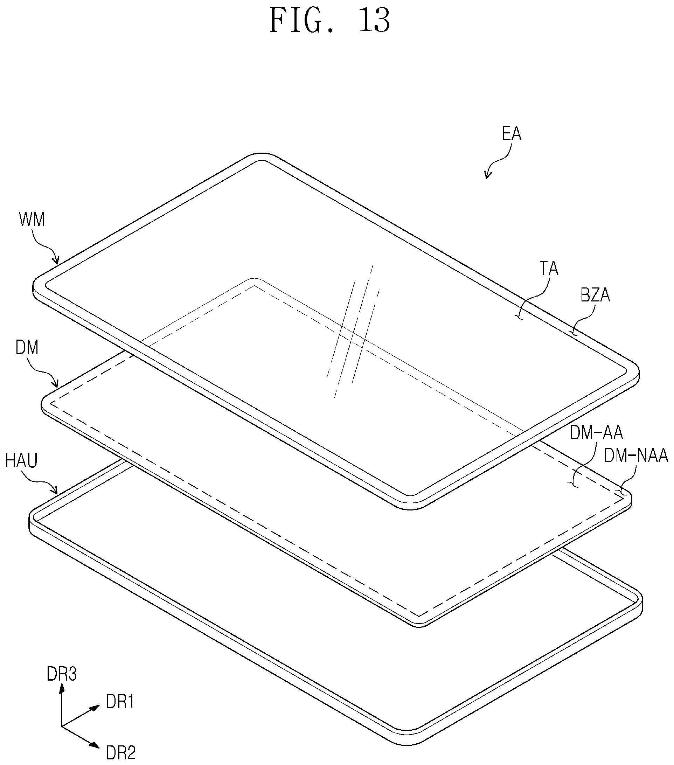

FIG. 12 is a perspective view showing an electronic device of one or more embodiments. FIG. 13 is an exploded perspective view showing an electronic device of one or more embodiments.

An electronic device EA may display an image IM through a display surface EA-IS. The image IM may include still images as well as dynamic images. The display surface EA-IS may be parallel to a plane defined by a first directional axis DR1 and a second directional axis DR2. FIG. 12 shows an electronic device EA provided with a flat display surface EA-IS, but embodiments are not limited thereto. For example, the electronic device EA may include a curved display surface or a three-dimensional display surface. The three-dimensional display surface may include a plurality of display regions indicating different directions.

The display surface EA-IS may include a display region EA-DA and a non-display region EA-NDA. The electronic device EA may display the image IM through the display region EA-DA.

The non-display region EA-NDA may have a selected color. The non-display region EA-NDA may be adjacent to the display region EA-DA. The non-display region EA-NDA may surround the display region EA-DA. Accordingly, the shape of the display region EA-DA may be defined substantially by the non-display region EA-NDA. However, FIG. 12 is presented as an example, and the non-display region EA-NDA may be disposed adjacent to only one side of the display region EA-DA, or may not be provided.

Referring to FIG. 13, the electronic device EA may include a display module DM. In addition, the electronic device EA may further include a window member WM and a housing HAU.

The window member WM may cover an entire outer portion of the electronic device EA. The window member WM may include a transmission region TA and a bezel region BZA. A front surface of the window member WM including the transmission region TA and the bezel region BZA may serve as a front surface of the electronic device EA. The transmission region TA may correspond to the display region EA-DA of the electronic device EA shown in FIG. 12, and the bezel region BZA may correspond to the non-display region EA-NDA of the electronic device EA shown in FIG. 12.

The transmission region TA may be an optically transparent region. The bezel region BZA may be a region having a relatively lower light transmittance than the transmission region TA. The bezel region BZA may have a prescribed color. The bezel region BZA may be adjacent to the transmission region TA and may surround the transmission region TA. The bezel region BZA may define a shape of the transmission region TA. However, embodiments are not limited to what is shown, and the bezel region BA may be disposed adjacent to only one side of the transmission region TA, and a portion thereof may not be provided.

The housing HAU may include a material having a relatively greater rigidity. For example, the housing HAU may include frames and/or plates formed of glass, plastic, or metal. The frames and/or plates may be provided in plurality. The housing HAU may provide a prescribed place for accommodation. The display module DM may be accommodated in the accommodation space so as to be provided from an external impact.

The display module DM may have the same configuration as at least one of the display modules DM, DM-TD, DM-a, DM-b, or DM-c according to one or more embodiments described with reference to FIGS. 1, 2, and 7 to 10. The display module DM may include the light emitting element ED described with reference to FIGS. 3 to 6. Accordingly, the electronic device EA including the display module DM according to one or more embodiments may exhibit excellent reliability.

In the display module DM, an active region DM-AA and a peripheral region DM-NAA may be defined. The active region DM-AA may overlap the display region EA-DA shown in FIG. 12, and the peripheral region DM-NAA may overlap the non-display region EA-NDA shown in FIG. 12.

The active region DM-AA may be a region activated according to electrical signals. The peripheral region DM-NAA may be a region adjacent to at least one side of the active region DM-AA. The active region DM-AA may include a non-light emitting region NPXA and light emitting regions PXA-R, PXA-G, and PXA-R shown in FIG. 1. The peripheral region DM-NAA may cover the active region DM-AA. However, embodiments are not limited thereto, and a portion of the peripheral region DM-NAA may be omitted unlike what is shown. A driving circuit, a driving line, or the like for driving the active region DM-AA may be disposed in the peripheral region DM-NAA.

The display module according to one or more embodiments may be applied to various electronic devices. The electronic device according to one or more embodiments may include the display module described herein, and may further include a module or device having additional functions in addition to the display module.

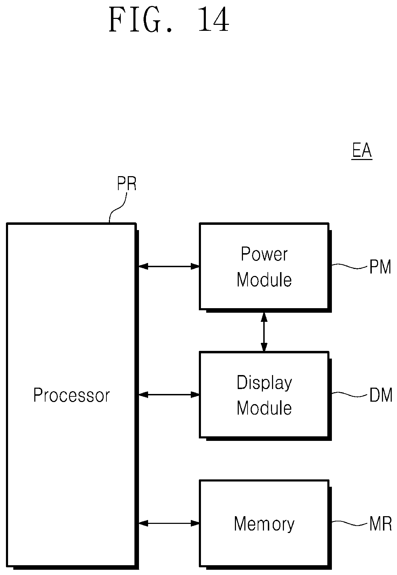

FIG. 14 is a block diagram of an electronic device according to one or more embodiments. Referring to FIG. 14, an electronic device EA according to one or more embodiments may include a display module DM, a processor PR, a memory MR, and a power module PM.

The processor PR may include at least one of a central processing unit (CPU), an application processor (AP), a graphic processing unit (GPU), a communication processor (CP), an image signal processor (ISP), or a controller.

The memory MR may store data information required for the operation of the processor PR or the display module DM. When the processor PR executes an application stored in the memory MR, image data signals and/or input control signals are transmitted to the display module DM, and the display module DM may process the received signal and output image information through a display screen.

The power module PM may include a power supply module such as a power adapter or a battery device, and a power conversion module that converts power supplied by the power supply module to generate power required for the operation of the electronic device EA.

At least one of the components of the electronic device EA described above may be included in the display device according to the above-described embodiments. In addition, some of the individual modules functionally included in one module may be included in the display device, and others may be separately provided from the display device. For example, the display device may include a display module DM, and the processor PR, the memory MR, and the power module PM may be provided in the form of other devices within the electronic device EA, rather than the display device.

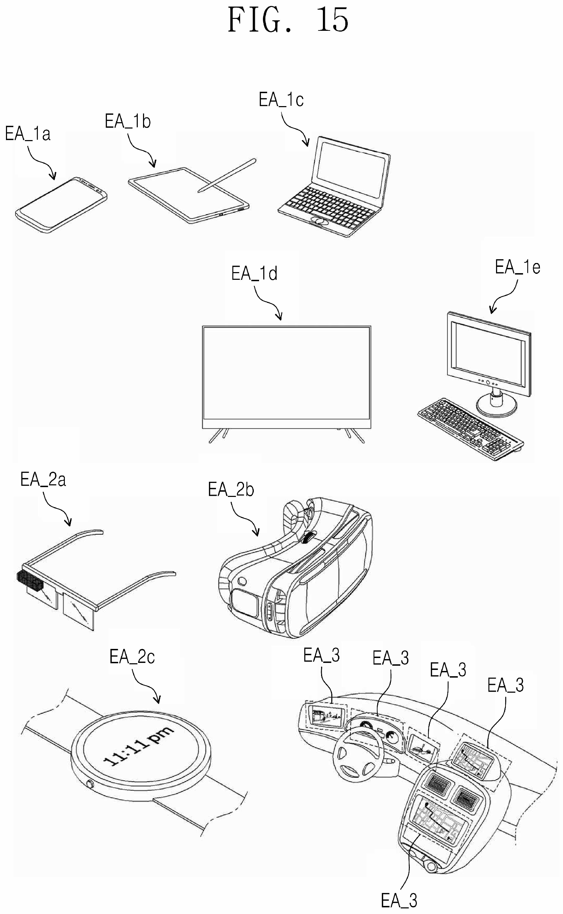

FIG. 15 shows schematic views of electronic devices according to various embodiments.

Referring to FIG. 15, various electronic devices to which the display module according to one or more embodiments is applied may include an electronic device for displaying images, such as a smart phone EA_1a, a tablet PC EA_1b, a laptop EA_1c, a TV EA_1d, and a desk monitor EA_1e, a wearable electronic device including a display module such as smart glasses EA_2a, a head mounted display EA_2b, and a smart watch EA_2c, and a vehicle electronic device EA_3 including a display module such as a center information display (CID) and a room mirror display disposed on an instrument panel, a center fascia, or a dashboard of a vehicle.

Hereinafter, with reference to Examples and Comparative Examples, a fused polycyclic compound represented by Formula 1 and a light emitting element according to one or more embodiments will be specifically described. In addition, Examples below are shown only for the understanding, and the scope of the disclosure is not limited thereto.

### EXAMPLES

### 1. Synthesis of fused polycyclic compounds represented by Formula 1

A process of synthesizing fused polycyclic compounds represented by Formula 1 according to one or more embodiments will be described in further detail by presenting a process of synthesizing fused polycyclic compounds D-4, B-4, C-3, and G-1 as examples. In addition, a process of synthesizing fused polycyclic compounds, which will be described hereinafter, is provided as an example, and thus a process of synthesizing compounds according to one or more embodiments is not limited to Examples below.

### (1) Synthesis of fused polycyclic compound D-4

Fused polycyclic compound D-4 according was synthesized by a process of Reaction Formula 1.

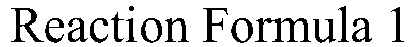

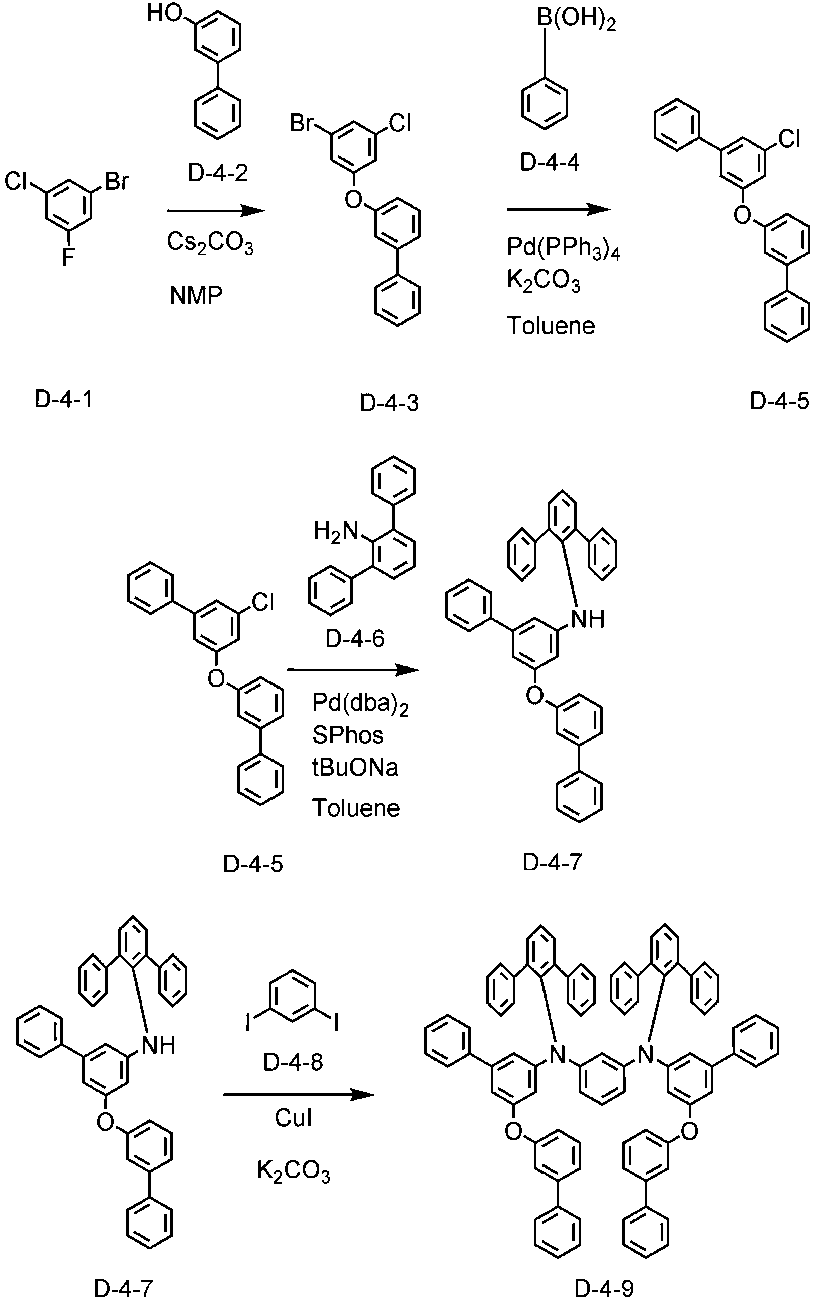

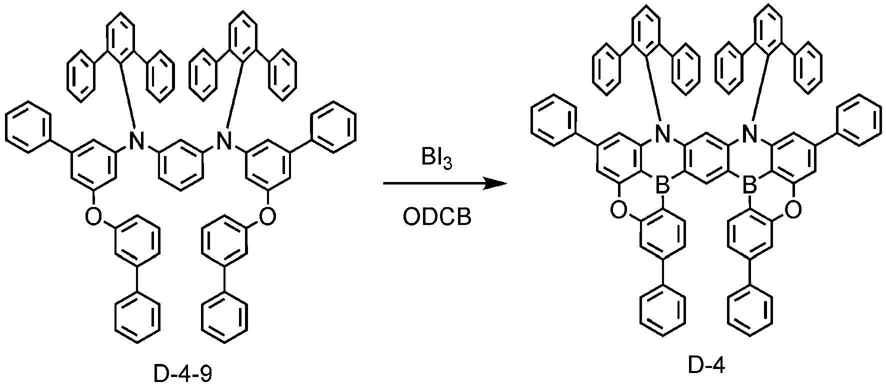

### Synthesis of Intermediate Compound D-4-3

D-4-1 (119 millimoles (mmol)), D-4-2 (125 mmol), and Cs₂CO₃ (179 mmol) were added to a three-necked flask and subjected to Ar substitution, and then 120 mL of N-methylpyrrolidone (NMP) was added and the mixture was stirred at 120 °C for 4 hours. Water was added to the reaction system, the organic layer was extracted using toluene. The organic layer was dried over magnesium sulfate and the solvent was removed under reduced pressure. The obtained crude product was purified using silica gel column chromatography (a mixed solvent of hexane/toluene) and recrystallization (a mixed solvent of ethanol/toluene) to obtain 80 mmol of a white solid (yield: 55%). The obtained purified product was determined to have a molecular weight of 359 g/mol through fast atom bombardment mass spectrometry (FABMS) measurement, indicating that the target Intermediate Compound D-4-3 was obtained.

### Synthesis of Intermediate Compound D-4-5

D-4-3 (80 mmol), D-4-4 (89 mmol), K₂CO₃ (120 mmol), and tetrakis(triphenylphosphine)palladium(0) (Pd(PPh₃)₄) (8 mmol) were added to a three-necked flask and subjected to Ar substitution, and then 800 mL of toluene was added and the mixture was stirred at 80 °C for 6 hours. Water was added to the reaction system, the organic layer was extracted using toluene. The organic layer was dried over magnesium sulfate and the solvent was removed under reduced pressure. The obtained crude product was purified using silica gel column chromatography (a mixed solvent of hexane/toluene) and recrystallization (a mixed solvent of ethanol/toluene) to obtain 40 mmol of a white solid (yield: 50%). The obtained purified product was determined to have a molecular weight of 357 g/mol through FABMS measurement, indicating that the target Intermediate Compound D-4-5 was obtained.

### Synthesis of Intermediate Compound D-4-7

D-4-5 (40 mmol), D-4-6 (50 mmol), tBuONa (120 mmol), bis(dibenzylideneacetone)palladium(0) (Pd(dba)₂) (8 mmol), and 2-dicyclohexylphosphino-2',6'-dimethoxybiphenyl (SPhos) (16 mmol) were added to a three-necked flask and subjected to Ar substitution, and then 200 mL of toluene was added and the mixture was stirred at 100 °C for 3 hours. Water was added to the reaction system, the organic layer was extracted using toluene. The organic layer was dried over magnesium sulfate and the solvent was removed under reduced pressure. The obtained crude product was purified using silica gel column chromatography (a mixed solvent of hexane/toluene) and recrystallization (a mixed solvent of ethanol/toluene) to obtain 23 mmol of a white solid (yield: 58%). The obtained purified product was determined to have a molecular weight of 566 g/mol through FABMS measurement, indicating that the target Intermediate Compound D-4-7 was obtained.

### Synthesis of Intermediate Compound D-4-9

D-4-7 (23 mmol), D-4-8 (23 mmol), K₂CO₃ (230 mmol), and CuI (23 mmol) were added to a three-necked flask and subjected to Ar substitution, and the mixture was stirred at 220 °C for 50 hours. Water was added to the reaction system, and the organic layer was extracted using toluene. The organic layer was dried over magnesium sulfate and the solvent was removed under reduced pressure. The obtained crude product was purified using silica gel column chromatography (a mixed solvent of hexane/toluene) and recrystallization (a mixed solvent of ethanol/toluene) to obtain 14 mmol of a white solid (yield: 60%). The obtained purified product was determined to have a molecular weight of 1206 g/mol through FABMS measurement, indicating that the target Intermediate Compound D-4-9 was obtained.

### Synthesis of Compound D-4

D-4-9 (14 mmol) was added to a three-necked flask and subjected to Ar substitution, and then 40 mL of ortho-dichlorobenzene (ODCB) was added and dissolved, and then BI₃ (56 mmol) was added and the mixture was stirred at 140 °C for 3 hours. The reaction solution was dispersed and washed using a large amount of acetonitrile, and the solid was collected through filtration. The obtained crude product was purified using silica gel column chromatography (a mixed solvent of hexane/dichloromethane) and recrystallization (a mixed solvent of ethanol/toluene) to obtain 5 mmol of a yellow solid (yield: 36%). The obtained purified product was determined to have a molecular weight of 1221 g/mol through FABMS measurement, indicating that the target Compound D-4 was obtained.

### (2) Synthesis of fused polycyclic compound B-4

Fused polycyclic compound B-4 was synthesized by a process of Reaction Formula 2.

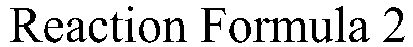

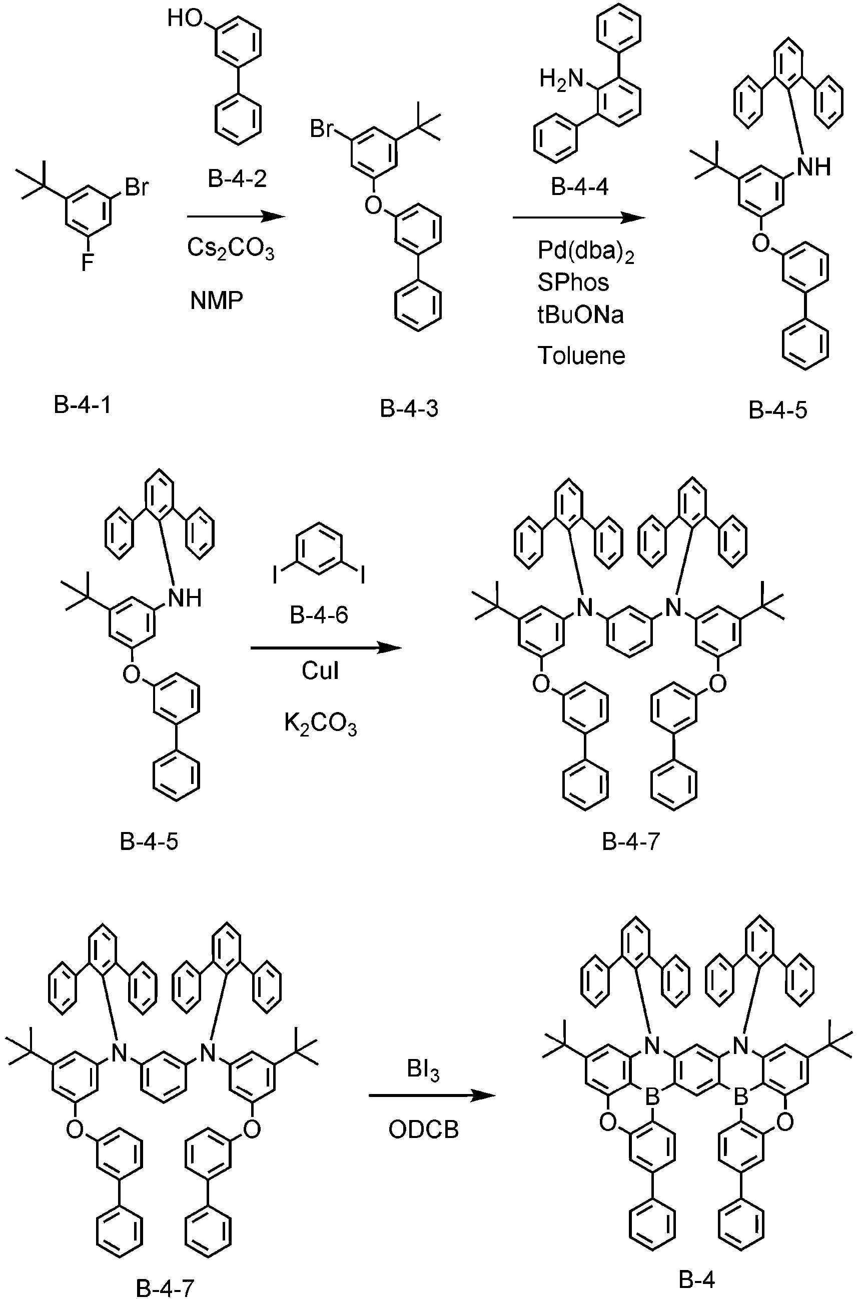

### Synthesis of Intermediate Compound B-4-3

B-4-1 (200 mmol), B-4-2 (210 mmol), and Cs₂CO₃ (400 mmol) were added to a three-necked flask and subjected to Ar substitution, and then 400 mL of NMP was added and the mixture was stirred at 120 °C for 10 hours. Water was added to the reaction system, and the organic layer was extracted using toluene. The organic layer was dried over magnesium sulfate and the solvent was removed under reduced pressure. The obtained crude product was purified using silica gel column chromatography (a mixed solvent of hexane/toluene) and recrystallization (a mixed solvent of ethanol/toluene) to obtain 120 mmol of a white solid (yield: 60%). The obtained purified product was determined to have a molecular weight of 381 g/mol through FABMS measurement, indicating that the target Intermediate Compound B-4-3 was obtained.

### Synthesis of Intermediate Compound B-4-5

B-4-3 (120 mmol), B-4-4 (130 mmol), tBuONa (240 mmol), Pd(dba)₂ (12 mmol), and SPhos (24 mmol) were added to a three-necked flask and subjected to Ar substitution, and then 1000 mL of toluene was added and the mixture was stirred at 100 °C for 5 hours. Water was added to the reaction system, and the organic layer was extracted using toluene. The organic layer was dried over magnesium sulfate and the solvent was removed under reduced pressure. The obtained crude product was purified using silica gel column chromatography (a mixed solvent of hexane/toluene) and recrystallization (a mixed solvent of ethanol/toluene) to obtain 79 mmol of a white solid (yield: 66%). The obtained purified product was determined to have a molecular weight of 546 g/mol through FABMS measurement, indicating that the target Intermediate Compound B-4-5 was obtained.

### Synthesis of Intermediate Compound B-4-7

B-4-5 (79 mmol), B-4-6 (79 mmol), K₂CO₃ (790 mmol), and CuI (79 mmol) were added to a three-necked flask and subjected to Ar substitution, and the mixture was stirred at 210°C for 36 hours. Water was added to the reaction system, and the organic layer was extracted using toluene. The organic layer was dried over magnesium sulfate and the solvent was removed under reduced pressure. The obtained crude product was purified using silica gel column chromatography (a mixed solvent of hexane/toluene) and recrystallization (a mixed solvent of ethanol/toluene) to obtain 26 mmol of a white solid (yield: 33%). The obtained purified product was determined to have a molecular weight of 1166 g/mol through FABMS measurement, indicating that the target Intermediate Compound B-4-7 was obtained.

### Synthesis of Compound B-4

B-4-7 (26 mmol) was added to a three-necked flask and subjected to Ar substitution, and then 60 mL of ODCB was added and dissolved, and then BI₃ (104 mmol) was added and the mixture was stirred at 140 °C for 4 hours. The reaction solution was dispersed and washed using a large amount of acetonitrile, and the solid was collected through filtration. The obtained crude product was purified using silica gel column chromatography (a mixed solvent of hexane/dichloromethane) and recrystallization (a mixed solvent of ethanol/toluene) to obtain 9 mmol of a yellow solid (yield: 35%). The obtained purified product was determined to have a molecular weight of 1181 g/mol through FABMS measurement, indicating that the target Compound B-4 was obtained.

### (3) Synthesis of fused polycyclic Compound C-3

Fused polycyclic Compound C-3 was synthesized by a process of Reaction Formula 3.

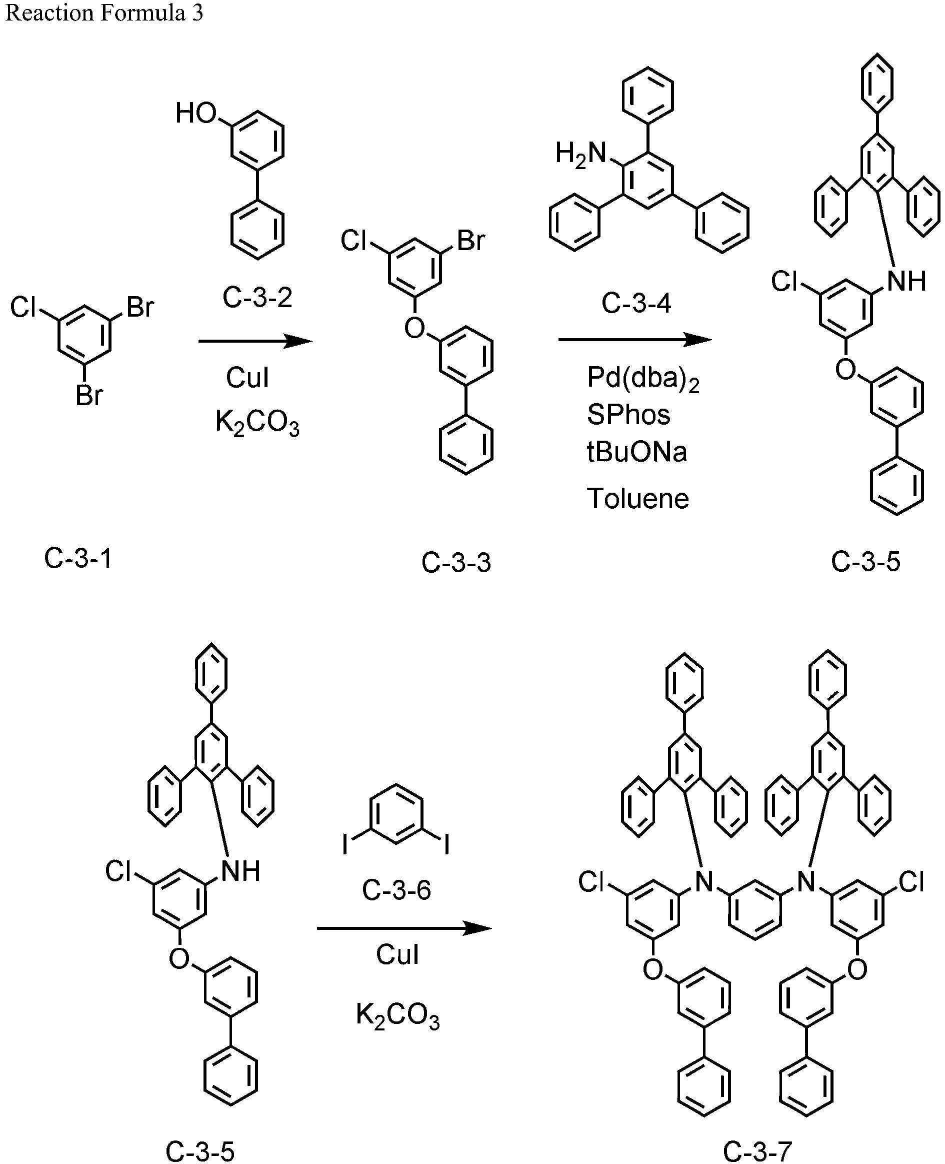

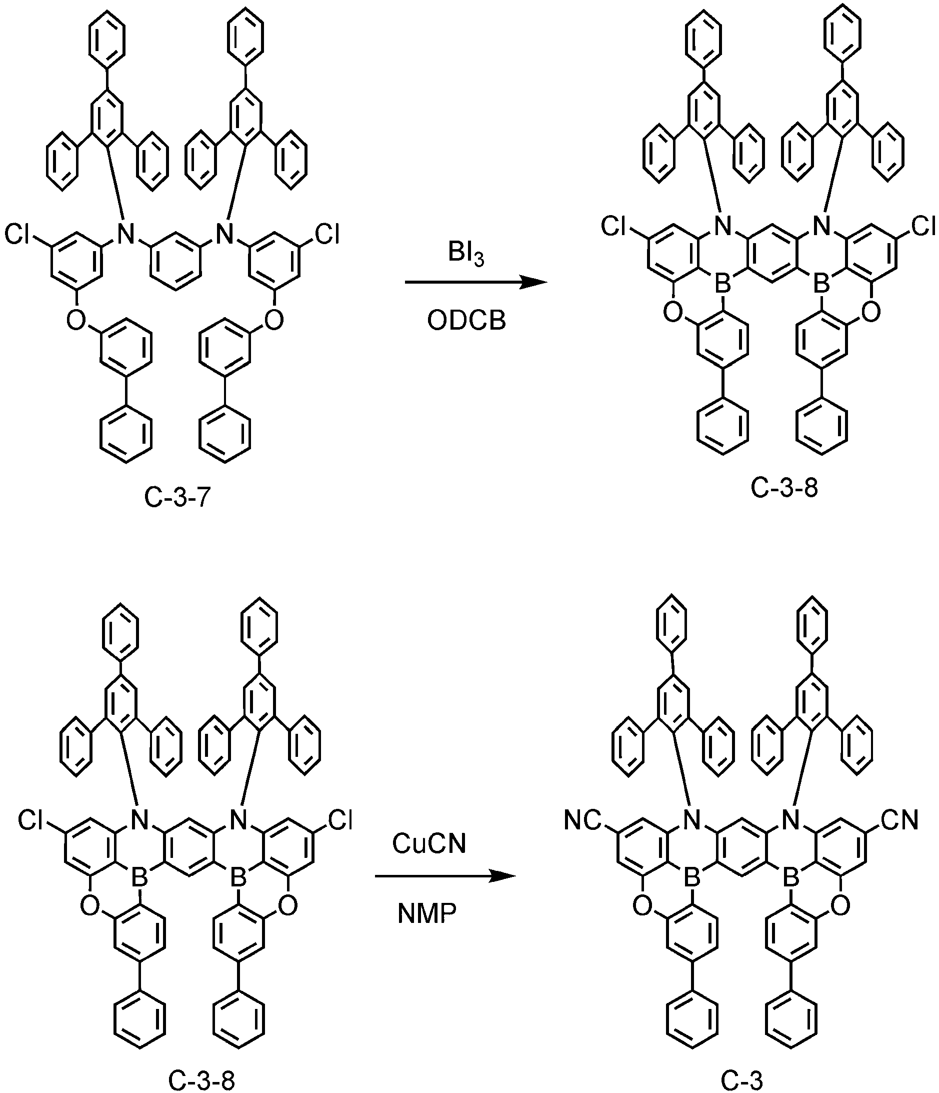

### Synthesis of Intermediate Compound C-3-3

C-3-1 (400 mmol), C-3-2 (200 mmol), K₂CO₃ (400 mmol), and CuI (200 mmol) were added to a three-necked flask and subjected to Ar substitution, and the mixture was stirred at 210 °C for 36 hours. Water was added to the reaction system, and the organic layer was extracted using toluene. The organic layer was dried over magnesium sulfate and the solvent was removed under reduced pressure. The obtained crude product was purified using silica gel column chromatography (a mixed solvent of hexane/toluene) and recrystallization (a mixed solvent of ethanol/toluene) to obtain 87 mmol of a white solid (yield: 44%). The obtained purified product was determined to have a molecular weight of 360 g/mol through FABMS measurement, indicating that the target Intermediate Compound C-3-3 was obtained.

### Synthesis of Intermediate Compound C-3-5

C-3-3 (87 mmol), C-3-4 (87 mmol), tBuONa (261 mmol), Pd(dba)₂ (9 mmol), and SPhos (18 mmol) were added to a three-necked flask and subjected to Ar substitution, and then 500 mL of toluene was added and the mixture was stirred at 100 °C for 2 hours. Water was added to the reaction system, and the organic layer was extracted using toluene. The organic layer was dried over magnesium sulfate and the solvent was removed under reduced pressure. The obtained crude product was purified using silica gel column chromatography (a mixed solvent of hexane/toluene) and recrystallization (a mixed solvent of ethanol/toluene) to obtain 60 mmol of a white solid (yield: 69%). The obtained purified product was determined to have a molecular weight of 600 g/mol through FABMS measurement, indicating that the target Intermediate Compound C-3-5 was obtained.

### Synthesis of Intermediate Compound C-3-7

C-3-5 (60 mmol), C-3-6 (30 mmol), K₂CO₃ (300 mmol), and CuI (60 mmol) were added to a three-necked flask and subjected to Ar substitution, and the mixture was stirred at 210 °C for 96 hours. Water was added to the reaction system, and the organic layer was extracted using toluene. The organic layer was dried over magnesium sulfate and the solvent was removed under reduced pressure. The obtained crude product was purified using silica gel column chromatography (a mixed solvent of hexane/toluene) and recrystallization (a mixed solvent of ethanol/toluene) to obtain 29 mmol of a white solid (yield: 48%). The obtained purified product was determined to have a molecular weight of 1274 g/mol through FABMS measurement, indicating that the target Intermediate Compound C-3-7 was obtained.

### Synthesis of Intermediate Compound C-3-8

C-3-7 (29 mmol) was added to a three-necked flask and subjected to Ar substitution, and then 20 mL of ODCB was added and dissolved, and then BI₃ (76 mmol) was added and the mixture was stirred at 140 °C for 5 hours. The reaction solution was dispersed and washed using a large amount of acetonitrile, and the solid was collected through filtration. The obtained crude product was purified using silica gel column chromatography (a mixed solvent of hexane/dichloromethane) and recrystallization (a mixed solvent of ethanol/toluene) to obtain 18 mmol of a yellow solid (yield: 62%). The obtained purified product was determined to have a molecular weight of 1290 g/mol through FABMS measurement, indicating that the target Intermediate Compound C-3-8 was obtained.

### Synthesis of Compound C-3

C-3-8 (18 mmol), CuCN (72 mmol), and NMP (10 mL) were added to a three-necked flask and subjected to Ar substitution, and the mixture was stirred at 180 °C for 5 hours. Water was added to the reaction system, and the organic layer was extracted using toluene. The organic layer was dried over magnesium sulfate and the solvent was removed under reduced pressure. The obtained crude product was purified using silica gel column chromatography (a mixed solvent of hexane/toluene) and recrystallization (a mixed solvent of ethanol/toluene) to obtain 5 mmol of a white solid (yield: 28%). The obtained purified product was determined to have a molecular weight of 1271 g/mol through FABMS measurement, indicating that the target Compound C-3 was obtained.

### (4) Synthesis of fused polycyclic Compound G-1

Fused polycyclic Compound G-1 was synthesized by a process of Reaction Formula 4.

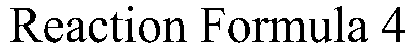

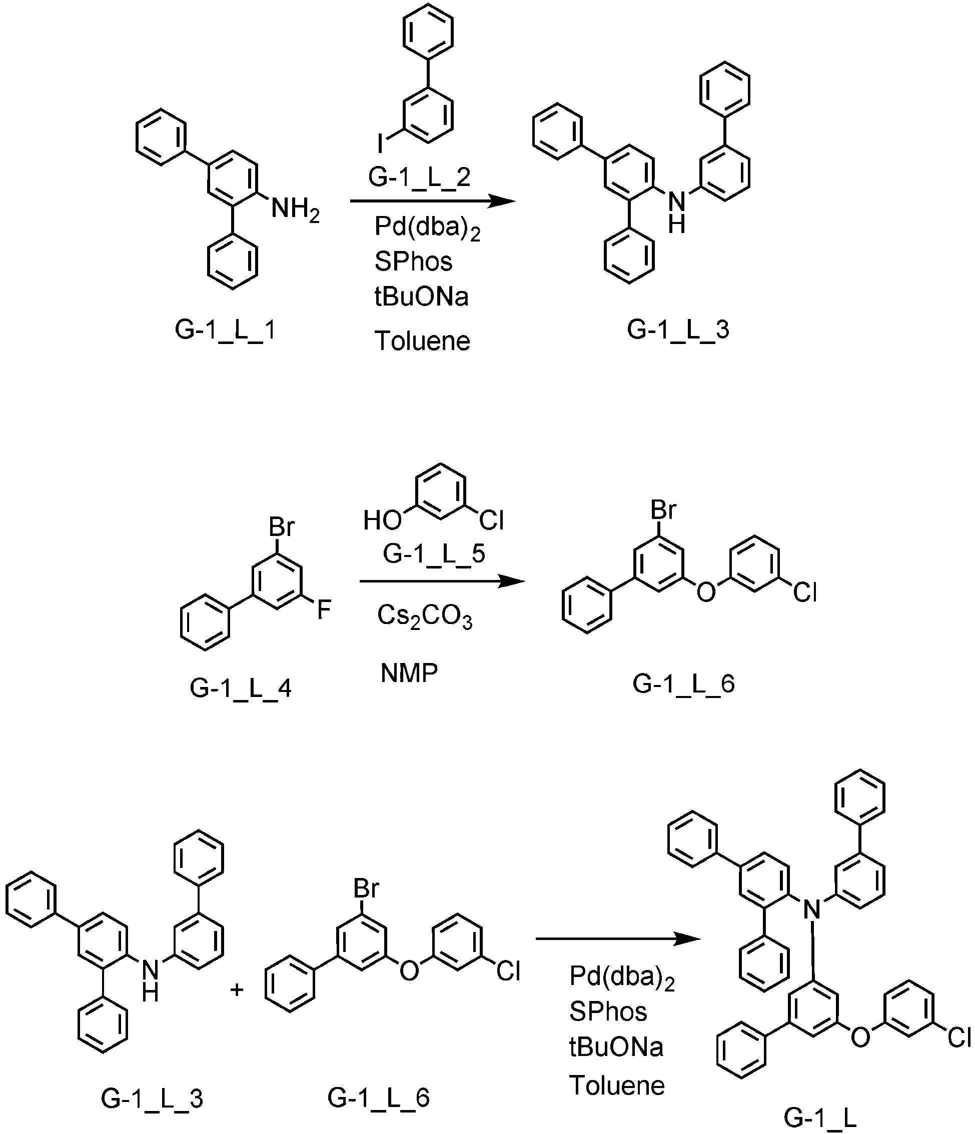

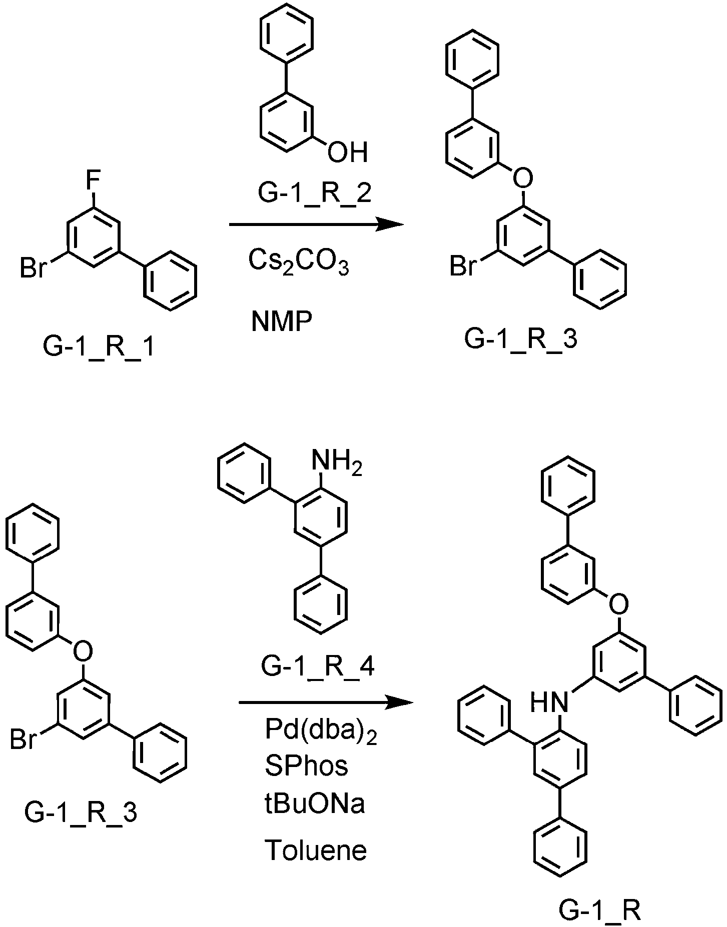

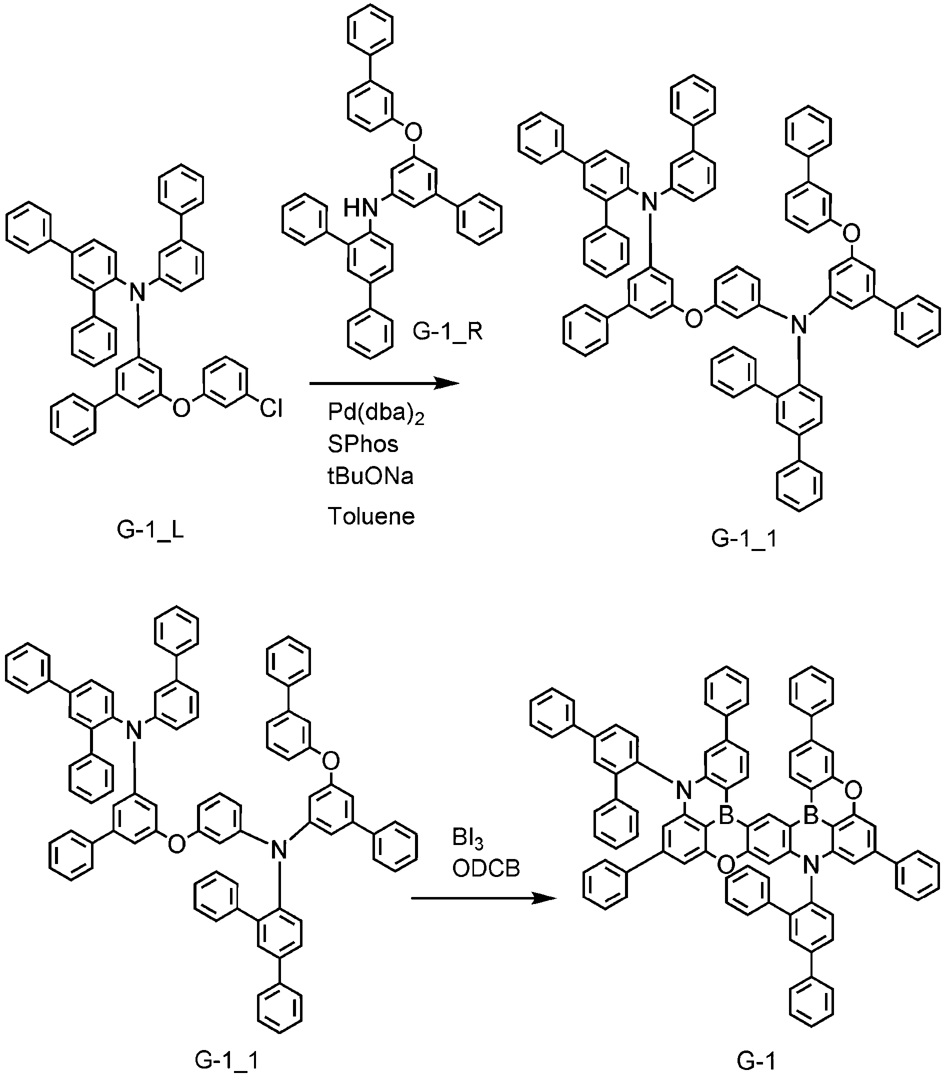

### Synthesis of Intermediate Compound G-1_L_3

G-1-L_1 (200 mmol), G-1-L_2 (200 mmol), tBuONa (220 mmol), Pd(dba)₂ (30 mmol), and SPhos (30 mmol) were added to a three-necked flask and subjected to Ar substitution, and then 1000 mL of toluene was added and the mixture was stirred at 80 °C for 5 hours. Water was added to the reaction system, and the organic layer was extracted using toluene. The organic layer was dried over magnesium sulfate and the solvent was removed under reduced pressure. The obtained crude product was purified using silica gel column chromatography (a mixed solvent of hexane/toluene) and recrystallization (a mixed solvent of ethanol/toluene) to obtain 140 mmol of a white solid (yield: 70%). The obtained purified product was determined to have a molecular weight of 398 g/mol through FABMS measurement, indicating that the target Intermediate Compound G-1_L_3 was obtained.

### Synthesis of Intermediate Compound G-1_L_6

G-1-L_4 (200 mmol), G-1-L_5 (210 mmol), and Cs₂CO₃ (420 mmol) were added to a three-necked flask and subjected to Ar substitution, and then 600 mL of NMP was added and the mixture was stirred at 120 °C for 5 hours. Water was added to the reaction system, and the organic layer was extracted using toluene. The organic layer was dried over magnesium sulfate and the solvent was removed under reduced pressure. The obtained crude product was purified using silica gel column chromatography (a mixed solvent of hexane/toluene) and recrystallization (a mixed solvent of ethanol/toluene) to obtain 167 mmol of a white solid (yield: 84%). The obtained purified product was determined to have a molecular weight of 360 g/mol through FABMS measurement, indicating that the target Intermediate Compound G-1_L_6 was obtained.

### Synthesis of Intermediate Compound G-1_L

G-1-L_6 (140 mmol), G-1-L_3 (140 mmol), tBuONa (220 mmol), Pd(dba)₂ (20 mmol), and SPhos (30 mmol) were added to a three-necked flask and subjected to Ar substitution, and then 1000 mL of toluene was added and the mixture was stirred at 100 °C for 12 hours. Water was added to the reaction system, and the organic layer was extracted using toluene. The organic layer was dried over magnesium sulfate and the solvent was removed under reduced pressure. The obtained crude product was purified using silica gel column chromatography (a mixed solvent of hexane/toluene) and recrystallization (a mixed solvent of ethanol/toluene) to obtain 110 mmol of a white solid (yield: 79%). The obtained purified product was determined to have a molecular weight of 676 g/mol through FABMS measurement, indicating that the target Intermediate Compound G-1_L was obtained.

### Synthesis of Intermediate Compound G-1_R_3

G-1-R_1 (200 mmol), G-1-R_2 (210 mmol), and Cs₂CO₃ (420 mmol) were added to a three-necked flask and subjected to Ar substitution, and then 500 mL of NMP was added and the mixture was stirred at 120 °C for 2 hours. Water was added to the reaction system, and the organic layer was extracted using toluene. The organic layer was dried over magnesium sulfate and the solvent was removed under reduced pressure. The obtained crude product was purified using silica gel column chromatography (a mixed solvent of hexane/toluene) and recrystallization (a mixed solvent of ethanol/toluene) to obtain 134 mmol of a white solid (yield: 67%). The obtained purified product was determined to have a molecular weight of 401 g/mol through FABMS measurement, indicating that the target Intermediate Compound G-1_R_3 was obtained.

### Synthesis of Intermediate Compound G-1_R

G-1-R_3 (134 mmol), G-1-R_4 (134 mmol), tBuONa (201 mmol), Pd(dba)₂ (30 mmol), and SPhos (30 mmol) were added to a three-necked flask and subjected to Ar substitution, and then 1000 mL of toluene was added and the mixture was stirred at 100 °C for 3 hours. Water was added to the reaction system, and the organic layer was extracted using toluene. The organic layer was dried over magnesium sulfate and the solvent was removed under reduced pressure. The obtained crude product was purified using silica gel column chromatography (a mixed solvent of hexane/toluene) and recrystallization (a mixed solvent of ethanol/toluene) to obtain 120 mmol of a white solid (yield: 90%). The obtained purified product was determined to have a molecular weight of 566 g/mol through FABMS measurement, indicating that the target Intermediate Compound G-1_R was obtained.

### Synthesis of Intermediate Compound G-1_1

G-1-L (110 mmol), G-1-R (110 mmol), tBuONa (220 mmol), Pd(dba)₂ (20 mmol), and SPhos (30 mmol) were added to a three-necked flask and subjected to Ar substitution, and then 1000 mL of toluene was added and the mixture was stirred at 120 °C for 8 hours. Water was added to the reaction system, and the organic layer was extracted using toluene. The organic layer was dried over magnesium sulfate and the solvent was removed under reduced pressure. The obtained crude product was purified using silica gel column chromatography (a mixed solvent of hexane/toluene) and recrystallization (a mixed solvent of ethanol/toluene) to obtain 66 mmol of a white solid (yield: 60%). The obtained purified product was determined to have a molecular weight of 1206 g/mol through FABMS measurement, indicating that the target Intermediate Compound G-1_1 was obtained.

### Synthesis of Compound G-1

G-1_1 (66 mol) was added to a three-necked flask and subjected to Ar substitution, and then 50 mL of ODCB was added and dissolved, and then BI₃ (264 mmol) was added and the mixture was stirred at 140 °C for 5 hours. The reaction solution was dispersed and washed using a large amount of acetonitrile, and the solid was collected through filtration. The obtained crude product was purified using silica gel column chromatography (a mixed solvent of hexane/dichloromethane) and recrystallization (a mixed solvent of ethanol/toluene) to obtain 34 mmol of a yellow solid (yield: 52%). The obtained purified product was determined to have a molecular weight of 1221 g/mol through FABMS measurement, indicating that the target Compound G-1 was obtained.

### 2. Evaluation of compounds

Table 1 shows evaluation results for Example Compounds and Comparative Example Compounds. Compounds D-4, B-4, C-3, and G-1, which are fused polycyclic compounds represented by Formula 1 according to one or more embodiments, were evaluated as the Example Compounds. As Comparative Example Compounds, Comparative Example Compounds X-1 to X-9 were used.

### Example Compounds

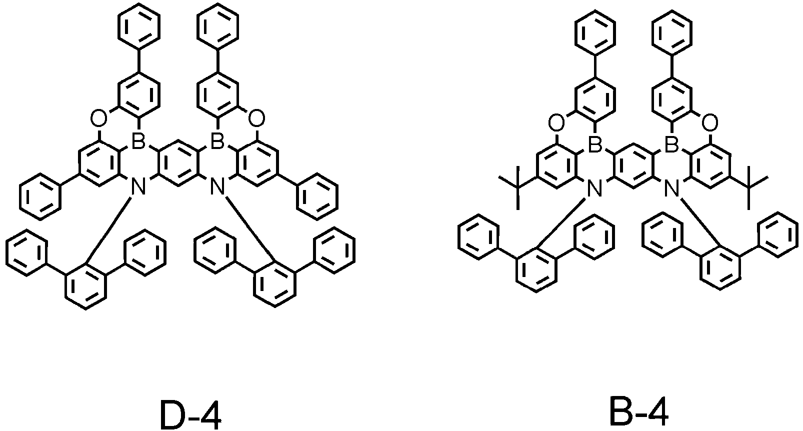

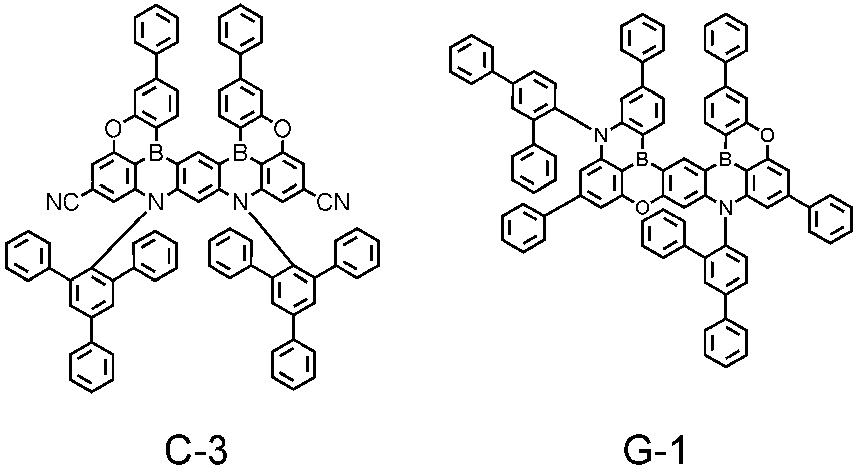

### Comparative Example Compounds

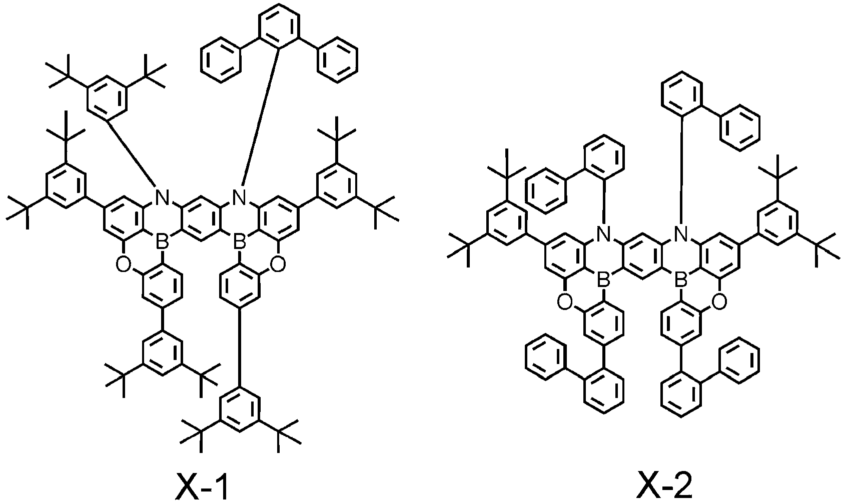

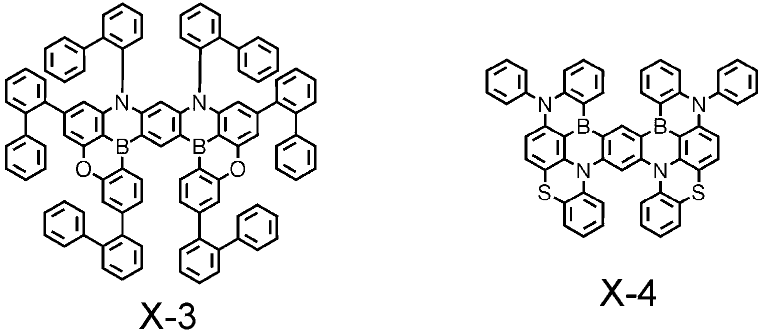

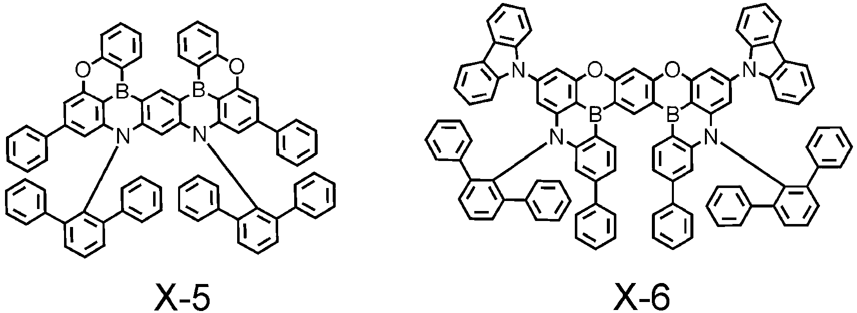

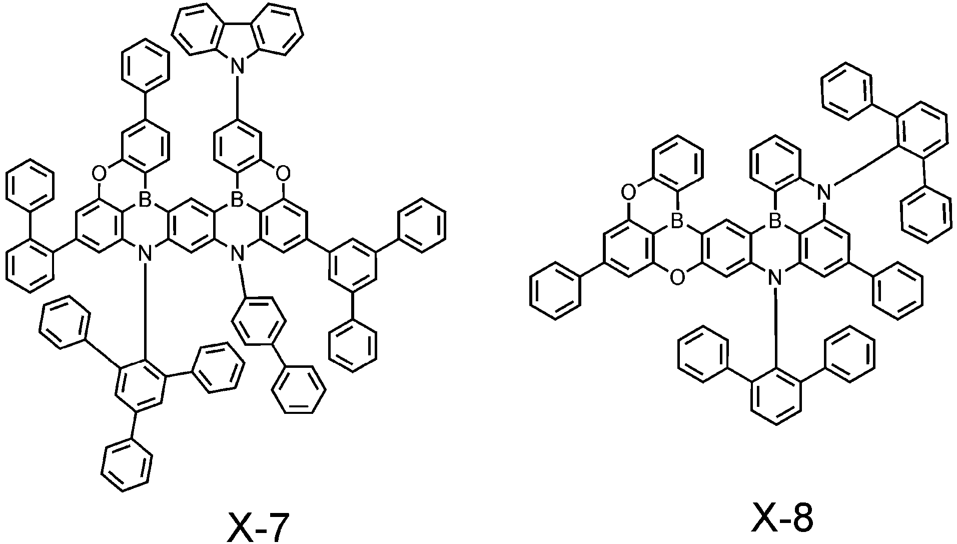

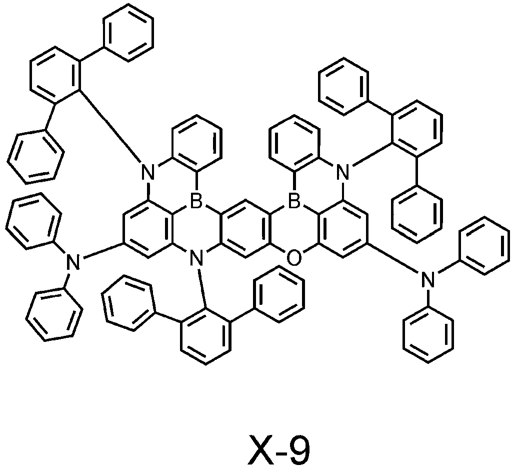

In Table 1, λₘₐₓ is the wavelength measured at the maximum emission intensity in the emission spectrum, and the photoluminescence quantum yield is the ratio of emitted quantum number to absorbed quantum number. In Table 1, λₘₐₓ was determined by measuring fluorescence emission spectrum after a 20 wt% doped film, with PPF as a matrix, was formed on a quartz glass through deposition using a JASCO V-670 spectrometer. Fluorescence quantum yield was measured using a JASCOILF-835 integrating sphere system.

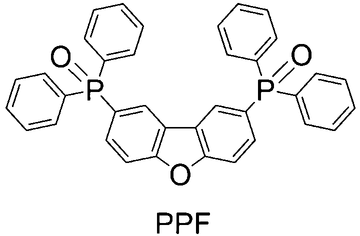

**Table 1**

| Compound | λₘₐₓ / nm | Fluorescence quantum yield / % |
|---|---|---|
| Example Compound D-4 | 458 | 95 |
| Example Compound B-4 | 449 | 93 |
| Example Compound C-3 | 461 | 85 |
| Example Compound G-1 | 462 | 96 |
| Comparative Example Compound X-1 | 459 | 84 |
| Comparative Example Compound X-2 | 462 | 80 |
| Comparative Example Compound X-3 | 465 | 75 |
| Comparative Example Compound X-4 | 487 | 66 |
| Comparative Example Compound X-5 | 453 | 64 |
| Comparative Example Compound X-6 | 455 | 83 |
| Comparative Example Compound X-7 | 463 | 79 |
| Comparative Example Compound X-8 | 470 | 80 |
| Comparative Example Compound X-9 | 458 | 83 |

Referring to λₘₐₓ in Table 1, it is seen that Comparative Compounds X-1 to X-9 and Compounds D-4, B-4, C-3, and G-1 emit light in the wavelength range of 440 nm to 490 nm. It is seen that compared to Comparative Compounds X-1 to X-9, Compounds D-4, B-4, C-3, and G-1 have higher fluorescence quantum yields. This indicates that Compounds D-4, B-4, C-3, and G-1 exhibit excellent efficiency.

Compounds D-4, B-4, C-3, and G-1 are fused polycyclic compounds represented by Formula 1 according to one or more embodiments, where benzene rings bonded to at least two nitrogen atoms contain at least four phenyl groups as substituents, and benzene rings bonded to two boron atoms each independently contain phenyl groups bonded to the boron atoms at a para position or a position immediately adjacent to the para position as a substituent. The two nitrogen atoms and the two boron atoms are ring-forming atoms in a fused ring of nine rings as a core structure. Accordingly, it is seen that the fused polycyclic compound represented by Formula 1 according to one or more embodiments may exhibit excellent material stability and contribute to improving color purity, efficiency, and lifespan of a light emitting element ED.

Comparative Examples Compounds X-1 to X-9 include a fused ring of nine rings as a core structure, and benzene rings are each independently bonded to nitrogen atoms and boron atoms bonded to the core structure, but is different from the fused polycyclic compound according to one or more embodiments in that the benzene rings bonded to at least two nitrogen atoms do not include at least four phenyl groups as substituents, or the benzene rings bonded to boron atoms do not each independently include phenyl groups as substituents. Accordingly, Comparative Examples Compounds X-1 to X-9 exhibit relatively lower fluorescence quantum yields.

### 3. Preparation and Evaluation of Light Emitting Element

### (1) Preparation of light emitting element

Light emitting elements including fused polycyclic compounds represented by Formula 1 according to one or more embodiments or Comparative Example Compounds were prepared through a method below. Light emitting elements of Examples 1 to 4 were prepared respectively using fused polycyclic compounds represented by Formula 1, with compounds D-4, B-4, C-3, and G-1 used as a dopant material of an emission layer. Light emitting elements of Comparative Examples 1 to 9 were prepared using Comparative Example Compounds X-1 to X-9 as a dopant material of an emission layer. Elements were prepared with the layer structure below, and evaluated. 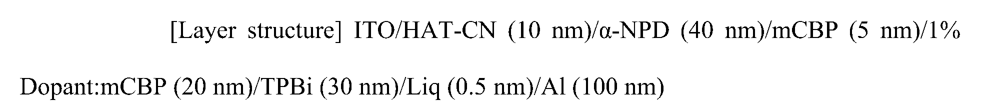[Layer structure] ITO/HAT-CN (10 nm)/α-NPD (40 nm)/mCBP (5 nm)/1% Dopant:mCBP (20 nm)/TPBi (30 nm)/Liq (0.5 nm)/Al (100 nm)

Specifically, an ITO having a thickness of 1500 Å was patterned on a glass substrate, washed with deionized (DI) water, and UV ozone-treated for 10 minutes. Thereafter, a hole injection layer having a thickness of 100 Å was formed using HAT-CN, and a hole transport layer having a thickness of 400 Å was formed using α-NPD.

Then, an electron blocking layer having a thickness of 50 Å was formed using mCBP, and an emission layer was formed by providing a respective Example Compound (or comparative example compound) and mCBP at a weight ratio of 1:99. The emission layer was formed to have a thickness of 200 Å. On the emission layer, an electron transport layer having a thickness of 300 Å was formed using TPBi, and an electron injection layer having a thickness of 5 Å was formed using Liq.

Then, a second electrode having a thickness of 1000 Å was formed using aluminium (Al). As for Examples, the hole injection layer, the hole transport layer, the emission layer, the electron transport layer, the electron injection layer, and the second electrode were formed using a vacuum deposition device.

### Materials used for preparation of light emitting elements

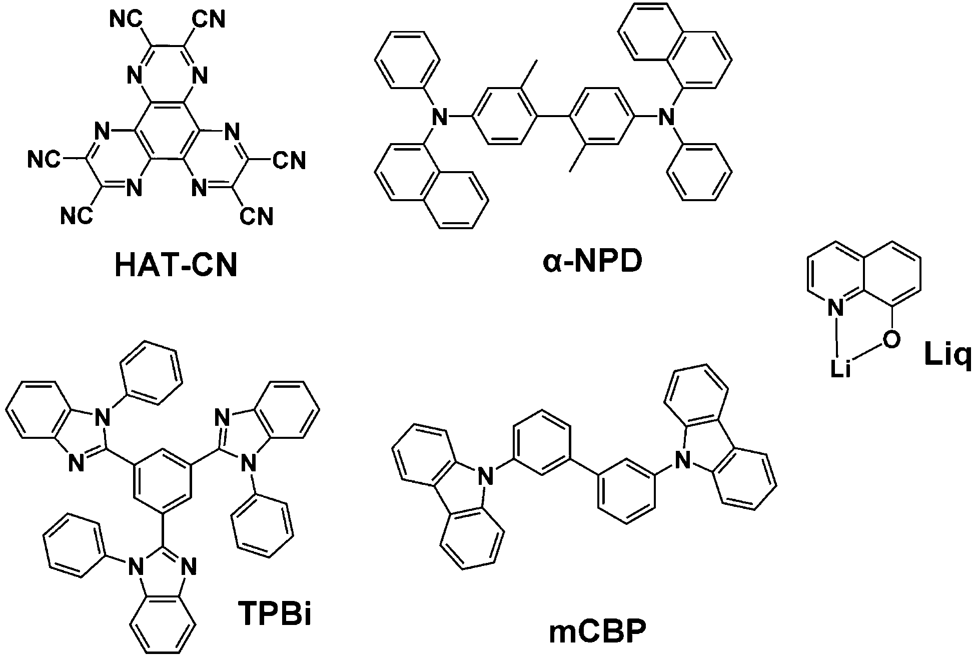

### (2) Evaluation of light emitting elements

Table 2 below shows evaluation results of the light emitting elements of the Examples and Comparative Examples. In Table 2, EQEₘₐₓ indicates the maximum external quantum efficiency (%), and LT₅₀ indicates the relative lifespan (%) when the half-life of Comparative Example 3 is set to 100%.

In Table 2, voltage and current density of light emitting elements were measured using a source meter (Keithley Instrument, 2400 series), and luminance and external quantum efficiency were measured using an external quantum efficiency measuring device (Hamamatsu Photonics, C9920-12).

**Table 2**

| Example of prepared element | Dopant | λₘₐₓ nm | EQEₘₐₓ % | LT₅₀ % |
|---|---|---|---|---|
| Example 1 | Example Compound D-4 | 460 | 26 | 232 |
| Example 2 | Example Compound B-4 | 453 | 24 | 120 |
| Example 3 | Example Compound C-3 | 463 | 24 | 209 |
| Example 4 | Example Compound G-1 | 462 | 26 | 254 |
| Comparative Example 1 | Comparative Example Compound X-1 | 461 | 23 | 36 |
| Comparative Example 2 | Comparative Example Compound X-2 | 464 | 22 | 78 |
| Comparative Example 3 | Comparative Example Compound X-3 | 467 | 21 | 100 |
| Comparative Example 4 | Comparative Example Compound X-4 | 489 | 19 | 88 |
| Comparative Example 5 | Comparative Example Compound X-5 | 455 | 18 | 61 |
| Comparative Example 6 | Comparative Example Compound X-6 | 457 | 20 | 98 |
| Comparative Example 7 | Comparative Example Compound X-7 | 465 | 19 | 79 |
| Comparative Example 8 | Comparative Example Compound X-8 | 472 | 24 | 49 |
| Comparative Example 9 | Comparative Example Compound X-9 | 461 | 20 | 88 |

Referring to Table 2, it is seen that the light emitting elements of Comparative Examples and Examples emit light in the wavelength range of 440 nm to 490 nm. It is seen that, compared to the light emitting elements of Comparative Examples 1 to 7, and 9, the light emitting elements of Examples 1 to 4 exhibit high element stability, high efficiency, and long lifespan. It is seen that, compared to the light emitting element of Comparative Example 8, the light emitting elements of Examples 1 to 4 exhibit long lifespan. The light emitting elements of Examples 1 to 4 include Compounds D-4, B-4, C-3, and G-1, and Compounds D-4, B-4, C-3, and G-1 are fused polycyclic compounds represented by Formula 1 according to one or more embodiments.

Compounds D-4, B-4, C-3, and G-1 are fused polycyclic compounds represented by Formula 1 according to one or more embodiments, where benzene rings bonded to an end of at least two nitrogen atoms in a core structure contain at least four phenyl groups as substituents, and benzene rings bonded to two boron atoms each independently contain phenyl groups as substituents. The core structure is a fused ring of nine rings. Accordingly, it is seen that the fused polycyclic compound according to one or more embodiments may exhibit excellent material stability and contribute to improving color purity, efficiency, and lifespan of a light emitting element ED.

The light emitting elements of Comparative Examples 1 to 9 each include Comparative Example Compounds X-1 to X-9. Comparative Example Compounds X-1 to X-4 have a fewer number of phenyl groups protecting entire molecules and do not include at least four substituents on a benzene ring bonded to a nitrogen atom, differing from the fused polycyclic compound represented by Formula 1 according to one or more embodiments. Comparative Example Compound X-5 does not include a phenyl group on a benzene ring bonded to a boron atom, differing from the fused polycyclic compound represented by Formula 1 according to one or more embodiments. Comparative Example Compound X-6 includes carbazole at an end of molecules, differing from the fused polycyclic compound represented by Formula 1 according to one or more embodiments.

Comparative Example Compound X-7 includes a phenyl group and a carbazole group on a benzene ring bonded to a boron atom, differing from the fused polycyclic compound represented by Formula 1 according to one or more embodiments. Comparative Example Compounds X-8 and X-9 do not include a phenyl group on a benzene ring bonded to a boron atom, differing from the fused polycyclic compound represented by Formula 1 according to one or more embodiments. Accordingly, the light emitting elements of Comparative Examples 1 to 7, and 9 exhibit low element stability, low efficiency, and short lifespan, and the light emitting element of Comparative Example 8 exhibits short lifespan.

An electronic device according to one or more embodiments may include a light emitting element. In the light emitting element according to one or more embodiments, an emission layer may include a fused polycyclic compound represented by Formula 1. The fused polycyclic compound represented by Formula 1 according to one or more embodiments includes, as a core structure, a fused ring of nine rings, which contains two boron atoms, at least two nitrogen atoms, and at least one oxygen or sulfur atom as ring-forming atoms. In addition, in the fused polycyclic compound represented by Formula 1 according to one or more embodiments, benzene rings bonded to at least two nitrogen atoms of a core structure may include at least four phenyl groups as substituents. In addition, benzene rings bonded to two boron atoms may each independently include phenyl groups bonded to the boron atoms at a para position or a position immediately adjacent to the para position as substituents. Accordingly, the fused polycyclic compound represented by Formula 1 according to one or more embodiments may exhibit excellent material stability, and the light emitting element including the fused polycyclic compound represented by Formula 1 according to one or more embodiments may exhibit improved efficiency and long lifespan.

A light emitting element according to one or more embodiments and an electronic device including the light emitting element include a fused polycyclic compound represented by Formula 1 according to one or more embodiments, and may thus exhibit high efficiency and long lifespan.

A fused polycyclic compound represented by Formula 1 according to one or more embodiments may contribute to improving efficiency and lifespan of a light emitting element.

In the above, description has been made with reference to embodiments of the disclosure, but those skilled or of ordinary skill in the art may understand that various modifications and changes may be made to the disclosure insofar as such modifications and changes do not depart from the technical scope of the disclosure as set forth in the claims to be described later.

Therefore, the technical scope of the disclosure is not to be limited to the contents stated in the detailed description of the specification, but should be determined by the claims.

## Claims

1. A fused polycyclic compound represented by Formula 1: 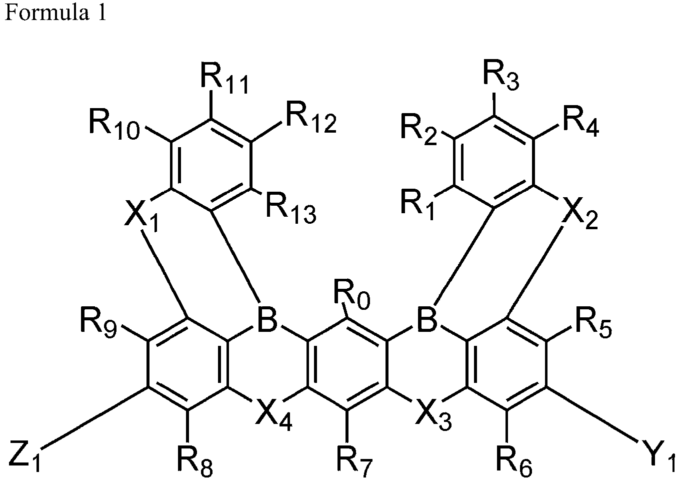 wherein, in Formula 1,
Y₁ and Z₁ are each independently a hydrogen atom, a deuterium atom, a cyano group, a nitro group, a substituted or unsubstituted amine group, a substituted or unsubstituted alkyl group having 1 to 20 carbon atoms, or a substituted or unsubstituted aryl group having 6 to 30 ring-forming carbon atoms,
X₁ to X₄ are each independently O, S, or a group represented by Formula 2,
at least two of X₁ to X₄ are a group represented by Formula 2,
R₀ to R₁₃ are each independently a hydrogen atom, a deuterium atom, a halogen atom, a cyano group, a nitro group, a substituted or unsubstituted amine group, a substituted or unsubstituted alkyl group having 1 to 20 carbon atoms, a substituted or unsubstituted aryl group having 6 to 30 ring-forming carbon atoms, a substituted or unsubstituted heteroaryl group having 5 to 30 ring-forming carbon atoms, or a group represented by Formula 3,
at least one of R₁ to R₄ is a group represented by Formula 3, and
at least one of R₁₀ to R₁₃ is a group represented by Formula 3: 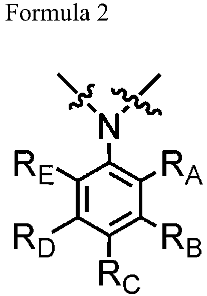
wherein, in Formula 2,
R_{A} to R_{E} are each independently a hydrogen atom, a deuterium atom, a halogen atom, a cyano group, a nitro group, a substituted or unsubstituted amine group, a substituted or unsubstituted alkyl group having 1 to 20 carbon atoms, a substituted or unsubstituted cycloalkyl group having 3 to 10 ring-forming carbon atoms, a substituted or unsubstituted aryl group having 6 to 30 ring-forming carbon atoms, a substituted or unsubstituted heteroaryl group having 5 to 30 ring-forming carbon atoms, or a group represented by Formula 3, 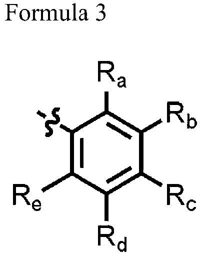
wherein, in Formula 3,
Rₐ to Rₑ are each independently a hydrogen atom, a deuterium atom, a halogen atom, a cyano group, a nitro group, a substituted or unsubstituted amine group, a substituted or unsubstituted alkyl group having 1 to 20 carbon atoms, a substituted or unsubstituted aryl group having 6 to 30 ring-forming carbon atoms, or a substituted or unsubstituted heteroaryl group having 5 to 30 ring-forming carbon atoms,
wherein the at least two of Formula 2 include 4 or more substituents represented by Formula 3.

2. The fused polycyclic compound of claim 1, wherein Formula 1 is represented by one of Formulae 1-A1 to 1-A3: 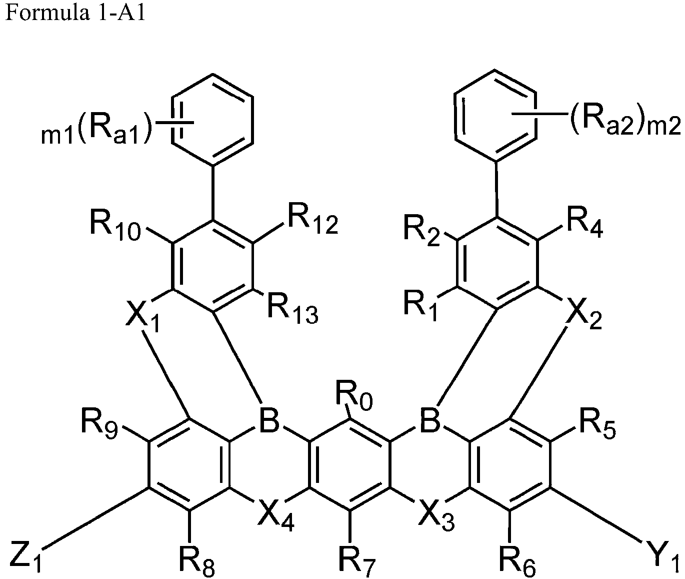 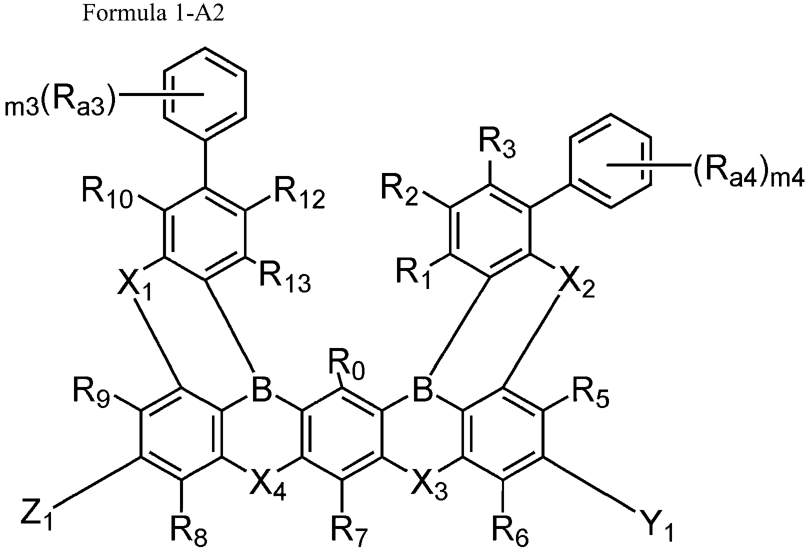 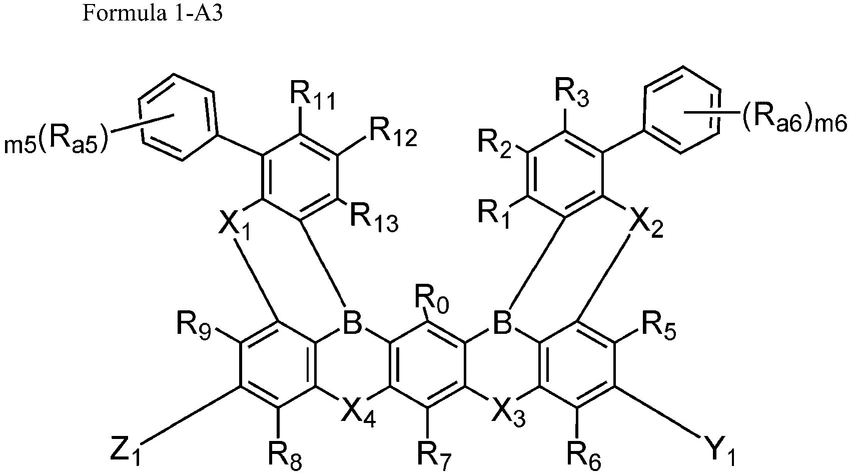 wherein, in Formulae 1-A1 to 1-A3,
m1 to m6 are each independently an integer of 0 to 5,
Rₐ₁ to Rₐ₆ are each independently a hydrogen atom, a deuterium atom, a cyano group, a substituted or unsubstituted alkyl group having 1 to 20 carbon atoms, or a substituted or unsubstituted aryl group having 6 to 30 ring-forming carbon atoms, and
X₁ to X₄, R₀ to R₁₃, Y₁, and Z₁ are the same as defined in claim 1.

3. The fused polycyclic compound of claim 1, wherein Formula 1 is represented by one of Formulae 1-B1 to 1-B3: 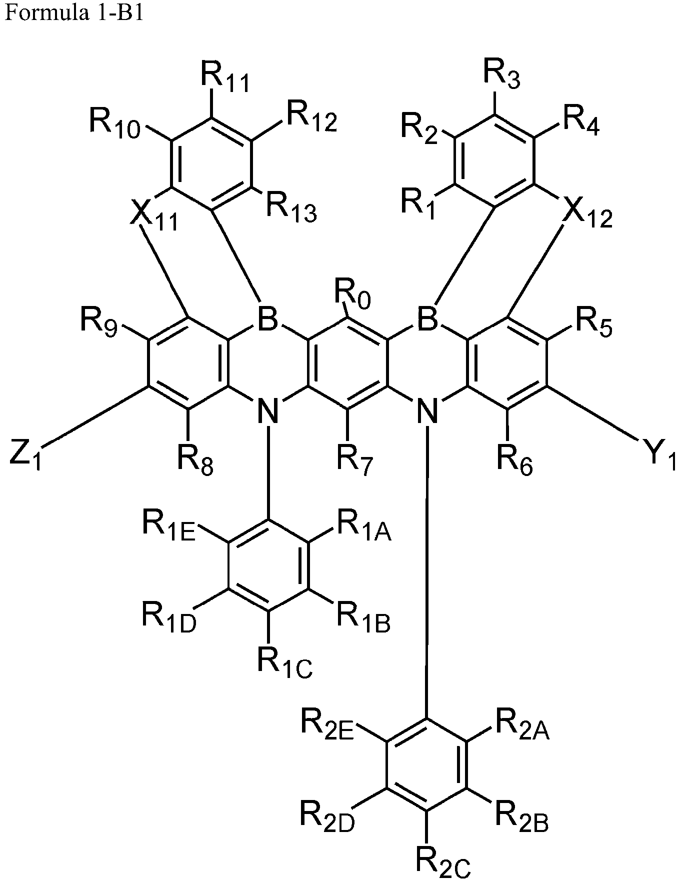 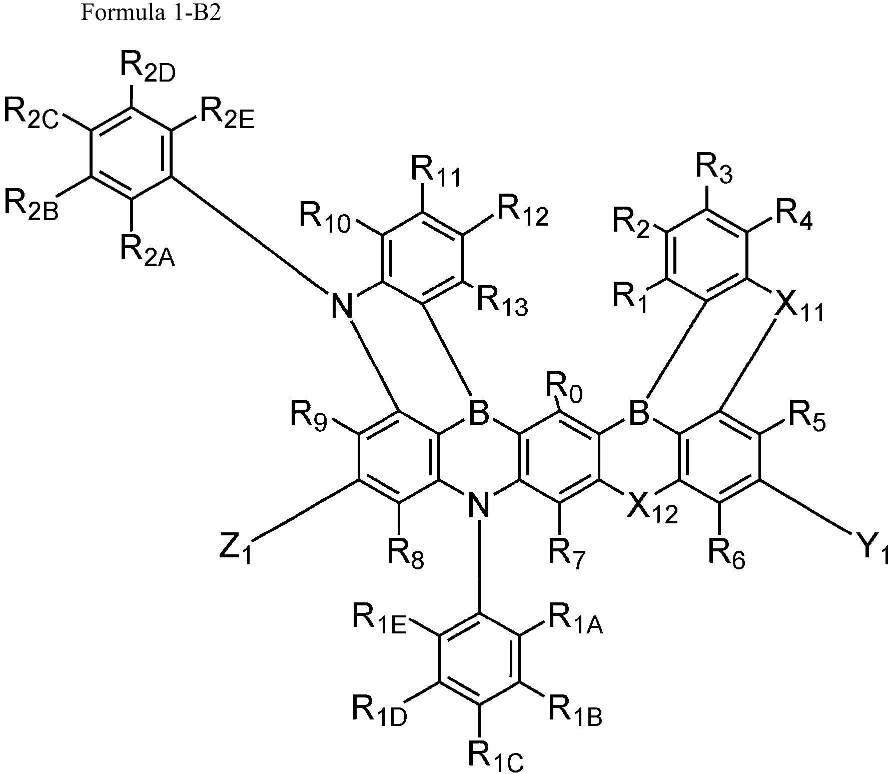 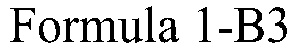 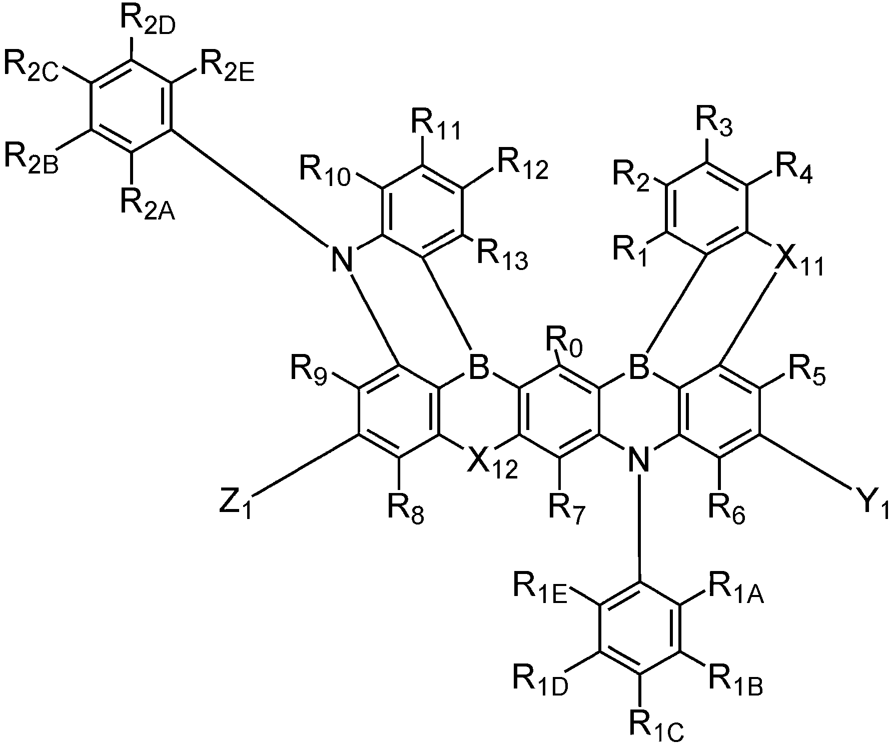 wherein, in Formulae 1-B1 to 1-B3,
X₁₁ and X₁₂ are each independently O or S,
R_{1A} to R_{1E} and R_{2A} to R_{2E} are each independently a hydrogen atom, a deuterium atom, a halogen atom, a cyano group, a nitro group, a substituted or unsubstituted amine group, a substituted or unsubstituted alkyl group having 1 to 20 carbon atoms, a substituted or unsubstituted cycloalkyl group having 3 to 10 ring-forming carbon atoms, a substituted or unsubstituted aryl group having 6 to 30 ring-forming carbon atoms, a substituted or unsubstituted heteroaryl group having 5 to 30 ring-forming carbon atoms, or a group represented by Formula 3,
among R_{1A} to R_{1E} and R_{2A} to R_{2E}, the number of substituents represented by Formula 3 is 4 or more, and
R₀ to R₁₃, Y₁, and Z₁ are the same as defined in claim 1.

4. The fused polycyclic compound of any one of claims 1 to 3, wherein Formula 2 is represented by one of Formulae 2-1 to 2-8: 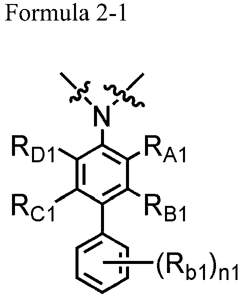 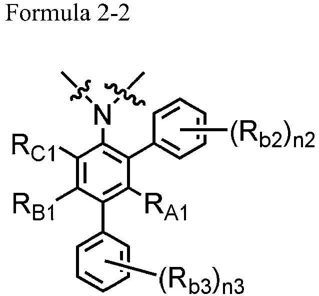 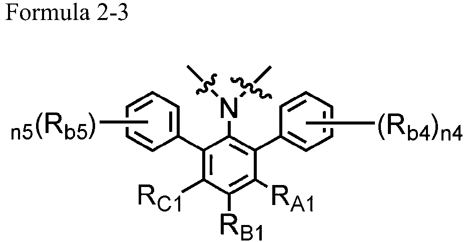 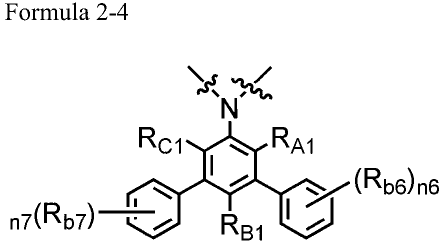 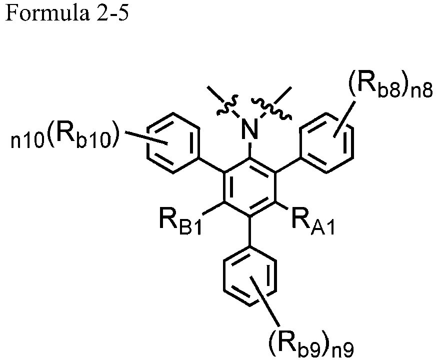 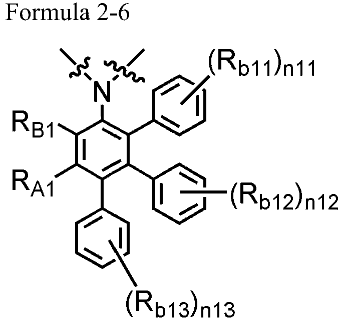 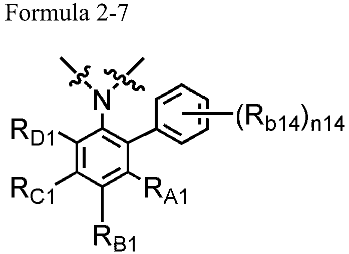 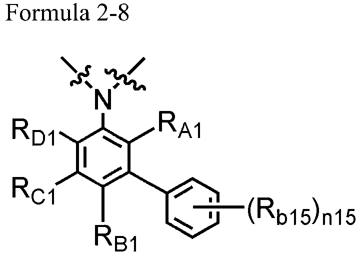 wherein, in Formulae 2-1 to 2-8,
n1 to n15 are each independently an integer of 0 to 5,
R_{b1} to R_{b15} are each independently a hydrogen atom, a deuterium atom, a substituted or unsubstituted alkyl group having 1 to 20 carbon atoms, or a substituted or unsubstituted aryl group having 6 to 30 ring-forming carbon atoms, and
R_{A1} to R_{D1} are each independently a hydrogen atom, a deuterium atom, a substituted or unsubstituted alkyl group having 1 to 20 carbon atoms, or a substituted or unsubstituted cycloalkyl group having 3 to 10 ring-forming carbon atoms.

5. The fused polycyclic compound of claim 4, wherein
Formula 2-1 is represented by one of 2-1A to 2-1C,
Formula 2-2 is represented by one of 2-2A and 2-2B,
Formula 2-3 is represented by one of 2-3A to 2-3G,
Formula 2-4 is represented by one of 2-4A and 2-4B,
Formula 2-5 is represented by one of 2-5A to 2-5D,
Formula 2-6 is represented by 2-6A,
Formula 2-7 is represented by 2-7A, and
Formula 2-8 is represented by 2-8A:

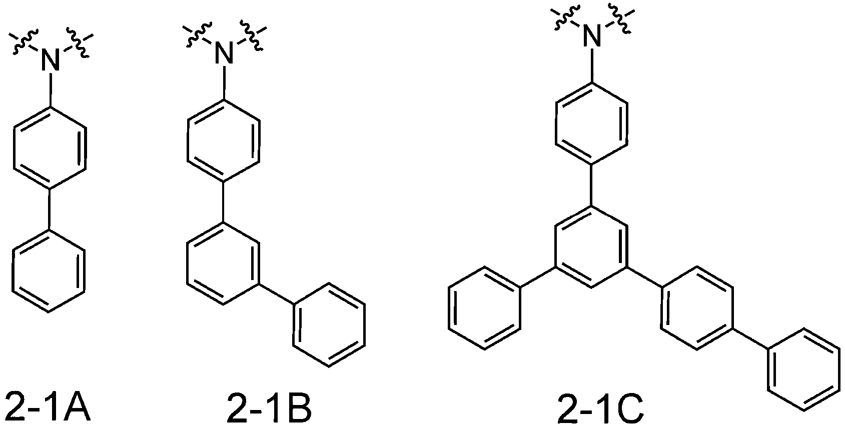

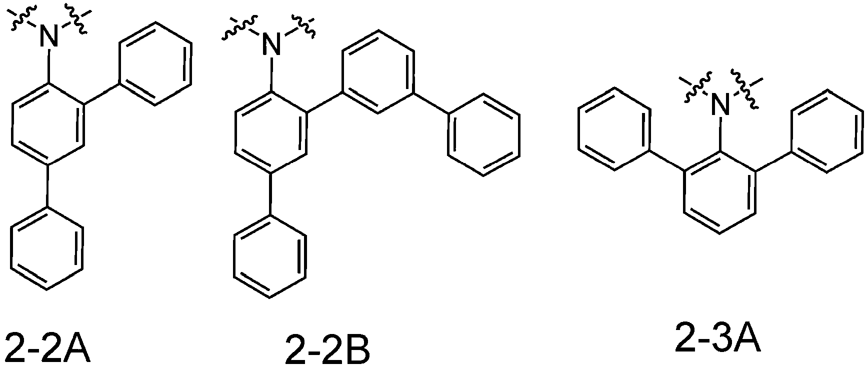

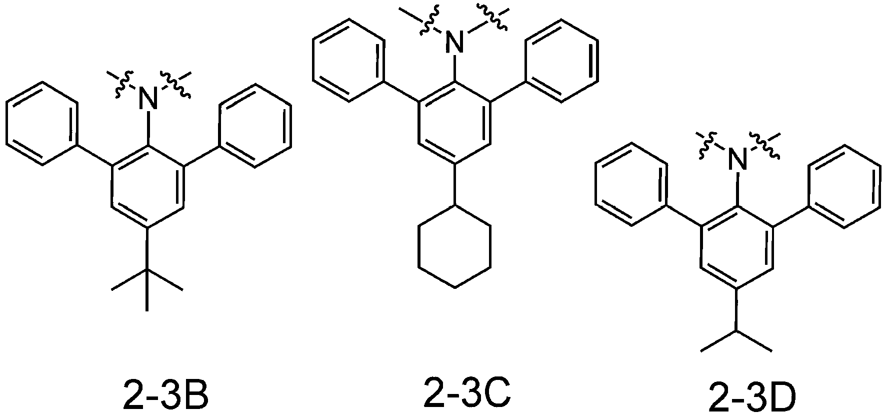

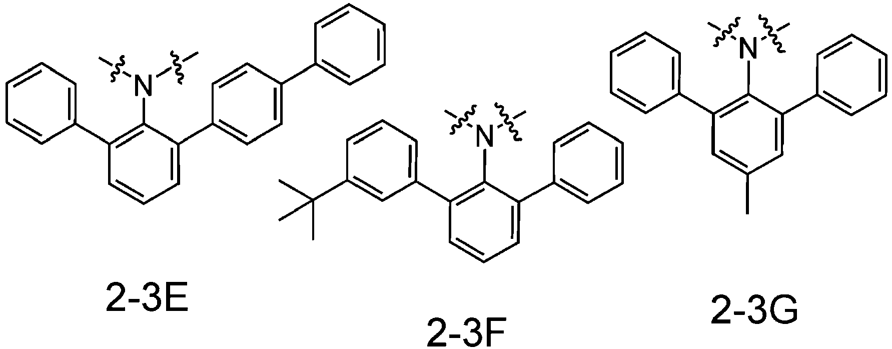

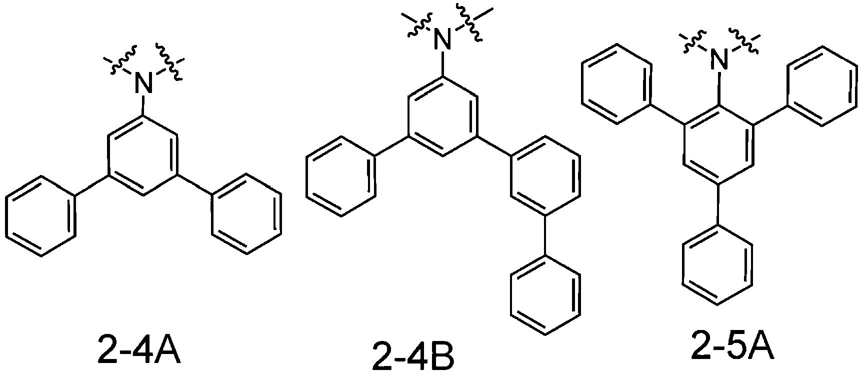

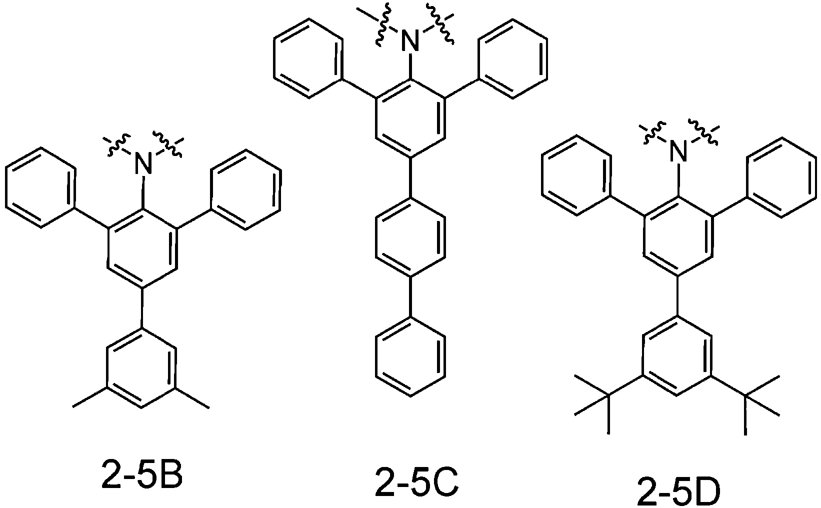

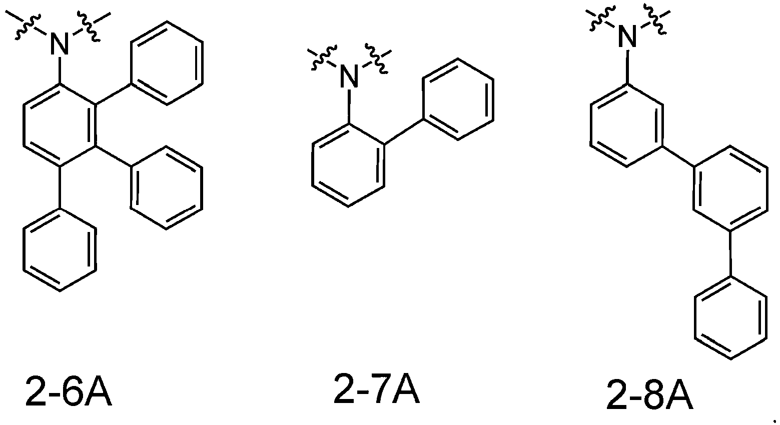

6. The fused polycyclic compound of any one of claims 1 to 5, wherein in Formula 1, the others of R₁ to R₄ and R₁₀ to R₁₃, which are not represented by Formula 3, are each independently a hydrogen atom or a deuterium atom.

7. The fused polycyclic compound of claim 1, wherein the fused polycyclic compound comprises a compound from Compound Group 1:

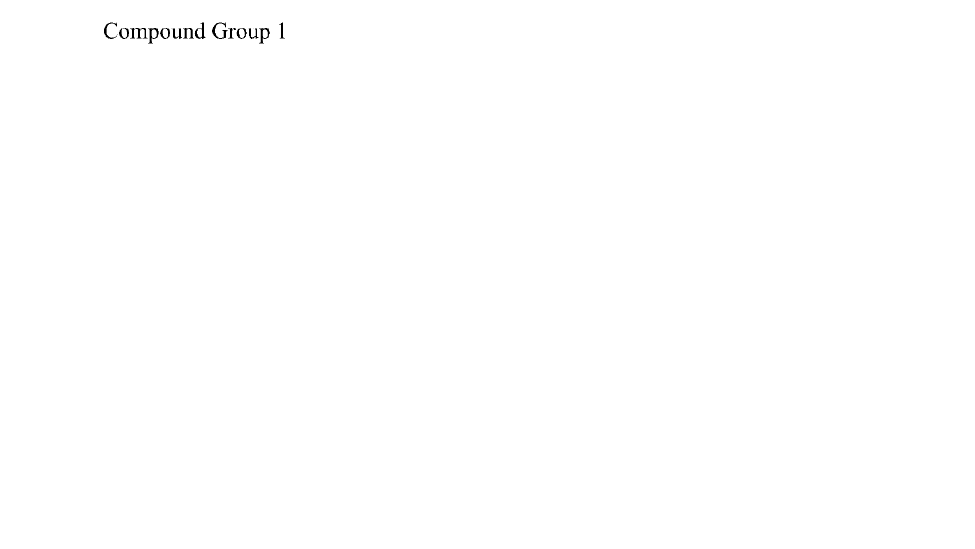

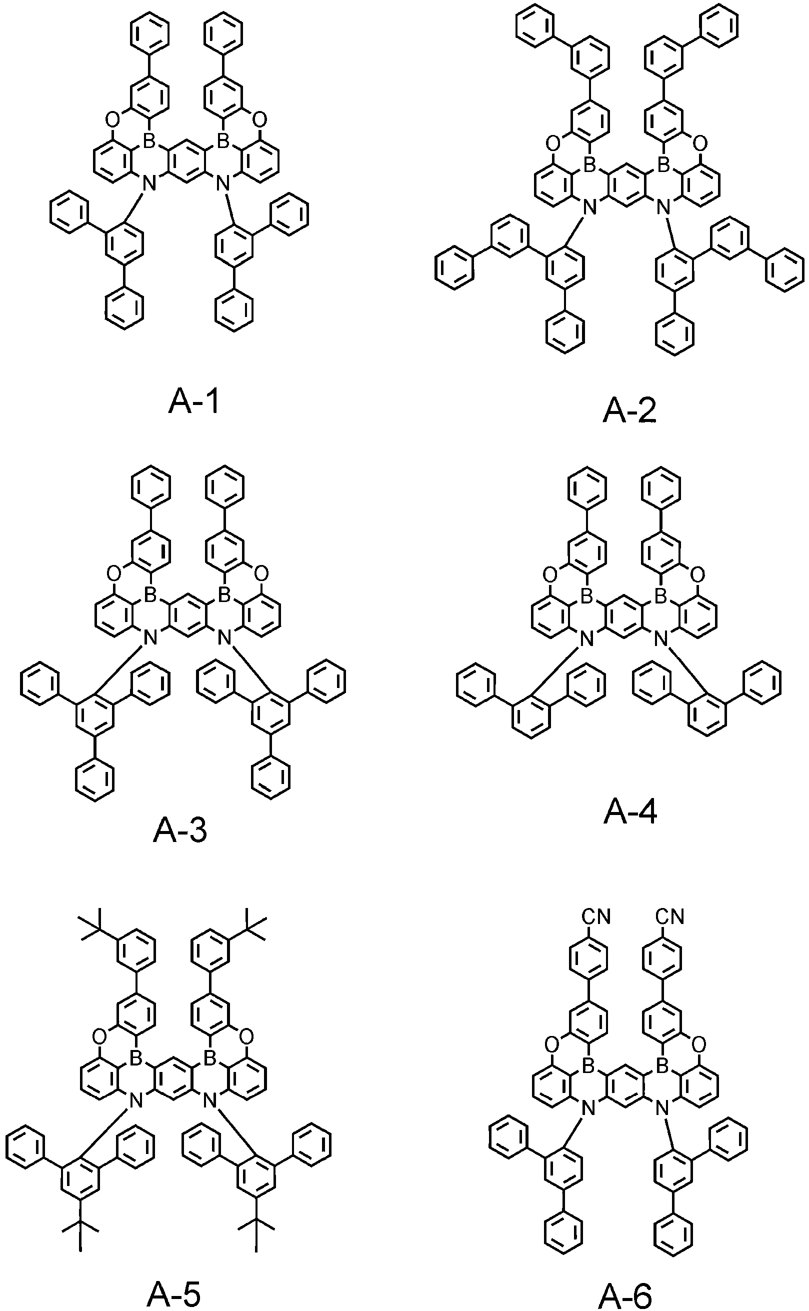

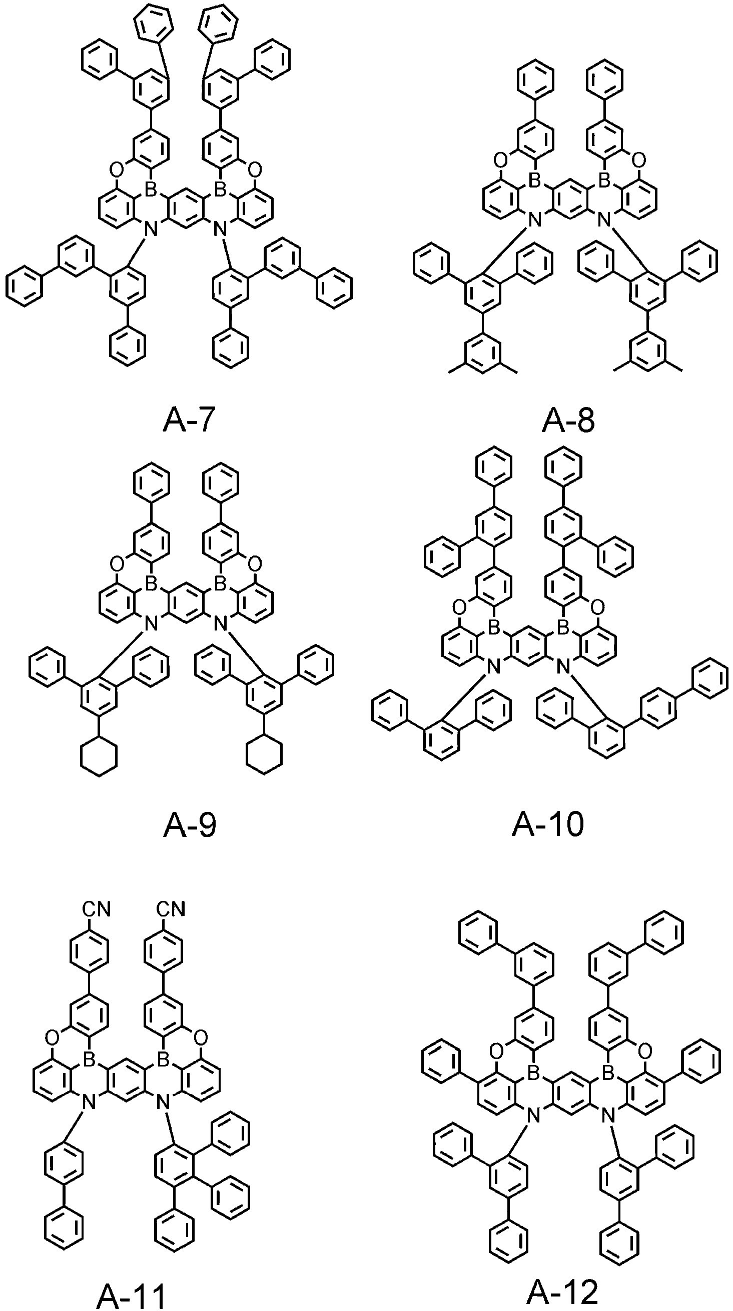

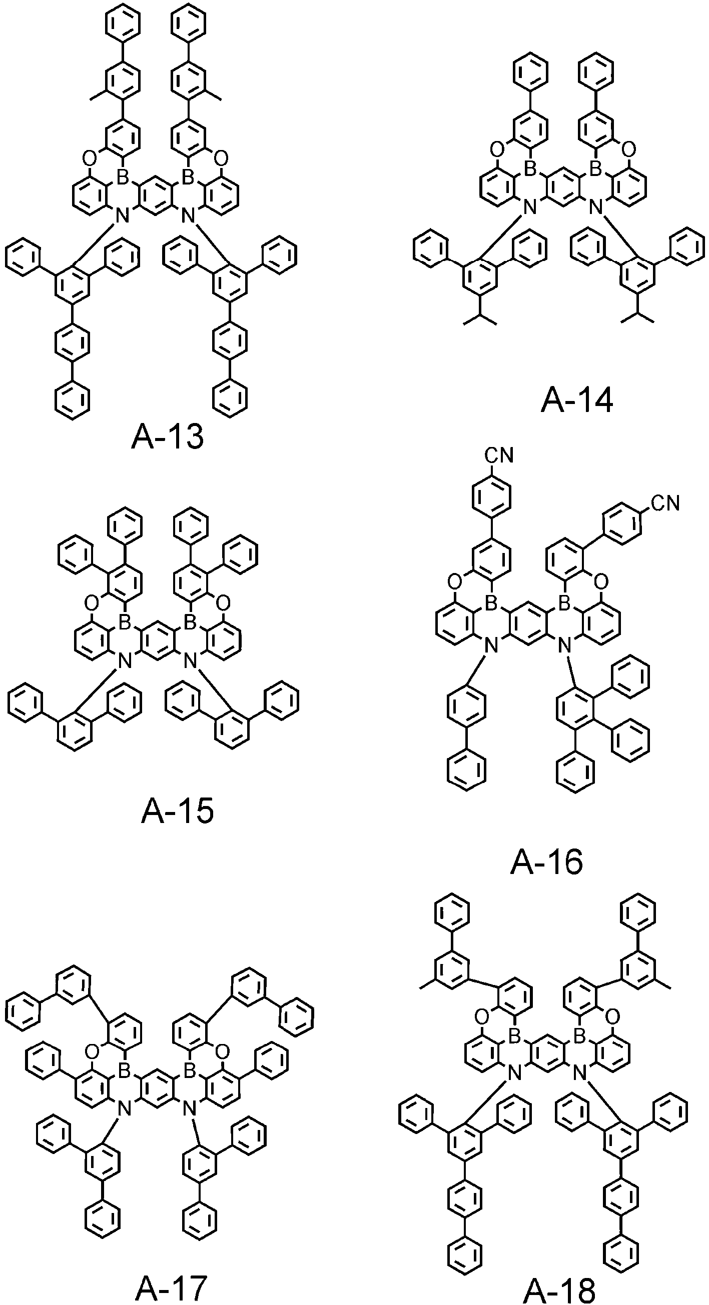

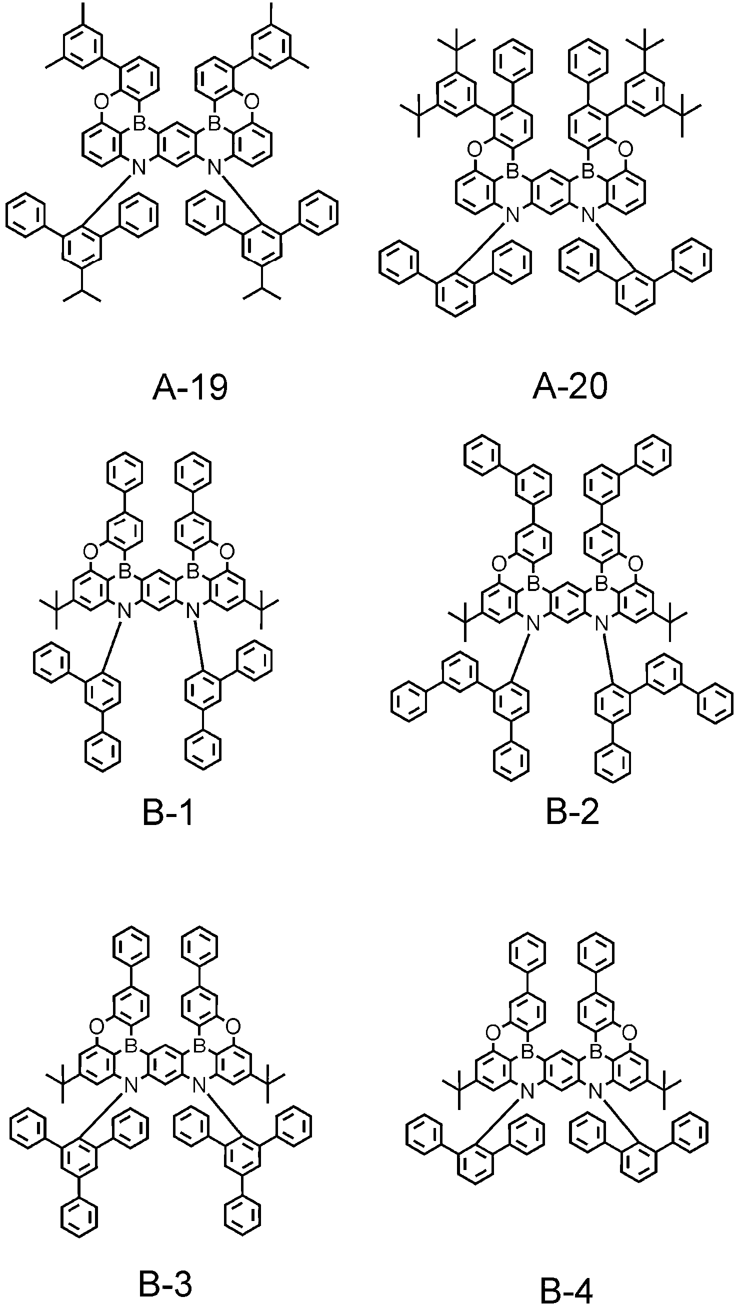

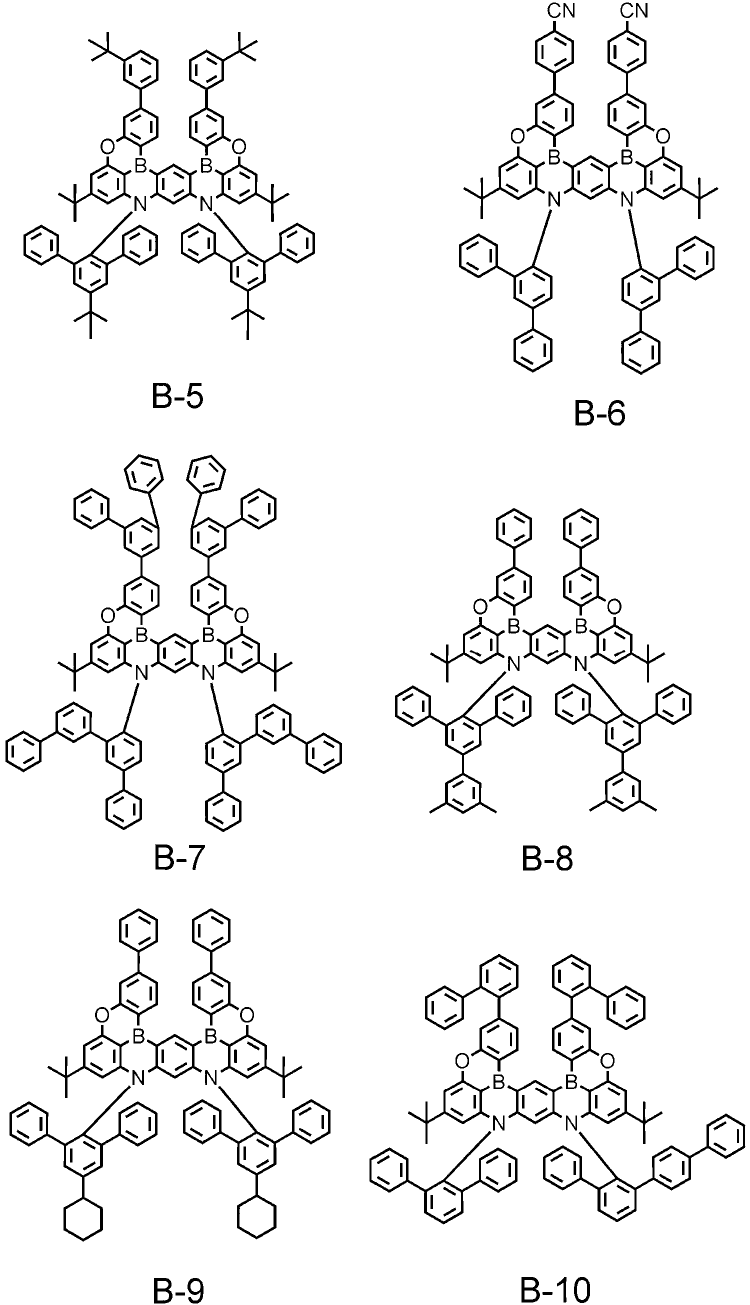

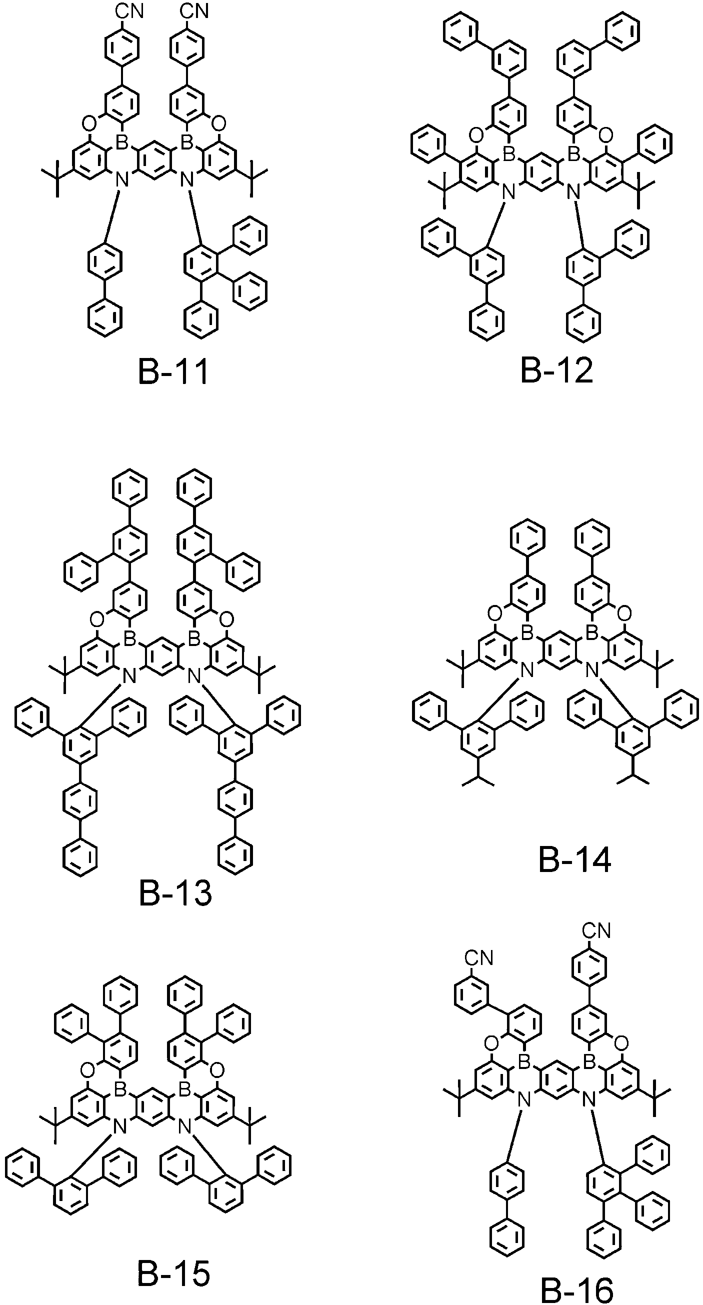

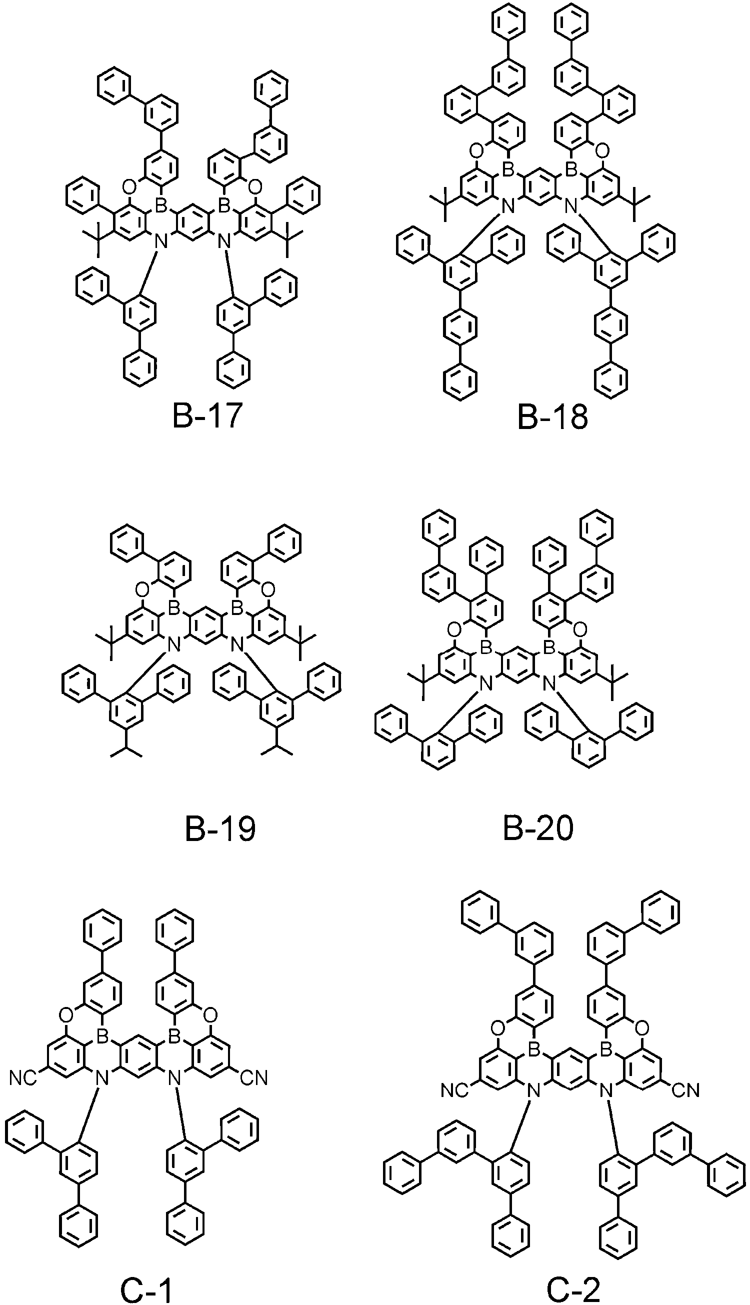

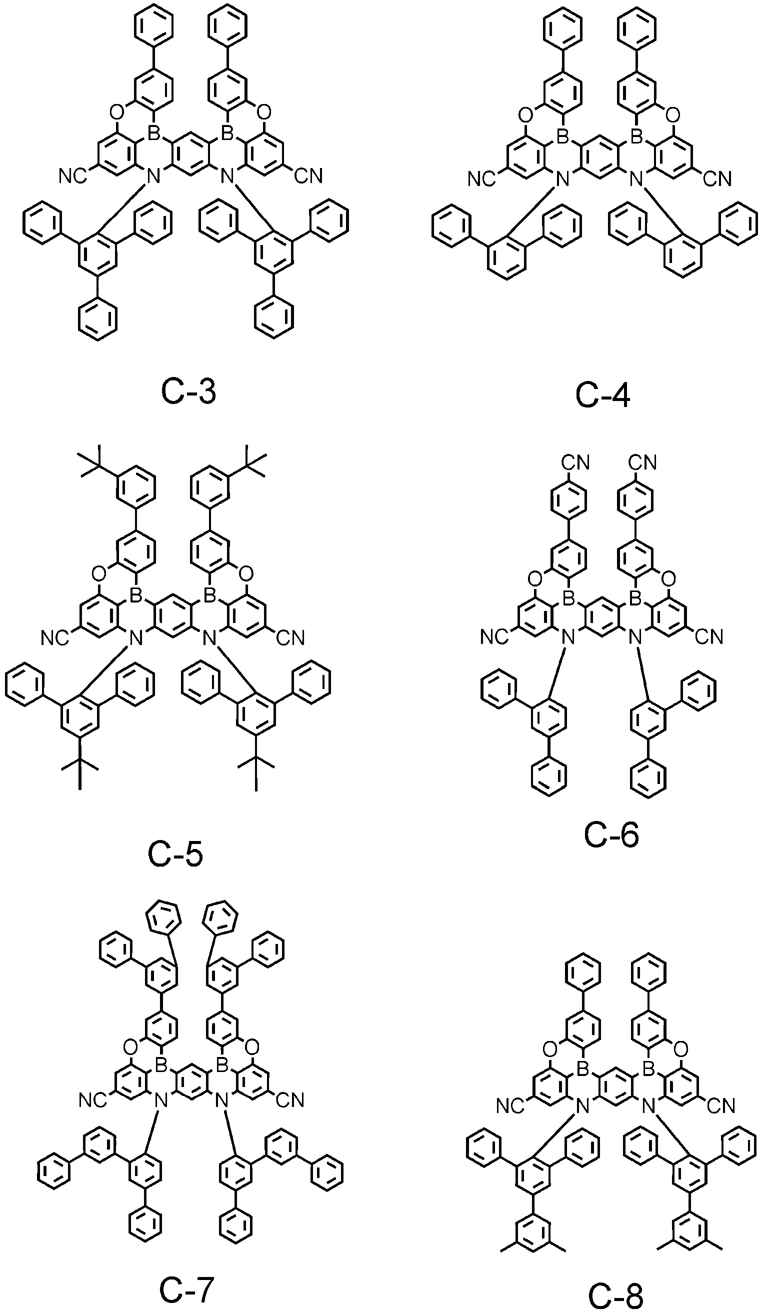

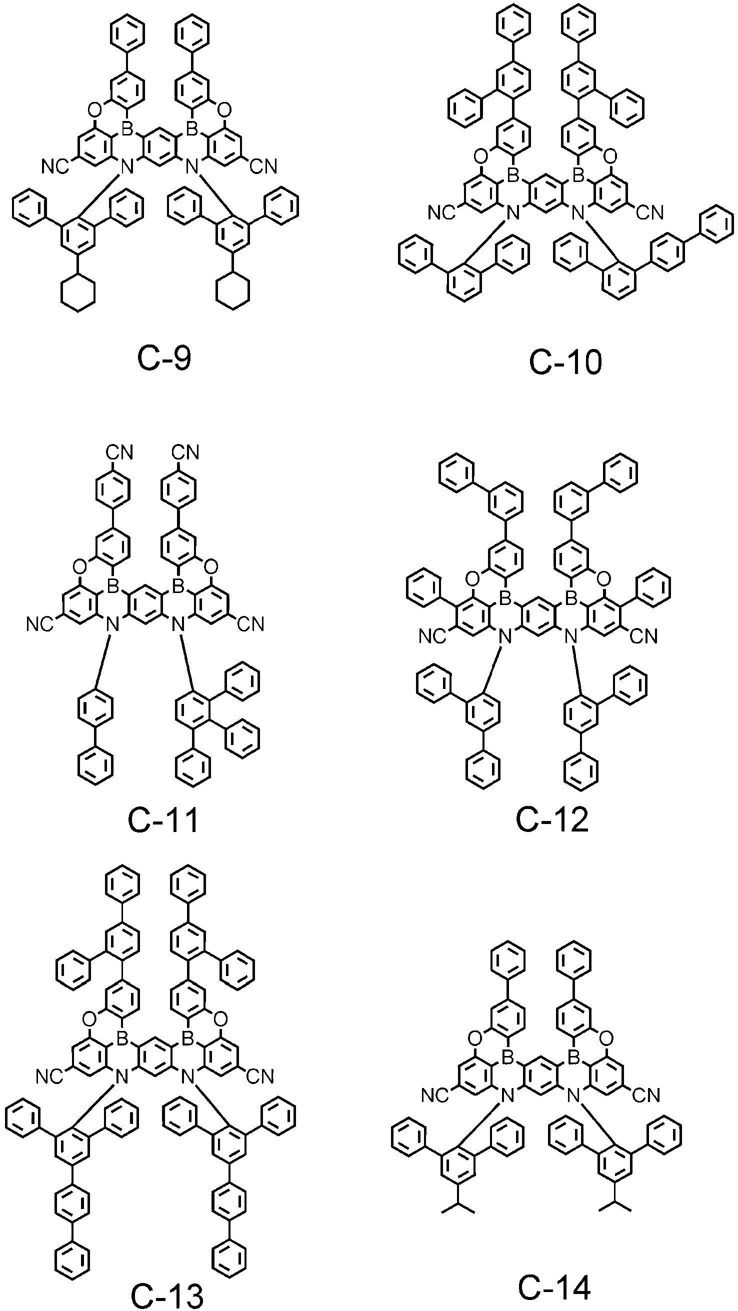

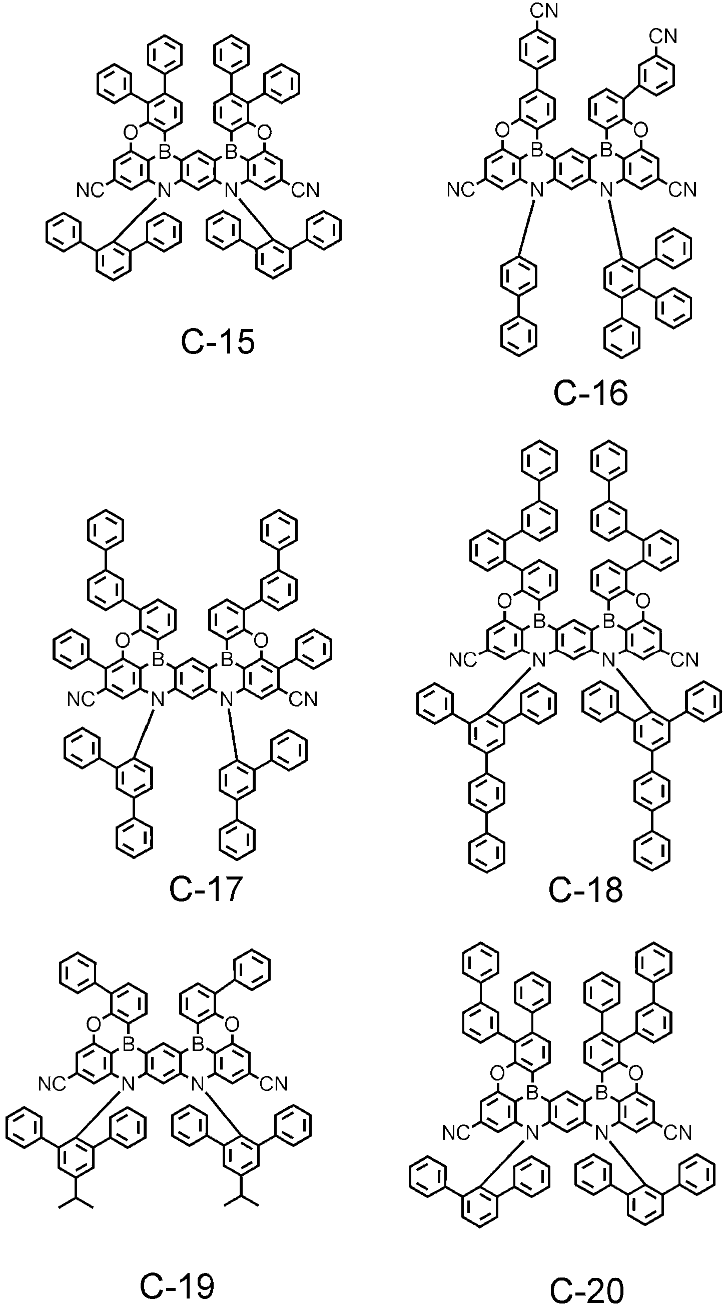

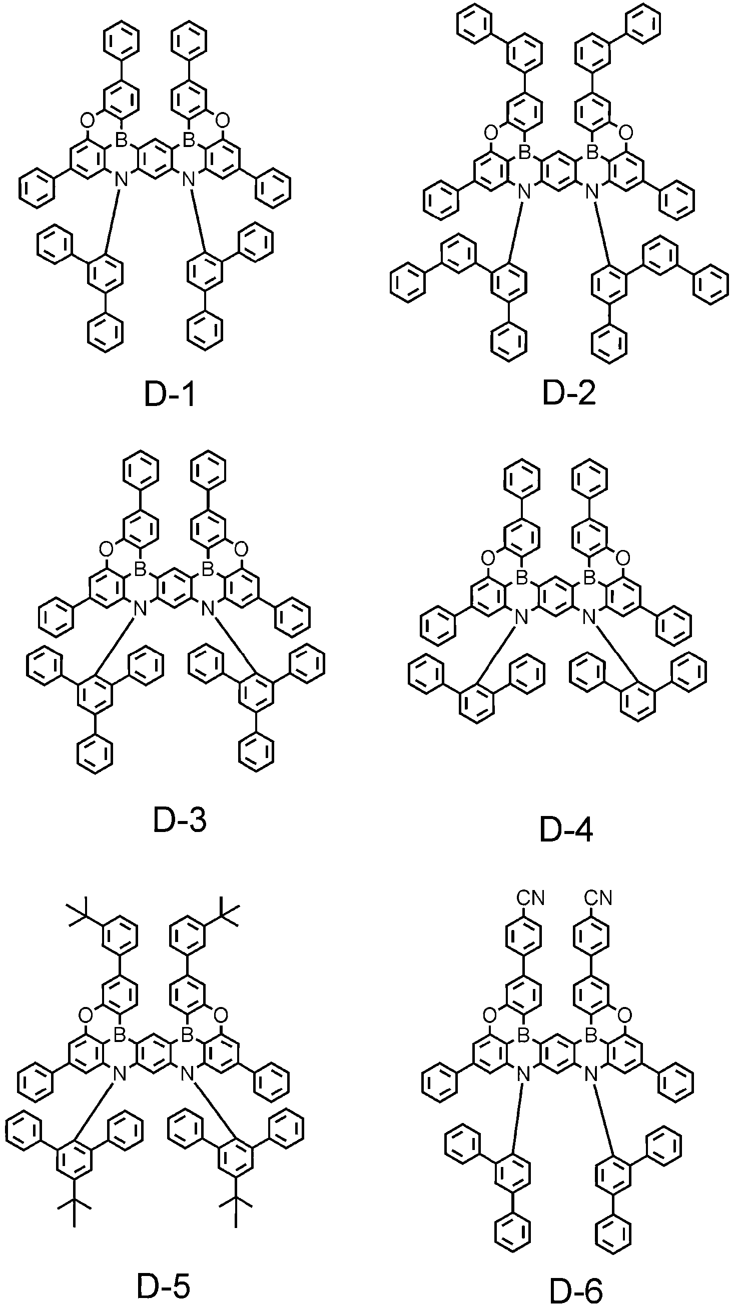

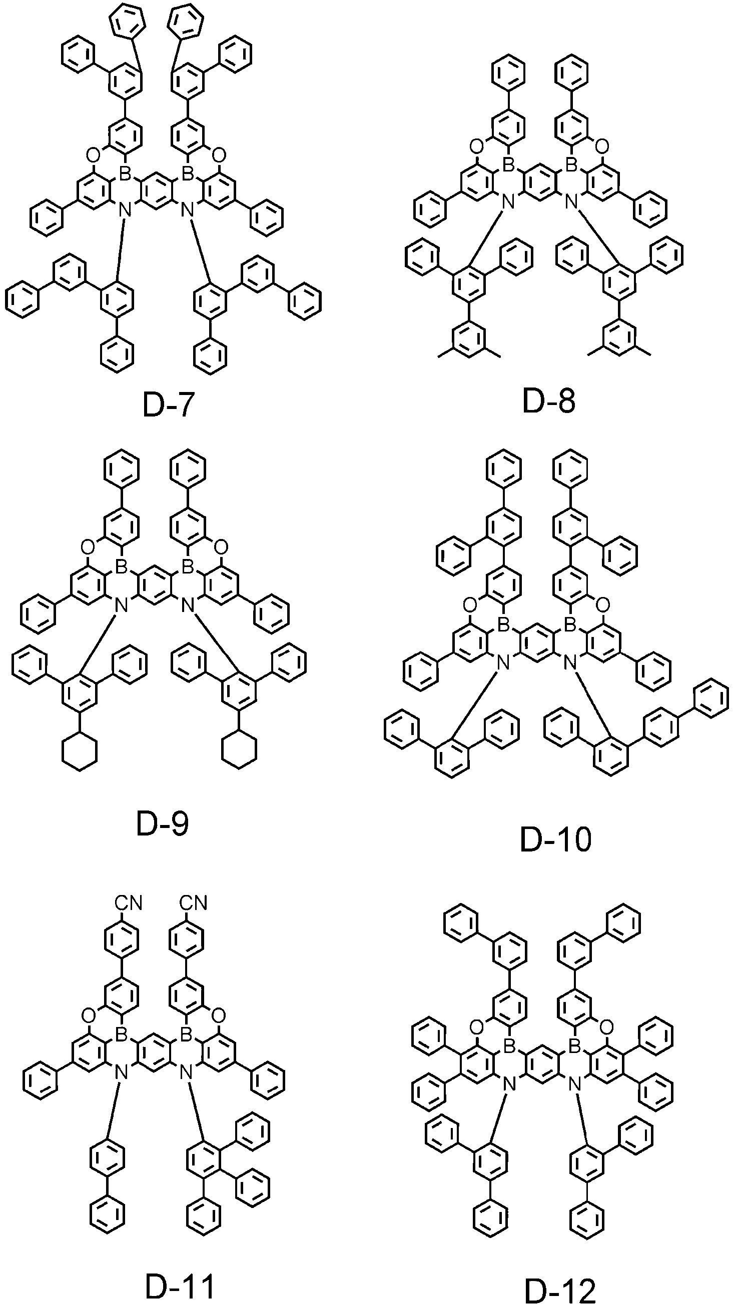

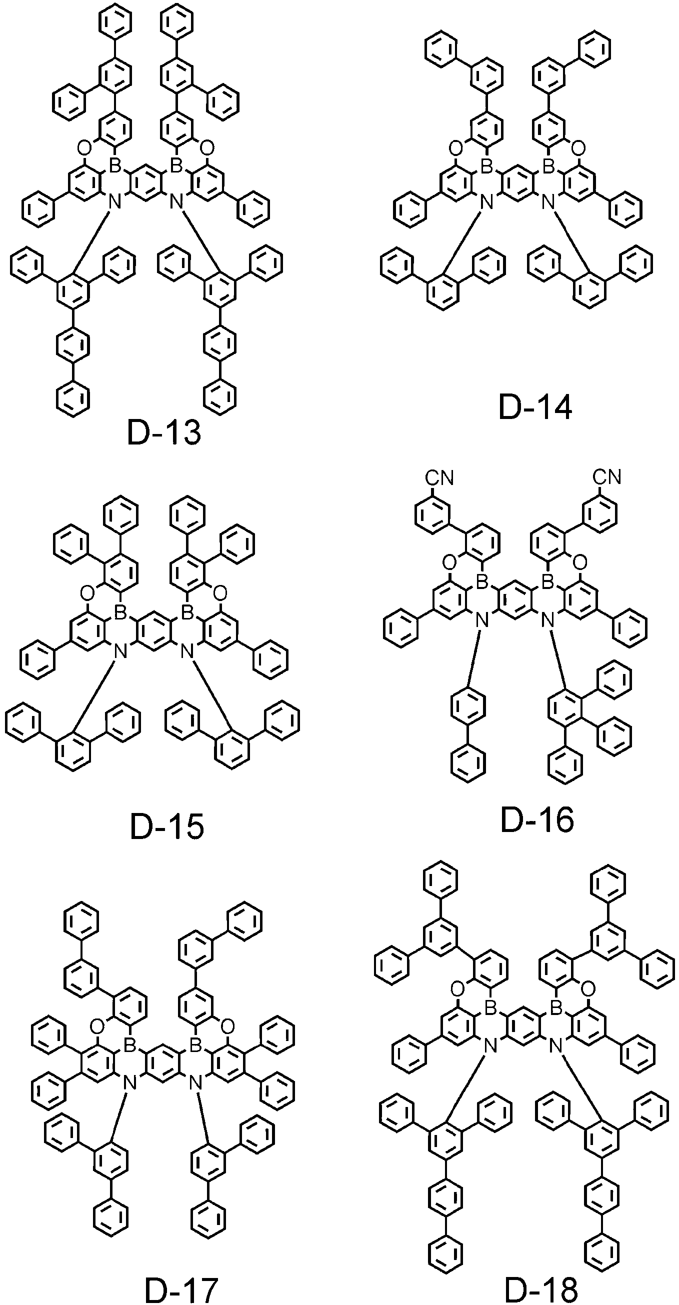

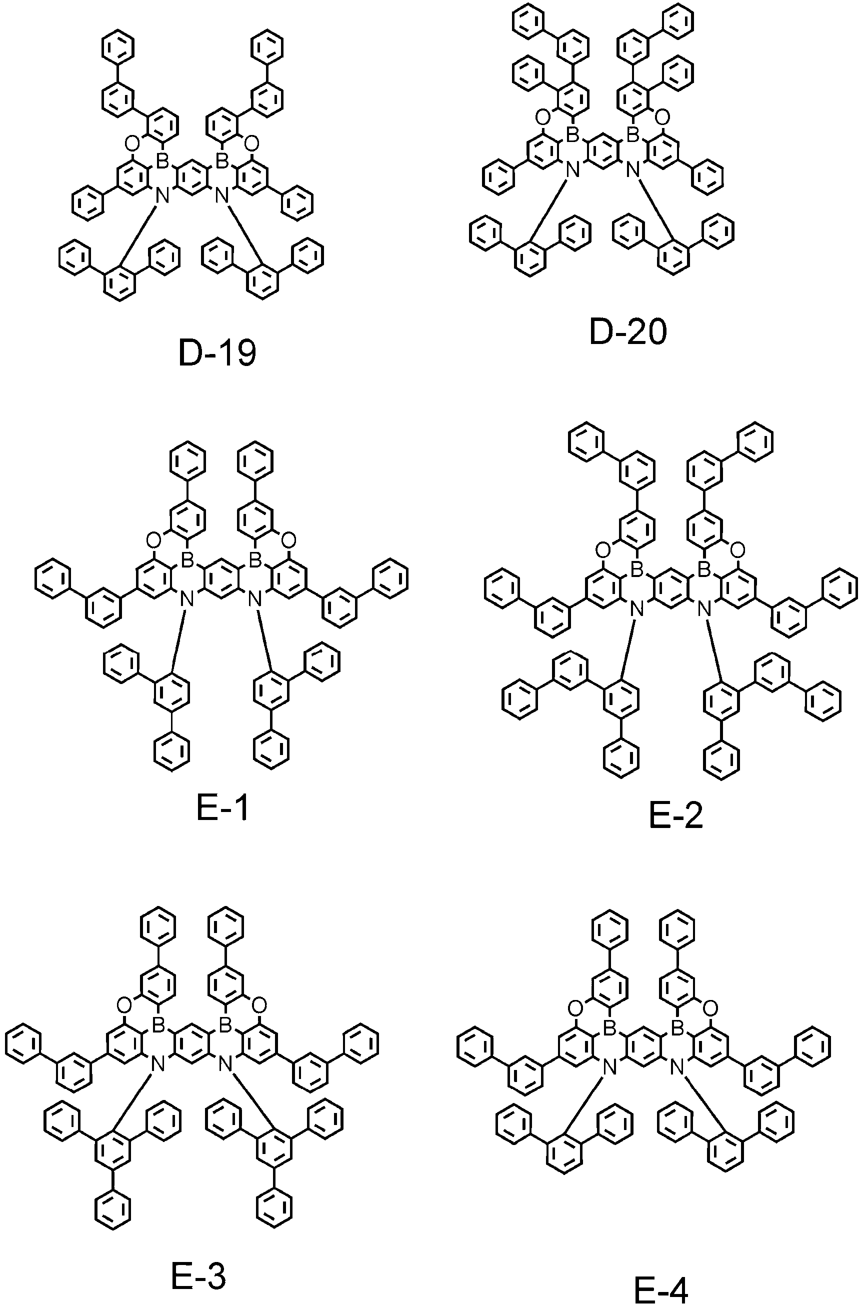

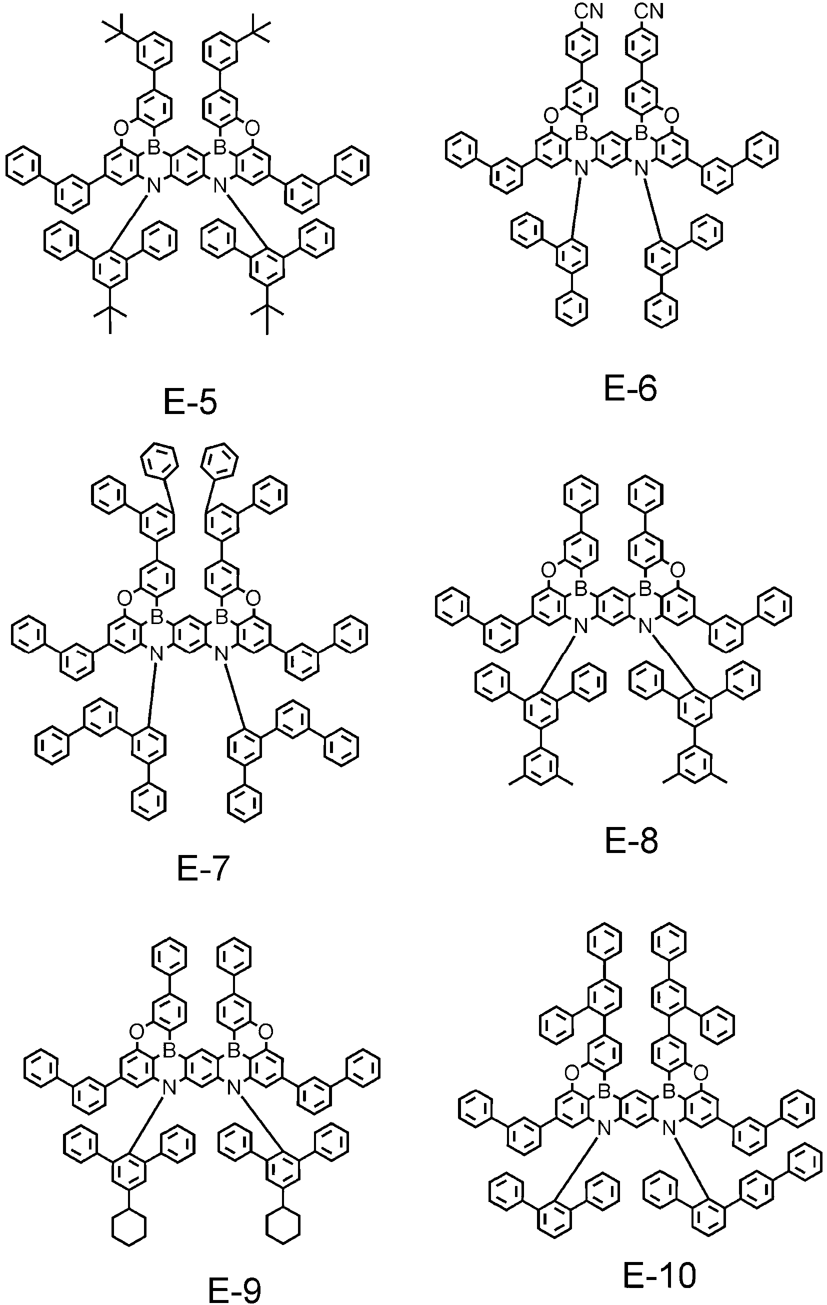

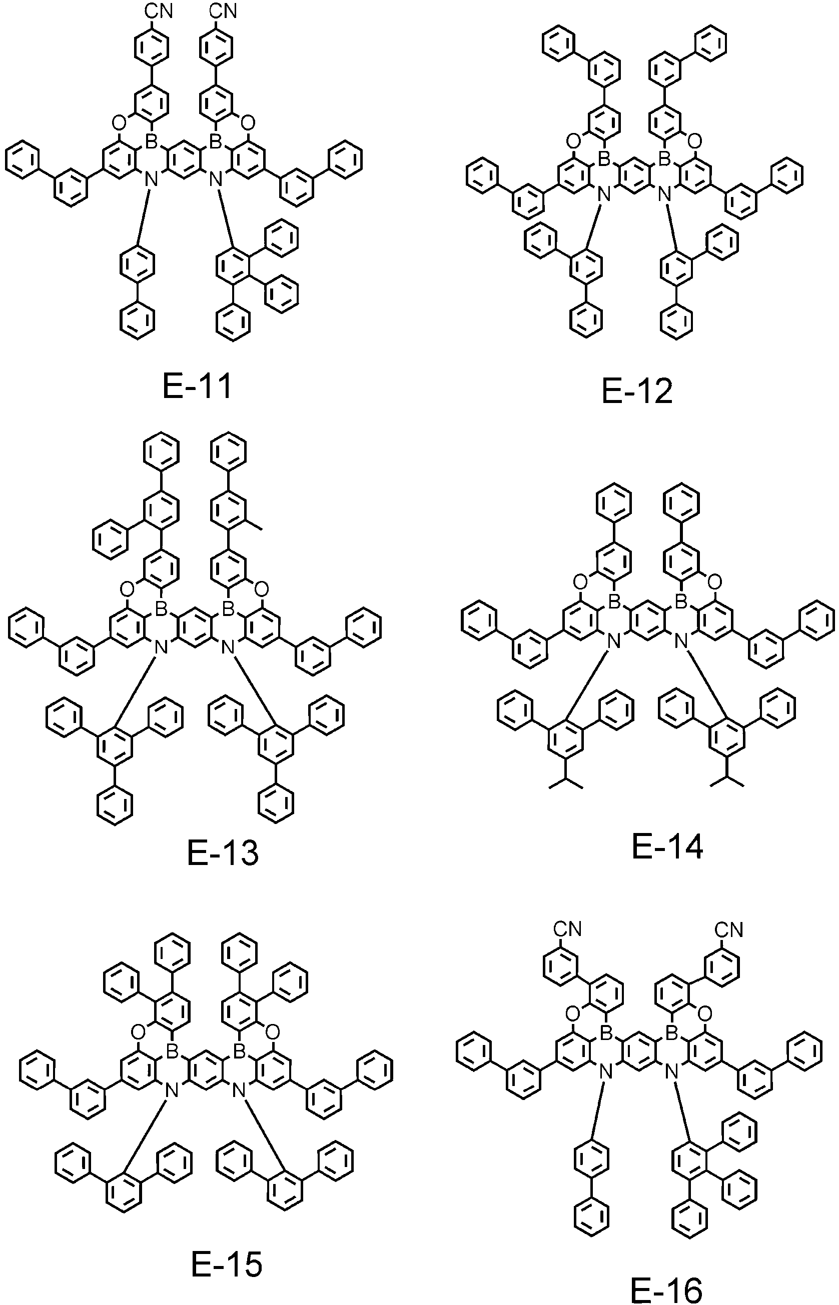

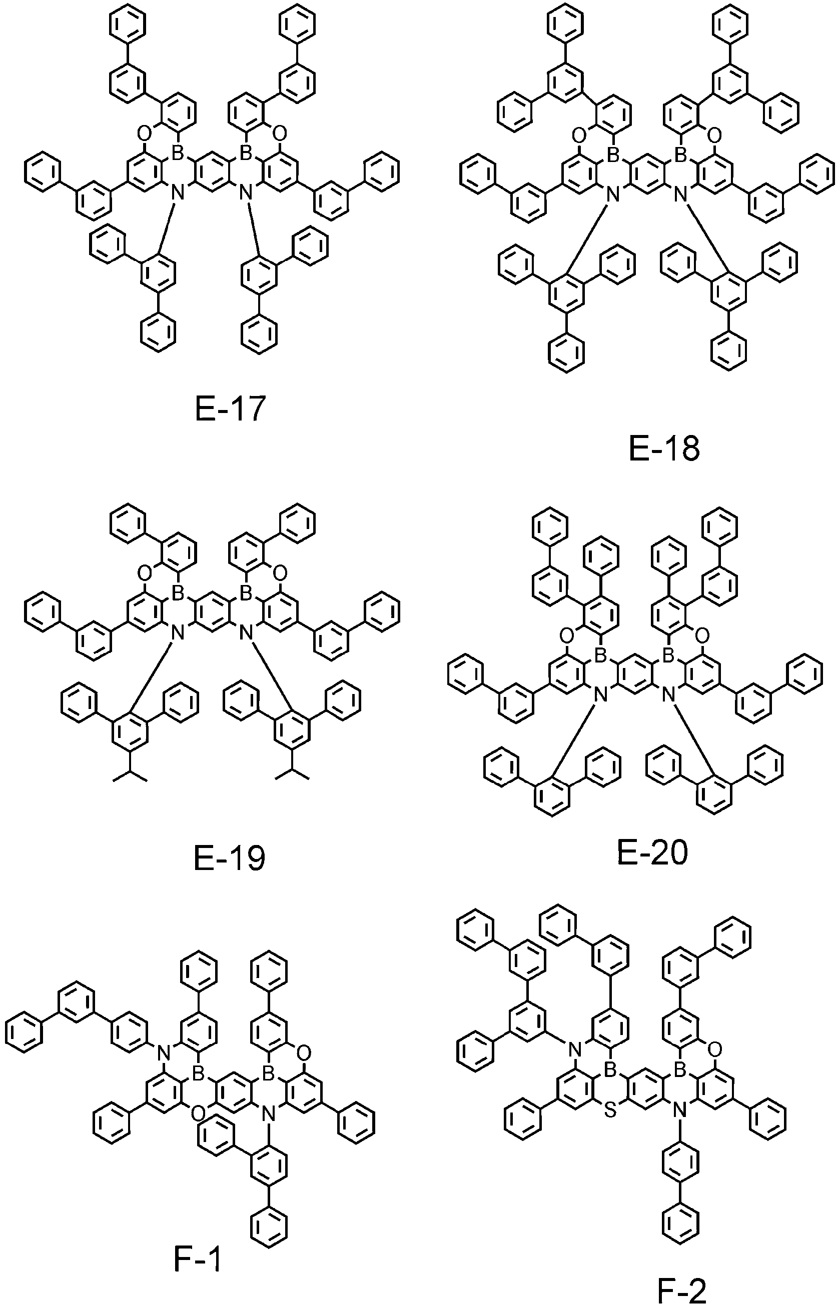

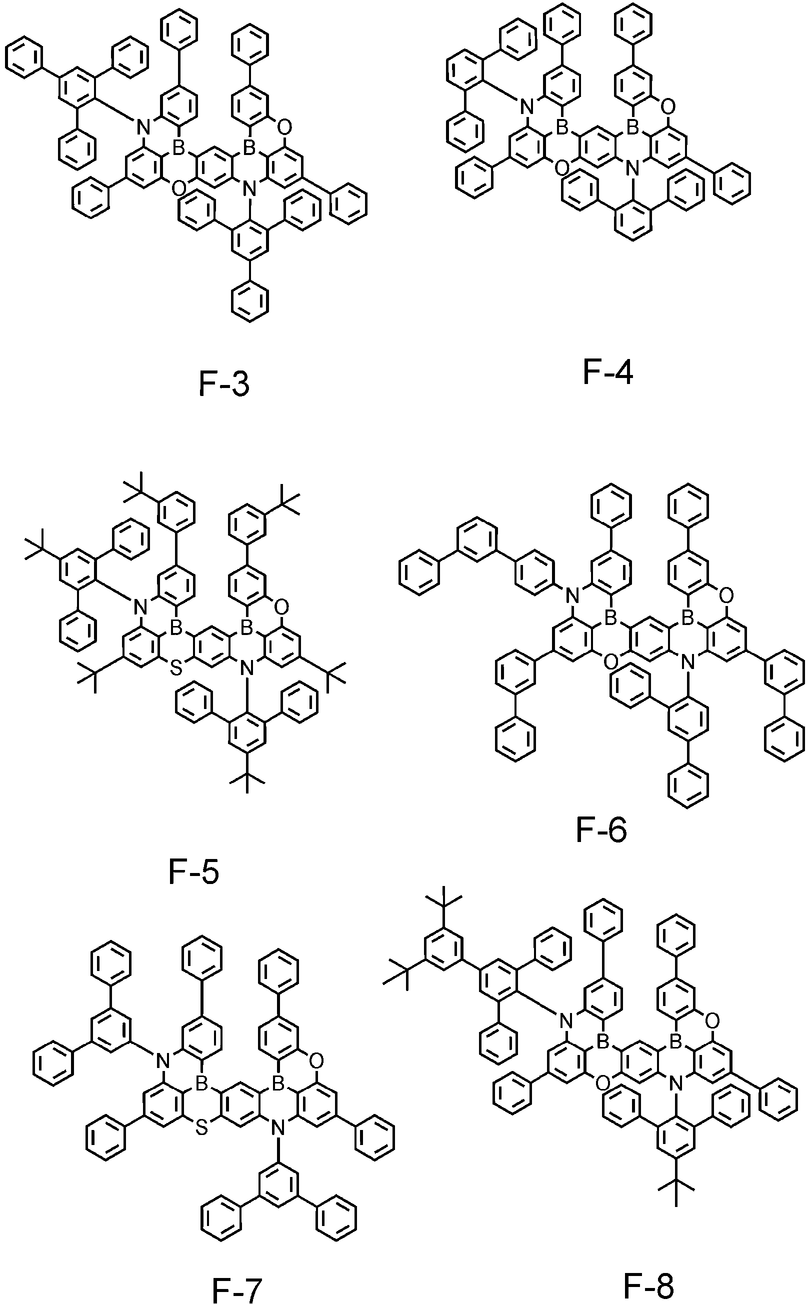

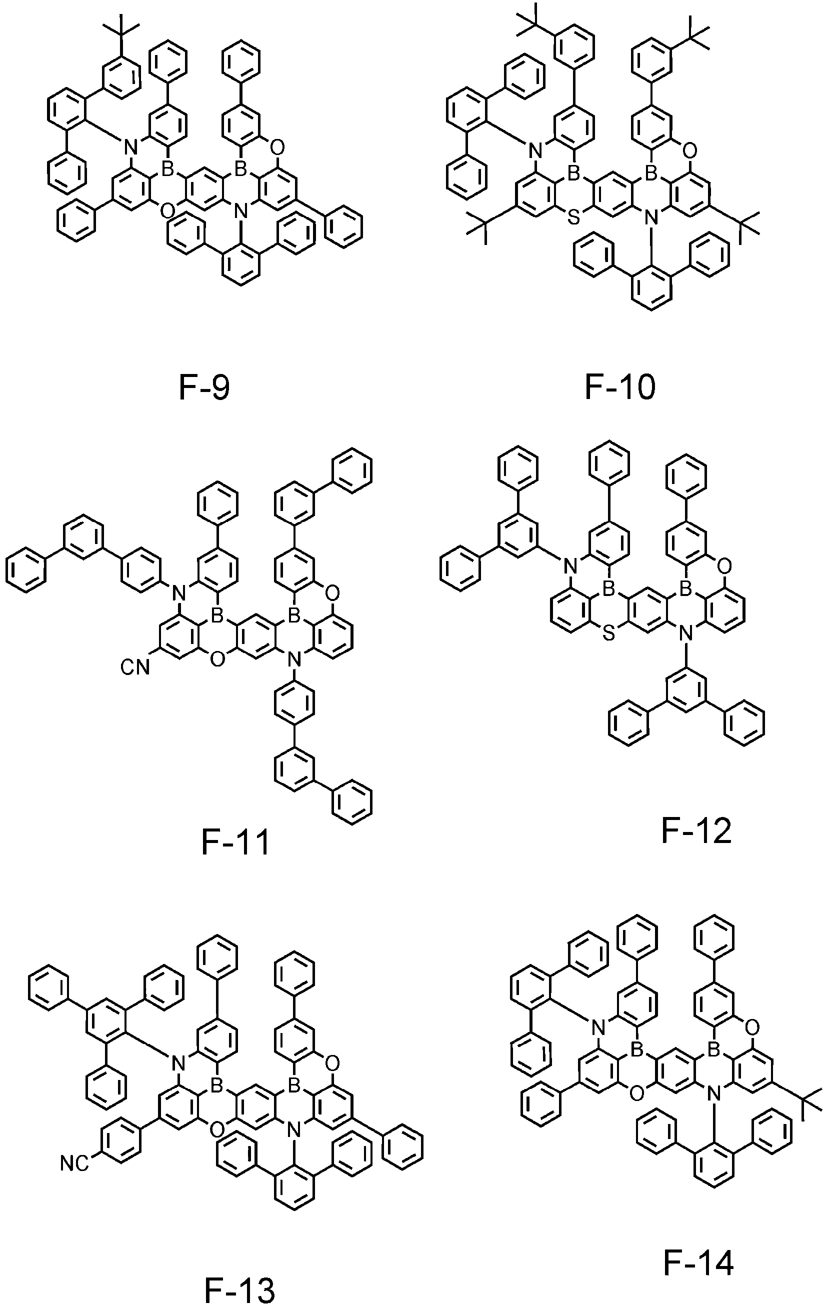

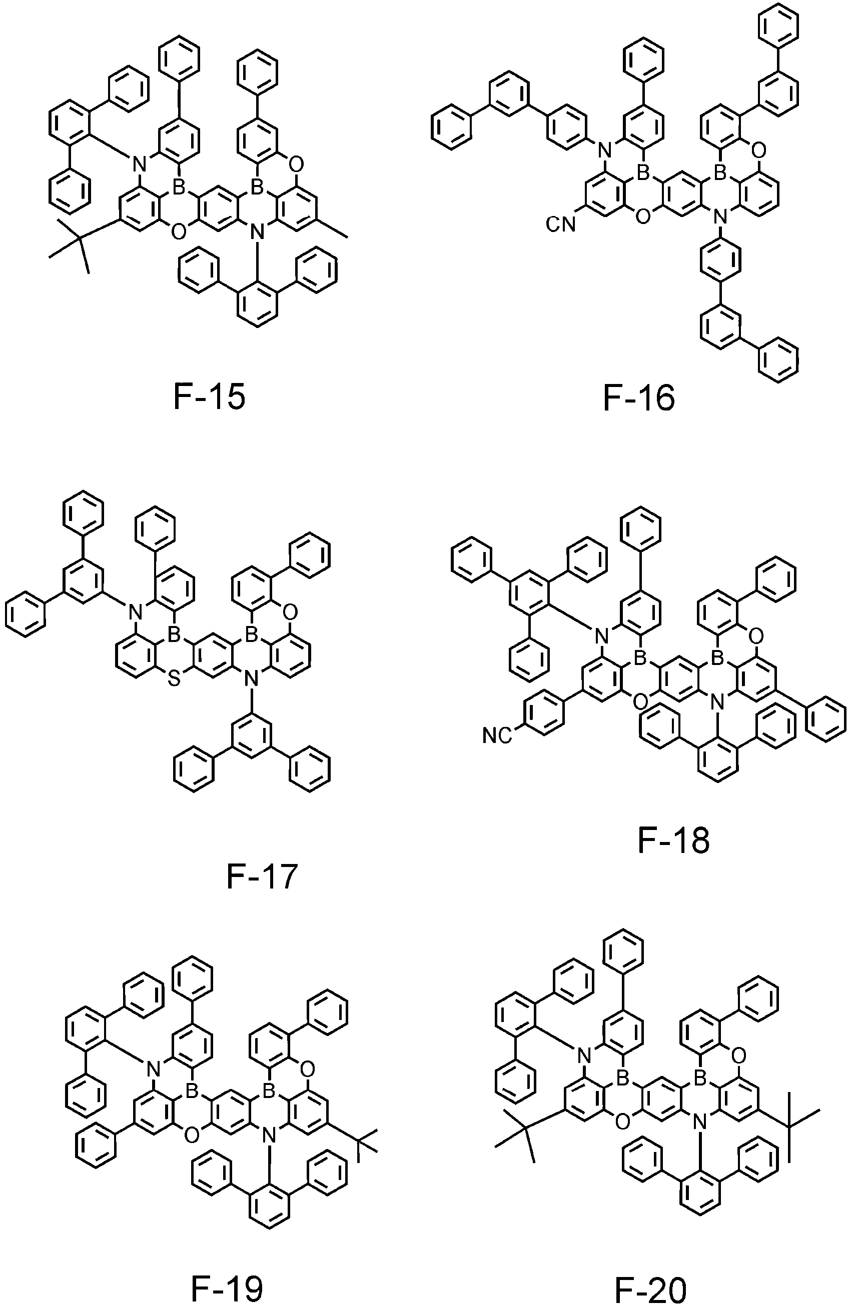

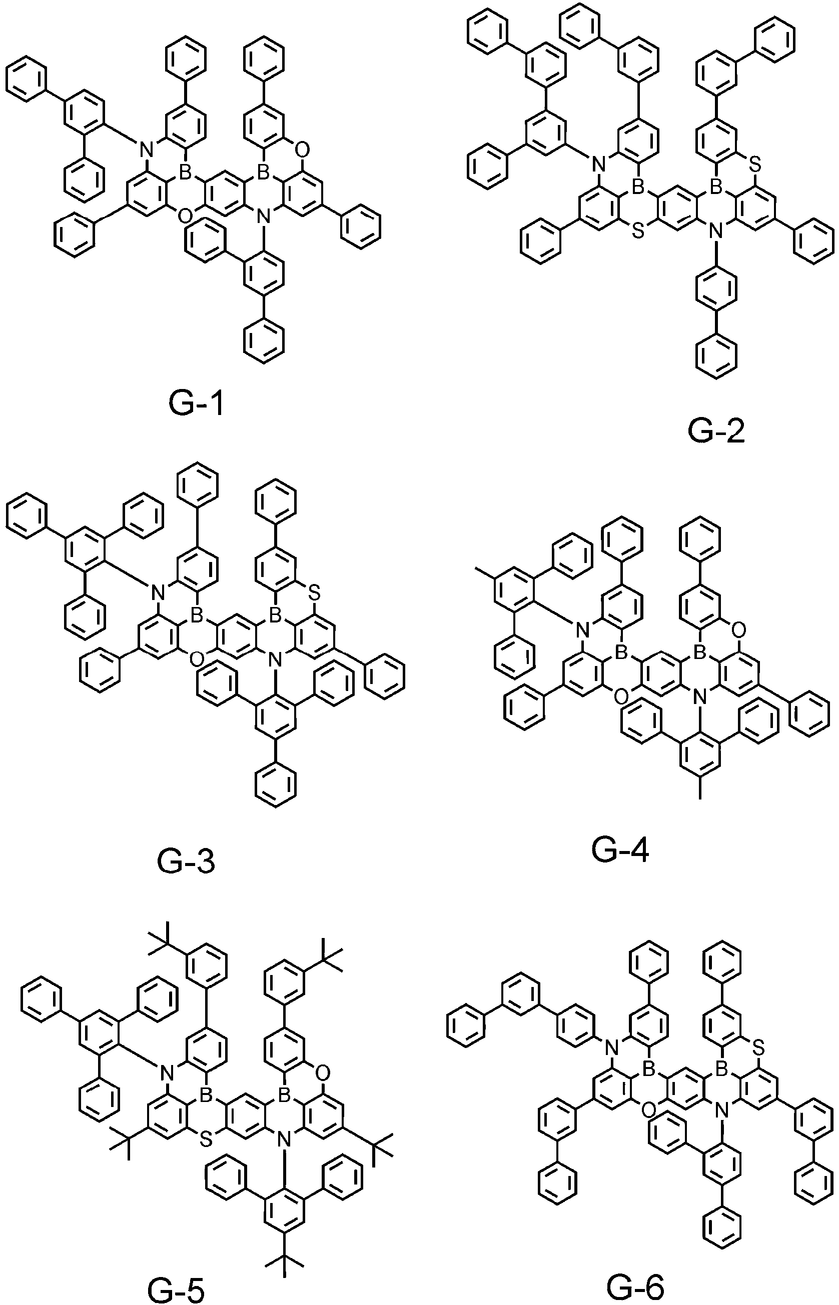

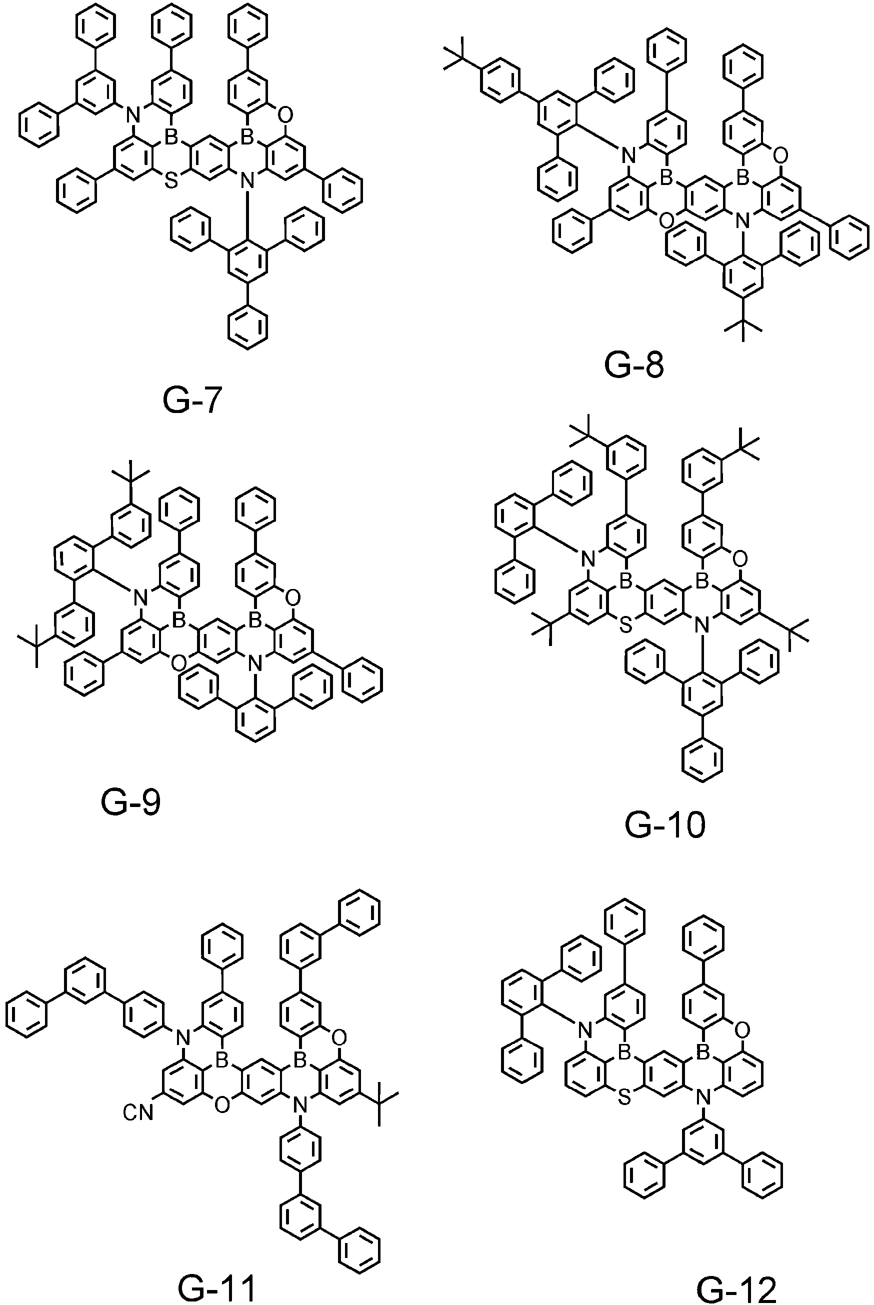

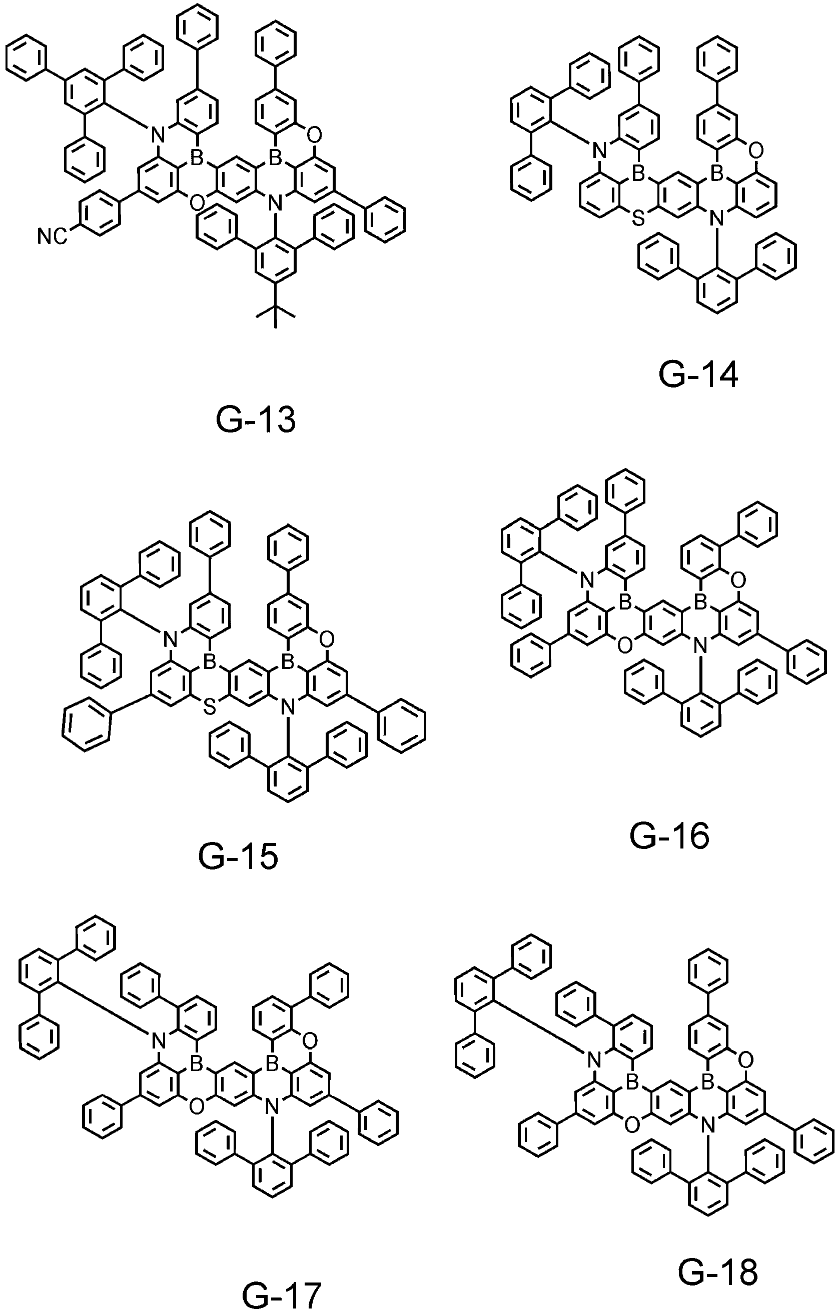

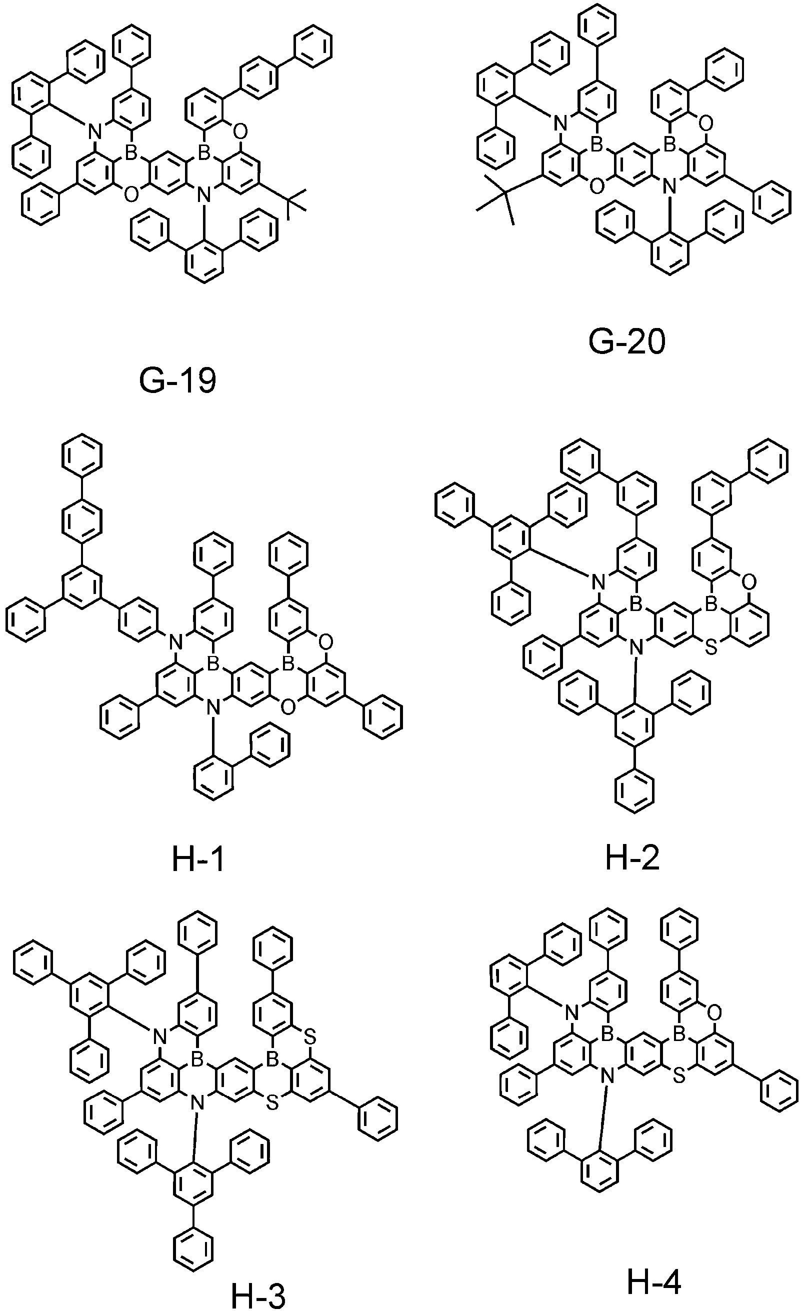

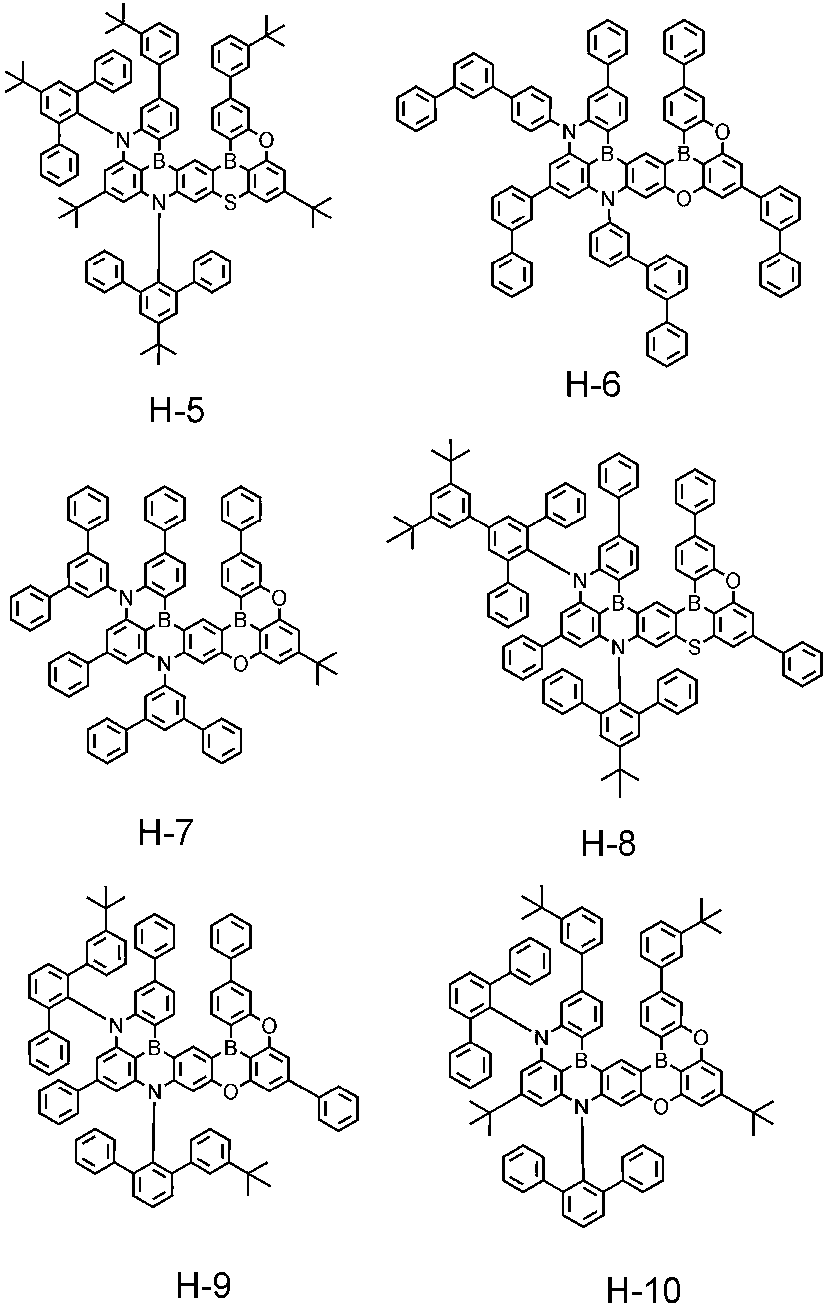

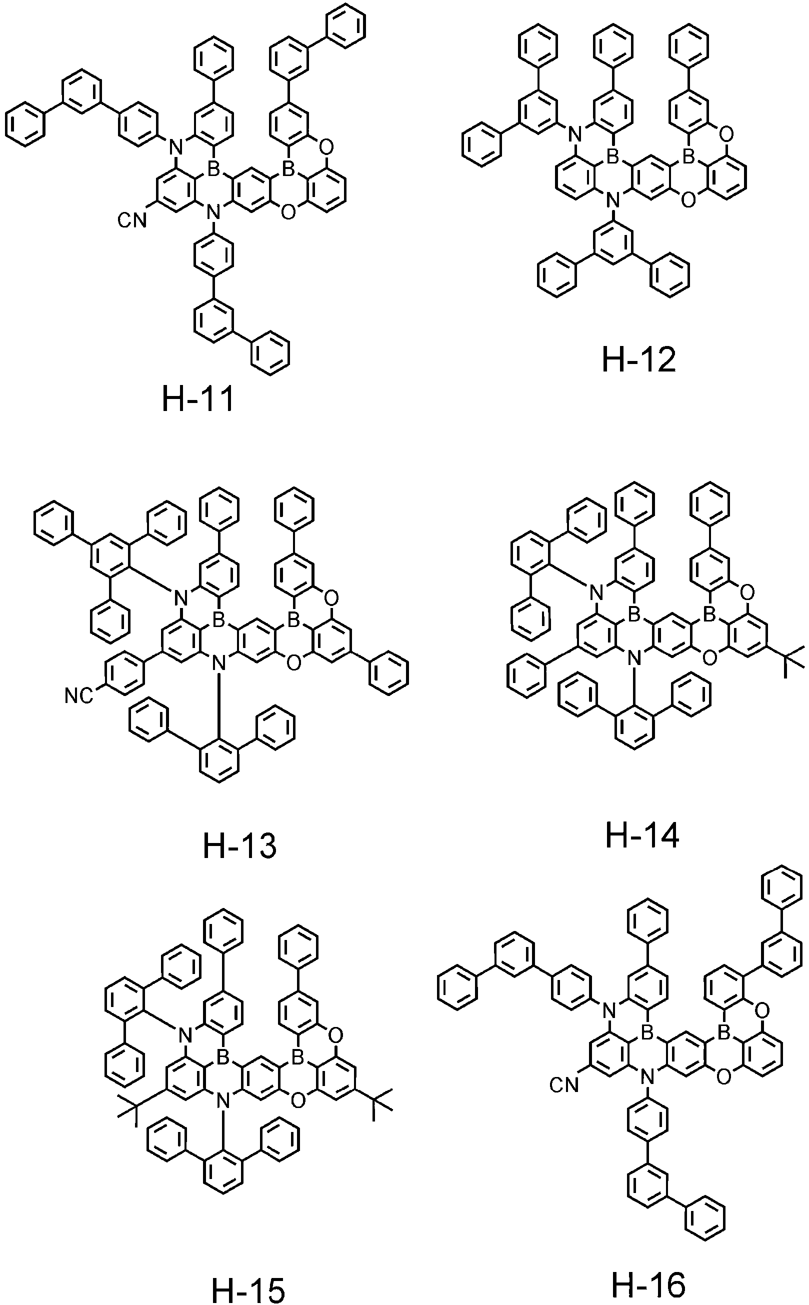

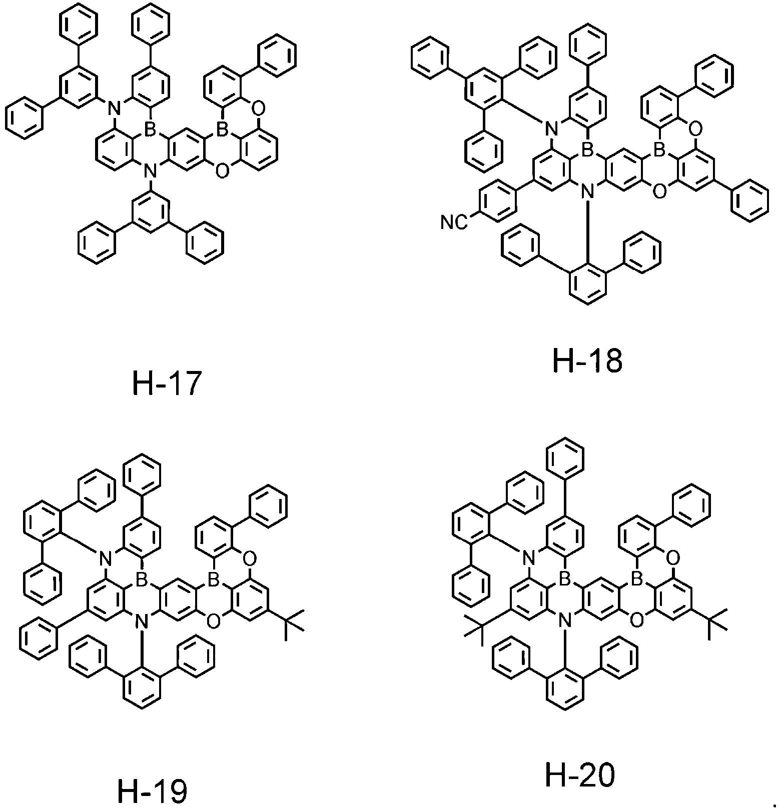

8. A light emitting element (ED) comprising:
a first electrode (EL1);
a second electrode (EL2) disposed on the first electrode (EL1); and
an emission layer (EML) disposed between the first electrode (EL1) and the second electrode (EL2),
wherein the emission layer (EML) comprises a first compound represented by Formula 1 according to any one of claims 1 to 7.

9. The light emitting element (ED) of claim 8, wherein the emission layer (EML) further comprises at least one of a second compound represented by Formula HT-1, a third compound represented by Formula ET-1, or a fourth compound represented by Formula D-1: 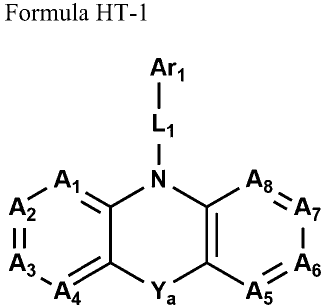 wherein, in Formula HT-1,
A₁ to A₈ are each independently N or CR₅₁,
L₁ is a direct linkage, a substituted or unsubstituted arylene group having 6 to 30 ring-forming carbon atoms, or a substituted or unsubstituted heteroarylene group having 2 to 30 ring-forming carbon atoms,
Yₐ is a direct linkage, CR₅₂R₅₃, or SiR₅₄R₅₅,
Ar₁ is a substituted or unsubstituted aryl group having 6 to 30 ring-forming carbon atoms, or a substituted or unsubstituted heteroaryl group having 2 to 30 ring-forming carbon atoms,
R₅₁ to R₅₅ are each independently a hydrogen atom, a deuterium atom, a halogen atom, a cyano group, a substituted or unsubstituted silyl group, a substituted or unsubstituted thio group, a substituted or unsubstituted oxy group, a substituted or unsubstituted amine group, a substituted or unsubstituted boron group, a substituted or unsubstituted alkyl group having 1 to 20 carbon atoms, a substituted or unsubstituted alkenyl group having 2 to 20 carbon atoms, a substituted or unsubstituted aryl group having 6 to 60 ring-forming carbon atoms, or a substituted or unsubstituted heteroaryl group having 2 to 60 ring-forming carbon atoms, or
R₅₁ to R₅₅ are optionally bonded to an adjacent group to form a ring, 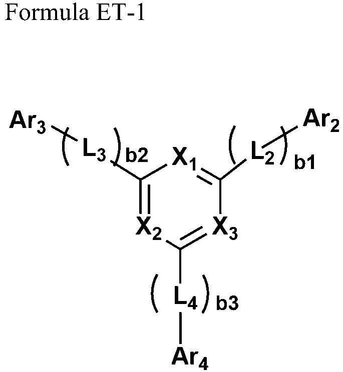
wherein, in Formula ET-1,
at least one of X₁ to X₃ is N, and the others of X₁ to X₃ are CR₅₆,
each R₅₆ is independently a hydrogen atom, a deuterium atom, a substituted or unsubstituted alkyl group having 1 to 20 carbon atoms, a substituted or unsubstituted aryl group having 6 to 60 ring-forming carbon atoms, or a substituted or unsubstituted heteroaryl group having 2 to 60 ring-forming carbon atoms,
b1 to b3 are each independently an integer of 0 to 10,
Ar₂ to Ar₄ are each independently a hydrogen atom, a deuterium atom, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms, and
L₂ to L₄ are each independently a direct linkage, a substituted or unsubstituted arylene group having 6 to 30 ring-forming carbon atoms, or a substituted or unsubstituted heteroarylene group having 2 to 30 ring-forming carbon atoms, 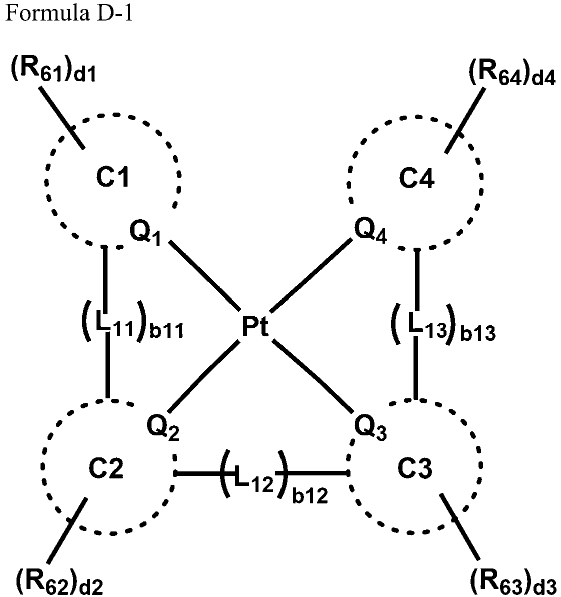
wherein, in Formula D-1,
Q₁ to Q₄ are each independently C or N,
ring C1 to ring C4 are each independently a substituted or unsubstituted aliphatic hydrocarbon ring having 5 to 30 ring-forming carbon atoms, a substituted or unsubstituted aryl group having 6 to 30 ring-forming carbon atoms, or a substituted or unsubstituted heterocycle having 2 to 30 ring-forming carbon atoms,
L₁₁ to L₁₃ are each independently a direct linkage, 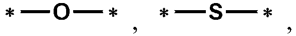 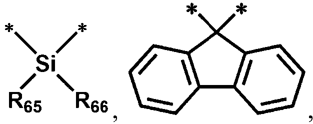 a substituted or unsubstituted alkylene group having 1 to 20 carbon atoms, a substituted or unsubstituted arylene group having 6 to 30 ring-forming carbon atoms, or a substituted or unsubstituted heteroarylene group having 2 to 30 ring-forming carbon atoms,
b11 to b13 are each independently 0 or 1,
R₆₁ to R₆₆ are each independently a hydrogen atom, a deuterium atom, a halogen atom, a cyano group, a substituted or unsubstituted silyl group, a substituted or unsubstituted thio group, a substituted or unsubstituted oxy group, a substituted or unsubstituted amine group, a substituted or unsubstituted boron group, a substituted or unsubstituted alkyl group having 1 to 20 carbon atoms, a substituted or unsubstituted alkenyl group having 2 to 20 carbon atoms, a substituted or unsubstituted aryl group having 6 to 60 ring-forming carbon atoms, or a substituted or unsubstituted heteroaryl group having 2 to 60 ring-forming carbon atoms, and
d1 to d4 are each independently an integer of 0 to 4.

10. An electronic device (EA) comprising a display module (DM) configured to provide images,
wherein the display module (DM) comprises:
a base layer (BS);
a circuit layer (DP-CL) disposed on the base layer (BS); and
a display element layer (DP-ED) disposed on the circuit layer (DP-CL), wherein the display element layer (DP-ED) comprises a light emitting element (ED),
wherein the light emitting element (ED) comprises a first electrode (EL1), a second electrode (EL2) disposed on the first electrode (EL1), and an emission layer (EML) disposed between the first electrode (EL1) and the second electrode (EL2), and
the emission layer (EML) comprises a fused polycyclic compound according to any one of claims 1 to 7.
